(19) Europäisches Patentamt
European Patent Office
Office européen des brevets

(11) **EP 3 612 342 B1**

(12) **EUROPÄISCHE PATENTSCHRIFT**

(45) Veröffentlichungstag und Bekanntmachung des Hinweises auf die Patenterteilung:
**28.02.2024  Patentblatt 2024/09**

(21) Anmeldenummer: **18700578.0**

(22) Anmeldetag: **15.01.2018**

(51) Internationale Patentklassifikation (IPC):
**B23K 26/00** (2014.01)   **B23K 26/53** (2014.01)
**B23K 26/0622** (2014.01)   **B28D 5/00** (2006.01)
**B23K 103/00** (2006.01)

(52) Gemeinsame Patentklassifikation (CPC):
**B23K 26/0624; B23K 26/0006; B23K 26/53;**
**B28D 5/0011; H01L 21/02005; H01L 21/7813;**
B23K 2103/56

(86) Internationale Anmeldenummer:
**PCT/EP2018/050897**

(87) Internationale Veröffentlichungsnummer:
**WO 2018/192689 (25.10.2018 Gazette 2018/43)**

(54) **VERFAHREN ZUR WAFERHERSTELLUNG MIT DEFINIERT AUSGERICHTETEN MODIFIKATIONSLINIEN**

METHOD FOR PRODUCING WAFERS WITH MODIFICATION LINES OF DEFINED ORIENTATION

PROCÉDÉ DE FABRICATION DE TRANCHES À LIGNES DE MODIFICATIONS ORIENTÉES DE FAÇON DÉFINIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.04.2017  DE 102017003830**
**11.08.2017  DE 102017007585**

(43) Veröffentlichungstag der Anmeldung:
**26.02.2020  Patentblatt 2020/09**

(73) Patentinhaber: **Siltectra GmbH**
**01099 Dresden (DE)**

(72) Erfinder:
• **SWOBODA, Marko**
**01097 Dresden (DE)**
• **RIESKE, Ralf**
**01099 Dresden (DE)**
• **BEYER, Christian**
**09599 Freiberg (DE)**
• **RICHTER, Jan**
**01277 Dresden (DE)**

(74) Vertreter: **Müller Hoffmann & Partner**
**Patentanwälte mbB**
**St.-Martin-Strasse 58**
**81541 München (DE)**

(56) Entgegenhaltungen:
WO-A2-2016/083609    WO-A2-2016/083610
DE-A1-102016 201 780    DE-A1-102016 209 554

EP 3 612 342 B1

**Beschreibung**

Die vorliegende Erfindung bezieht sich gemäß Anspruch 1 auf ein Verfahren zur Modifikation eines Festkörpers, insbesondere zum Abtrennen von mindestens einer Festkörperschicht von einem Spendersubstrat.

Halbleitermaterialien werden z.B. in großen Zylindern aus kristallinem Material, sogenannten Ingots, gewachsen, während Industrieprozesse oft Wafermaterial mit unterschiedlicher Dicke und Oberflächenqualität erfordern. Wafering von spröden Halbleitermaterialien wird häufig mit Diamant- oder Slurry-basierten Drahtsäge-Prozessen durchgeführt. Diese Sägeprozesse führen nicht nur zu Schnittspalt-Verlust von potenziell wertvollem Material, sondern auch zu Oberflächenrauheit und unter der Oberfläche zur Beschädigung des Kristalls. Diese Aspekte des Wafering mit Sägeprozessen machen Polier- und Schleifschritte im Waferherstellungsprozess erforderlich, was zu zusätzlichen Schäden und Prozesskosten führt.

Um diese Probleme beim herkömmlichen Wafering und Dünnen von Halbleitern anzugehen, wurden sog. kerfless Technologien entwickelt, die eine Verringerung der Schnittspaltverluste versprechen - wenn nicht gar deren Beseitigung, sowie von Schaden unter der Oberfläche und Schleifprozessschritten. Kerf-freie Wafering-Techniken haben das Potenzial, um Schäden in Halbleiterherstellungsverfahren drastisch zu reduzieren. Spannungsbasierte Abtrennverfahren, wie das sog. Spalling (bzw. Splitten), verwenden extern aufgebrachte Spannungen um kristalline Materialien entlang ihrer Kristallebenen mit gut definierter Dicke zu trennen. Spalling kann mit Nickel-Chrom-Legierungen, Silber-Aluminiumpaste, Epoxidharz, Aluminium und Nickel erfolgen. Substrate zeigen nach dem Spalling jedoch sogenannte Wallner-Linien, die von der Rissausbreitung im Kristall herrühren.

Es wurde Spalling unter Verwendung von Unterschieden in den thermischen Ausdehnungskoeffizienten zwischen einem spröden Material und einem auf der Oberfläche des Materials anhaftenden Polymer ermöglicht. Abkühlen der verbundenen Materialien unterhalb der Glasübergangstemperatur des Polymers induziert Spannungen, die zur Materialtrennung entlang einer Rissebene führen. Ein Vorteil dieses speziellen Verfahrens im Gegensatz zu anderen Arten von Spalling ist, dass durch den Prozess des Kühlens keine erhöhte Diffusion von unerwünschten chemischen Komponenten durch das Material auftritt, im Gegensatz zu Hochtemperaturverfahren, die auch zum Spalling verwendet werden. Spalling Verfahren neigen jedoch dazu, in ihrer Kontrolle über die erreichte Wafer-Dicke begrenzt zu sein, und ein Abstimmen des vertikalen Orts der Rissausbreitung ist kompliziert. Darüber hinaus entstehen beim Spalling sehr prominente Muster von Wallner-Linien auf der Oberfläche. Dieses Muster besteht aus streifenförmigen Rillen und Erhebungen, die von der Rissausbreitung im Halbleitermaterial stammen und eine Ableitung der Rissdynamik im Substrat ermöglichen. Üblicherweise beginnt der Riss an einem gewissen Punkt am Rand und breitet sich dann rasch von der Kante des Substrats aus. Wallner-Linien von herkömmlichen Spalling-Oberflächen erhöhen die resultierende Oberflächenrauheit stark, oft bis zu dem Punkt, ab dem vor der Weiterverarbeitung und der Herstellung von Schaltkreisen auf dem Substrat zusätzliche Polier- oder Schleif Schritte erforderlich sind.

Die Druckschrift WO2016/083610 der Anmelderin, auf deren Offenbarungsgehalt hiermit Bezug genommen wird, offenbart ein lasergestütztes Abtrennen von Festkörperschichten von Spendersubstraten, insbesondere Beispiele der Modifikationserzeugung.

Durch die Druckschrift DE102016201780A1 (Anfangspunkt dieser Erfindung) wird ein Verfahren offenbart, bei dem mittels Laserstrahlen Risse zum Ablösen eines Wafers in einem Ingot erzeugt werden. Die Ablösung erfolgt in Abhängigkeit von einer Ultraschallbeaufschlagung. Dieses Verfahren ist nachteilig, da es aufgrund seiner Prozessparameter sehr festgelegt ist und ferner einen hohen Nachbearbeitungsaufwand erfordert, wobei durch die Nachbearbeitung hohe Kosten und Materialverluste erzeugt werden.

Es ist somit die Aufgabe der vorliegenden Erfindung ein Verfahren zur Modifikation eines Festkörpers, insbesondere zum Abtrennen von mindestens einer Festkörperschicht von einem Spendersubstrat bereitzustellen, das gegenüber dem bekannten Verfahren besser ist, insbesondere geringere Materialverluste ermöglicht und/oder eine Möglichkeit zur vorteilhafteren Herstellung von elektrischen Komponenten bereitzustellen und/oder vorteilhafte Mehrkomponentenanordnungen bereitzustellen..

Die zuvor genannte Aufgabe wird durch ein Verfahren zur Modifikation eines Festkörpers, insbesondere zum Abtrennen von mindestens einer Festkörperschicht von einem Spendersubstrat gemäß Anspruch 1 gelöst. Das erfindungsgemäße Verfahren umfasst dabei zumindest die Schritte: Bereitstellen des Spendersubstrats, wobei das Spendersubstrat Kristallgitterebenen aufweist, die gegenüber einer ebenen Hauptoberfläche geneigt sind, wobei die Hauptoberfläche das Spendersubstrat in Längsrichtung des Spendersubstarts einerseits begrenzt, wobei sich eine Kristallgitterebenennormale gegenüber einer Hauptoberflächennormalen in eine erste Richtung neigt, Bereitstellen von mindestens einem Laser, Einbringen von Laserstrahlung des Lasers in das Innere des Festkörpers über die Hauptoberfläche zum Verändern der Materialeigenschaften des Festkörpers im Bereich von mindestens einem Laserfokus, wobei der Laserfokus durch von dem Laser emittierten Laserstrahlen des Lasers gebildet wird, wobei die Veränderung der Materialeigenschaft durch Verändern des Eindringortes der Laserstrahlung in das Spendersubstrat eine linienförmige Gestalt ausbildet, wobei die Veränderungen der Materialeigenschaft auf einer Erzeugungsebene erzeugt werden, die parallel zur Hauptoberfläche verläuft, wobei sich die linienförmige Gestalt zumindest abschnittsweise geradlinig erstreckt und wobei die Kristallgitterebenen des Spendersubstrats gegenüber der Erzeugungsebene geneigt ausgerichtet sind, wobei die linienförmige Gestalt, insbesondere zumindest der sich geradlinig erstreckende Abschnitt, gegenüber einer sich an der Schnittstelle zwischen der Erzeugungsebene und der Kristallgitterebene ergebenden Schnittlinie bzw. Schnittgeraden geneigt ist, wobei durch die veränderte Materialeigenschaft das Spendersubstrat in Form von unterkritischen Rissen einreißt, Abtrennen der Festkörperschicht durch Einleiten einer äußeren Kraft in das Spendersubstrat zum Verbinden der unterkritischen Risse oder so viel Material auf der Erzeugungsebene mittels der Laserstrahlung verändert wird, dass sich unter Verbindung der unterkritischen Risse die Festkörperschicht von dem Spendersubstart ablöst. Die Hauptoberfläche wird hierbei bevorzugt als ideal ebene Oberfläche angesehen/definiert.

Dieses Verfahren ist vorteilhaft, da dadurch, dass die linienförmige Gestalt gegenüber einer sich an der Schnittstelle zwischen der Erzeugungsebene und der Kristallgitterebene ergebenden Schnittlinie bzw. Schnittgeraden geneigt ist, das Risswachstum senkrecht zur Schreibrichtung begrenzt wird. Die Modifikationen je Schreiblinie werden somit nicht in denselben Kristallgitterebenen erzeugt. Z.B. die ersten 1-5% der Modifikationen je Schreiblinie können somit nur noch einen Bruchteil, insbesondere weniger als 75% oder weniger als 50% oder weniger als 25% oder weniger als 10% oder keine Kristallgitterebenen, der letzten 1-5% der Modifikationen derselben Schreiblinie schneiden. Die Schreiblinie ist hierbei bevorzugt länger als 1cm oder länger als 10cm oder länger als 20cm oder bis zu 20cm lang oder bis zu 30cm lang oder bis zu 40cm lang oder bis zu 50cm lang. Er werden somit je Schreiblinie deutlich weniger Modifikationen in denselben Kristallgitterebenen erzeugt, wodurch eine Rissausbreitung entlang dieser Kristallgitterebenen begrenzt wird. Geneigt ist hierbei als nicht parallel oder nicht überlagernd zu verstehen und kann somit zum Beispiel schon ab einem Winkel von 0,05° vorliegen, wobei sich auch bei sehr kleinen Winkeln, insbesondere unter 1°, über die Erstreckungslänge der linienförmigen Gestalt voneinander verschiedene Kristallgitterebenen, insbesondere Gleitebenen, durch die Modifikation bzw. Modifikationen lokal geschnitten bzw. modifiziert bzw. verändert werden.

Dies führt zu einem wesentlichen zweiten Vorteil der vorliegenden Erfindung, nämlich dass die Schreibrichtung nicht zwingend derart ausgeführt werden muss, dass die weiteren erzeugten Risse die zuletzt erzeugten Risse überlagern müssen. Es ist nunmehr auch möglich, dass die Schreibrichtung entgegengerichtet ist. Aufgrund der möglichen Kürze der Risse durch das erfindungsgemäße Verfahren erfolgt nämlich kein Abschatten durch die zuletzt erfolgten Risse. Dies ermöglicht es, dass trotz der entgegengerichteten Schreibrichtung z.B. Linienabstände von weniger als 100$\mu$m, insbesondere von weniger als 75$\mu$m oder von weniger als 50$\mu$m oder von weniger als 30 $\mu$m oder von weniger als 20 $\mu$m oder von weniger als 10 $\mu$m oder von weniger als 5 $\mu$m oder von weniger als 2 $\mu$m, realisiert werden können.

Als Veränderung der Materialeigenschaft kann hierbei bevorzugt das Erzeugen einer Materialmodifikation bzw. das Erzeugen eines Kristallgitterdefekts, insbesondere das Bewirken eines lokal begrenzten Phasenwechsels, verstanden werden.

Alternativ wird kann das vorliegende Verfahren zumindest durch die nachfolgend genannten Schritte definiert werden, die je Ausführungsform eines oder mehrere der mit dieser Schrift offenbarten Merkmale aufweist: Bereitstellen eines Festkörpers, Erzeugen von Modifikationen, insbesondere mittels Laserstrahlung, in dem Festkörper zum Ausbilden bzw. Erzeugen eines Ablösebereichs bzw. einer Ablöseebene bzw. eines Rissführungsbereich und Abtrennen von einer Festkörperschicht von dem Festkörper infolge einer Rissausbreitung entlang des Ablösebereichs bzw. der Ablöseebene bzw. des Rissführungsbereichs oder Teilen des Festkörpers entlang des Ablösebereichs bzw. der Ablöseebene bzw. des Rissführungsbereichs.

Weitere bevorzugte Ausführungsformen sind Gegenstand der Unteransprüche und/oder der nachfolgenden Beschreibungsanteile.

Gemäß einer ersten bevorzugten Ausführungsform der vorliegenden Erfindung ist die linienförmige Gestalt bzw. Schreiblinie gegenüber der Schnittlinie in einem Winkelbereich zwischen 3° und 87°, insbesondere in einem Winkelbereich zwischen 5° und 60° und bevorzugt zwischen 10° und 50°, insbesondere zwischen 10° und 30°, wie z.B. zwischen 12° und 20° oder zwischen 13° und 15°, oder zwischen 20° und 50°, insbesondere zwischen 25° und 40° oder zwischen 30° und 45° oder zwischen 28° und 35°, geneigt. Diese Lösung ist vorteilhaft, da die Neigung so groß ist, dass ausreichend viele unterschiedliche Kristallgitterebenen Bestandteil jeder weiteren Modifikation derselben linienförmigen Gestalt bzw. Schreiblinie sind.

Gemäß einer weiteren bevorzugten Ausführungsform der vorliegenden Erfindung wird so viel Material des Spendersubstrats unter Ausbildung einer linienförmigen Gestalt oder mehrerer linienförmiger Gestalten verändert, dass sich aus den infolge der Festkörperschichtenabtrennung freigelegten Enden der einzelnen Kristallgitterebenen und den Materialveränderungen Moreémuster ergeben, wobei hierzu eine Vielzahl sich linienförmig und bevorzugt geradlinig erstreckender und parallel zueinander ausgerichteter Materialveränderungsbereiche erzeugt werden.

Eine linienförmige Gestalt ist hierbei bevorzugt als Punktmenge anzusehen, die eine gerade oder gebogene Linie ausbildet, wobei die linienförmige Gestalt auch abschnittsweise einen oder mehrere gerade Anteile und/oder abschnittsweise einen oder mehrere gebogene Anteile aufweisen kann. Die Abstände zwischen den Zentren der einzelnen Punkte liegen dabei bevorzugt weniger als 250$\mu$m, insbesondere weniger als 150 $\mu$m oder weniger als 50 $\mu$m oder weniger als 15$\mu$m oder weniger als 10$\mu$m oder weniger als 5$\mu$m oder weniger als 2$\mu$m, auseinander.

Bevorzugt werden mehrere linienförmige Gestalten auf derselben Erzeugungsebene erzeugt, bevorzugt sind zumindest mehrere der linienförmigen Gestalten im gleichen Abstand zueinander angeordnet. Bevorzugt können die linienförmigen Gestalten bogenförmig insbesondere kreisbogenförmig oder gerade ausgebildet sein.

Die Laserstrahlung wird gemäß einer weiteren bevorzugten Ausführungsform der vorliegenden Erfindung mit Pulslängen von weniger als 5ns oder weniger als 2ns, insbesondere von weniger als 1ns oder von weniger als 700ps oder von weniger als 500ps oder von weniger als 400ps oder von weniger als 300ps oder von weniger als 200ps oder von weniger als 150ps oder von weniger als 100ps oder von weniger als 50ps oder von weniger als 10ps, erzeugt.

Bevorzugt werden Veränderungen der Materialeigenschaft bzw. Modifikationen jeweils mit Laserpulsen erzeugt, die kurzer sind als 5ns, insbesondere kürzer als 2ns oder 1ns sind. Besonders bevorzugt liegt die zeitliche Dauer der einzelnen Laserpulse zwischen 50ps und 4000ps oder zwischen 50ps und 2000ps oder zwischen 50ps und 1000ps, insbesondere zwischen 50ps und 900ps oder zwischen 50ps und 700ps oder zwischen 50ps und 500ps oder zwischen 50ps und 300ps oder zwischen 300ps und 900ps oder zwischen 500ps und 900ps oder zwischen 700ps und 900ps oder zwischen 300ps und 500ps oder zwischen 500ps und 700ps oder zwischen 300ps und 700ps oder kürzer als 900ps oder kürzer als 700ps oder kürzer als 500ps oder kürzer als 300ps oder kürzer als 100ps oder kürzer als 50ps.

Die Laserstrahlung wird gemäß einer weiteren bevorzugten Ausführungsform der vorliegenden Erfindung mit Pulsenergien erzeugt, wobei die Pulsenergien zwischen 100 nJ und 1 mJ oder 500 nJ und 100 $\mu$J oder 1 $\mu$J und 50 $\mu$J liegen. Bevorzugt liegt die Pulsenergie pro Einzelschuss bei 0,1-50 $\mu$J nach dem Objektiv bzw. nach dem letzten optischen Aufbereitungsmittel und vor dem Eindringen der Laserstrahlung in den Festkörper. Sollten z.B. mittels eines DOEs mehrere Fokusse erzeugt werden, so weist die jedem einzelnen Fokus zugeordnete Laserstrahlung nach dem Objektiv bzw. nach dem letzten optischen Aufbereitungsmittel und vor dem Eindringen der Laserstrahlung in den Festkörper eine Pulsenergie von 0,1-50 $\mu$J auf.

Gemäß einer weiteren Ausführungsform wird zur definierten Temperierung bzw. zum Erzeugen der Modifikation bzw. zum Verändern, insbesondere zum lokalen Verändern, einer Materialeigenschaft des Spendersubstarts die LASER-Strahlung mit einer Pulsdichte zwischen 0,1nJ/$\mu$m2 und 10000 nJ/$\mu$m2 bevorzugt zwischen 1nJ/$\mu$m2 und 1000 nJ/$\mu$m2 und besonders bevorzugt zwischen 3nJ/$\mu$m2 und 200 nJ/$\mu$m2 in den Festkörper eingebracht.

Gemäß einer weiteren Ausführungsform werden Auslösemodifikation zum Auslösen von unterkritischen Rissen erzeugt, wobei zumindest ein Prozessparameter zum Erzeugen der Auslösemodifikationen von zumindest einem Prozessparameter zum Erzeugten der Basis-Modifikationen verschieden ist, bevorzugt sind mehrere Prozessparameter voneinander verschieden. Zusätzlich oder alternativ können die Auslösemodifikationen in einer Richtung erzeugt werden, die zur Verlaufsrichtung der Linie, entlang der die Basis-Modifikationen erzeugt werden, geneigt oder beabstandet ist.

Die unterkritischen Risse, insbesondere erzeugt durch Auslösemodifikationen und/oder durch den Ablösebereich bzw. die Ablöseebene definierende Modifikationen bzw. durch eine linienförmige Gestalt ausbildende Modifikationen, breiten sich bevorzugt weniger als 5mm, insbesondere weniger als 3mm oder weniger als 1mm oder weniger als 0,5mm oder weniger als 0,25mm oder weniger als 0,1mm, aus. Eine geneigte Ausrichtung kann hierbei z.B. einem Winkel zwischen 0° und 90° entsprechen, bevorzugt einem Winkel zwischen 85° und 90° und besonders bevorzugt einen Winkel von 90°.

Es handelt sich um einen Schwellprozess, der ausgelöst wird, wenn eine kritische Intensität (also Leistung/Fläche) überschritten wird. Das heißt, kurze Pulse brauchen weniger Energie/Puls, höhere numerische Apertur konzentriert die Energie auf einen kleineren Punkt, braucht also auch niedrigere Energie um die Schwellintensität zu erreichen.

Eine größere Tiefe bedeutet meist Absorptionsverluste, weswegen die Energie dahingehend wieder angepasst werden muss, Beispiel SiC: NA=0.4, 180$\mu$m Tiefe, 3ns Pulslänge, Pulsenergie ca. 7$\mu$J, bei 350$\mu$m Tiefe eher 9$\mu$J.

Generell brauchen härtere Materialien (Saphir, Aluminiumoxidkeramik, SiC, GaN) in den Linien größeren Pulsüberlapp, also kleinere Pulsabstände (<=1$\mu$m), dafür werden die Linienabstände tendenziell größer gewählt (z.B. >5$\mu$m), während weichere Materialien wie GaAs und Si eher größere Pulsabstände (>1$\mu$m) und dafür kleinere Linienabstände (<5$\mu$m) benötigen.

Beispielmuster SiC - mit fs-Pulsen: Pulsenergie ca. 800nJ, Pulsabstand 50nm und größer, bis 200nm, Linienmuster wie folgt: 30 Linien mit 1$\mu$m Abstand, dann 20$\mu$m Lücke, dann wieder 30 Linien, dann 96$\mu$m Lücke und dann von vorn, gekreuzt mit 30 Linien, 20$\mu$m Lücke und 30 Linien (immer mit 1$\mu$m Abstand zwischen den Linien), dann 300$\mu$m Lücke und dann wieder 30/20/30-er Linienblock. Tiefe 180$\mu$m, Dotiergrad des SiC (durch Flächenwiderstand charakterisiert >21mOhm cm), Pulslänge 400fs, numerische Apertur 0.65.

Das Festkörpermaterial ist gemäß einer bevorzugten Ausführungsform Silizium, wobei die Numerische Apertur zwischen 0,5 und 0,8, insbesondere bei 0,65, liegt, die Einstrahltiefe zwischen 200$\mu$m und 400$\mu$m, insbesondere bei 300$\mu$m, liegt der Pulsabstand zwischen 1$\mu$m und 5$\mu$m, insbesondere bei 2$\mu$m, liegt, der Linienabstand zwischen 1$\mu$m und 5$\mu$m, insbesondere bei 2 $\mu$m, liegt, die Pulsdauer zwischen 50ns und 400ns, insbesondere bei 300ns, liegt und die Pulsenergie zwischen 5$\mu$J und 15$\mu$J, insbesondere bei 10$\mu$J, liegt.

Das Festkörpermaterial ist gemäß einer bevorzugten Ausführungsform SiC, wobei die Numerische Apertur zwischen 0,3 und 0,8, insbesondere bei 0,4, liegt, die Einstrahltiefe zwischen 100$\mu$m und 300$\mu$m, insbesondere bei 180$\mu$m, liegt der Pulsabstand zwischen 0,1$\mu$m und 3$\mu$m, insbesondere bei 1$\mu$m, liegt, der Linienabstand zwischen 20$\mu$m und 100$\mu$m, insbesondere bei 75 $\mu$m, liegt, die Pulsdauer zwischen 1ns und 10ns, insbesondere bei 3ns, liegt und die Pulsenergie zwischen 3μJ und 15μJ, insbesondere bei 7μJ, liegt.

Beispielmuster Aluminiumoxidkeramik: Pulsabstand 500nm, Linienabstand 10μm, Pulsdauer 3ns, Pulsenergie 22μJ, NA=0.4

Beispielmuster Saphir: 3fach geschriebene Linien in 0°, 45°, 90° zum Flat, jeweils mit 1,5μm Linienabstand, Pulsabstand 300nm, Pulsenergie im ersten Durchgang 350nJ, im zweiten Durchgang 300nJ und im dritten Durchgang 250nJ, bei einer NA von 0.65 und einer Pulsdauer von 250fs.

Generell nimmt die Oberflächenrauheit mit kürzeren Pulsen ab, mit Femtosekundenpulsen kann man bessere Oberflächen erzeugen (Rauheiten unter 3μm) als mit Nanosekundenpulsen (eher über 3μm), dafür ist der Prozess teurer und dauert länger. Pikosekundenpulse stellen einen Mittelweg dar. Der Vorteil bei kürzeren Pulsen ist, dass die Phasenumwandlung athermischer erfolgt, also eine geringere Kopplung zwischen Laserpuls und Kristallgitter erfolgt, und damit weniger Schwingungen (Phononen) angeregt werden - der Prozess also insgesamt kälter abläuft. Dafür müssen größere Bereiche amorphisiert (Phasenumwandlung) werden, damit die kritische Spannung aufgebaut wird, die die Risse auslöst.

Gemäß einer weiteren Ausführungsform breiten sich die unterkritischen Risse zwischen 5μm und 200μm, insbesondere zwischen 10μm und 100μm oder zwischen 10μm und 50μm oder zwischen 10μm und 30μm oder zwischen 20μm und 100μm oder zwischen 20μm und 50μm oder zwischen 20μm und 30μm, im Festkörper aus. Diese Ausführungsform ist vorteilhaft, da eine kleinere Rissausbreitung geringere Nachbearbeitungsaufwendung erfordert. Die unterkritischen Risse breiten sich entlang der Kristallgittergrenzen aus, da das Kristallgitter des Festkörpers jedoch bevorzugt gegenüber der Ablöseebene, insbesondere in einem Winkel zwischen 2° und 6°, geneigt ist, resultiert eine im Profil sägezahnförmige Oberfläche. Je weiter die Risse laufen, desto größer ist der Abstand zwischen den Tälern und Spitzen dieser sägezahnförmigen Oberfläche, wodurch auch umso mehr Material entfernt werden muss, wenn eine Oberflächenrauheit von weniger als 80nm oder von weniger als 50nm oder zwischen 20nm und 50nm erzeugt werden soll. Die Rissausbreitung der unterkritischen Risse verläuft somit gemäß einer weiteren Ausführungsform der vorliegenden Erfindung gegenüber der Einstrahlrichtung der Laserstrahlen in einer von einem Winkel von 90° abweichenden geneigten Richtung, insbesondere ist die Rissausbreitungsrichtung bevorzugt zwischen 93° und 99°, insbesondere genau 94° oder 98° oder zwischen 93° und 95°, gegenüber der Einstrahlrichtung geneigt.

Gemäß einer weiteren Ausführungsform reißen die Abschnitte zwischen den Bereichen mehrerer Linien, in denen sich die unterkritischen Risse ausgebreitet haben, infolge der Spannungen bzw. der Einleitung der äußeren Kraft, die z.B. durch den Glasübergang oder die Ultraschallbehandlung erzeugt werden, ein. Diese Ausführungsform ist vorteilhaft, da aufgrund der zuvor bewirkten Vorschädigungen im Inneren des Festkörpers, insbesondere aufgrund der unterkritischen Risse, die erforderlichen Spannungen deutlich geringer sein können. Ferner wird der Riss sehr präzise geführt.

Die Aufnahmeschicht wird gemäß einer weiteren Ausführungsform an einer Oberfläche des Festkörpers angeordnet oder daran erzeugt, die gegenüber der Oberfläche des Festkörpers liegt, an der die Schichten und/oder Bauteile zum Ausbilden der Kompositstruktur angeordnet sind.

Vor dem Auslösen des Risses wird auf der Seite des Festkörpers, an der bevorzugt keine weitere Schicht und/oder Bauelemente angeordnet sind, die verfahrensgemäße Aufnahmeschicht, insbesondere in Form einer Polymerfolie, aufgebracht.

Im Weg der Laserstrahlung ist gemäß einer weiteren bevorzugten Ausführungsform der vorliegenden Erfindung vor dem Eindringen der Laserstrahlung in das Spendersubstrat bzw. in den Festkörper ein diffraktives optisches Element (DOE) angeordnet. Die Laserstrahlung wird durch das DOE auf mehrere Lichtpfade zum Erzeugen mehrerer Fokusse aufgeteilt. Das DOE bewirkt bevorzugt über eine Länge von 200μm eine Bildfeldwölbung, die kleiner oder gleich 50μm, insbesondere kleiner oder gleich 30μm oder kleiner oder gleich 10μm oder kleiner oder gleich 5 μm oder kleiner oder gleich 3μm, ist, wobei durch das DOE zumindest 2 und bevorzugt mindestens oder genau 3 oder mindestens oder genau 4 oder mindestens oder genau 5 oder mindestens oder genau oder bis zu 10 oder mindestens oder genau oder bis zu 20 oder mindestens oder genau oder bis zu 50 oder bis zu 100 Fokusse zur Veränderung der Materialeigenschaften des Spendersubstrats zeitgleich erzeugt werden. Diese Ausführungsform ist vorteilhaft, da eine signifikante Prozessbeschleunigung erzielt werden kann.

Mehrere Spendersubstrate sind gemäß einer weiteren bevorzugten Ausführungsform der vorliegenden Erfindung während der Veränderung der Materialeigenschaft zeitgleich nebeneinander auf einer Rotationseinrichtung, insbesondere einem Rotationstisch, angeordnet und um eine gemeinsame Rotationsachse rotierbar. Die Rotationsgeschwindigkeit ist bevorzugt größer als 10 Umdrehungen / Minute und bevorzugt größer als 50 Umdrehungen / Minute und besonders bevorzugt größer als 150 Umdrehungen / Minute, insbesondere bis zu 600 Umdrehungen / Minute, ist. Die linienförmige Gestalt ist hierbei bevorzugt gebogen. Der Winkel, in dem die gebogene linienförmige Gestalt gegenüber der sich an der Schnittstelle zwischen der Erzeugungsebene und der Kristallgitterebene ergebenden Schnittlinie geneigt ist, ist hierbei bevorzugt als mittlerer Winkel anzusehen, besonders bevorzugt wird nur bei der Erzeugung einer gebogenen linienförmigen Gestalt ein mittlerer Winkel definiert/verwendet. Der mittlere Winkel bezieht sich dabei bevorzugt ausschließlich auf die mittleren 80% der Erstreckungslänge der jeweiligen gebogenen linienförmigen Gestalt, d.h. die Neigung bzw. die Winkel der ersten 10% und die Neigung bzw. die Winkel der letzten 10% der Erstreckungslänge werden hierbei zur Bestimmung des mittleren Winkels bevorzugt nicht berücksichtigt. Bevorzugt wird für jede relevante Modifikation der gebogenen linienförmigen Gestalt die Neigung bzw. der Winkel gegenüber der Schnittgeraden bestimmt, aufsummiert und durch die Anzahl der aufsummierten Winkelwerte geteilt.

Eine Strahlformungseinrichtung zur Veränderung der Eigenschaften der beaufschlagenden Laserstrahlung, insbesondere eine Einrichtung zur Veränderung der Polarisation der Laserstrahlen, insbesondere in Form einer drehenden Lambda-Halbe-Platte oder einer Pockels-Zelle, ist gemäß einer weiteren bevorzugten Ausführungsform der vorliegenden Erfindung vorgesehen und/oder die Strahlformungseinrichtung ist bevorzugt dazu ausgebildet, die Laserstrahlung zirkulär oder elliptisch zu polarisieren, wobei das Spendersubstrat mit der zirkulär oder elliptisch polarisierten Laserstrahlung, insbesondere in Form von Lambda-Viertel-Platten, beaufschlagt wird.

Gemäß einer weiteren bevorzugten Ausführungsform der vorliegenden Erfindung ist eine Strahlformungseinrichtung zur Veränderung der Eigenschaften der beaufschlagenden Laserstrahlen vorgesehen. Diese Eigenschaften der Laserstrahlen sind insbesondere die Polarisationseigenschaften der Laserstrahlen, das räumliche Profil der Laserstrahlen vor und nach der Fokussierung und die räumliche und zeitliche Phasenverteilung der einzelnen Wellenlängen der beaufschlagenden Laserstrahlen, die durch die wellenlängenabhängige Dispersion in einzelnen Elementen des Strahlengangs wie der fokussierenden Optik beeinflusst werden kann.

Dazu kann die Strahlformungseinrichtung zum Beispiel mit einer drehenden Lambda-Halbe-Platte oder ähnlichen doppelbrechenden Elementen zur Veränderung der Polarisation von durchlaufenden Laserstrahlen ausgestattet sein. Dadurch kann die Polarisation der beaufschlagenden Laserstrahlen in Abhängigkeit von der Rotationsgeschwindigkeit des Aufnahmeanteils verändert werden. Zusätzlich kann dadurch auch die Polarisationsrichtung in einem bestimmten Winkel zu Kristallrichtungen des Festkörpers auf dem Aufnahmeanteil verändert werden. Dies kann zum Beispiel auch durch ein Element ähnlich einer Pockels-Zelle in der Strahlformungseinrichtung bewirkt werden, zusätzlich oder alternativ zur Lambda-Halbe-Platte. Bei solchen Elementen bewirkt ein äußeres elektrisches Feld eine feldabhängige Doppelbrechung im Material, der sogenannte Pockels-Effekt oder lineare elektrooptische Effekt, der dazu verwendet werden kann, abhängig von der angelegten elektrischen Spannung die Polarisation von Laserstrahlen zu verändern. Diese Lösung bietet den Vorteil, dass sie gegenüber einer rotierenden Platte schnellere Schaltzeiten aufweisen und so besser mit der Bewegung des Tisches bzw. des Festkörpers synchronisiert werden kann.

Alternativ kann die Strahlformungseinrichtung auch derart ausgestaltet sein, dass die Laserstrahlen vor der Beaufschlagung des Festkörpers zirkulär polarisiert sind. Laserstrahlung ist meist linear polarisiert, kann aber durch doppelbrechende optische Elemente wie Lambda-Viertel-Platten in zirkular polarisiertes Licht umgewandelt werden. Zirkular polarisiertes Licht wird hingegen durch eben ein solches Element wieder zurück in linear polarisiertes Licht umgewandelt. Hierbei ist es auch möglich, dass eine Mischform bzw. Kombination aus zirkular und linear polarisierter Laserstrahlung, sog. elliptisch polarisierte Laserstrahlung, verwendet wird.

Grundsätzlich wird hierdurch eine Lösung für das Problem bereitgestellt, dass bei der Mehrphotonenabsorption der Wirkungsquerschnitt sehr stark von der Kristallrichtung bzw. dem Winkel zwischen der Polarisationsrichtung des Lichtes und der Kristallorientierung abhängt, da sich beim Rotieren des Festkörpers die Kristallrichtung ständig in Bezug auf den Laserstrahl ändern würde, kann dies durch eine synchronisierte Rotation der Laserpolarisation oder zirkular oder elliptisch polarisiertes Laserlicht behoben werden und der Wirkungsquerschnitt für die Mehrphotonenabsorption konstant gehalten werden.

Zusätzlich kann die Strahlformungseinrichtung derart ausgebildet sein, dass sie das räumliche Profil der Laserstrahlen vor der Fokussierung oder im Fokus ändert. Dies kann durch einfache Elemente wie einen Schlitz oder Teleskop in nur einer Raumrichtung erreicht werden. Ein solches Teleskop kann zum Beispiel aus einer Kombination einer Zylinderlinse mit einer Zylinderstreulinse erreicht werden, deren relative Brennweiten dann die Laserstrahlgrößenveränderung in einer Raumrichtung vorschreibt. Das Teleskop kann aber auch aus mehreren Elementen bestehen um eine Kreuzung der Laserstrahlen zu verhindern. Abhängig vom räumlichen Strahlprofil der Laserstrahlen vor der Fokussierung, kann die Form des Fokus beim Beaufschlagen des Festkörpers ebenso verändert und vorteilhaft gewählt werden. Dafür kann die Strahlformungseinrichtung zusätzlich dazu ausgebildet sein, dass die Form des Laserstrahlfokus' in Abhängigkeit von der Rotationsgeschwindigkeit des Aufnahmeanteils oder auch der Orientierung des Festkörpers verändert werden kann. So kann zum Beispiel bei der Beaufschlagung des Festkörpers in einem Bereich des Festkörpers der näher zur Rotationsachse liegt ein daran angepasstes räumliches Profil im Fokus durch die Strahlformungseinrichtung erzeugt werden, wie zum Beispiel ein sich nach außen verjüngendes Laserstrahlprofil.

Zahlreiche Materialien, insbesondere transparente Materialien wie Gläser und Kristalle zeichnen sich durch einen wellenlängenabhängigen Brechungsindex aus. Laserstrahlen in Pulsform, insbesondere solche im Femtosekundenbereich, bestehen aus einem Spektrum von Wellenlängen, die in einer Strahlformungseinheit oder einer Optik zum Fokussieren vor der Beaufschlagung des Festkörpers unterschiedliche Brechungsindices erfahren können. Diese Dispersion führt dazu, dass Femtosekundenlaserpulse länger werden, wodurch ihre Spitzenintensität sinkt, was für die Anwendung von Mehrphotonenprozessen unerwünscht ist. Die Strahlformungseinheit kann dementsprechend so ausgebildet werden, dass sie die Dispersion anderer optischer Elemente im Strahlengang vor oder nach der Fokussierung kompensiert. Diese Dispersion kann sowohl im Raum als chromatische Aberration oder in der Zeit als Pulsverlängerung oder Pulskompression wirken. Insbesondere kann die Dispersion durch die Strahlformungseinheit auch so verändert und genutzt werden, dass im Fokus eine vordefinierte Farbverteilung der im Laserpuls vorhandenen Wellenlängen entsteht.

Übliche Mittel zur Kompensation und dem Einbringen künstlicher Phasenverteilungen in Laserpulsen, zum Beispiel um Dispersion auszugleichen, sind Kombinationen von Prismen oder Beugungsgittern, sogenannte Spatial-Light-Modulators (SLMs), die auf Flüssigkristallen basieren, oder gechirpte Spiegel, die eine spezielle Abfolge dielektrischer Schichten unterschiedlicher Brechindizes aufweisen.

Diese Lösung, insbesondere zur Kompensation von Dispersion, ist vorteilhaft, da sie das Problem ausgleicht, dass beim Durchlaufen kurzer Pulse (z.B. kleiner 100 fs) verstärkt Dispersionen auftreten, d.h. der Puls zerfließt, da einige Lichtanteile schneller sind als andere. Der Puls würde sonst länger werden, wodurch seine Spitzenintensität sinken würde, was bei der Anwendung von Mehrphotonenprozessen unerwünscht ist.

Die Hauptoberfläche ist gemäß einer weiteren Ausführungsform nach dem Abtrennen der Festkörperschicht Bestandteil der Festkörperschicht und weist nach dem Abtrennen bevorzugt eine geringere Dicke als das verbleibende Restspendersubstrat auf. Diese Ausführungsform ist vorteilhaft, da das verbleibende Spendersubstrat aufbereitet und als Festkörperschicht oder zum Abtrennen einer weiteren Festkörperschicht verwendet werden kann.

Das Spendersubstrat weist gemäß einer weiteren bevorzugten Ausführungsform der vorliegenden Erfindung eine chemischen Verbindung, wie Siliziumcarbid, auf oder besteht daraus, wobei die chemische Verbindung bevorzugt einen Stoff oder mehrere Stoffe ausgewählt aus der dritten, vierten und/oder fünften Hauptgruppe des Periodensystems der Elemente und/oder der 12. Nebengruppe des Periodensystem der Elemente aufweist, wobei die Materialveränderung eine vorbestimmte Stoffumwandlung des Ausgangsmaterials, insbesondere Siliziumcarbid, des Spendersubstrats in ein Zielmaterial, insbesondere Silizium und Kohlenstoff, darstellt.

Die Stoffumwandlung stellt gemäß einer weiteren Ausführungsform eine Zerlegung der chemischen Verbindung in mehrere oder in alle einzelne Bestandteile bzw. Elemente dar. Diese Ausführungsform ist vorteilhaft, da durch die gezielte Zerlegung der chemischen Verbindung des Festkörpers die für eine Abtrennung des Festkörperanteils am besten geeignete Materialkombination definiert eingestellt werden kann.

Gemäß der vorliegenden Beschreibung wird unter einem Festkörper-Ausgangsmaterial bevorzugt ein monokristallines, polykristallines oder amorphes Material verstanden. Bevorzugt eignen sich wegen der stark anisotropen atomaren Bindungskräfte Monokristalline mit einer stark anisotropen Struktur. Das Festkörper-Ausgangsmaterial weist bevorzugt ein Material oder eine Materialkombination aus einer der Hauptgruppen 3, 4, 5 und/oder der Nebengruppe 12 des Periodensystems der Elemente, insbesondere eine Kombination aus Elementen der 3.,4., 5. Hauptgruppe und der Nebengruppe 12, wie z.B. Zinkoxid oder Cadmiumtellurid, auf.

Neben Siliziumcarbid kann das Halbleiter-Ausgangsmaterial beispielsweise auch aus Silizium, Galliumarsenid GaAs, Galliumnitrid GaN, Siliciumcarbid SiC, Indiumphosphid InP, Zinkoxid ZnO, Aluminiumnitrid AlN, Germanium, Gallium(III)-oxid $Ga_2O_3$, Aluminiumoxid $Al_2O_3$ (Saphir), Galliumphosphid GaP, Indiumarsenid InAs, Indiumnitrid InN, Aluminiumarsenid AlAs oder Diamant bestehen.

Der Festkörper bzw. das Werkstück (z.B. Wafer) bzw. das Spendersubstrat weist bevorzugt ein Material oder eine Materialkombination aus einer der Hauptgruppen 3, 4 und 5 des Periodensystems der Elemente auf, wie z.B. SiC, Si, SiGe, Ge, GaAs, InP, GaN, $Al_2O_3$ (Saphir), AlN. Besonders bevorzugt weist der Festkörper eine Kombination aus der vierten, dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann der Festkörper eine Keramik (z.B. $Al_2O_3$ - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Der Festkörper weist somit bevorzugt ein Halbleitermaterial oder ein Keramikmaterial auf bzw. besonders bevorzugt besteht der Festkörper aus mindestens einem Halbleitermaterial oder einem Keramikmaterial. Der Festkörper ist bevorzugt ein Ingot oder ein Wafer. Besonders bevorzugt handelt es sich bei dem Festkörper um ein für Laserstrahlen zumindest teilweise transparentes Material. Es ist somit weiterhin denkbar, dass der Festkörper ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAlSb, Hochtemperatursupraleiter, insbesondere seltene Erden Cuprate (z.B. $YBa_2Cu_3O_7$). Es ist zusätzlich oder alternativ denkbar, dass der Festkörper eine Photomaske ist, wobei als Photomaskenmaterial im vorliegenden Fall bevorzugt jedes zum Anmeldetag bekannte Photomaskenmaterial und besonders bevorzugt Kombinationen daraus verwendet werden können. Ferner kann der Festkörper zusätzlich oder alternativ Siliziumcarbid (SiC) aufweisen oder daraus bestehen. Der Festkörper ist bevorzugt ein Ingot, der in einem Ausgangszustand, d.h. in einem Zustand vor dem Abtrennen des ersten Festkörperanteils, bevorzugt mehr als 5 kg oder mehr als 10 kg oder mehr als 15 kg oder mehr als 20 kg oder mehr als 25 kg oder mehr als 30 kg oder mehr als 35 kg oder mehr als 50 kg wiegt. Der Festkörperanteil ist bevorzugt eine Festkörperschicht, insbesondere ein Wafer mit mindestens 300mm Durchmesser.

Die Modifikationen können eine Phasenumwandlung des Festkörpermaterials, insbesondere von Siliziumkarbid in Silizium und Kohlenstoff, darstellen, wodurch eine Volumenausdehnung im Festkörper erzeugt wird, was wiederum Druckspannungen im Festkörper erzeugt.

Zum Erzeugen der äußeren Kraft wird gemäß einer weiteren bevorzugten Ausführungsform der vorliegenden Erfindung ein Polymermaterial an der Hauptoberfläche angeordnet. Das Polymermaterial weist bevorzugt eine Glasübergangstemperatur von unter 20°C, insbesondere von unter 10°C oder von unter 0°C auf. Das Polymermaterial wird besonders bevorzugt auf eine Temperatur unterhalb der Glasübergangstemperatur abgekühlt, wobei durch den erfolgenden Glasübergang mechanische Spannungen im Spendersubstrat erzeugt werden, wobei durch die mechanischen Spannungen die unterkritischen Risse miteinander verbunden werden, wodurch die Festkörperschicht vom Spendersubstrat abgelöst wird. Bevorzugt erfolgt das Abtrennen der Festkörperschicht von dem Festkörper dadurch, dass der Festkörper im Rissführungsbereich durch die Modifikationen derart geschwächt wird, dass sich die Festkörperschicht infolge des Materialabtrags von dem Festkörper ablöst oder nach dem Materialabtrag eine solche Anzahl an Modifikationen erzeugt wird, dass der Festkörper im Rissführungsbereich derart geschwächt wird, dass sich die Festkörperschicht von dem Festkörper ablöst oder eine Spannungserzeugungsschicht an einer zur umlaufenden Oberfläche geneigt ausgerichteten, insbesondere ebenen, Oberfläche des Festkörpers erzeugt oder angeordnet wird und durch ein thermisches Beaufschlagen der Spannungserzeugungsschicht mechanische Spannungen in dem Festkörper erzeugt werden, wobei durch die mechanischen Spannungen ein Riss zum Abtrennen einer Festkörperschicht entsteht, der sich ausgehend von der durch den Materialabtrag freigelegten Oberfläche des Festkörpers entlang der Modifikationen ausbreitet oder der Festkörper nach der Erzeugung der Modifikationen thermisch beaufschlagt, insbesondere abgekühlt, wird und sich infolge der thermischen Beaufschlagung die Festkörperschicht von dem Festkörper entlang des Rissführungsbereichs ablöst.

Somit weist der Schritt des Anordnens oder Erzeugens einer Aufnahmeschicht an dem Festkörper bevorzugt das Merkmale auf, dass die Aufnahmeschicht ein Polymermaterial, insbesondere Polydimethylsiloxan oder ein Elastomer oder ein Epoxidharz oder eine Kombination daraus, aufweist oder daraus besteht, und das Polymermaterial infolge einer thermischen Beaufschlagung der Aufnahmeschicht zum, insbesondere mechanischen, Erzeugen von Rissausbreitungsspannungen in dem Festkörper einen Glasübergang erfährt, wobei sich durch die Rissausbreitungsspannungen ein Riss in dem Festkörper entlang dem Rissführungsbereich ausbreitet.

Gemäß einer weiteren Ausführungsform weist die Aufnahmeschicht massemäßig zumindest mehrheitlich und bevorzugt vollständig ein Polymermaterial auf oder besteht daraus, wobei der Glasübergang des Polymermaterials zwischen -100°C und 0°C, insbesondere zwischen -85°C und -10°C oder zwischen -80°C und -20°C oder zwischen -65°C und -40°C oder zwischen -60°C und -50°C, liegt.

Die Aufnahmeschicht besteht bevorzugt aus einem Polymer-Hybrid-Material oder weist ein solches auf, das besonders bevorzugt eine Polymermatrix ausbildet, wobei sich in der Polymermatrix ein Füllstoff befindet, wobei die Polymermatrix bevorzugt eine Polydimethylsiloxan-Matrix ist und wobei der Masseanteil der Polymermatrix am Polymer-Hybrid-Material bevorzugt 80 % bis 99 % und besonders bevorzugt 90 % bis 99 % beträgt.

Die Aufnahmeschicht wird bevorzugt als vorgefertigte Folie bereitgestellt und an den Festkörper angekoppelt, insbesondere angeklebt oder angebondet.

Es wird daher ein Polymer-Hybrid-Material zur Verwendung in einem Splitting-Verfahren angegeben, bei welchem aus einem Festkörper-Ausgangsmaterial zumindest zwei Festkörper-Teilstücke erzeugt werden. Das Polymer-Hybrid-Material umfasst nach einer Ausführungsform eine Polymermatrix und zumindest einen darin eingebetteten ersten Füllstoff. Insofern im Folgenden von einem bzw. dem Füllstoff die Rede ist, soll gleichfalls die Möglichkeit mehrerer Füllstoffe mit einbezogen sein. Beispielsweise kann der Füllstoff eine Mischung verschiedener Materialien umfassen, z. B. Metallpartikel und anorganische Fasern.

Als Polymermatrix kann jedes Polymer oder eine Mischung verschiedener Polymere genutzt werden, mit dessen Hilfe sich die für eine Teilung des Festkörper-Ausgangsmaterials notwendigen Spannungen erzeugen lassen. Beispielsweise kann die Polymermatrix als Elastomermatrix, bevorzugt als Polydiorganolsiloxan-Matrix, besonders bevorzugt als Polydimethylsiloxan-Matrix, ausgebildet sein. Derartige Polymermaterialien lassen sich besonders einfach als Matrixmaterial in Kombination mit Füllstoffen nutzen, da die Eigenschaften aufgrund des variierbaren Vernetzungsgrads flexibel eingestellt und an den jeweiligen Füllstoff sowie das zu teilende Festkörper-Ausgangsmaterial angepasst werden können. Gemäß einer Ausführungsvariante beträgt der Masseanteil der Polymermatrix am Polymer-Hybrid-Material 80 % bis 99 %, 10 bevorzugt 90 % bis 99 %.

Der erste Füllstoff kann organischer oder anorganischer Natur sein und sowohl aus einem chemischen Element als auch aus einer chemischen Verbindung oder einem Stoffgemisch, beispielsweise einer Legierung, bestehen.

Der erste Füllstoff ist derart aufgebaut, dass er als Reaktant, Initiator, Katalysator oder Promotor während des Ablösens des Polymer-Hybrid-Materials vom Festkörper- Teilstück nach der Teilung wirkt und dadurch im Vergleich zu einem Polymermaterial ohne ersten Füllstoff zu einem schnelleren Ablösen des Polymer-Hybrid-Materials vom Festkörper-Teilstück nach der Teilung führt.

Die konkrete chemische Zusammensetzung und Ausgestaltung des ersten Füllstoffs sowie dessen Masseanteil ist dabei insbesondere abhängig vom konkreten Material der Polymermatrix, welche abgelöst werden soll, dem dafür genutzten Lösungsmittel und den verwendeten Reaktanten. Weiterhin spielen auch das Material des Festkörper-Ausgangsmaterials und die Dimensionen des zu teilenden Festkörper-Ausgangsmaterials eine Rolle.

Der konkrete Anteil des ersten Füllstoffs in der Polymermatrix ist stark vom Material des Füllstoffs und dessen Wirkungsweise abhängig. Zum einen muss die Polymermatrix trotz Füllstoff ihrer Aufgabe der Erzeugung von Spannungen noch gerecht werden können. Zum anderen muss der Anteil des ersten Füllstoffs hoch genug sein, um die angestrebte Beeinflussung der Polymerentfernung zu erreichen. Den jeweils optimalen Masseanteil des ersten Füllstoffs kann der Fachmann im Rahmen einfacher konzentrationsabhängig durchgeführter Versuche ermitteln.

Zur Verbesserung der mechanischen Eigenschaften kann zusätzlich ein weiterer Füllstoff, wie z. B. pyrogene Kieselsäure in Form eines anorganischen Netzwerkes im Polymer beitragen. Neben diesen starken Wechselwirkungen in Form des Netzwerks können auch weniger starke Interaktionen durch rein hydrodynamische Verstärkungen zur Verbesserung beitragen. Beispielhaft ist hier eine gezielte Steigerung der Viskosität zu nennen, die eine verbesserte Verarbeitung im Splitting-Verfahren ermöglicht und so zu verbesserten Fertigungstoleranzen beitragen kann. Weiterhin wird durch diese Wechselwirkung eine Verringerung der inneren Freiheitsgrade hinsichtlich einer strukturellen Umorientierung mit zunehmender Bewehrung erschwert.

Dies führt zu einer gewünschten Erniedrigung der Glasübergangstemperatur des eingesetzten Polymers im Polymer-Hybrid-Material, was den Vorteil einer geringeren Temperatur im Splitting-Verfahren ermöglicht. Es wird der erste Füllstoff in einem Polymer-Hybrid-Material zur Beschleunigung des Ablösens des Polymer-Hybrid-Materials von einem Festkörper-Teilstück, das durch Teilung mittels eines Splittingverfahrens, bei dem ein Festkörper-Ausgangsmaterial in zumindest zwei Festkörper- Teilstücke geteilt wird, erhalten wird, verwendet.

Der erste Füllstoff kann in der Polymermatrix derart verteilt sein, dass der Masseanteil des ersten Füllstoffs ausgehend von der äußeren, d. h. unteren, Grenzfläche des Polymer-Hybrid-Materials, die während des Splitting-Verfahrens mit dem Festkörper-Ausgangsmaterial verbunden ist, in Richtung einer parallel zur unteren Grenzfläche angeordneten weiteren Grenzfläche des Polymer-Hybrid- Materials, abnimmt. Dies bedeutet, dass der Masseanteil des Füllstoffs nahe beim Festkörper-Ausgangsmaterial bzw. Teilstück größer ist als in den übrigen Bereichen des Polymer-Hybrid-Materials. Diese Verteilung des ersten Füllstoffs ermöglicht eine besonders effektive Entfernung des Polymer-Hybrid-Materials nach der Trennung, da sich der der erste Füllstoff nahe an der Grenzfläche zum Festkörper-Teilstück befindet und dort seine Wirkung entfalten kann. Gleichzeitig weisen die restlichen Bereiche des Polymer-Hybrid-Materials weniger oder gar keine Anteile des ersten Füllstoffs auf, so dass die Funktion des Polymers möglichst wenig beeinflusst wird.

In einer Ausgestaltung ist das Polymer-Hybrid-Material schichtförmig aufgebaut, wobei lediglich eine dem Festkörper-Ausgangsmaterial zugewandte Schicht den ersten Füllstoff aufweist, während das restliche Polymer-Hybrid-Material frei vom ersten Füllstoff ist.

Weiterhin kann ein unterer Bereich des Polymer-Hybrid-Materials, der direkt an dessen untere Grenzfläche angrenzt frei von dem ersten Füllstoff sein. Damit kann sich eine Bereichsabfolge wie folgt ergeben: Benachbart zum Festkörper-Ausgangsmaterial befindet sich zunächst ein Bereich ohne ersten Füllstoff, darauf folgt ein Bereich mit einem hohen Anteil an erstem Füllstoff und danach ein Bereich mit niedrigem Anteil an erstem Füllstoff oder ohne ersten Füllstoff.

Diese und alle im Folgenden beschriebenen Bereiche können in Form von Schichten ausgebildet sein, d. h. der Bereich erstreckt sich überwiegend parallel zu der Grenzfläche des Festkörper-Ausgangsmaterials, auf die das Polymer-Hybrid-Material aufgebracht wird und weist eine Längs- und Querausdehnung zumindest im Bereich dieser Grenzfläche auf.

Ein unterer Bereich ohne ersten Füllstoff kann insbesondere für den Fall vorgesehen werden, dass der erste Füllstoff die Haftung des Polymer-Hybrid-Materials auf dem Festkörper-Ausgangsmaterial verschlechtert. Um dies zu vermeiden, wird zunächst ein Bereich ohne ersten Füllstoff angeordnet, auf den ein Bereich mit einem hohen Anteil an erstem Füllstoff folgt, damit der erste Füllstoff seine Funktion erfüllen kann. Eine untere Schicht ohne ersten Füllstoff kann beispielsweise eine Dicke zwischen 10 $\mu$m und 500 $\mu$m, beispielsweise 100 $\mu$m, aufweisen.

Weiterhin kann ein oberer Bereich des Polymer-Hybrid-Materials, der direkt an dessen obere Grenzfläche angrenzt frei von dem ersten Füllstoff sein. Unter der oberen Grenzfläche ist dabei die Grenzfläche zu verstehen, die das Polymer-Hybrid-Material gegenüberliegend zur unteren Grenzfläche und zum Festkörper-Ausgangsmaterial zur Umgebung hin begrenzt. Untere und obere Grenzfläche können parallel zueinander angeordnet sein.

Ein solcher oberer Bereich ohne ersten Füllstoff kann insbesondere dann vorgesehen werden, wenn der erste Füllstoff die Wärmeübertragung zwischen Umgebung und Polymer-Hybrid-Material nachteilig beeinflusst, beispielsweise wenn die Abkühlung des Polymer-Hybrid-Materials verzögert werden würde.

Der erste Füllstoff kann ein Material umfassen oder aus einem Material bestehen, dass mit einem Reaktionsmittel, bevorzugt einem Oxidationsmittel unter Freisetzung eines gasförmigen Produkts reagieren kann.

Dadurch sind in der Polymermatrix Kavitäten generierbar, die einen schnelleren Zugang der Reaktanten und Lösungsmittel zur Polymermatrix und einer etwaigen vorhandenen Opferschicht ermöglichen und zudem einen schnelleren Abtransport der Edukte und gelösten Bestandteile bewirken.

Durch die Generierung gasförmiger Reaktionsprodukte können zusätzliche Triebkräfte eingebracht werden, die die Entfernung des Polymer-Hybrid-Materials weiter unterstützen.

Die Ausbildung zusätzlicher Kavitäten sowie das Entstehen gasförmiger Reaktionsprodukte beschleunigt die Polymerentfernung und trägt daher zu einer Erhöhung der Gesamtausbeute des Splitting-Verfahrens bei. Durch Variation des Anteils an erstem Füllstoff kann die Kavitätendichte im Grenzbereich zwischen Festkörper-Teilstück und Polymer-Hybrid-Material bzw. zwischen Opferschicht und Polymer- Hybrid-Material gezielt beeinflusst werden.

Der erste Füllstoff kann ein Metall, insbesondere Aluminium, Eisen, Zink und/oder Kupfer umfassen oder aus einem Metall, insbesondere den zuvor genannten Metallen, bestehen.

"Bestehend aus" schließt auf alle vorliegend genannten Materialien bezogen ein, dass technologisch bedingte Verunreinigungen oder technologisch bedingte Beimengungen, die z. B. der Herstellung der Füllstoffe sowie deren Verteilung oder Anbindung an die Polymermatrix dienlich sind, enthalten sein können.

Metallische Füllstoffe können mit Oxidationsmitteln wie z.B. Salzsäure, Salpetersäure, Zitronensäure, Ameisensäure oder Sulfaminsäure reagieren unter Freisetzung eines gasförmigen Produkts reagieren und dadurch aus dem Polymer-Hybrid-Material entfernt werden.

Beispielsweise reagiert Aluminium mit konzentrierter Salzsäure unter Ausbildung von solvatisierten Metallionen und Wasserstoff gemäß folgender Gleichung:□16 HCl + 2 Al + 12 H2O ! 2 [AlCl3*6 H2O] + 3 H2

In ähnlicher Weise führt die Reaktion von Zink als Füllstoff durch Reaktion mit konzentrierter Salzsäure zur Bildung 5 zusätzlicher Kavitäten: Zn + 2 HCl!ZnCl2 + H2 In den genannten Beispielen werden durch die Generierung von Wasserstoff, zusätzliche Triebkräfte eingebracht, die die Entfernung des Polymer-Hybrid-Materials weiter unterstützen. Zudem kann der erste Füllstoff die Temperaturleitfähigkeit innerhalb des Polymer-Hybrid-Materials verbessern, beispielsweise, indem der erste Füllstoff eine höhere Temperaturleitfähigkeit als das Polymer der Polymermatrix aufweist. Dies kann beispielsweise der Fall sein, wenn Ein weiterer Vorteil für den Fall, dass der erste Füllstoff ein Metall umfasst, liegt in der verbesserten Temperaturleitfähigkeit innerhalb des Polymer-Hybrid- Materials. Dadurch Durch eine verbesserte Temperaturleitfähigkeit sind können die für die Teilung des Festkörper-Ausgangsmaterials mittels Abkühlung erzeugten Spannungen effektiver, d. h. schneller und unter geringerem Verbrauch an Kühlmittel, generierbar sein. Dies erhöht kann die Gesamtausbeute des Splitting-Verfahrens erhöhen.

Weiterhin kann im Polymer-Hybrid-Material ein zweiter 25 Füllstoff vorgesehen sein, der die Haftung des Polymer- Hybrid-Materials auf dem Festkörper-Ausgangsmaterial im Vergleich zu einem Polymer-Hybrid-Material ohne zweiten Füllstoff erhöht. Bevorzugt wird die Haftung im Vergleich zu einem Polymermaterial ohne Füllstoff erhöht.

Beispielsweise kann es sich bei dem zweiten Füllstoff um einen Füllstoff handeln, der mittels Plasma aktiviert werden kann. Durch die Plasmaaktivierung resultieren neue Oberflächenspezies, die so geschaffen werden können, dass eine stärkere Wechselwirkung mit der Oberfläche des Festkörper-Ausgangsmaterials resultiert und im Ergebnis die Haftung des Polymer-Hybrid-Materials verbessert wird.

Die Art der durch die Plasmabehandlung erzielbaren Oberflächenspezies ist dabei vorrangig von der Prozessführung des Plasmaprozesses abhängig. Beispielsweise können während der Plasmabehandlung Gase wie Stickstoff, Sauerstoff, Silane oder Chlorsilane zugefügt werden, so dass beispielsweise polare Gruppen entstehen, welche stärker mit der Oberfläche des Festkörper- Ausgangsmaterials wechselwirken können.

Der zweite Füllstoff kann in der Polymermatrix so verteilt 15 sein, dass der Masseanteil des zweiten Füllstoffs in Richtung der unteren Grenzfläche zunimmt. Beispielsweise kann das Polymer-Hybrid-Material den zweiten Füllstoff lediglich in einem Bereich angrenzend an die untere Grenzfläche enthalten, wobei der Bereich auch als Schicht im Sinne der oben genannten Definition ausgebildet sein kann.

Dies ermöglicht die Anordnung des zweiten Füllstoffs bevorzugt in der Nähe der Grenzfläche zwischen Polymer-Hybrid-Material und Festkörper-Ausgangsmaterial, wodurch die Haftung verbessert und damit eine größere Kraftübertragung in das zu teilende Festkörper-Ausgangsmaterial ermöglicht wird. Beispielsweise kann der zweite Füllstoff Kern-Schale-Polymerpartikel bzw. Core-Shell-Polymerpartikel umfassen.

Dabei sind Partikel bevorzugt, deren Polymerzusammensetzung sich von der Polymermatrix des Polymer-Hybrid-Materials dahingehend unterscheidet, dass insbesondere die Oberfläche, d. h. die Schale, der Kern-Schale-Partikel stärker aktivierbar ist, z. B. mittels Niedertemperaturplasmas.

Beispiele hierfür sind Kern-Schale-Partikel umfassend einen Polysiloxan-Kern mit einer Acrylat-Schale oder umfassend einen nanoskaligen Silikat-Kern mit einer Epoxid-Schale oder umfassend einen Kautschukpartikel-Kern mit eines Epoxid-Schale oder umfassend einen Nitrilkautschukpartikel-Kern mit einer Epoxid-Schale. Der zweite Füllstoff kann mittels Niedertemperaturplasma, z.B. Kaltplasma, aktivierbar sein. Beispielsweise kann das Plasma mittels dielektrischer Barriereentladung (DBE) erzeugt werden. Hierbei können Elektronendichten im Bereich von 1014 bis 1016 m-3 erzeugt werden. Die durchschnittliche Temperatur des durch DBE erzeugten "kalten" Nichtgleichgewichtsplasmas (Plasmavolumen) beträgt ca. 300 ± 40 K bei Umgebungsdruck. Die durchschnittliche Temperatur des durch DBE erzeugten nichtthermischen Plasmas beträgt ca. 70 °C bei Umgebungsdruck.

Bei der DBE-Behandlung wird die Oberfläche beispielsweise mit uni- oder bipolaren Pulsen von Pulsdauern von wenigen Mikrosekunden bis zu einigen zehn Nanosekunden und Amplituden im einstelligen bis zweistelligen Kilovoltbereich beaufschlagt. Hierbei sind keine metallischen Elektroden im Entladungsraum und somit keine metallischen Verunreinigungen oder Elektrodenverschleiß zu erwarten.

Vorteilhaft ist zudem eine hohe Effizienz, da an den Elektroden keine Ladungsträger aus- oder eintreten müssen.

Dielektrische Oberflächen können bei niedrigen Temperaturen modifiziert und chemisch aktiviert werden. Die Oberflächenmodifikation kann beispielsweise durch eine Wechselwirkung und Reaktion der Oberflächenspezies durch Ionenbombardement erfolgen.

Weiterhin können gezielt Prozessgase, wie z. B. Stickstoff, Sauerstoff, Wasserstoff, Silane oder Chlorsilane, z. B. SixHyEz mitE=F,Cl,Br,I,O,Hundx=0bis10,z=0 bis 10, SiH4, Si(EtO)4 oder Me3SiOSiMe3, bei einer Plasmabehandlung zugefügt werden, um beispielsweise bestimmte chemische Gruppen an der Oberfläche zu erzeugen. Der zweite Füllstoff kann des Weiteren mittels Korona-□5 Behandlung, Flammenbehandlung, Fluorierung, Ozonierung oder UV-Behandlung bzw. Eximer-Bestrahlung aktivierbar sein. Durch eine derartige Aktivierung werden beispielsweise polare Gruppen an der Oberfläche des zweiten Füllstoffs generiert, die mit der Oberfläche des Festkörper-Ausgangsmaterials wechselwirken können und so die Haftung verbessern. Das Polymer-Hybrid-Material kann weiterhin zusätzlich im Vergleich zu einem Polymer-Hybrid-Material mit einem ersten oder zu einem Polymer-Hybrid-Material mit einem ersten und einem zweiten Füllstoff einen dritten Füllstoff umfassen. Dieser dritte Füllstoff weist im Vergleich zu dem Polymer der Polymermatrix eine höhere Temperaturleitfähigkeit und/oder einen höheren Elastizitätsmodul auf.

Beispielsweise liegt der E-Modul des Polymers bei Tieftemperaturbedingungen im unteren einstelligen Gigapascalbereich (ca. 1-3 GPa), während beispielsweise metallische Füllstoffe einen E-Modul im zweistelligen bis dreistelligen Gigapascalbereich aufweisen. Bei einem entsprechenden hohen Füllstoffanteil ist ein perkolierendes Füllstoffnetzwerk möglich, was eine verbesserte "Krafteinkopplung" in das Festkörper-Ausgangsmaterial ermöglicht.

Die Perkolation wird wesentlich durch den Volumenfüllgrad der jeweiligen Füllstoffe beeinflusst (z. B. 0,1 Vol%, 1:130 Vol% bis 10 Vol% je nach Aspektverhältnis). Mit zunehmender Krafteinleitung kann der viskoelastische Schichtaufbau der Polymerstruktur eingetaucht werden und mehrere Perkolationspfade wirksam werden. Hier können verbesserte Wärmeübergänge ermöglicht werden, da es zu einem verbesserten Kontakt der Füllstoffe mit der Oberfläche des Festkörper-Ausgangsmaterials kommen kann.

Die mechanische Stabilität des Polymer-Hybrid-Materials wird auch bei tiefen Temperaturen schneller erreicht. In Summe kommt es zu einer geringeren Standardabweichung der entsprechenden Struktur-Eigenschaftsprofile wie z. B. Bruchspannung und Bruchdehnung des Polymer-Hybrid-Materials und somit zu einer Erhöhung der Gesamtausbeute des Splitting-Verfahrens. Die ortsaufgelösten Eigenschaftsprofiländerungen (Spannungsspitzen im Polymer-Hybrid-Material) und somit im Festkörper sind kleiner, was zu einer höheren Gesamtausbeute des Splitting-Verfahrens und einer besseren Qualität der erzeugten Festkörper-Teilstücke führt.

Der dritte Füllstoff kann einen verbesserten Wärmeübergang zwischen Umgebung und Polymer-Hybrid-Material und eine schnellere Wärmeleitung innerhalb des Polymer-Hybrid-Materials bewirken, sodass das Polymer-Hybrid-Material schneller abgekühlt werden kann und das Splitting-Verfahren insgesamt schneller und damit effektiver durchgeführt werden kann.

Durch eine Erhöhung des Elastizitätsmoduls lassen sich höhere Spannungen für die Teilung des Festkörper-Ausgangsmaterials erzeugen, so dass auch Festkörper-Ausgangsmaterialien geteilt werden können, für die eine besonders hohe Spannung benötigt wird.

Zudem kann der dritte Füllstoff auch der Beeinflussung des thermischen Ausdehnungskoeffizienten dienen. Ziel ist dabei ein möglichst großer Unterschied zwischen den Wärmeausdehnungskoeffizienten des Polymer-Hybrid-Materials und des zu teilenden Festkörper-Ausgangsmaterials, um zusätzliche, für die Teilung notwendige Spannungen erzeugen zu können. Bevorzugt weist der dritte Füllstoff einen hohen thermischen Ausdehnungskoeffizienten, d. h. einen Ausdehnungskoeffizienten, der höher als derjenige der Polymermatrix ist, auf. Beispielsweise kann der thermische Ausdehnungskoeffizient des dritten Füllstoffs mehr als 300 ppm/K betragen.

Der dritte Füllstoff kann so in der Polymermatrix verteilt sein, dass der Masseanteil des dritten Füllstoffs in Richtung der oberen Grenzfläche zunimmt, um einen schnelleren Wärmeübergang insbesondere an der Grenzfläche zur Umgebung zu ermöglichen.

Der dritte Füllstoff kann ein Metall, insbesondere Aluminium, Eisen, Zink und/oder Kupfer, umfassen oder aus einem der genannten Metalle bestehen. Metalle zeichnen sich im Allgemeinen durch eine hohe Wärmeleitfähigkeit und Temperaturleitfähigkeit aus.

Die beschriebenen Füllstoffe (erster, zweiter, dritter Füllstoff) können in partikulärer Form in der Polymermatrix verteilt vorliegen, wobei die Partikelgröße im µm- und nm-Bereich, bezogen auf zumindest eine Dimension des Partikels, liegen kann. Neben einer kugelförmigen Gestalt können die Füllstoffpartikel auch andere Ausgestaltungen, beispielsweise eine stäbchenförmige oder scheibenförmige Gestalt annehmen.

Die Füllstoffpartikel können sämtliche Partikelgrößenverteilungen aufweisen, beispielsweise monomodal oder bimodal, eng, insbesondere monodispers, oder breit. Die Füllstoffe können an die Polymermatrix sowohl physikalisch, z. B. durch Einbettung in das Polymernetzwerk, als auch chemisch angebunden sein. Weiterhin können einer oder mehrere der beschriebenen, Füllstoffe anorganische oder organische Fasern, beispielsweise Kohle-, Glas-, Basalt- oder Aramidfasern, umfassen oder aus solchen bestehen, sofern die zuvor beschriebenen Funktionen damit vereinbar sind. Optional kann auch ein weiterer Füllstoff hinzugefügt werden, der die genannten Fasern umfasst oder aus solchen besteht.

Fasern weisen üblicherweise stark anisotrope Eigenschaften auf. Durch eine richtungsabhängige Positionierung des Füllstoffs im Polymer-Hybrid-Material besteht die Möglichkeit einer gezielten Beeinflussung der für die Teilung des Festkörper-Ausgangsmaterials notwendigen Spannungen. Dies kann zur Erhöhung der Gesamtausbeute des Splitting-Verfahrens beitragen. Ein zusätzlicher Vorteil besteht in dem Falle, dass ein☐organischer oder anorganischer Füllstoff als Faserstoff mit einer stark anisotropen Struktur eingesetzt wird, darin, dass dadurch eine Verbesserung der mechanischen Eigenschaften innerhalb des Polymer-Hybrid-Materials erreicht werden kann.

Die beschriebenen Füllstoffe können zudem Kern-Schale- Partikeln umfassen oder daraus bestehen. Zusätzlich oder alternativ kann ein weiterer Füllstoff umfassend oder bestehend aus Kern-Schale-Partikeln im Polymer-Hybrid-Material vorgesehen sein.

Der Einsatz von Kern-Schale-Polymerpartikeln erlaubt zusätzlich neben einer verbesserten Aktivierbarkeit auch eine neue Gestaltung von energieabsorbierenden Mechanismen, die in

Summe zu einer Schlagzähigkeits- und Bruchzähigkeitserhöhung, insbesondere einer Erhöhung der Tieftemperatur-Schlagzähigkeit, des Polymer-Hybrid-Materials beim Einsatz im Splitting-Verfahren führen können und somit ebenfalls zu einer höheren Gesamtausbeute des Splitting- Verfahrens beitragen können. Beispielsweise kann eine mechanische Zerstörung einer Folie aus einem Polymer-Hybrid-Material mit einer geringeren Wahrscheinlichkeit auftreten, so dass die Möglichkeit einer Wiederverwendung der Folie begünstigt werden kann.

Beispielhaft kann durch Unterbindung der Rissausbreitung aufgrund von Kern-Schale-Polymerpartikel eine Zerstörung der Folie beim Splitting-Verfahren verhindert werden und somit Wiederverwertungswege eröffnet werden.

Hierbei können enthaltene Elastomerpartikel eine plastische Deformation erfahren und Hohlräume bilden, wodurch weitere zusätzliche Energie aufgenommen werden kann. Ebenso ist eine zusätzliche Energieaufnahme durch das Scherfließen der Matrix kompensierbar, was insgesamt die mechanischen Eigenschaften verbessert. Kern-Schale-Partikel zeichnen sich dadurch aus, dass ein in der Regel kugelförmiger Kern aus einem Material von einer Schale aus einem zweiten Material umgeben ist. Die Schale kann entweder den Kern komplett umhüllen oder aber auch durchlässig sein. Bei den Materialien kann es sich sowohl um anorganische Materialien, wie z. B. Metalle, oder um organische Materialien, wie z. B. Polymere handeln. Beispielsweise können zwei verschiedene Metalle miteinander kombiniert werden. Es besteht aber auch die Möglichkeit, einen Kern aus einem Polymer mit einer Schale aus einem Metall oder einem zweiten Polymer zu umgeben.

Kern-Schale-Partikel ermöglichen die Kombination der Eigenschaften des ersten und zweiten Materials. Beispielsweise kann über einen preiswerten Polymerkern die Größe und Dichte der Füllstoffpartikel festgelegt werden, während die metallische Schale wie oben beschrieben reagieren kann. Aufgrund ihrer oftmals monodispersen Partikelgrößenverteilung lassen sich die Eigenschaften der Kern-Schale-Partikel zudem präzise vorhersagen und einstellen.

Darüber hinaus können ein oder mehrere Füllstoffe (erster, 5 zweiter und/oder dritter Füllstoff) Kohlenstoff in Form von Industrieruß (Carbon Black), Graphit, zerkleinerten Kohlenstofffasern (chopped carbon fiber), Kohlenstoffnanofasern (carbon nanofibers), bevorzugt in Form von Kohlenstoffnanoröhrchen (carbon nanotubes, CNT), wie z.B. mehrwandigen Kohlenstoffnanoröhrchen (multi-walled carbon nanotubes, MWCNT) sowie einwandigen Kohlenstoffnanoröhrchen (single-walled carbon nanotubes, SWCNT), umfassen oder aus diesen bestehen. Bei Kohlenstoffnanoröhrchen handelt es sich um zylinderförmige Graphitlagen, die aus einer unterschiedlichen Anzahl an Zylindern aufgebaut sind.

Bestehen diese Röhrchen nur aus einem Zylinder, so werden sie als singlewalled carbon nanotubes (SWCNT) bezeichnet. Sind zwei oder mehr Zylinder vorhanden, entstehen entweder double-walled (DWCNT) oder die multi-walled carbon nanotubes (MWCNT). Diese können vorzugsweise konzentrisch ineinander geschachtelt vorliegen.

Gemäß verschiedenen Ausführungsvarianten kann der dritte Füllstoff MWCNTs umfassen oder aus diesen bestehen, da diese eine besonders hohe Wärmeleitfähigkeit (> 3000 W*(m*K)-1) besitzen und gleichzeitig eine sehr hohe Reißfestigkeit im Bereich von 5-60 GPa aufweisen. Die hohe mechanische Stabilität zeigt sich dabei in hohen Reißwerten, extremer Elastizität und einer sehr guten Strapazierfähigkeit des Füllstoffs.

Grundlage hierfür sind die sp2 hybridisierten starken $\sigma$-C-C- Bindungen verbunden mit einem delokalisierten p-Orbital als $\pi$-Bindung zu drei benachbarten Kohlenstoffatomen. Hierbei sind Verbiegungen bis zu 90° möglich.

Mit SWCNT sind noch höhere Eigenschaftswerte erreichbar (E- Modul: 410 GPa bis 4150 GPa vs. Graphit: 1000 GPa, SWCNT: Wärmeleitfähigkeit ca. 6000 W*(m*K)-1). Allerdings zeigt sich hier ein schlechteres Leistungs-/Kosten-Verhältnis im Vergleich zu MWCNT. Die Zylinderdurchmesser von MWCNT liegen typischerweise im Bereich von 1 nm bis 100 nm, bevorzugt von 5 bis 50 nm, mit einer Länge von 500 nm bis 1000 $\mu$m.

Gemäß weiteren Ausführungsvarianten kann der dritte Füllstoff MWCNT umfassen und gleichzeitig der zweite und/oder erste Füllstoff Industrieruß umfassen oder aus diesem bestehen, da hier ebenfalls eine Verbesserung der Wärmeleitfähigkeit (z. B. bis zu 200 W*(m*K)-1) erreicht werden kann. Da der Einsatz von beispielhaft Industrieruß eine deutlich geringere Reißfestigkeit mit Werten von < 0,4 GPa aufweist, ist eine Kombination aus beiden oder weiteren Füllstoffen möglich und kann zu einer Verbesserung der Gesamtsplitausbeute und zu einer Verbesserung der Gesamtkosten im Splitting-Verfahren führt.

20 Hierbei liegen die mittleren Durchmesser der Rußpartikel (Carbon Black) im Bereich von 5 nm bis 500 nm, bevorzugt von 20 nm bis 200 nm, besonders bevorzugt von 40 nm bis 100 nm.

Weiterhin können die Füllstoffe Kieselsäure, beispielsweise pyrogene Kieselsäure, umfassen oder aus dieser bestehen. 25 Zusätzlich oder alternativ kann ein weiterer Füllstoff umfassend oder bestehend aus Kieselsäure im Polymer-Hybrid-Material vorgesehen sein.

Pyrogene Kieselsäure kann ein dreidimensionales Netzwerk ausbilden und dadurch zur Verbesserung der mechanischen□30 Stabilität beitragen. Somit kann ein solcher Füllstoff der gezielten Einstellung der mechanischen Eigenschaften des Polymer-Hybrid-Materials dienen. Einer oder mehrere der genannten Füllstoffe (erster, zweiter, dritter Füllstoff) können aus demselben Material bestehen, sofern dies mit der ihnen zugeschriebenen Funktion vereinbar ist. Beispielsweise kann sowohl der erste als auch der dritte Füllstoff Aluminium umfassen oder aus Aluminium bestehen. Aluminium lässt sich wie oben beschrieben sowohl zur Generierung von Kavitäten und damit zur Beschleunigung des Ablösens des Polymer-Hybrid-Materials vom Festkörper- Teilstück nutzen als auch zur Erhöhung der Temperaturleitfähigkeit. Eine derartige Ausgestaltung vereinfacht den Herstellungsprozess, da es ausreichend sein kann, nur einen oder zwei Füllstoffe hinzuzufügen, um alle Funktionen zu erfüllen.

Erster und zweiter sowie ggf. dritter Füllstoff können auch aus unterschiedlichen Materialien bestehen. Dadurch wird eine individuelle und damit bessere Anpassung des Füllstoffs an die gewünschte Funktion ermöglicht.

Eine Folie zur Verwendung im Verfahren nach einer Ausführungsform umfasst ein Polymer-Hybrid-Material, wie obenstehend beschrieben. Die Folie kann eine Dicke von beispielsweise 0,5 bis 5 mm aufweisen.

Auf zumindest diese Oberfläche wird ein Polymer-Hybrid-Material oder eine Folie der oben beschriebenen Art aufgebracht, so dass eine entsprechende Verbundstruktur resultiert. Das aufgebrachte Polymer-Hybrid-Material bzw. die aufgebrachte Folie werden im Folgenden auch als Aufnahmeschicht bezeichnet. Die Dicke einer solchen Aufnahmeschicht kann beispielsweise zwischen 0,5 mm und 5 mm, insbesondere zwischen 1mm und 3mm, liegen. Optional kann das Polymer-Hybrid-Material oder die Folie auch auf mehrere freiliegende Oberflächen, insbesondere auf parallel zueinander angeordnete Oberflächen aufgebracht werden.

Die thermische Beaufschlagung stellt bevorzugt ein Abkühlen der Aufnahmeschicht unter die Umgebungstemperatur und bevorzugt unter 10 °C und besondere bevorzugt unter 0 °C und weiter bevorzugt unter -10 °C oder unter -40 °C dar.

Die Abkühlung der Aufnahmeschicht erfolgt höchst bevorzugt derart, dass zumindest ein Teil der Aufnahmeschicht einen Glasübergang vollzieht. Die Abkühlung kann hierbei eine Abkühlung auf unter -100 °C sein, die z. B. mittels flüssigen Stickstoffs bewirkbar ist. Diese Ausführungsform ist vorteilhaft, da sich die Aufnahmeschicht in Abhängigkeit von der Temperaturveränderung zusammenzieht und/oder einen Glasübergang erfährt und die dabei entstehenden Kräfte auf das Festkörper-Ausgangsmaterial übertragen werden, wodurch mechanische Spannungen in dem Festkörper erzeugbar sind, die zum Auslösen eines Risses und/oder zur Rissausbreitung führen, wobei sich der Riss zunächst entlang der ersten Ablöseebene zum Abspalten der Festkörperschicht ausbreitet.

In einem weiteren Schritt wird das Polymer-Hybrid-Material oder die Folie vom Festkörper-Teilstück, beispielsweise durch eine chemische Reaktion, ein physikalischer Ablösevorgang und/oder mechanisches Abtragen, entfernt.

Der Ablösevorgang des Polymer-Hybrid-Materials vom Festkörper-Teilstück kann bei moderater Umgebungstemperatur, z. B. im Bereich von 20 °C bis 30 °C stattfinden, bevorzugt im höheren Temperaturbereich von 30 °C bis 95 °C, z. B. von 50 °C bis 90 °C, oder aber beispielsweise auch in einem unteren Temperaturbereich zwischen 1 °C und 19 °C.

Der erhöhte Temperaturbereich kann eine Verkürzung einer chemischen Ablösereaktion aufgrund einer Erhöhung der Reaktionsgeschwindigkeit ermöglichen, z. B. im Falle der Verwendung einer Opferschicht zwischen dem Polymer-Hybrid-Material und dem Festkörper. Im Falle der Verwendung einer Opferschicht kann das Ablösen in wässriger Lösung erfolgen, vorteilhaft bei einem pH-Wert im Bereich von 2 - 6. Gemäß verschiedenen Ausführungsvarianten kann beispielhaft der Ablösevorgang in Form einer Behandlung mit einer Lösung aus einem geeigneten apolaren Lösungsmittel erfolgen, wobei moderate Umgebungstemperaturen im Bereich von 1 °C bis 50 °C bevorzugt und von 20°C bis 40°C besonders bevorzugt sind.

Ein besonderer Vorteil hierbei ist das Ablösen ohne eine Temperatureinwirkung auf die Folie. Hierbei können vorteilhaft aliphatische und aromatische Kohlenwasserstoffe wie z. B. Toluol, n-Pentan, n-Hexan, aber auch halogenierte Lösungsmittel, wie z. B. Tetrachlorkohlenstoff, angewendet werden. Hierbei können zusätzliche Kräfte in das abzulösende Polymer-Hybrid-Material und die Grenzfläche zum Festkörper-Teilstück eingebracht werden, da durch eine Lösungsmittelbehandlung eine sehr starke reversible Quellung des Polymers-Hybriden-Materials auftreten kann, wodurch das Ablösen insgesamt vereinfacht wird.

Gemäß weiteren Ausführungsvarianten kann eine Kombination mit dem oben beschriebenen Ablösemechanismus der Opferschicht und der Behandlung mit einem geeigneten apolaren Lösungsmittel erfolgen - ebenfalls ohne Temperatureinwirkung auf die Folie.

Der Materialabtrag erfolgt hierbei bevorzugt in Längsrichtung des Festkörpers.

Gemäß einer weiteren bevorzugten Ausführungsform der vorliegenden Erfindung weist das Verfahren zusätzlich den Schritt des Bewegens des Spendersubstrats relativ zum Laser auf. Der Laser wird dabei zur definierten Fokussierung der Laserstrahlung und/oder zur Anpassung der Laserenergie bevorzugt kontinuierlich in Abhängigkeit von mindestens einem Parameter und bevorzugt einer Vielzahl an Parametern, insbesondere mindestens zwei Parametern, eingestellt. Somit erfolgt bevorzugt eine positionsabhängige Laserleistungseinstellung zur Anpassung an Inhomogenitäten der Proben bzw. des Festkörpers bzw. des Substrats.

Je nach Herstellverfahren treten z.B. Dotierinhomogenitäten im Festkörper auf, die mittels der genannten Lösung vorteilhaft kompensiert werden können. Beispiel: Silizumcarbid (SiC) wird in Gasphasenabscheidung durch Aufblasen von Dotiergas (N2) hergestellt, dabei einsteht ein mit dem Auge deutlich sichtbarer Dotierfleck. Diese Inhomogenitäten erfordern für die erfolgreiche Lasermodifikation (ausreichende Schädigung besonders bevorzugt ohne Rissinduzierung) häufig andere Laserparameter als die mittleren Laserparameter für sonst homogen angenommene Werkstücke/ Proben. Für die Mehrzahl der Proben sind die Prozessparameter robust (d.h. Prozessfenster ausreichend groß) um mit mittleren Laserparameter für im Mittel homogene Proben erfolgreich zu modifizieren. Für größere lokale Materialeigenschaftsabweichungen müssen lokal angepasste Laserparameter verwendet werden. Somit sind in-line Anpassungen oder Anpassungen mit Vorwissen denkbar.

Diese Lösung ist vorteilhaft, da manche Materialien (Bsp.: SiC) lokale Brechindex- und andere Materialeigenschaftsunterschiede (z.B. Absorption, Transmission, Streuung) aufweisen, die mittels einer positionsabhängigen Einstellung der Laserbeaufschlagung ausgeglichen oder kompensiert werden können. Bevorzugt dienen einzelne oder mehrere der Materialeigenschaften: Absorption, Transmission, Streuung, Brechungsindex, etc. jeweils als mögliche Parameter. Positionsabhängig bedeutet hierbei, dass eine Relativbewegung des zu behandelnden Festkörpers gegenüber der Laserbeaufschlagungseinrichtung erfolgt. Es ist hierbei somit denkbar, dass die Laserbeaufschlagungseinrichtung und/oder der Festkörper bewegt werden. Der mindestens eine Parameter wird bevorzugt vor der Beaufschlagung des Festkörpers mit den Laserstrahlen im Rahmen eines Analyseschritts erfasst. Die Veränderung des Parameters über die Einstrahloberfläche und/oder über das beaufschlagte Volumen des Festkörpers wird bevorzugt datenmäßig in Form von Eigenschaftsprofildaten abrufbar vorgehalten und wird besonders bevorzugt zum Ansteuern der Laserbeaufschlagungseinrichtung zur positionsabhängigen Laserbeaufschlagung des Festkörpers verwendet. Zusätzlich ist denkbar, dass eine Verfahreinrichtung, auf welcher der Festkörper angeordnet wird, insbesondere ein X-/Y-Tisch oder ein Rotationstisch, in Abhängigkeit der Eigenschaftsprofildaten angesteuert bzw. betrieben wird. Alternativ ist denkbar, dass die Eigenschaftsprofildaten erzeugt und in Echtzeit ausgewertet werden, d.h. unmittelbar zur Ansteuerung der Laserbeaufschlagungseinrichtung und/oder der Verfahreinrichtung verwendet werden.

In-line Anpassungen basieren somit bevorzugt auf Änderungen, die in Echtzeit (mit Sensorvorlauf vor Bearbeitungsposition) erfasst werden können. Besonders eignen sich dabei berührungslose einseitige (also reflektive anstelle transmittive) Messverfahren, wie z.B. spektrale Reflexion. Für Anpassungen mit Vorwissen wird bevorzugt eine Laseranlage benötigt, die eine Karte mit Korrekturfaktoren K(x,y,) als Vorwissen vor der Bearbeitung einlesen und mit dessen Hilfe Laserparameter lokal (x,y) einstellt. Die Proben werden bevorzugt bei der Fixierung bevorzugt auf der Verfahreinrichtung, insbesondere dem Chuck/Carrier, bevorzugt mit exakter Orientierung versehen, so dass dieses Vorwissen mit dem Chuck/Carrier in der Maschine registriert werden kann. Zur Anpassung der lokalen Energiedichte eignen sich z.B. eine Leistungsnachführung, angepasste Schreibmuster (andere Perforationsdichte) oder Mehrfachüberfahrten mit unterschiedlichem Schreibmustern.

Gemäß einer weiteren bevorzugten Ausführungsform ist ein zusätzlicher oder alternativer Parameter der Grad der Dotierung des Festkörpermaterials, der bevorzugt durch die Analyse von zurückgestreutem Licht (bevorzugt Raman-Streuung) bestimmt wird, wobei das zurückgestreute Licht eine andere Wellenlänge oder einen anderen Wellenlängenbereich aufweist als zum Auslösen der Zurückstreuung definiert eingestrahltes Licht, wobei ein Raman-Instrument bevorzugt Bestandteil der Vorrichtung ist und der Grad der Dotierung bevorzugt mittels des Raman-Instruments bestimmt wird, wobei ein oder mehrere oder alle dieser Parameter bevorzugt mittels eines gemeinsamen Detektionskopfes, insbesondere zeitgleich, erfasst werden. Die Ramanspektroskopie wird bevorzugt ebenfalls bei Gläsern, Saphir, Aluminiumoxidkeramik eingesetzt. Das Raman-Verfahren ist vorteilhaft, da es in der Tiefe des Materials misst, aber nur von einer Seite, keine hohe Transmission benötigt und durch einen Fit an das Raman-Spektrum die Ladungsträgerdichte/Dotierung ausgibt, die mit den Laserparametern korreliert werden kann.

Ein zusätzlicher oder alternativer Parameter ist gemäß einer weiteren bevorzugten Ausführungsform der vorliegenden Erfindung der Grad der Dotierung des Festkörpers an einem vorbestimmten Ort oder in einem vorbestimmten Bereich, insbesondere im Inneren, des Festkörpers, insbesondere beabstandet zur Festkörperoberfläche. Bevorzugt wird der Grad der Dotierung derart mit Ortsinformationen verknüpft, dass eine Behandlungskarte entstehet bzw. ortsaufgelöste Behandlungsanweisung bereitgestellt werden, die ortsabhängig die Laserparameter, insbesondere Laserfokus und/oder Laserenergie, und/oder weitere Maschinenparameter, insbesondere die Vorschubgeschwindigkeit, vorgibt bzw. vorgeben.

Der Grad der Dotierung wird gemäß einer weiteren Ausführungsform durch die Analyse von zurückgestreutem Licht mit einer unelastischen Streuung (Raman-Streuung) bestimmt, wobei das zurückgestreute Licht eine andere Wellenlänge oder einen anderen Wellenlängenbereich aufweist als zum Auslösen der Zurückstreuung definiert eingestrahltes Licht, wobei das zurückgestreute Licht von dem vordefinierten Ort aus oder von dem vorbestimmten Bereich aus zurückgestreut wird.

Diese Ausführungsform ist vorteilhaft, da im Laserverfahren, insbesondere auf SiC (aber auch anderen Materialien) der Prozess ortsangepasst geführt werden muss (z.B. andere Laserenergie, etc.). Es wurde erkannt, dass z.B. bei SiC hierfür insbesondere die Dotierung entscheidend ist, da diese die Transparenz des Materials für die Bearbeitungswellenlänge ändert und höhere Laserenergien erforderlich macht.

Der Grad der Dotierung wird gemäß einer weiteren Ausführungsform mittels einer ellipsometrischen Messung (z.B. Müller-Matrix-Ellipsometrie mit Rückseitenreflexion) bestimmt. Die ellipsometrische Messung beruht bevorzugt auf einer optischen Transmission des Materials.

Gemäß einer weiteren Ausführungsform wird der Grad der Dotierung mittels einer rein optisch kalibrierten Transmissionsmessung bestimmt, wobei die Kalibrierung mittels Hall-Messung und 4-Punkt-Messung bewirkt wird. Dieses Verfahren kann ebenfalls die Dotierung/Zahl der freien Ladungsträger im Material ermitteln, die dann die für den Prozess benötigte Laserenergie ermitteln lässt.

Der Grad der Dotierung wird gemäß einer weiteren Ausführungsform mittels einer Wirbelstrommessung bestimmt, wobei bevorzugt Leitfähigkeitsunterschiede im Festkörpermaterial bestimmt und ausgewertet werden.

Darin zeigt beispielhaft:

| | |
|---|---|
| Fig. 1 | ein Spendersubstrat mit gegenüber der Längsachse in einem Winkel von ungleich 90° ausgerichteten Kristallgitterebenen und erzeugten Laserschreiblinien; |
| Fig. 2 | eine weiteres Spendersubstrat mit gegenüber der Längsachse in einem Winkel von ungleich 90° ausgerichteten Kristallgitterebenen und erzeugten Laserschreiblinien, wobei die Ausrichtung der Laserschreiblinien bzw. linienartigen Gestalt mittels Ebenen definiert ist; |
| Fig. 3 | dass die Modifikationen einer linienförmigen Gestalt eine Vielzahl unterschiedlicher Kristallgitterebenen schneiden; |
| Fig. 4 | eine schematische Darstellung von zwei durch Modifikationen ausgebildete Linien, |
| Fig. 5a-d | verschiedene Kühleinrichtungen, die bevorzugt zum Kühlen im Zusammenhang mit erfindungsgemäßen Verfahren einsetzbar sind, |
| Fig. 6a-c | drei unterschiedliche schematische Beispiele für die Rissausbreitung zwischen Modifikationen, |
| Fig. 7 | unterschiedlich orientierte Modifikationslinien zur Bewirkung unterschiedlicher Funktionen, |
| Fig. 8 | ein Beispiel einer Schottky Diode, |
| Fig. 9 | ein Beispiel eines MOSFETs, |
| Fig. 10a-b | die Erzeugung von sich vom Rand aus in das Innere des Festkörpers hinein erstreckenden Vertiefungen, wobei die Vertiefungen sich bevorzugt entlang einer durch Modifikationen 9 definierten Ablöseebene erstrecken, |
| Fig. 11 | ein erstes Beispiel für eine Randbehandlung im Rahmen der Festkörperscheibenherstellung bzw. Festkörperschichtenherstellung gemäß einer Ausführungsform, die nicht von der vorliegenden Erfindung abgedeckt ist, |
| Fig. 12 | ein Beispiel für eine Randbehandlung im Rahmen der Festkörperscheibenherstellung bzw. Festkörperlagenherstellung gemäß einer Ausführungsform, die nicht von der vorliegenden Erfindung abgedeckt ist, |
| Fig. 13 | ein weiteres Beispiel für eine Randbehandlung im Rahmen der Festkörperscheibenherstellung bzw. Festkörperlagenherstellung gemäß einer Ausführungsform, die nicht von der vorliegenden Erfindung abgedeckt ist, |
| Fig. 14a/b | Darstellungen, die Schwierigkeiten beim Erzeugen von Modifikationen in einem Festkörper verdeutlichen, insbesondere wenn die Modifikationen mittels LASER-Strahlen erzeugt werden, |
| Fig. 15 | eine Darstellung, die verschiedene LASER-Strahlwinkel zeigt, |
| Fig. 16a/16b | eine Darstellung, eines Modifikationserzeugungsschrittes und eine schematische Darstellung der erzeugten Modifikationen, |
| Fig. 17a/17b | zwei Darstellungen von Modifikationserzeugungsschritten, |
| Fig. 18 | eine Modifikationserzeugung mit einer Aberrationsanpassung und, |
| Fig. 19 | eine schematische Darstellung eines Festkörpers, der Vertiefungen aufweist, die von einer Spannungserzeugungsschicht überdeckt bzw. überlagert bzw. verschlossen werden, |
| Fig. 20a-20d | ein weiteres Beispiel für eine Randbehandlung im Rahmen der Festkörperscheibenherstellung gemäß einer Ausführungsform, die nicht von der vorliegenden Erfindung abgedeckt ist, |

| | |
|---|---|
| Fig. 21a-f | einen Behandlungsablauf gemäß einer Ausführungsform, die nicht von der vorliegenden Erfindung abgedeckt ist, |
| Fig. 22a-b | zwei schematische Beispiele für Festkörperanordnungen, wie sie im Rahmen von Ausführungsformen des erfindungsgemäßen Verfahrens bereitgestellt werden können, |
| Fig. 23a-i | weitere schematische Beispiele für Festkörperanordnungen bzw. Festkörperanordnungen die im Rahmen von Ausführungsformen des erfindungsgemäßen Verfahrens - als Zwischenprodukt - erzeugt werden können, |
| Fig. 24 | ein Beispiel eines Kristallgitters mit Gleitebene für 4HSiC, |
| Fig. 25a | ein Beispiel eines Kristallgitters mit Gleitebene 110 für Si, |
| Fig. 25b | ein Beispiel eines Kristallgitters mit Gleitebene 100 für Si, |
| Fig. 25c | ein Beispiel eines Kristallgitters mit Gleitebene 111 für Si, |
| Fig. 26a-27a | die Veränderung der Neigung der linienförmigen Gestalt gegenüber den Enden der Kristallebene, wenn das Spendersubstrat mittels einer Rotationseinrichtung unter einer Lasereinrichtung vorbeibewegt wird, |
| Fig. 27b | eine Draufsicht auf eine exemplarische Rotationseinrichtung, |
| Fig. 27c | eine Seitenansicht eine Bearbeitungsanlage, wobei die Bearbeitungsanlage ein bevorzugt linear verfahrbares Laserelement und eine Rotationseinrichtung mit einer Vielzahl darauf angeordneter Spendersubstrate aufweist, |
| Fig. 28a | die Erzeugung einer dreidimensionalen Rissführungsschicht, |
| Fig. 28b | die Erzeugung einer weiteren Rissführungsschicht zur Erzeugung eines dreidimensionalen Festkörpers, |
| Fig. 29a | einen schematischen Aufbau zum Erzeugen von Defekten in einem Festkörper, |
| Fig. 29b | eine schematische Darstellung einer Schichtanordnung vor dem Abtrennen einer Festkörperschicht von einem Festkörper, |
| Fig. 29c | eine schematische Darstellung einer Schichtanordnung nach dem Abtrennen einer Festkörperschicht von einem Festkörper, |
| Fig. 30a | eine erste schematisch dargestellte Variante zur Defekterzeugung mittels Laserstrahlung, |
| Fig. 30b | eine zweite schematisch dargestellte Variante zur Defekterzeugung mittels Laserstrahlung, |
| Fig. 31a | eine schematische Seitenansicht eines unebenen Wafers gemäß einem zum Verständnis der Erfindung beitragenden Beispiel, das nicht von der vorliegenden Erfindung abgedeckt ist, |
| Fig. 31b | eine schematische Seitenansicht eines unebenen Wafers mit einer daran angeordneten oder erzeugten Beschichtung gemäß einem zum Verständnis der Erfindung beitragenden Beispiel, das nicht von der vorliegenden Erfindung abgedeckt ist, |
| Fig. 31c | eine schematische Seitenansicht einer bevorzugten Form einer Mehrschichtanordnung gemäß einer Ausführungsform nach einer definierten Temperierung, |
| Fig. 32 | ein Beispiel einer Laserbeaufschlagungs-einrichtung gemäß einer Ausführungsform, die nicht von der vorliegenden Erfindung abgedeckt ist, |
| Fig. 33a | ein Beispiel einer Vorrichtung, die nicht von der vorliegenden Erfindung abgedeckt ist, |
| Fig. 33b | die Beaufschlagung einer an dem Festkörper angeordneten Polymerschicht mit einem Funktionsfluid, |
| Fig. 34a | eine exemplarische Darstellung eines Oberflächenprofils eines Festkörpers und der Brechzahlen dieses Oberflächenprofils, |
| Fig. 34b | mehrere Darstellungen von Oberflächenprofilen, |
| Fig. 35a | mehrere Darstellungen der Veränderungen von Regelpositionen des Laserkopfes; und |
| Fig. 35b | zwei Verläufe, die Profile unterschiedlicher Modifikationsverteilungen repräsentieren, |
| Fig. 36a | einen schematischen Aufbau eines Raman-Instruments, wie es im Rahmen einer Ausführungsform verwendet wird, insbesondere wie es bevorzugt Bestandteil einer für die Ausführungsform geeigneten Vorrichtung ist, die nicht von der vorliegenden Erfindung abgedeckt ist, |
| Fig. 36b | verschiedene exemplarische Schwingungszustände der Gitterschwingungen von SiC, |
| Fig. 37a und 37b | zwei Schaubilder, welche Dotierkonzentrationen in einem Festkörper darstellen, |
| Fig. 38a | einen Feedforwardprozess nach einer Ausführungsform, die nicht von der vorliegenden Erfindung abgedeckt ist, |
| Fig. 38b | einen Feedbackprozess nach einer Ausführungsform, die nicht von der vorliegenden Erfindung abgedeckt ist, |
| Fig. 39 | eine Beispiel einer schematischen Darstellung der Ablöseebene, |
| Fig. 40a | zeigt eine schematisch Draufsicht und eine schematische Seitenansicht des Festkörpers, |
| Fig. 40b | zeigt die Darstellung der Fig. 40a und eine schematische Darstellung einer ersten Ablöseebene, |
| Fig. 41 | zeigt schematisch eine weitere Anordnung der die Ablöseebenen definierenden Defekte, |

| Fig. 42a | zeigt ein schematisches Beispiel der Ausbildung mehrerer zweiter Ablöseebenen, |
|---|---|
| Fig. 42b | zeigt ein weiteres schematisches Beispiel bzgl. der Ausbildung der zweiten Ablöseebenen und der dritten Ablöseebenen, |
| Fig. 43 | zeigt eine Festkörperschicht mit zweiten Ablöseebenen, die an einer Polymerschicht angeordnet ist, |
| Fig. 44a | zeigt eine Festkörperschicht vor der Zerteilung in Festkörperelemente, |
| Fig. 44b | zeigt eine Festkörperschicht nach der Zerteilung in Festkörperelemente, |
| Fig. 45a | schematisch eine Vorrichtung zur Druckbeaufschlagung eines mit einer Spannungserzeugungsschicht versehenen Spendersubstrats mittels einer Druckbeaufschlagungseinrichtung, |
| Fig. 45b | schematisch eine Anordnung gemäß Fig. 45b, wobei das Spendersubstrat in seinem Inneren mittels Laserstrahlen modifiziert wurde, |
| Fig. 46 | schematisch eine Vorrichtung zum Begrenzen einer Auslenkbewegung der abgetrennten Festkörperschichtanteile, |
| Fig. 47a-c | schematisch eine Druckbeaufschlagungseinrichtung mit mehreren Druckbeaufschlagungselementen, |
| Fig. 48a | schematisch eine Vorrichtung zur Beaufschlagung unterschiedlicher Oberflächenanteile der Spannungserzeugungsschicht mit unterschiedlichen Drücken, |
| Fig. 48b | schematisch eine Vorrichtung zur Beaufschlagung unterschiedlicher Oberflächenanteile der Spannungserzeugungsschicht mit unterschiedlichen Drücken und zur Begrenzung der Auslenkbewegung der Festkörperscheibe, und |
| Fig. 48c | schematisch eine Draufsicht auf die in Fig. 48b gezeigte Vorrichtung, |
| Fig. 49 | zeigt eine schematische Querschnittsdarstellung eines dicken Wafers zum Abtrennen mehrerer Festkörperschichten, wobei alle Festkörperschichten denselben Durchmesser aufweisen, |
| Fig. 50 | zeigt eine schematische Querschnittsdarstellung eines dicken Wafers zum Abtrennen mehrerer Festkörperschichten, wobei alle Festkörperschichten unterschiedliche Durchmesser aufweisen, |
| Fig. 51a-d | verschiedene Darstellung von mehreren Wafern mit unterschiedlichen Durchmessern, |
| Fig. 52 | eine Funktion, in Abhängigkeit derer sich mittels Laserstrahlen durch eine mit Metall beschichtete Oberfläche in einen Festkörper einbringen lassen, |
| Fig. 53 | zwei bevorzugte Beispiele von Schreibpfaden während der Modifikationserzeugung, |
| Fig. 54a-b | Beispiele zur Erläuterung des Effekts von Bauteilen, Implantgebieten, Dotierungen, Ätzgräben, etc. auf den Ort des Fokusses, |
| Fig. 55-56 | weitere Beispiele zur Erläuterung des Effekts von Bauteilen, Implantgebieten, Dotierungen, Ätzgräben, etc. auf den Ort des Fokusses, |
| Fig. 57 | schematische Darstellungen von gaußschen Strahlprofilen und nichtgaußschen Strahlprofilen, |
| Fig. 58 | Darstellung von Zeitpunkten zur Erzeugung von Modifikationen mittels Laserstrahlen im Inneren eines Festkörpers, wobei die Modifikationen in einem Frontsideprozess erzeugt werden, und |
| Fig. 59 | Darstellung von Zeitpunkten zur Erzeugung von Modifikationen mittels Laserstrahlen im Inneren eines Festkörpers, wobei die Modifikationen in einem Backsideprozess erzeugt werden. |

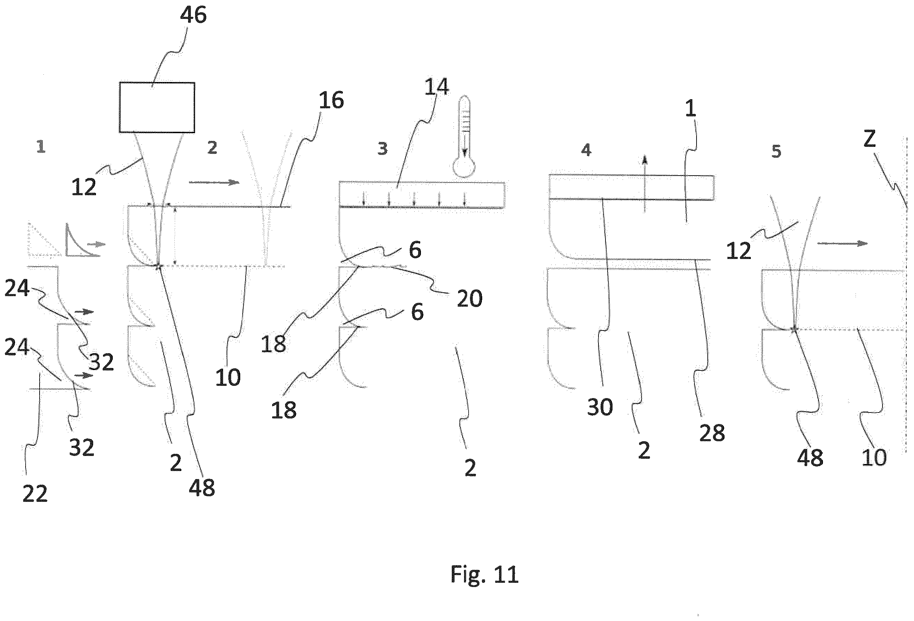

Die in der Figuren 11-13, 20a-d, 31a-c, 36a, und 38a-b dargestellten Ausführungsformen sind nicht von der vorliegenden Erfindung abgedeckt.

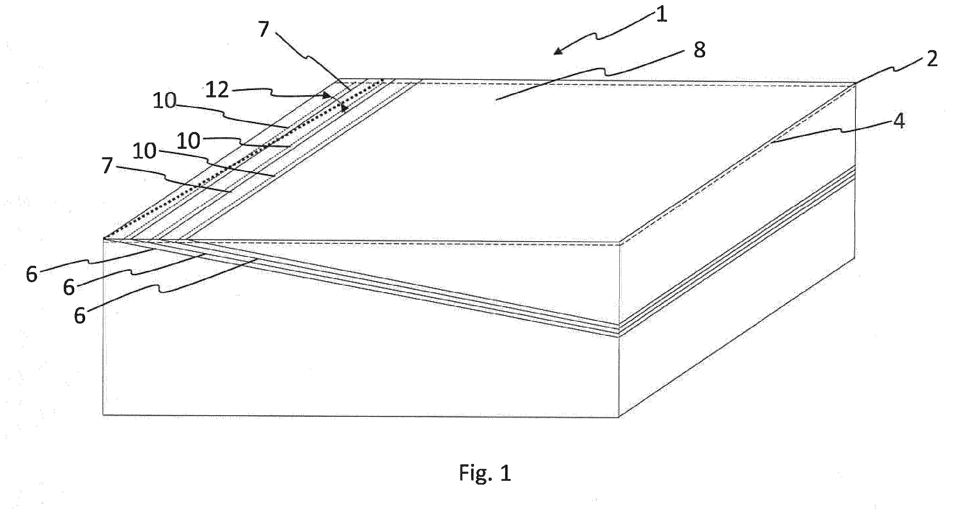

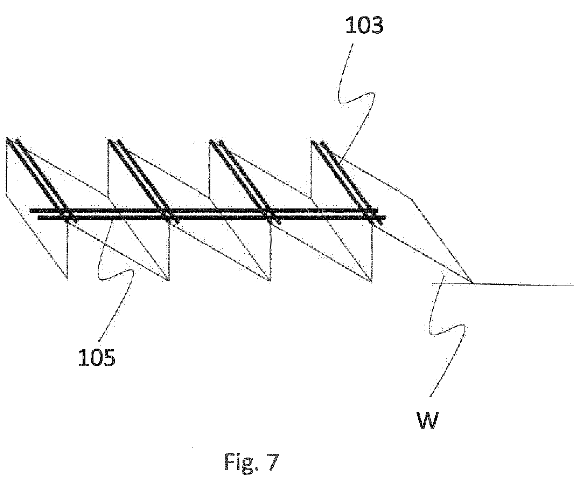

Fig. 1 zeigt schematisch, dass Laserstrahlung 14 (vgl. Fig. 7c) eines Lasers über eine Hauptoberfläche 8 in das Innere des Festkörpers 1 zum Verändern der Materialeigenschaften des Festkörpers 1 im Bereich von mindestens einem Laserfokus eingebracht wird, wobei der Laserfokus durch von dem Laser emittierten Laserstrahlen des Lasers gebildet wird. Die Veränderung der Materialeigenschaft bildet durch verändern des Eindringortes der Laserstrahlung in das Spendersubstrat 1 eine linienförmige Gestalt 103 aus, wobei die Veränderungen der Materialeigenschaft auf mindestens einer, insbesondere derselben, Erzeugungsebene 4 erzeugt werden. Die Kristallgitterebenen 6 des Spendersubstrats 1 sind dabei gegenüber der Erzeugungsebene 4 geneigt, insbesondere in einem Winkel zwischen 3° und 9° bevorzugt von 4° oder 8°, ausgerichtet. Die linienförmige Gestalt 103 bzw. Schreiblinie ist dabei gegenüber einer sich an der Schnittstelle zwischen der Erzeugungsebene 4 und der Kristallgitterebene 6 ergebenden Schnittlinie 10 geneigt. Durch die veränderte Materialeigenschaft reißt das Spendersubstrat 1 in Form von unterkritischen Rissen ein. Ein Schritt des Abtrennens der Festkörperschicht 2 durch Einleiten einer äußeren Kraft in das Spendersubstrat 1 zum Verbinden der unterkritischen Risse ist hierbei nicht dargestellt. Alternativ dazu kann so viel Material auf der Erzeugungsebene 4 mittels der Laserstrahlung verändert werden, dass sich unter Verbindung der unterkritischen Risse die Festkörperschicht 2 von dem Spendersubstart 1 ablöst.

Die Bearbeitung findet in Form von Erzeugung linienförmiger Gestalten 103 bzw. Schreiblinien bzw. Linien statt, die durch Setzen einzelner Laserschüsse in einem definierten Abstand gebildet werden.

Konkret ist z.B. die Herstellung eines Wafers aus Siliziumkarbid vom Polytyp 4H mit einer 0001 Oberfläche mit/ohne Dotierung mit einem off-angle in Kristallachse von >0° (Industriestandard sind 4° oder 8° - um die Richtung einer Hauptachse) möglich. Da die Gleitebene der hexagonalen Kristallstruktur parallel zur 0001 Ebene verläuft, ergibt sich eine Schnittgerade der 0001 Kristallebene mit der Waferoberfläche, da diese um den off-angle relativ dazu geneigt ist.

Grundüberlegung des neuen Verfahrens ist es somit, dass die Bearbeitungsrichtung der Laserlinien 103 von der Richtung dieser Schnittgeraden abweicht. Ebenso soll die Bearbeitungsrichtung bevorzugt nicht entlang einer der Hauptrichtungen des Kristalls oder entlang der Schnittgeraden der bevorzugten Gleitebene des Kristalls mit der Oberfläche des Kristalls verlaufen.

Ferner ist z.B. die Herstellung eines Wafers aus Siliziumkarbid vom Polytyp 4H möglich. Siliziumkarbid vom Polytyp 4H weist ein hexagonales Kristallsystem mit einer Wurtzit-Struktur und einer sechsfachen-Symmetrie in der 0001 Ebene auf. Dementsprechend findet sich alle 60° eine neue Hauptachse des Kristalls. Wenn die Oberfläche durch die der Bearbeitungslaser in das zu bearbeitende Materialstück eindringt, entlang der 0001-Ebene geschnitten ist, so findet sich die sechsfache Symmetrie bei Rotation um die Oberflächennormale wieder. Hier ergibt sich dann eine Linienschreibrichtung, die um 30° zu den jeweiligen Hauptachsen rotiert und damit zwischen zwei Hauptachsen orientiert ist. Auf diese Weise wird sichergestellt, dass die geschriebene Linie die Einheitszellen des Kristalls möglichst kreuzt und sich Risse, die größere Bereiche umfassen und mehrere Einheitszellen auf einmal betreffen, schwerer ausbilden können. Siliziumkarbid vom Polytyp 4H wird oft in einem Off-Winkel von 4° relativ zur 0001-Ebene geschnitten, um Epitaxie-Schritte in der späteren Bearbeitung zu vereinfachen. Hierbei zeigt sich, dass die Projektion der Hauptachsen des Kristalls zueinander weiterhin nahezu 60° zueinander hat, weswegen 30°+/-3° ein bevorzugter Schreibwinkel für die Bearbeitung nach einer Ausführungsform ist.

Ferner ist z.B. die Herstellung eines Wafers aus kubischem SiC (sogenannt 3C) möglich. Kubisches SiC verhält sich wie kubische Kristallsysteme, hat also als bevorzugte Gleitebene die 111-Ebene, woraus sich eine bevorzugte Linienschreibrichtung von 22,5°+/-3° ergibt.

Ferner ist z.B. die Herstellung eines Wafers aus Silizium mit einer 100 Oberfläche mit/ohne Dotierung mit einem off-angle der Kristallachse von 0° möglich.

Die bevorzugte Gleitebene für Silizium mit seiner kubischen Struktur (Diamantstruktur) ist die 111 Ebene welche die Waferoberfläche im 45° Winkel zu den Kristallhauptachsen schneidet. Daraus ergibt sich damit ein angestrebter Linienschreibwinkel von 22.5°+/-3° zu den Hauptachsen des Kristalls und der Schnittgeraden der Gleitebene mit der Waferoberfläche, die zueinander in 45° Winkel orientiert sind.

Da auch Silizium-Substrate mit einem Off-Angle geschnitten sein können, kann hier wieder ein anderer Bearbeitungswinkel bevorzugt sein. Bei einer Verkippung um eine Hauptachse um einen Winkel a wird an der Oberfläche des Substrats die Symmetrie von einer 4fachen zu einer 2fachen Symmetrie durch die Kippung gebrochen. Die projizierte Länge der Hauptachse um die nicht gekippt wird, skaliert dann proportional zu cos(a), was zu einer Veränderung des Idealwinkels zwischen Hauptachsen und Schnittgerade der Gleitebene mit der Oberfläche führt. Die aufgrund der Symmetriebrechung dann möglichen zwei Linienschreibwinkel b sind dann entweder b1= tan-1(cos a)/2 oder b2= tan-1(1/cos a)/2.

Für Galliumnitrid mit einer hexagonalen Wurtzit-Struktur mit einer 6-fachen Kristallsymmetrie in der 0001-Ebene deren bevorzugte Gleitebene die 0001-Ebene ist, ergibt sich aus dem daraus folgenden Winkel von 60° für die Hauptachsen des Kristalls eine bevorzugte Linienrichtung von 30°+/-3° zu den Hauptachsen.

Für Saphir - oder Aluminiumoxid mit einer hexagonalen Korund-Struktur mit einer 6-fachen Kristallsymmetrie in der 0001-Ebene ergibt sich aus dem daraus folgenden Winkel von 60° für die Hauptachsen des Kristalls eine bevorzugte Linienrichtung von 30°+/-3° zu den Hauptachsen für sog. C-Plane-Saphir.

Für A-Plane geschnittenen Saphir ist die Hauptachsenorientierung im 90°-Winkel, mit einer 180°-Symmetrie, woraus sich ein bevorzugter Linienschreibwinkel von 45°+/-3° ergibt.

C-Plane-Substrate von Saphir sind so geschnitten, dass sich an der Oberfläche die sechsfache Symmetrie zeigt und die Oberfläche mit der Gleitebene übereinstimmt, also ein Winkel von 30°+/-3° bevorzugt ist.

Für M-Plane geschnittenen Saphir ist die Hauptachsenorientierung im 90°-Winkel, mit einer 180°-Symmetrie, woraus sich ein bevorzugter Linienschreibwinkel von 45°+/-3° ergibt.

R-Plane-Saphir hat keine Rotationssymmetrie, aber Hauptachsprojektionen in 45° zur Projektionsgeraden der Gleitebene, weswegen auch hier 22,5°+/-3° Schreibrichtung bevorzugt ist.

Für Lithiumtantalat mit einer triklinen Struktur, die mit dem hexagonalen Kristallsystem verwandt ist, ergibt sich, abhängig von der Orientierung des Substrats eine Schreibrichtung zwischen 10°+/-3° und 45°+/-3° relativ zu den einzelnen Hauptachsen und ihrer Projektion in die Substratoberfläche.

Für Galliumarsenid mit einer Zinkblende-Struktur mit einer 4-fachen Kristallsymmetrie in der 100-Ebene deren bevorzugte Gleitebene die 111-Ebene ist, ergibt sich aus dem daraus folgenden Winkel von 90° für die Hauptachsen des Kristalls eine bevorzugte Linienrichtung von 22,5°+/-3° zu den Hauptachsen des Substrats bzw. Spendersubstrats 1 mit einer 100-Oberfläche.

Für Galliumoxid mit einer monoklinen, kubischen Struktur mit einer 4-fachen Kristallsymmetrie in der 100-Ebene deren bevorzugte Gleitebene die 111-Ebene ist, ergibt sich aus dem daraus folgenden Winkel von 90° für die Hauptachsen des Kristalls eine bevorzugte Linienrichtung von 22,5°+/-3° zu den Hauptachsen des Substrats mit einer 100-Oberfläche.

Für Germanium mit einer Diamant-Struktur mit einer 4-fachen Kristallsymmetrie in der 100-Ebene deren bevorzugte Gleitebene die 111-Ebene ist, ergibt sich aus dem daraus folgenden Winkel von 90° für die Hauptachsen des Kristalls eine bevorzugte Linienrichtung von 22,5°+/-3° zu den Hauptachsen des Substrats mit einer 100-Oberfläche.

Für Indiumphosphid mit einer Zinkblende-Struktur mit einer 4-fachen Kristallsymmetrie in der 100-Ebene deren bevorzugte Gleitebene die 111-Ebene ist, ergibt sich aus dem daraus folgenden Winkel von 90° für die Hauptachsen des Kristalls eine bevorzugte Linienrichtung von 22,5°+/-3° zu den Hauptachsen des Substrats mit einer 100-Oberfläche.

Für Yttrium-Aluminium-Granat mit einer kubischen Struktur mit einer 4-fachen Kristallsymmetrie in der 100-Ebene deren bevorzugte Gleitebene die 111-Ebene ist, ergibt sich aus dem daraus folgenden Winkel von 90° für die Hauptachsen des Kristalls eine bevorzugte Linienrichtung von 22,5°+/-3° zu den Hauptachsen des Substrats mit einer 100-Oberfläche.

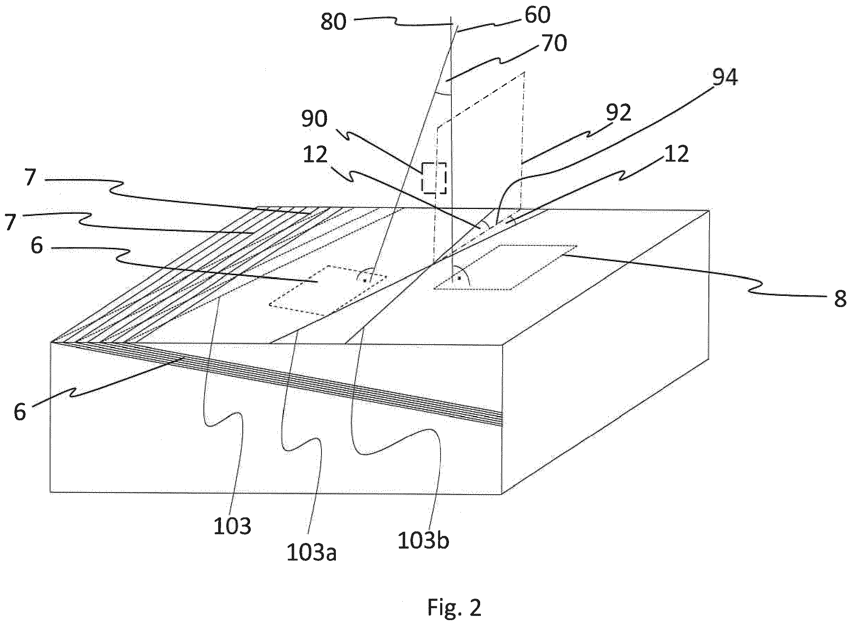

Fig. 2 zeigt einen wesentlichen Schritt zum Abtrennen von mindestens einer Festkörperschicht 2 von einem Spendersubstrat 1 und eine geometrische Herleitung der Ausrichtung der Schreiblinie 103 bzw. der Ausrichtung der linienförmigen Gestalt gemäß einer Ausführungsform.

Gemäß dieser Darstellung kann das Verfahren gemäß einer Ausführungsform auch oder gemäß einem zum Verständnis der Erfindung beitragenden Beispiel alternativ die nachfolgenden Schritte umfassen:
Bereitstellen des Spendersubstrats 1, wobei das Spendersubstrat 1 Kristallgitterebenen 6 aufweist, die gegenüber einer ebenen Hauptoberfläche 8 geneigt sind, wobei die Hauptoberfläche 8 das Spendersubstrat 1 in Längsrichtung L des Spendersubstarts 1 einerseits begrenzt, wobei sich eine Kristallgitterebenennormale 60 gegenüber einer Hauptoberflächennormalen 80 in eine erste Richtung neigt, Bereitstellen von mindestens einem Laser 29, Einbringen von Laserstrahlung 14 des Lasers in das Innere des Festkörpers bzw. Spendersubstrats 1 über die Hauptoberfläche 8 zum Verändern der Materialeigenschaften des Festkörpers im Bereich von mindestens einem Laserfokus, wobei der Laserfokus durch von dem Laser emittierten Laserstrahlen des Lasers gebildet wird, wobei die Veränderung der Materialeigenschaft durch Verändern des Eindringortes der Laserstrahlung in das Spendersubstrat 1 eine linienförmige Gestalt ausbildet, wobei sich die linienförmige Gestalt bevorzugt zumindest abschnittsweise geradlinig erstreckt und wobei die linienförmige Gestalt, insbesondere zumindest der sich geradlinig erstreckende Abschnitt, parallel zur Hauptoberfläche 8 erzeugt wird und sich dabei in einer zweiten Richtung erstreckt, die gegenüber der ersten Richtung in einem Winkel geneigt ist, der von 90° verschieden ist, wobei durch die veränderten Materialeigenschaft das Spendersubstrat 1 in Form von unterkritischen Rissen einreißt, Abtrennen der Festkörperschicht durch Einleiten einer äußeren Kraft in das Spendersubstrat zum Verbinden der unterkritischen Risse oder so viel Material auf der Erzeugungsebene mittels der Lasterstrahlung verändert wird, dass sich unter Verbindung der unterkritischen Risse die Festkörperschicht von dem Spendersubstart ablöst. Die Hauptoberfläche ist dabei bevorzugt Bestandteil der abgetrennten Festkörperschicht 2.

Die zweite Richtung ist dabei bevorzugt gegenüber der ersten Richtung in einem Winkelbereich zwischen 45° und 87°, insbesondere in einem Winkelbereich zwischen 70° und 80° und bevorzugt mit 76°, geneigt.

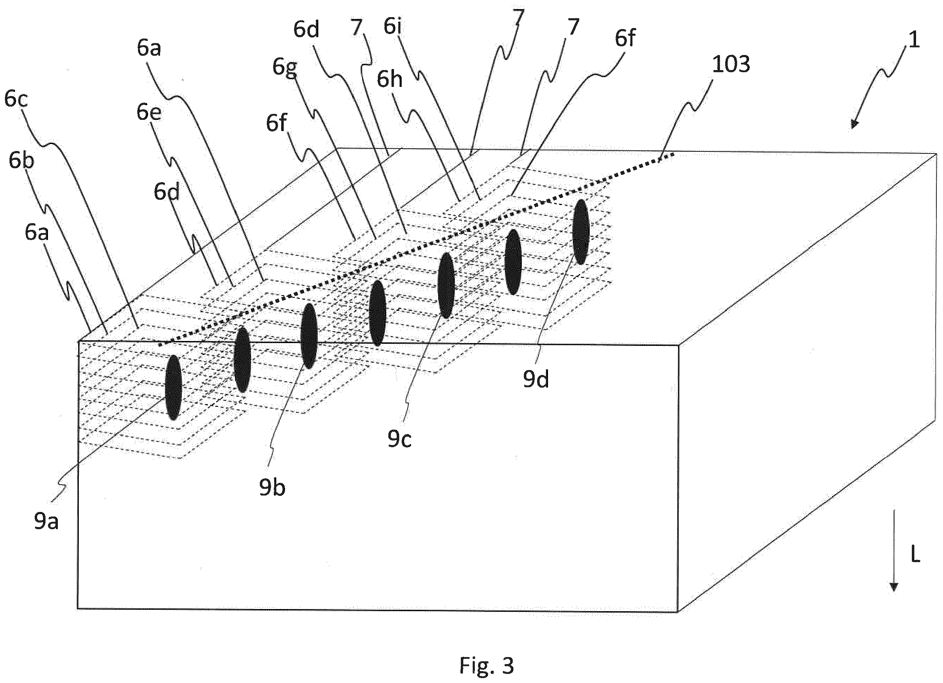

Fig. 3 zeigt, dass die linienförmige Gestalt 103 bzw. die Schreiblinie gegenüber den Enden der Kristallgitterebene oder wie in Fig. 2 gezeigt gegenüber einer sich an der Schnittstelle zwischen der Erzeugungsebene 4 und der Kristallgitterebene 6 ergebenden Schnittlinie 10 bzw. Schnittgeraden geneigt ist. Durch diese Ausrichtung wird das Risswachstum in Richtung der Kristallgitterebenen 6 (insbesondere Gleitebenen) begrenzt. Die Modifikationen 9 je Schreiblinie werden somit nicht in denselben Kristallgitterebenen 6 erzeugt. Z.B. die ersten 1-5% der Modifikationen je Schreiblinie 103 können somit nur noch einen Bruchteil, insbesondere weniger als 75% oder weniger als 50% oder weniger als 25% oder weniger als 10% oder keine Kristallgitterebenen, der letzten 1-5% der Modifikationen derselben Schreiblinie 103 in Substratlängsrichtung L schneiden. Dieser Zusammenhang wird insbesondere dadurch schematisch verdeutlicht, dass die Modifikation 9a die Kristallgitterebenen 6a-6c schneidet und die Modifikation 9b die Kristallgitterebenen 6a, 6d und 6e schneidet. Somit schneiden zwei Modifikationen 9a und 9b obwohl sie Bestandteil derselben linearen Gestalt 103 bzw. Schreiblinie sind, unterschiedliche Kristallgitterebenen. Ferner ist ersichtlich, dass z.B. die Modifikationen 9c und 9d bevorzugt andere, insbesondere mehrheitlich oder vollständig andere, Kristallgitterebenen (6d, 6f, 6g; 6f, 6h, 6i) schneidet als die Modifikation 9a (6a, 6b, 6c).

Die Enden 7 der Kristallgitterebenen 6 auf der Hauptoberfläche 8 bilden in einer mikroskopischen Schnittdarstellung bevorzugt eine Art Sägezahnmuster aus.

Die einzelnen Kristallgitterebenen 6a-6i sind bevorzugt in einem Winkel zwischen 2° und 10°, insbesondere zwischen 3° und 9°, wie z.B. 4° oder 8°, gegenüber der Längsachse L geneigt. Bevorzugt sind die einzelnen Kristallgitterebenen des Spendersubstrats 1 parallel zueinander ausgerichtet.

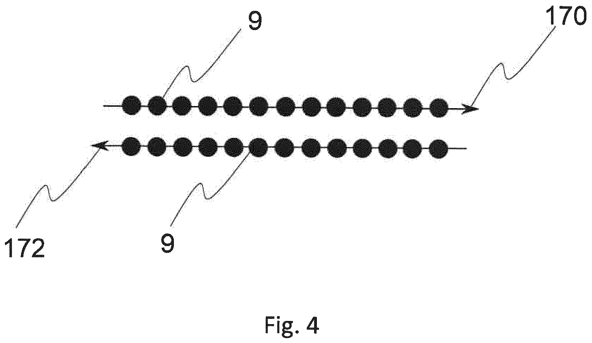

Fig. 4 zeigt eine Illustration eines Beispiels für ein Schreibmuster bei einer X-Y-Bearbeitung:
Pfeile 170, 172 repräsentieren die Laservorschubrichtung, die schwarzen Kreise repräsentieren die unterschiedlichen Laserschüsse bzw. Modifikationen 9, die hier mit ihrer Schadwirkung im Material nicht überlappen. Es ist hierbei bevorzugt, wenn der Laser zunächst in eine Richtung fährt und Modifikationen 9 erzeugt, bevor er umkehrt und Modifikationen 9 in der zweiten (unteren) Richtung schreibt.

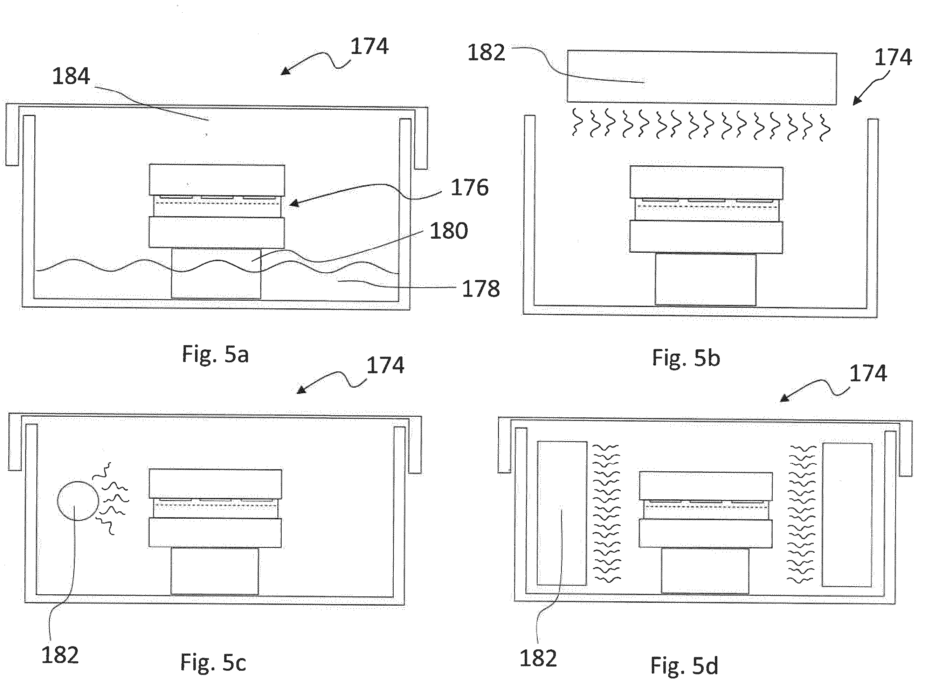

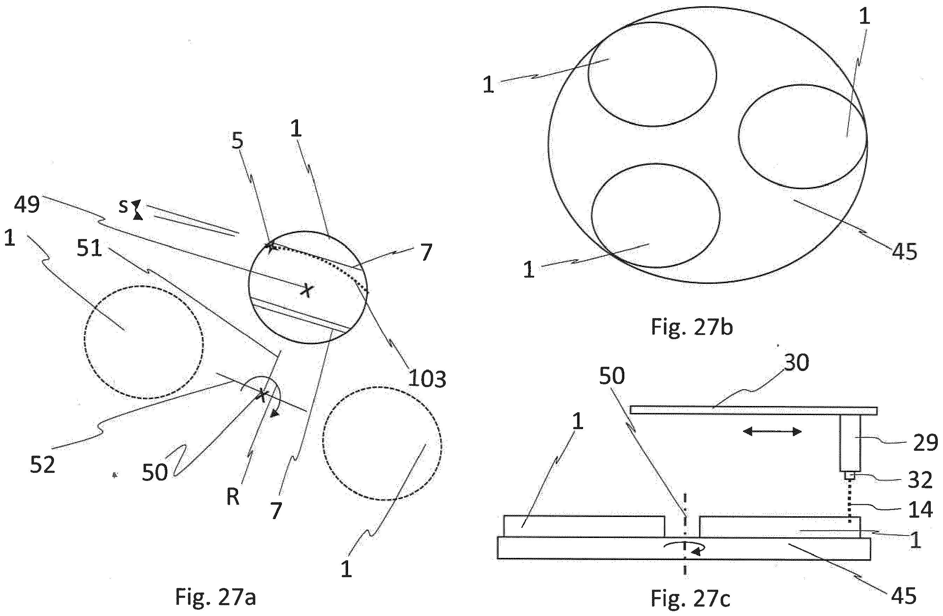

Die Figuren 5a bis 5d zeigen verschiedene Kühleinrichtungen 174. Die in diesen Kühleinrichtungen 174 prozessierten Festkörperanordnungen 176 resultieren aus den verschiedenen in den Figuren 27a bis 27i gezeigten und

19

beschriebenen Ausprägungen bzw. Gestaltungen der mit einer oder mehreren Aufnahmeschicht/en 140, 146 versehenen Festkörper 1. Die hierin gezeigten Kühleinrichtungen 174 verwenden alle zum Kühlen ein verflüssigtes Gas 178 als Ausgangskühlmedium. Dieses Ausgangskühlmedium wird je nach Ausführungsform entweder vernebelt oder verdampft. Bevorzugt handelt es sich bei dem Ausgangskühlmedium um flüssigen Stickstoff. Alternative Kühlverfahren z.B. mittels Piezoelementen sind ebenfalls vorstellbar und möglich.

Die Kühleinrichtung 174 dient dabei bevorzugt zum Abkühlen der Aufnahmeschicht 140, 146 auf eine Temperatur zwischen -85°C und -10°C, insbesondere auf eine Temperatur zwischen -80°C und -50°C.

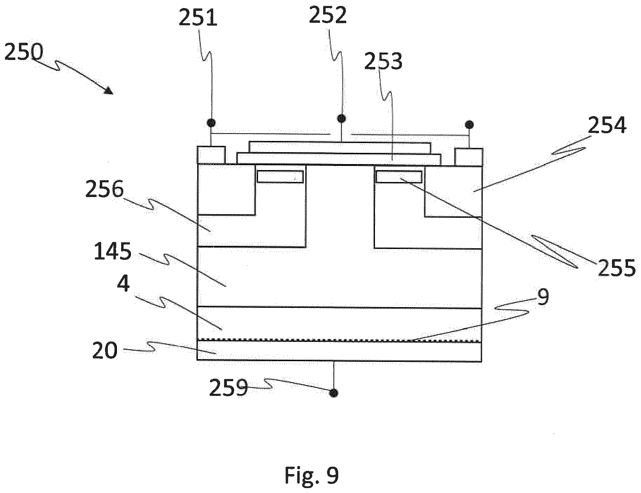

Gemäß Fig. 9a weist die Kühleinrichtung 174 ein Stickstoffbad auf, wobei die Aufnahmeschicht beabstandet, insbesondere mittels einer einstellbaren Positioniereinrichtung 180, zu in dem Stickstoffbad vorgehaltenen flüssigen Stickstoff positioniert wird. Somit wird die Festkörperanordnung bevorzugt auf einer Positioniereinrichtung bzw. auf einer Halterung über einem Stickstoffbad angeordnet. Es resultiert somit ein Temperaturgradient über die Kammerhöhe und die Temperatur an der Festköperanordnung ist über die Füllhöhe mit dem Ausgangskühlmedium oder die Position der Festkörperanordnung 176 (Abstand zum Boden der Kammer) einstellbar.

Gemäß den Ausführungsformen der Figuren 9b bis 9d kann die Kühleinrichtung bevorzugt ein Vernebelungsmittel, insbesondere mindestens oder genau eine perforierte Rohrleitung, zum Vernebeln von flüssigem Stickstoff oder ein Vernebelungsmittel zum Vernebeln von flüssigem Stickstoff aufweisen und die Kühlwirkung durch vernebelten oder verdampften Stickstoff erzeugt werden.

Gemäß Fig. 5b wird bevorzugt ein homogenes Sprühgerät/Nebler zum Sprühen oder Vernebeln bereitgestellt. Das Sprühen oder Vernebeln erfolgt bevorzugt oberhalb der Festkörperanordnung 176. Ferner erfolgen bevorzugt Temperaturmessungen zur Temperaturkontrolle, die Ausgangsdaten zum Regelten eines Ventils, insbesondere Stickstoffventils, ausgeben. Die Temperaturmessungen erfolgen bevorzugt am Substrat bzw. am Festkörper 1 oder an der Aufnahmeschicht 140.

Das Substrat bzw. der Festkörper 1 bzw. die Festkörperanordnung 176 ruht bevorzugt über dem Kammerboden um Stickstoffabsetzen am Boden der Kammer auszuweichen.

Gemäß Fig. 5c wird bevorzugt eine perforierte Rohrleitung als homogenes Sprühgerät verwendet. Ferner erfolgen bevorzugt Temperaturmessungen zur Temperaturkontrolle, die Ausgangsdaten zum Regelten eines Ventils, insbesondere Stickstoffventils, ausgeben. Die Temperaturmessungen erfolgen bevorzugt am Substrat bzw. am Festkörper 1 oder an der Aufnahmeschicht 140.

Das Substrat bzw. der Festkörper 1 bzw. die Festkörperanordnung 176 ruht bevorzugt über dem Kammerboden um Stickstoffabsetzen am Boden der Kammer auszuweichen.

Gemäß Fig. 5d zeigt eine Kühleinrichtung 176 die ein homogenes Sprühgerät/Nebler 182 zum Kühlen von bevorzugt mehreren bzw. jeder Seite aufweist. Ferner erfolgen bevorzugt Temperaturmessungen zur Temperaturkontrolle, die Ausgangsdaten zum Regelten eines Ventils, insbesondere Stickstoffventils, ausgeben. Die Temperaturmessungen erfolgen bevorzugt am Substrat bzw. am Festkörper 1 oder an der Aufnahmeschicht 140.

Das Substrat bzw. der Festkörper 1 bzw. die Festkörperanordnung 176 ruht bevorzugt über dem Kammerboden um Stickstoffabsetzen am Boden der Kammer auszuweichen.

Die Kammer 184 der Kühleinrichtung 174 ist bevorzugt verschlossen um einen Temperaturgradient möglichst durch Isolation zu vermindern.

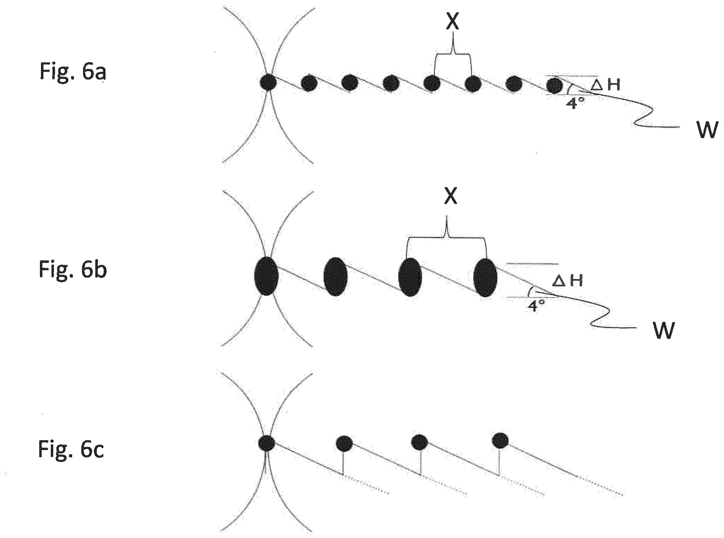

Fig. 6 zeigt drei Beispiele für bevorzugte Zusammenhänge zwischen der Kristallgitterorientierung und der Modifikationserzeugung. Dieses Verfahren ist insbesondere für das Abtrennen von Festkörperschichten von einem aus SIC bestehenden oder SiC aufweisenden Festkörper sinnvoll. Durch diese Zusammenhänge ergibt sich eine weitere Ausführungsform des Verfahrens. Diese weitere Ausführungsform dient bevorzugt zum Abtrennen von mindestens einer Festkörperschicht von mindestens einem Festkörper 1, insbesondere von einem Wafer von einem Ingot oder zum Dünnen eines Wafers. Die weitere Ausführungsform des Verfahrens umfasst dabei bevorzugt mindestens die Schritte: Erzeugung einer Vielzahl an Modifikationen 2 mittels Laserstrahlen im Inneren des Festkörpers 1 zum Ausbilden einer Ablöseebene 4, und Einleiten einer äußeren Kraft in den Festkörper 1 zum Erzeugen von Spannungen in dem Festkörper 1, wobei die äußere Kraft so stark ist, dass die Spannungen eine Rissausbreitung entlang der Ablöseebene 4 bewirkt.

Die Modifikationen werden nacheinander in mindestens einer Zeile oder Reihe oder Linie erzeugt, wobei die in einer Zeile oder Reihe oder Linie erzeugten Modifikationen 2 bevorzugt in einem Abstand X und mit einer Höhe H erzeugt werden, damit ein sich zwischen zwei aufeinander folgenden Modifikationen ausbreitender Riss, insbesondere in Kristallgitterrichtung ausbreitender Riss, dessen Rissausbreitungsrichtung in einem Winkel W gegenüber der Ablöseebene ausgerichtet ist, die beiden Modifikationen miteinander verbindet. Der Winkel W liegt hierbei bevorzugt zwischen 2° und 6°, insbesondere bei 4°. Bevorzugt breitet sich der Riss von einem Bereich unterhalb des Zentrums einer ersten Modifikation hin zu einem Bereich oberhalb des Zentrums einer zweiten Modifikation hin aus. Der hierbei wesentliche Zusammenhang ist daher, dass die Größe der Modifikation in Abhängigkeit des Abstands der Modifikationen und des Winkels W verändert werden kann bzw. muss.

Ferner kann dieses Verfahren auch den Schritt des Erzeugens einer Kompositstruktur durch Anordnen oder Erzeugen von Schichten und/oder Bauteilen 150 an oder oberhalb einer zunächst freiliegenden Oberfläche des Festkörpers 1 aufweisen, wobei die freiliegende Oberfläche bevorzugt Bestandteil der abzutrennenden Festkörperschicht ist. Besonders bevorzugt werden die Modifikationen zum Ausbilden der Ablöseebene 4 vor der Erzeugung der Kompositstruktur erzeugt.

Zum Einleiten der äußeren Kraft kann z.B. analog zu den zuvor beschriebenen Verfahren eine Aufnahmeschicht 140 an einer freiliegenden Oberfläche der Kompositstruktur bzw. des Festkörpers angeordnet werden.

Die drei Abbildungen 6a bis 6c sollen verdeutlichen, wie die Größe der durch Laser amorphisierten/phasenumgewandelten Schad-/Modifikationszone die vom Sägezahnmuster des Risses durchlaufene Höhe beeinflusst. Generell läuft der Riss entlang der Kristallebenen also zwischen einzelnen Atomen des Kristalls. In der modifizierten Zone sind diese klaren Ebenen nicht mehr existent, der kommt also zum Halt.

Durch eine bevorzugt möglichst hohe numerische Apertur kann die Schadzone entlang der Strahlrichtung verkleinert werden, wie auch lateral in der Brennebene. Da nur die Schwellintensität erreicht werden muss, genügt hier dann auch eine kleinere Pulsenergie.

Wenn nun die Schadzone geeigneter Weise kleiner ausgebildet ist, so können die Lasermodifikationen dichter gesetzt werden, was den Sägezahn kürzer laufen lässt und insgesamt eine geringere Höhenausdehnung der modifizierten Ebene bedingt (erstes Bild).

Ist die Schadzone hingegen größer ausgebildet (höhere Energie und/oder niedrigere numerische Apertur - Fig. 6b) - wird durch den erhöhten Druck der amorphisierten Zone auch ein größerer Mikroriss ausgelöst, den einzufangen (d.h. kontrolliert zu stoppen) man mit einer Schadzone größerer Ausdehnung in größerem Abstand ermöglicht.

Fig. 6c schließlich zeigt die Gefahr auf, wenn die Schadzone nicht ausreichend groß ist und zu weit laufende Risse durch die Lasermodifikation ausgelöst werden, die Risse laufen zum einen zu weit - d.h. der durch die Risse entstandene Höhenunterschied wird größer als gewünscht - und zum anderen werden die Risse unter den weiteren Schadzonen hindurchgetrieben und nicht vom amorphisierten Material gestoppt. Dies führt dann wieder zu Materialverlusten, da alle eingerissenen Materialschichten für das Endprodukt oder eine erneute Laserbearbeitung entfernt werden müssen.

Fig. 7 zeigt eine schematisch dargestellte Momentaufnahme aus einem Verfahren gemäß einer weiteren Ausführungsform. Die weitere Ausführungsform des Verfahrens dient bevorzugt zum Abtrennen von mindestens einer Festkörperschicht von mindestens einem Festkörper 1, insbesondere von einem Wafer von einem Ingot oder zum Dünnen eines Wafers. Die weitere Ausführungsform des Verfahrens umfasst dabei bevorzugt mindestens die Schritte: Erzeugung einer Vielzahl an Modifikationen 2 mittels Laserstrahlen im Inneren des Festkörpers 1 zum Ausbilden einer Ablöseebene 4, und Einleiten einer äußeren Kraft in den Festkörper 1 zum Erzeugen von Spannungen in dem Festkörper 1, wobei die äußere Kraft so stark ist, dass die Spannungen eine Rissausbreitung entlang der Ablöseebene 4 bewirkt.

In einem ersten Schritt werden die Modifikationen auf einer Linie 103 und bevorzugt im gleichen Abstand zueinander erzeugt. Weiterhin ist vorstellbar dass eine Vielzahl dieser im ersten Schritt erzeugten Linien erzeugt werden. Diese ersten Linien werden besonders bevorzugt parallel zur Rissausbreitungsrichtung und bevorzugt geradlinig oder kreisbogenförmig, insbesondere in derselben Ebene, erzeugt. Nach der Erzeugung dieser ersten Linien werden bevorzugt zweite Linien 105 zum Auslösen und/oder Treiben von bevorzugt unterkritischen Rissen erzeugt. Diese zweiten Linien werden ebenfalls bevorzugt geradlinig erzeugt. Besonders bevorzugt sind die zweiten Linien gegenüber den ersten Linien geneigt, insbesondere orthogonal ausgerichtet. Die zweiten Linien erstrecken sich bevorzugt in derselben Ebene wie die ersten Linien oder besonders bevorzugt in einer Ebene die parallel zu der Ebene ist, in der sich die ersten Linien erstrecken. Anschließende werden bevorzugt dritte Linien erzeugt zum Verbinden der unterkritischen Risse erzeugt.

Dieses Verfahren ist insbesondere für das Abtrennen von Festkörperschichten von einem aus SIC bestehenden oder SiC aufweisenden Festkörper bzw. Spendersubstrat sinnvoll.

Ferner können die Modifikationen nacheinander in mindestens einer Zeile oder Reihe oder Linie erzeugt werden, wobei die in einer Zeile oder Reihe oder Linie erzeugten Modifikationen 9 bevorzugt in einem Abstand X und mit einer Höhe H erzeugt werden, damit ein sich zwischen zwei aufeinander folgenden Modifikationen ausbreitender Riss, insbesondere in Kristallgitterrichtung ausbreitender Riss, dessen Rissausbreitungsrichtung in einem Winkel W gegenüber der Ablöseebene ausgerichtet ist, die beiden Modifikationen miteinander verbindet. Der Winkel W liegt hierbei bevorzugt zwischen 2° und 6°, insbesondere bei 4°. Bevorzugt breitet sich der Riss von einem Bereich unterhalb des Zentrums einer ersten Modifikation hin zu einem Bereich oberhalb des Zentrums einer zweiten Modifikation hin aus. Der hierbei wesentliche Zusammenhang ist daher, dass die Größe der Modifikation in Abhängigkeit des Abstands der Modifikationen und des Winkels W verändert werden kann bzw. muss.

Ferner kann dieses Verfahren auch den Schritt des Erzeugens einer Kompositstruktur durch Anordnen oder Erzeugen von Schichten und/oder Bauteilen 150 an oder oberhalb einer zunächst freiliegenden Oberfläche des Festkörpers 1 aufweisen, wobei die freiliegende Oberfläche bevorzugt Bestandteil der abzutrennenden Festkörperschicht ist. Besonders bevorzugt werden die Modifikationen zum Ausbilden der Ablöseebene vor der Erzeugung der Kompositstruktur erzeugt.

Zum Einleiten der äußeren Kraft kann z.B. analog zu den zuvor beschriebenen Verfahren eine Aufnahmeschicht 140 an einer freiliegenden Oberfläche der Kompositstruktur bzw. des Festkörpers angeordnet werden.

Somit werden im Laserverfahren gemäß einer Ausführungsform bevorzugt auf SiC (aber auch anderen Materialien) Linien parallel zur Rissausbreitungsrichtung (bevorzugt Querlinien genannt) erzeugt, um zunächst eine Ebene für die bevorzugte Rissauslösung zu definieren (Rissinitialisierung), bevor Längslinien die Risse treiben. Hierbei werden die Risse erst quer, dann längs initialisiert, bevor ein finaler Schritt Linien zwischen die Längslinien des zweiten Schritts setzt um die Risse vollflächig auszulösen. Dies ermöglicht kürzere Risslaufwege, was die finale Oberflächenrauheit minimiert.

Beispielbild für Querlinien (mit dem Sägezahn) und Rissauslöselinien (auf den Wellenkämmen des Sägezahns).

Somit bezieht sich eine Ausführungsform der vorliegenden Erfindung auf ein Verfahren zum Abtrennen von mindestens einer Festkörperschicht 2 von einem Spendersubstrat 1. Das Verfahren umfasst dabei bevorzugt mindesten die Schritte: Bereitstellen des Spendersubstrats 1, wobei das Spendersubstrat 1 Kristallgitterebenen 6 aufweist, die gegenüber einer ebenen Hauptoberfläche 8 geneigt sind, wobei die Hauptoberfläche 8 das Spendersubstrat 1 in Längsrichtung des Spendersubstarts 1 einerseits begrenzt, wobei sich eine Kristallgitterebenennormale gegenüber einer Hauptoberflächennormalen in eine erste Richtung neigt, Bereitstellen von mindestens einem Laser 29, Einbringen von Laserstrahlung 14 des Lasers 29 in das Innere des Festkörpers 1 über die Hauptoberfläche (8) zum Verändern der Materialeigenschaften des Festkörpers 1 im Bereich von mindestens einem Laserfokus, wobei der Laserfokus durch von dem Laser emittierten Laserstrahlen des Lasers gebildet wird, wobei die Veränderung der Materialeigenschaft durch Verändern des Eindringortes der Laserstrahlung in das Spendersubstrat 1 eine linienförmige Gestalt 103 ausbildet, wobei die Veränderungen der Materialeigenschaft auf mindestens einer Erzeugungsebene 4 erzeugt werden, wobei die Kristallgitterebenen 6 des Spendersubstrats 1 gegenüber der Erzeugungsebene 4 geneigt ausgerichtet sind, wobei die linienförmige Gestalt 103 gegenüber einer sich an der Schnittstelle zwischen der Erzeugungsebene 4 und der Kristallgitterebene 6 ergebenden Schnittlinie 10 geneigt ist, wobei durch die veränderte Materialeigenschaft das Spendersubstrat 1 in Form von unterkritischen Rissen einreißt, Abtrennen der Festkörperschicht 2 durch Einleiten einer äußeren Kraft in das Spendersubstrat 1 zum Verbinden der unterkritischen Risse oder so viel Material auf der Erzeugungsebene 4 mittels der Lasterstrahlung verändert wird, dass sich unter Verbindung der unterkritischen Risse die Festkörperschicht 2 von dem Spendersubstart 1 ablöst.

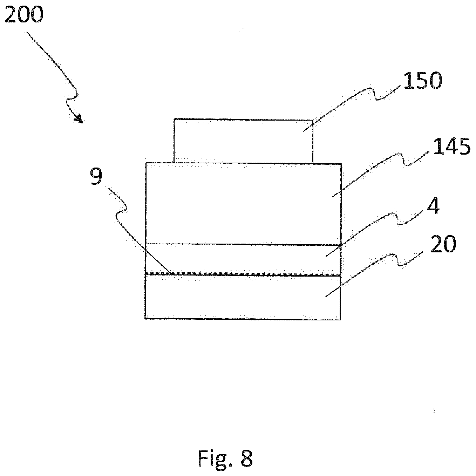

Fig. 8 zeigt exemplarisch eine Schottky Diode 200. Diese Diode 200 weist dabei bevorzugt eine Festkörperschicht 4 auf, die wiederum mittels Laserstrahlung modifizierte Anteile, insbesondere Modifikationen 9, aufweist. Die Modifikationen 9 sind hierbei in der Nähe einer ersten Oberfläche der Festkörperschicht 4 erzeugt. An dieser ersten Oberfläche der Festkörperschicht 4 ist dabei bevorzugt eine Metallschicht 20, insbesondere mittels Sputtern oder chemischer Abscheidung, erzeugt worden. Die Festkörperschicht 4 weist gegenüber der ersten Oberfläche eine zweite Oberfläche auf, an der, insbesondere mittels eines Epitaxiverfahrens, eine weitere Schicht 145 erzeugt ist. Die Festkörperschicht 4 besteht dabei bevorzugt aus hochdotiertem SiC bzw. weist hochdotiertes SiC auf und die erzeugte Schicht 145 besteht bevorzugt aus schwach dotiertem SiC oder weist schwach dotiertes SiC auf. Schwachdotiert bedeutet hierbei bevorzugt weniger dotiert als hochdotiert. Somit weist die erzeugte Schicht 145 bevorzugt je Volumeneinheit weniger Dotierung auf als die Festkörperschicht 4. Das Bezugszeichen 150 kennzeichnet einen Schottkykontakt.

Fig. 9 zeigt exemplarisch den Aufbau eines MOSFETs 250. Dieser MOSFET 250 weist dabei bevorzugt eine Festkörperschicht 4 auf, die wiederum mittels Laserstrahlung modifizierte Anteile, insbesondere Modifikationen 9, aufweist. Die Modifikationen 9 sind hierbei in der Nähe einer ersten Oberfläche der Festkörperschicht 4 erzeugt. An dieser ersten Oberfläche der Festkörperschicht 4 ist dabei bevorzugt eine Metallschicht 20, insbesondere mittels Sputtern oder chemischer Abscheidung, erzeugt worden. Die Metallschicht 20 bildet dabei bevorzugt über einen Anschluss 259 einen Drain (high) aus. Die Festkörperschicht 4 weist gegenüber der ersten Oberfläche eine zweite Oberfläche auf. An der zweiten Oberfläche ist eine weitere Schicht, insbesondere n type SiC, ausgebildet, insbesondere erzeugt oder angeordnet. Das Bezugszeichen 256 kennzeichnet eine weitere Material bzw. Element, insbesondere p type SiC. Das Bezugszeichen 254 steht für n+. Das Bezugszeichen 255 kennzeichnet bevorzugt einen oder mehrere Kanäle, insbesondere zum Leiten des Stroms. Die mit dem Bezugszeichen 253 gekennzeichnete Lage/Sicht besteht bevorzugt aus SiO2 oder weist solches auf. Das Bezugszeichen 251 kennzeichnet eine Quelle (low) und das Bezugszeichen 252 kennzeichnet ein Gate.

Eine Ausführungsform der vorliegenden Erfindung kann sich somit auf ein Verfahren zum Bereitstellen von mindestens einer Festkörperschicht 4 beziehen, wobei die Festkörperschicht 4 von einem Festkörper 1 abgetrennt wird. Ein Verfahren gemäß einer solchen Ausführungsform umfasst dabei mindestens die Schritte: Erzeugung einer Vielzahl an Modifikationen 9 mittels Laserstrahlen im Inneren des Festkörpers 1 zum Ausbilden einer Ablöseebene 8, wobei durch die Modifikationen 9 Druckspannungen im Festkörper 1 erzeugt werden, Abtrennen der Festkörperschicht 4 durch eine Separation des verbleibenden Festkörpers 1 und der Festkörperschicht 4 entlang der durch die Modifikationen 9 ausgebildeten Ablöseebene 8, wobei zumindest Bestandteile der die Druckspannungen erzeugenden Modifikationen 9 an der Festkörperschicht 4 verbleiben, wobei so viele Modifikationen 9 erzeugt werden, dass sich die Festkörperschicht 4 aufgrund der Modifikationen 9 vom Festkörper 1 ablöst oder wobei einer äußeren Kraft in den Festkörper 1 zum Erzeugen von weiteren Spannungen in dem Festkörper 1 eingeleitet wird, wobei die äußere Kraft so stark ist, dass die Spannungen eine Rissausbreitung entlang der durch die Modifikationen ausgebildeten Ablöseebene 8 bewirken, Erzeugen einer Metallschicht an der durch die Abtrennung der Festkörperschicht 4 von dem Festkörper 1 freigelegten Oberfläche zum zumindest teilweisen und bevorzugt mehrheitlichen und besonders bevorzugt vollständigen Kompensieren einer durch die Druckspannungen der verbleibenden Modifikationsbestandteile bewirkten Verformung der Festkörperschicht 4 oder zum zumindest teilweisen und bevorzugt mehrheitlichen oder vollständigen Kompensieren der Druckspannungen

Eine Ausführungsform der vorliegenden Erfindung bezieht sich auf ein Verfahren zum Erzeugen von elektrischen Komponenten. Dieses Verfahren umfasst bevorzugt die Schritte Erzeugung einer Vielzahl an Modifikationen 9 mittels Laserstrahlen im Inneren eines Festkörpers 1 zum Ausbilden einer Ablöseebene 8, wobei durch die Modifikationen 9 Druckspannungen im Festkörper 1 erzeugt werden, Erzeugen einer Kompositstruktur durch Anordnen oder Erzeugen von Schichten und/oder Bauteilen 150 an oder oberhalb einer zunächst freiliegenden Oberfläche 5 des Festkörpers 1, wobei die freiliegende Oberfläche 5 Bestandteil der abzutrennenden Festkörperschicht 4 ist, Abtrennen der Festkörperschicht 4 durch eine Separation des verbleibenden Festkörpers 1 und der Festkörperschicht 4 entlang der durch die Modifikationen 9 ausgebildeten Ablöseebene 8, wobei zumindest Bestandteile der die Druckspannungen erzeugenden Modifikationen 9 an der Festkörperschicht 4 verbleiben, wobei so viele Modifikationen 9 erzeugt werden, dass sich die Festkörperschicht 4 aufgrund der Modifikationen 9 vom Festkörper 1 ablöst oder wobei einer äußeren Kraft in den Festkörper 1 zum Erzeugen von weiteren Spannungen in dem Festkörper 1 eingeleitet wird, wobei die äußere Kraft so stark ist, dass die Spannungen eine Rissausbreitung entlang der durch die Modifikationen ausgebildeten Ablöseebene 8 bewirken, Erzeugen einer Metallschicht 20 an der durch die Abtrennung der Festkörperschicht 4 von dem Festkörper 1 freigelegten Oberfläche zum zumindest teilweisen Kompensieren der durch Modifikationsbestandteile bewirkten Druckspannungen.

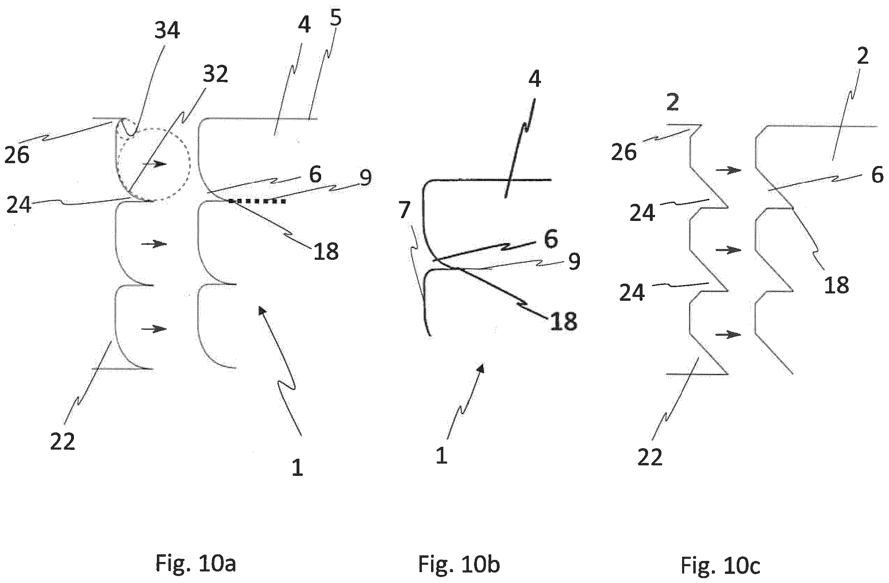

Fig. 10a zeigt eine Darstellung, die ein Schleifwerkzeug 22 mit einer bestimmten Kontur zeigt. Wird in Bezug auf das Schleifwerkzeug von einem ebenen, geraden oder gebogenen Anteil gesprochen, dann ist damit immer ein Anteil der gezeigten Kontur zu verstehen. Selbstverständlich kann das Schleifwerkzeug 22 z.B. als ein Rotationsschleifwerkezeug ausgebildet sein, wodurch sich die an die Kontur in Umfangsrichtung anschließenden Anteile in Umfangsrichtung bevorzugt gebogen erstrecken würden. Das in der ersten Darstellung der Fig. 10a gezeigte Schleifwerkzeug 22 weist einen ersten Bearbeitungsanteil 24 auf, der eine gebogene Hauptschleiffläche 32 aufweist, und weist einen zweiten Bearbeitungsanteil 26 auf, der eine gebogene Nebenschleiffläche 34 aufweist, wobei der Radius der Hauptschleiffläche 32 größer ist als der Radius der Nebenschleiffläche 34, bevorzugt ist der Radius der Hauptschleiffläche 32 mindestens doppelt, dreifach, vierfach oder fünffach so groß, wie der Radius der Nebenschleiffläche 34.

Es wird somit zusätzlich oder alternativ ein Verfahren zum Abtrennen von mindestens einer Festkörperlage 4, insbesondere einer Festkörperscheibe oder Festkörperschicht, von einem Spendersubstrat 1 oder Festkörper bereitgestellt. Im Rahmen der vorliegenden Schutzrechtsschrift können die Begriffe Spendersubstrat und Festkörper bevorzugt synonym verwendet werden. Dieses Verfahren umfasst dabei bevorzugt die Schritte: Bereitstellen eines Spendersubstrats 1, Erzeugen von Modifikationen 9 im Inneren des Spendersubstrats 1 mittels LASER-Strahlen, wobei durch die Modifikationen 9 ein Ablösebereich vorgegeben wird, entlang dem eine Abtrennung der Festkörperlage von dem Spendersubstrat 1 erfolgt, Abtragen von Material des Spendersubstrats 1 ausgehend von einer sich in Umfangsrichtung des Spendersubstrats 1 erstreckenden Oberfläche in Richtung Zentrum (Z) des Spendersubstrats 1, insbesondere zum Erzeugen einer umlaufenden Vertiefung, wobei durch den Materialabtrag der Ablösebereich 8 bzw. eine Ablöseebene freigelegt wird, Abtrennen der Festkörperlage 4 von dem Spendersubstrat 1, wobei das Spendersubstrat im Ablösebereich durch die Modifikationen derart geschwächt wird, dass sich die Festkörperlage 4 infolge des Materialabtrags von dem Spendersubstrat 1 ablöst oder nach dem Materialabtrag eine solche Anzahl an Modifikationen 9 erzeugt wird, dass das Spendersubstrat 1 im Ablösebereich derart geschwächt wird, dass sich die Festkörperlage 4 von dem Spendersubstrat 1 ablöst oder eine Spannungserzeugungsschicht 140 bzw. Aufnahmeschicht an einer zur umlaufenden Oberfläche geneigt ausgerichteten, insbesondere ebenen, Oberfläche des Spendersubstrats 1 erzeugt oder angeordnet wird und durch ein thermisches Beaufschlagen der Spannungserzeugungsschicht 140 mechanische Spannungen in dem Spendersubstrat 1 erzeugt werden, wobei durch die mechanischen Spannungen ein Riss zum Abtrennen einer Festkörperlage 4 entsteht, der sich ausgehend von der durch den Materialabtrag freigelegten Oberfläche des Spendersubstrats entlang der Modifikationen 9 ausbreitet. Es ist hierbei möglich, dass die Modifikationen 9 teilweise oder vollständig vor dem Materialabtrag oder nach dem Materialabtrag erzeugt werden. Die Vertiefung 6 wird somit bevorzugt in Richtung Zentrum Z bis zu einem Vertiefungsende 18 hin enger. Bevorzugt verläuft die Vertiefung keilförmig, wobei das Vertiefungsende 18 bevorzugt genau in der Ebene liegt, in der sich der Riss ausbreitet oder in der die Modifikationen 9 erzeugt werden. Weiterhin ist es möglich, dass eine Kompositstruktur durch Anordnen oder Erzeugen von Schichten und/oder Bauteilen 150 an oder oberhalb einer zunächst freiliegenden Oberfläche 5 des Festkörpers 1 erzeugt wird, wobei die freiliegende Oberfläche 5 Bestandteil der abzutrennenden Festkörperschicht 4 ist. Die Modifikationen 9 zum Ausbilden der Ablöseebene 8 werden dabei bevorzugt vor der Erzeugung der Kompositstruktur erzeugt.

Nach der Erzeugung der Kompositstruktur erfolgt bevorzugt das Einleiten einer äußeren Kraft in den Festkörper 1 zum Erzeugen von Spannungen in dem Festkörper 1, wobei die äußere Kraft so stark ist, dass die Spannungen eine Rissausbreitung entlang der Ablöseebene 8 bewirkt.

Fig. 10b zeigt eine Darstellung, gemäß der die in Fig. 10a gezeigten Modifikationen 9, die insbesondere amorphe Anteile des Kristallgitters darstellen, ätzend behandelt wurden. Es erfolgt somit bevorzugt eine Ätzbehandlung nicht kristalliner Bestandteile des Festkörpers 1, während die kristallinen Bestandteile des Festkörpers nicht oder im Wesentlichen nicht durch die Ätzbehandlung verändert werden. Es wird somit bevorzugt der Effekt ausgenutzt, dass Ätzverfahren selektiv auf kristallin - nicht kristalline Bereiche eingestellt werden können. Das Bezugszeichen 19 kennzeichnet somit einen Bereich, in dem die Festkörperschicht 4 durch eine Ätzbehandlung von Modifikationen 9 vom verbleibenden Restfestkörper abgetrennt ist. Diese Lösung ist vorteilhaft, da die mechanische Rissöffnung durch das Ätzen bzw. Anätzen tiefer in den Kristall geführt wird. Dies schafft einen genauer definierten Rissanfang. Bevorzugt gilt, je dünner und je tiefer sich die Vertiefung bzw. Kerbe in das Innere des Festkörpers hinein erstreckt, desto besser ist das hinsichtlich der Oberflächengüte einer infolge einer Abspaltung der Festkörperschicht freigelegten Oberfläche. Die Ätzparameter werden dabei bevorzugt derart gewählt, dass nicht amorphe Anteile, insbesondere eine eventuell polierten Oberseite 5 und/oder der nicht modifizierte Rand 7 nicht geätzt werden. Somit kann das Verfahren nach einer Ausführungsform, insbesondere hinsichtlich des in Fig. 10a beschriebenen Verfahrens, z.B. um den Schritt einer ätzenden Behandlung bzw. ätzenden Entfernung von den Ablösebereich zumindest abschnittsweise vorgebenden Modifikationen 9 ergänzt werden. Der Festkörper 1, insbesondere vor einer Erzeugung einer Kompositstruktur, besteht dabei bevorzugt aus SiC oder weist SiC auf. Bevorzugt weist der Festkörper mindestens 95% (massenmäßig) oder mindestens 99% (massenmäßig) oder mindestens 99,99% (massenmäßig) SiC auf.

Es wird ferner darauf hingewiesen, dass der Materialabtrag am Rand des Festkörpers, insbesondere mit nachfolgendem Ätzschritt, bei jedem mit dieser Schutzrechtsschrift offenbarten Verfahren ergänzbar ist.

Gemäß der dritten Darstellung, der Fig. 10c, weist der erste Bearbeitungsanteil 24 des Schleifwerkzeugs 22 eine gerade Hauptschleiffläche 32 auf und der zweite Bearbeitungsanteil 26 weist eine gerade Nebenschleiffläche 34 auf, wobei mittels der Hauptschleiffläche 32 mehr Material als mit der Nebenschleiffläche 34 von dem Spendersubstrat 2 entfernt wird.

Fig. 11 zeigt fünf Darstellungen, die Beispiele für die Festkörperscheibenherstellung bzw.

Waferherstellung gemäß Ausführungsformen des vorliegenden Verfahrens zeigen, die nicht von der vorliegenden Erfindung abgedeckt sind.

Darstellung 1 zeigt dabei ein Schleifwerkzeug 22, das zwei zueinander beabstandete Bearbeitungsanteile 24 aufweist, die jeweils eine Hauptschleiffläche 32 ausbilden. Die Hauptschleifflächen 32 sind dabei so ausgebildet, dass sie in einem Spendersubstrat 2 Vertiefungen 6 erzeugen. Das Schleifwerkzeug 22 ist bevorzugt als Rotationsschleifwerkzeug oder als Bandschleifwerkzeug ausgebildet.

Darstellung 2 der Fig. 11 zeigt ein Spendersubstrat 2, in dem mittels des Schleifwerkzeugs 22 Vertiefungen 6 erzeugt wurden. Die Vertiefungen 6 sind dabei in Längsrichtung des Spenderwafers 2 bevorzugt gleichmäßig zueinander beabstandet, wobei auch denkbar, ist, dass die Abstände unterschiedlich groß sind. Gemäß der zweiten Darstellung in Fig. 2 werden ferner mittels einer LASER-Einrichtung 46 Modifikationen 10 im Spendersubstrat 2 erzeugt. Die LASER-Einrichtung 46 emittiert dazu LASER-Strahlen 12, die über eine bevorzugt ebene Oberfläche 16 des Spendersubstrats 2 in das Spendersubstrat 2 eindringen und an einem Fokuspunkt 48, insbesondere durch eine Mehrphotonenanregung, eine Modifikation 10 der Gitterstruktur des Festkörpers bzw. des Spendersubstrats 2 erzeugt bzw. bewirkt. Die Modifikation 10 stellt hierbei bevorzugt eine Materialumwandlung, insbesondere eine Überführung des Materials in eine andere Phase, oder eine Materialzerstörung dar.

Die dritte Darstellung zeigt, dass eine Spannungserzeugungsschicht 14 an der Oberfläche 16, über welche die LASER-Strahlen 12 zum Erzeugen der Modifikationen 10 in das Spendersubstrat 2 eingeleitet wurden, erzeugt oder angeordnet wurde. Die Spannungserzeugungsschicht 14 wird zum Erzeugen von mechanischen Spannungen im Spendersubstrat 2 thermisch beaufschlagt bzw. temperiert, insbesondere abgekühlt. Durch das thermische Beaufschlagen der Spannungserzeugungsschicht 14, zieht sich die Spannungserzeugungsschicht 14 zusammen, wodurch sich die mechanischen Spannungen in dem Spendersubstrat 2 ergeben. Die zuvor erzeugten Vertiefungen 6 bilden dabei Kerben aus, durch welche die mechanischen Spannungen derart geleitet werden können, dass sich der durch die Spannungen ergebende Riss 20 gezielt in dem durch die Modifikationen 10 vorgegebenen Rissführungsbereich ausbreitet. Die Vertiefungsenden 18 grenzen daher bevorzugt an dem jeweiligen durch die Modifikationen 10 vorgegebenen Rissführungsbereich an. Bevorzugt wird immer nur genau die Festkörperschicht 1 abgespaltet, deren Vertiefung 6 am wenigsten zur Spannungserzeugungsschicht 14 beabstandet ist.

Die Darstellung 4 zeigt einen Zustand, nach erfolgter Rissausbreitung. Die Festkörperscheibe 1 ist von dem Spendersubstrat 2 abgespalten und die Spannungserzeugungsschicht 14 verbleibt zunächst weiterhin an der Oberfläche 16 der Festkörperscheibe 1.

Das Bezugszeichen 28 kennzeichnet, welche Seite der Festkörperscheibe 1 hier als Unterseite der Festkörperscheibe 1 bezeichnet ist und das Bezugszeichen 30 kennzeichnet, welche Seite der Festkörperscheibe 1 hier als Oberseite der Festkörperscheibe 1 bezeichnet ist.

Die Darstellung 5 zeigt ein Verfahren, bei dem ohne eine Spannungserzeugungsschicht 14 eine Ablösung der Festkörperschicht 1 vom Spendersubstrat 2 bewirkt wird. Es werden hierbei bevorzugt nach der Erzeugung der Vertiefung 6 so viele Modifikationen 10 mittels LASER-Strahlen 12 erzeugt, dass sich die Festkörperschicht 1 vom Spendersubstrat 2 ablöst. Die gestrichelte Linie Z kennzeichnet hierbei bevorzugt ein Zentrum bzw. eine Rotationsachse des Spendersubstrats 2. Das Spendersubstrat 2 ist bevorzugt um die Rotationsachse Z rotierbar.

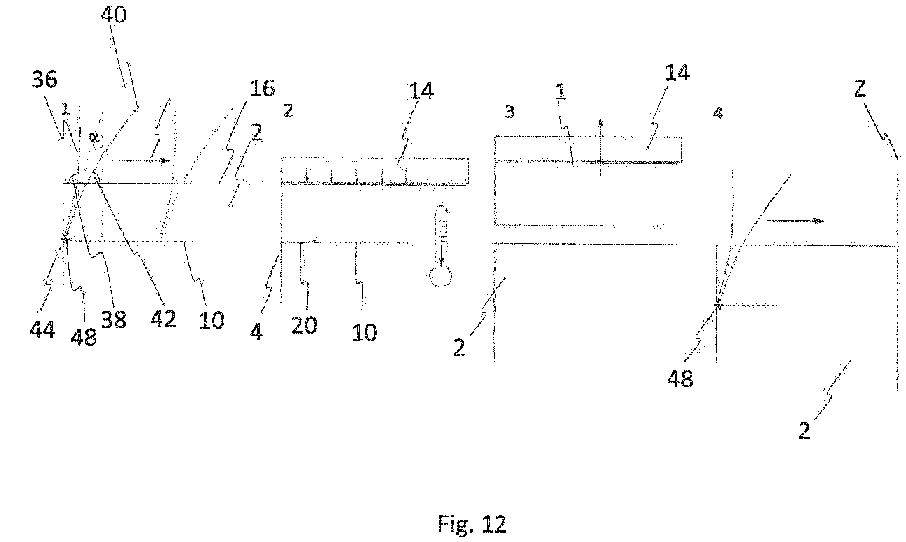

Fig. 12 zeigt 4 Darstellungen. In der ersten Darstellung der Fig. 12 ist ein Spendersubstrat 2 gezeigt, dass mit LASER-Strahlen 12 beaufschlagt wird. Die LASER-Strahlen 12 sind in ihrer Gesamtheit derart gegenüber der Oberfläche 16, über die die LASER-Strahlen in das Spendersubstrat 2 eindringen, geneigt, dass die Neigung von einem 90° Winkel abweicht. Bevorzugt ist ein erster Anteil 36 an LASER-Strahlen 12 gegenüber der Oberfläche 16 in einem ersten Winkel 38 orientiert und ein weiterer Anteil 40 an LASER-Strahlen 12 ist gegenüber der Oberfläche 16 in einem zweiten Winkel 42 orientiert. Die LASER-Strahlanteile 36 und 40 sind bevorzugt zur Erzeugung aller zur Abtrennung einer bestimmten Festkörperschicht 1 erzeugten Modifikationen 12 gegenüber der Oberfläche 16, über die die LASER-Strahlenanteile 36, 40 in das Spendersubstrat 2 eindringen, bevorzugt stets identisch geneigt. Es kann der ersten Darstellung der Fig. 4 ferner entnommen werden, dass der Fokuspunkt 48 zum Erzeugen von Modifikationen 10 aufgrund der geneigten LASER-Strahlanteile 36, 40 in dem Spendersubstrat 2 bis zum Rand 44 oder unmittelbar bis zum Rand 44 geführt werden kann.

Der Darstellung 2 der Fig. 12 lässt sich ferner entnehmen, dass gemäß der geneigt ausgerichteten LASER-Strahlanteile 36, 40 eine materialabtragende Behandlung des Rands 44 des Spendersubstrats 2 nicht oder nur deutlich reduziert erforderlich ist. Die an der Oberfläche 16 angeordnete oder erzeugte Spannungserzeugungsschicht 14 bewirkt eine Erzeugung mechanischer Spannungen in dem Spendersubstrat 2, wodurch sich aufgrund der bis zum Rand 44 erzeugten Modifikationen 10 ein Riss 20 sehr präzise geführt vom Rand 44 in das Spendersubstrat 2 hineinausbreitet.

Der Darstellung 3 der Fig. 12 zeigt eine vollständig vom Spendersubstrat 2 abgespaltete Festkörperscheibe 1, wobei die Festkörperscheibe 1 gemäß dieser Ausführungsform bevorzugt keine Kantenbehandlung erfahren hat.

Darstellung 4 der Fig. 12 deutet an, dass ebenfalls durch das Erzeugen von Modifikationen 10 mittels LASER-Strahlen 36, 40 (ohne eine Spannungserzeugungsschicht 14) eine Festkörperscheibe 1 von dem Spendersubstrat 2 entfernbar ist.

Eine Ausführungsform bezieht sich somit auf ein Verfahren zum Abtrennen von Festkörperscheiben 1 von einem Spendersubstrat 2. Ein solches Verfahren, das nicht von der vorliegenden Erfindung abgedeckt ist, umfasst dabei die Schritte:
Bereitstellen eines Spendersubstrats 2, Erzeugen von Modifikationen 10 im Inneren des Spendersubstrats 2 mittels LASER-Strahlen 12, wobei die LASER-Strahlen 12 über eine ebene Oberfläche 16 des Spendersubstrats 2 in das Spendersubstrat 2 eindringen, wobei die Gesamtheit der LASER-Strahlen 12 derart gegenüber der ebenen Oberfläche 16 des Spendersubstrats 2 geneigt ist, dass ein erster Anteil 36 der LASER-Strahlen 12 in einem ersten Winkel 38 zur ebenen Oberfläche 16 des Spendersubstrats 2 in das Spendersubstrat 2 eindringt und mindestens ein weiterer Anteil 40 der LASER-Strahlen 12 in einem zweiten Winkel 42 zur eben Oberfläche 16 des Spendersubstrats 2 in das Spendersubstrat 2 eindringt, wobei sich der Betrag des ersten Winkels 38 von dem Betrag des zweiten Winkels 42 unterscheidet, wobei der erste Anteil 36 der LASER-Strahlen 12 und der weitere Anteil 40 der LASER-Strahlen 12 zum Erzeugen der Modifikation 10 im Spendersubstrat 2 fokussiert werden, wobei sich die Festkörperscheibe 1 durch die erzeugten Modifikationen 10 von dem Spendersubstrat 2 ablöst oder eine Spannungserzeugungsschicht 14 an der ebenen Oberfläche 16 des Spendersubstrats 2 erzeugt oder angeordnet wird und durch ein thermisches Beaufschlagen der Spannungserzeugungsschicht 14 mechanische Spannungen in dem Spendersubstrat 2 erzeugt werden, wobei durch die mechanischen Spannungen ein Riss 20 zum Abtrennen einer Festkörperschicht 1 entsteht, der sich entlang der Modifikationen 10 ausbreitet.

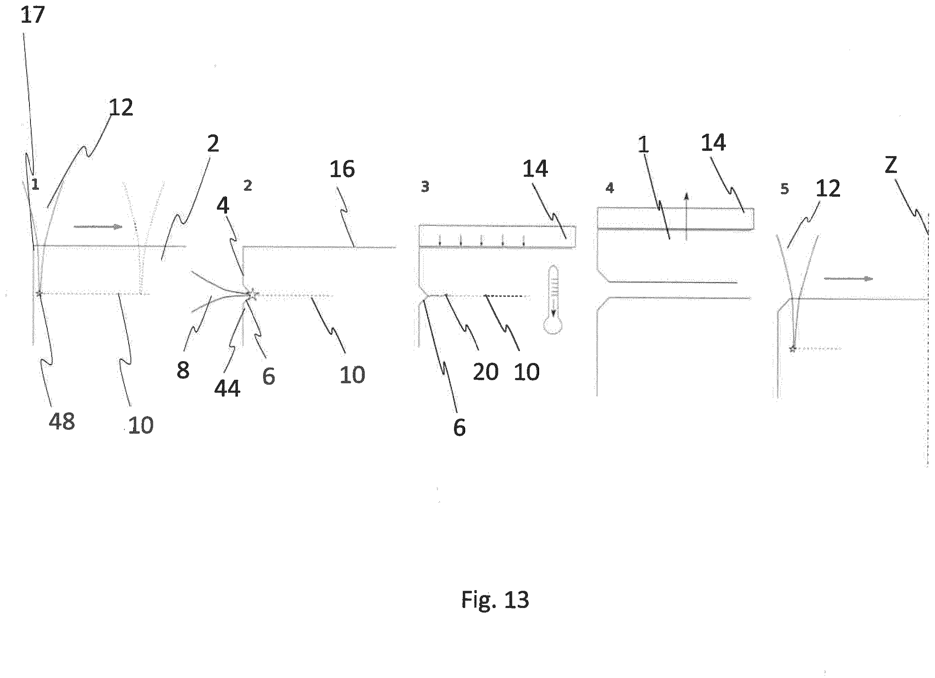

Fig. 13 zeigt eine weitere Ausführungsform des Verfahrens, das nicht von der vorliegenden Erfindung abgedeckt ist. Es kann durch einen Vergleich der ersten und der fünften Darstellung erkannt werden, dass die mittels den LASER-Strahlen 12 erzeugten Modifikationen 10 im Falle einer ebenen Oberfläche 16 näher zum Rand 44 hin erzeugt werden können, als wenn die Kante 17 der Oberfläche 16 entfernt ist, wie dies in der fünften Darstellung gezeigt ist. Die LASER-Strahlen 12 dringen hierbei analog zur bzgl. Fig.12 erläuterten Modifikationserzeugung in das Spendersubstrat 2 ein.

Die zweite Darstellung der Fig. 13 zeigt die Erzeugung einer Vertiefung 6 ausgehend von einer umlaufenden Oberfläche 4 in Richtung Zentrum Z des Spendersubstrats 2, wobei die

Vertiefung mittels Ablations-LASER-Strahlen 8 eines Ablations-LASERS (nicht gezeigt) erzeugt wird. Bevorzugt verdampfen die Ablations-LASER-Strahlen 8 hierbei zum Erzeugen der Vertiefung 6 das Material des Spendersubstrats 2.

Gemäß Darstellung 3 der Fig. 13 ist die Form der Vertiefung nicht unsymmetrisch, sondern symmetrisch erzeugt. Somit wird ebenfalls gemäß dieser Darstellung eine Spannungserzeugungsschicht 14 an dem Spendersubstrat 2 erzeugt oder angeordnet und zum Erzeugen von mechanischen Spannungen zum Auslösen eines Risses 20 thermisch beaufschlagt, insbesondere mittels flüssigem Stickstoff.

Darstellung 4 der Fig. 13 zeigt die vom Spendersubstrat 2 abgespaltete Festkörperscheibe 1, an der weiterhin die Spannungserzeugungsschicht angeordnet ist.

Der Darstellung 5 der Fig. 13 lässt sich weiter entnehmen, dass bei einem Spendersubstrat 2 dessen Kante 17 bearbeitet ist, die mittels Ablations-LASER-Strahlen 8 zu erzeugende Vertiefung 6 weiter in Richtung Zentrum des Spendersubstrats 2 hineinreichen muss, als wenn die Kante 17 nicht bearbeitet ist. Es ist hierbei jedoch ebenfalls vorstellbar, dass die Vertiefung nicht mittels Ablations-LASER-Strahlen 8, sondern mittels eines Schleifwerkzeugs 22 (wie es z.B. aus der Figur 1 bekannt ist) erzeugt wird.

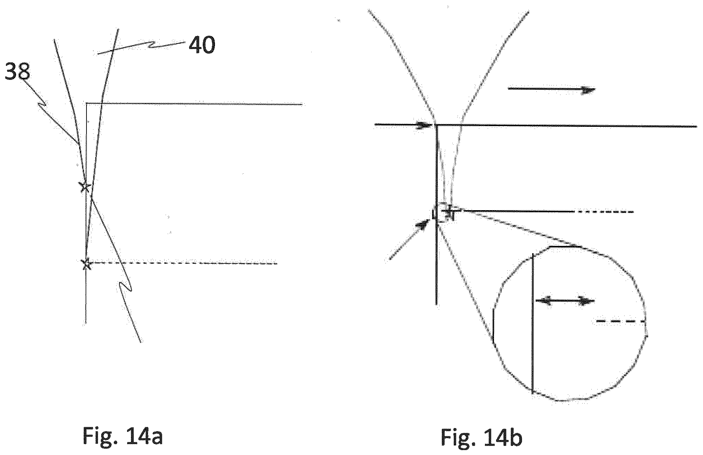

Die Figuren 14a und 14b zeigen ein bei der Erzeugung von Modifikationen mittels LASER-Strahlen 12 auftretendes Problem im Randbereich des Spendersubstrats 2. Durch die unterschiedlichen Brechindizes in der Luft und im Spendersubstrat treffen die LASER-Strahlanteile 38, 40 eines LASER-Strahls 12 nicht genau zusammen, wodurch ungewünschte Effekte, wie die Erzeugung von Defekten an ungewünschten Orten, eine ungewünschte lokale Aufheizung oder ein Verhinderung einer Modifikationserzeugung.

Fig. 14b zeigt, dass eine problemlose Erzeugung von Modifikationen 10 erst erfolgen kann, wenn die zu erzeugende Modifikation 10 soweit von der umlaufenden Oberfläche des Spendersubstrats 2 entfernt ist, dass beide LASER-Strahlanteile 38, 40 jeweils durch Material mit demselben Brechungsindex und bevorzugt über die gleiche Weglänge gebrochen werden. Dies führt jedoch dazu, dass die Modifikationserzeugung, wie sie im zum Randbereich beabstandeten Bereich erfolgt, nicht ohne weiteres auf den Randbereich erstreckt werden kann.

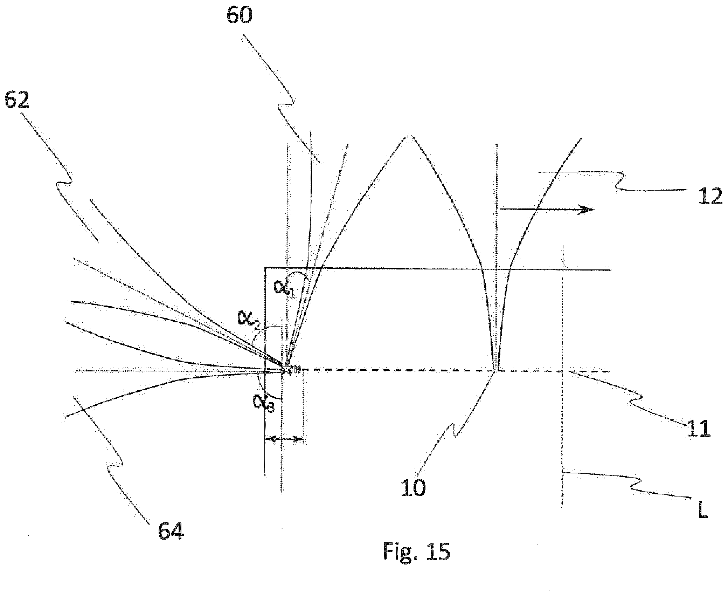

Fig. 15 zeigt eine Anordnung gemäß der ein LASER-Strahl 12 parallel zur Längsachse L ausgerichtet ist. Ferner zeigt diese Darstellung zusätzlich oder alternativ einen LASER-Strahl 60, der in einem Winkel $\alpha1$ gegenüber der Längsachse L geneigt ist. Beide LASER-Strahlen 12 und 60 können hierbei zur Erzeugung der Modifikationen 10 dienen, durch die ein Ablösebereich 11 vorgegeben wird. Es ist hierbei denkbar, dass durch den gegenüber der Längsachse L ungeneigten LASER-Strahl 12 eine Mehrzahl der Modifikationen 10 erzeugt wird und im Randbereich, d.h. in einem Abstand von weniger als 10 mm, insbesondere von weniger als 5 mm oder von weniger als 2 mm oder von weniger als 1 mm oder von weniger als 0,5 mm zur umlaufenden Oberfläche (Umfangsoberfläche), die Modifikationen 10 durch den gegenüber der Längsachse L geneigten LASER-Strahl 60 erzeugt werden.

Alternativ ist ferner denkbar, dass alle Modifikationen 10 des Ablösebereichs oder die Mehrzahl der Modifikationen 10 des Ablösebereichs 11 durch den gegenüber der Längsachse L in einem Winkel $\alpha1$ geneigten LASER-Strahl 60 erzeugt werden.

Im Rahmen einer Ausführungsform zusätzlich oder gemäß einem für das Verständnis der Erfindung hilfreichen Beispiel alternativ können die Modifikationen 10 im Randbereich durch einen weiteren gegenüber der Längsachse L des Spendersubstrats 2 geneigten LASER-Strahl 62, 64 erzeugt werden, wobei dieser LASER-Strahl bevorzugt über eine umlaufende Oberfläche des Spendersubstrats 2 in das Spendersubstrat 2 eindringt. Der Darstellung kann entnommen werden, dass ein LASER-Strahl 62 z.B. in einem Winkel $\alpha2$, der größer als 0° und kleiner als 90° ist, gegenüber dem Ablösebereich 11 über die umlaufende Oberfläche in das Spendersubstrat 2 zur Erzeugung der Modifikationen 10 im Randbereich einleitbar ist. Ferner kann der Darstellung entnommen werden, dass ein LASER-Strahl 64 in der Erstreckungsrichtung des Ablösebereichs 11 über die umlaufende Oberfläche des Spendersubstrats 2 in das Spendersubstrat 2 zum Erzeugen der Modifikationen 10 einleitbar ist. Der LASER-Strahl 64 ist dabei bevorzugt in einem Winkel $\alpha3$, zwischen 80° und 100°, insbesondere 90° oder im Wesentlichen 90°, gegenüber der Längsachse L des Spendersubstrats 2 geneigt.

Somit kann durch einen der LASER-Strahlen 60, 62, 64 eine Modifikationserzeugung 10 im Bereich des Randes erfolgen.

Weiterhin können die Aussagen zu Fig. 12 analog auf die in Fig. 15 gezeigten Gegenstände angewendet oder übertragen werden.

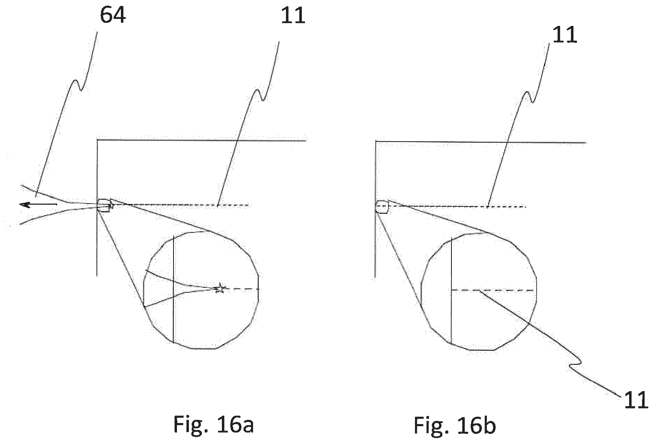

Fig. 16a zeigt einen bis auf den Randbereich erzeugten Ablösebereich 11. Ferner zeigt Fig. 16a die Modifikationserzeugung mittels eines LASER-Strahls 64. Durch den LASER-Strahl 64 werden bevorzugt in radialer Richtung mehrere Modifikationen 10, insbesondere auf einer Linie, mit größer werdenden Abständen zum Zentrum bzw. einer Rotationsachse (die sich bevorzugt orthogonal zur ebenen Oberfläche 16 des Spendersubstrats 2 erstreckt) des Spenderwafers 2 erzeugt.

Fig. 16b zeigt schematisch einen Zustand nach der Erzeugung der Modifikationen 10. Der Ablösebereich 11 ist gemäß dieser Darstellung in Form einer sich vollständig im Inneren des Spenderwafers 2 erstreckenden Modifikationslage ausgebildet.

Die Figuren 17a und 17b zeigen zwei Varianten zur Erzeugung von Modifikationen 10 mittels über die umlaufende Oberfläche eingeleiteter LASER-Strahlen.

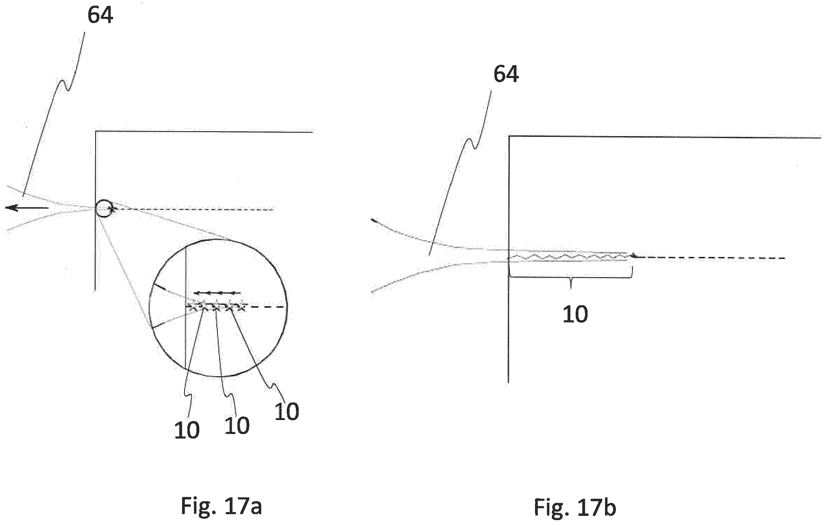

Gemäß Fig. 17a erfolgt die Erzeugung einer Vielzahl an Modifikationen 10 über dieselbe Eindringstelle, durch die die LASER-Strahlen 64 in das Spendersubstrat 2 eindringen. Die LASER-Strahlen werden zur Erzeugung der Modifikationen 10 auf unterschiedliche Tiefen in radialer Richtung in das Spendersubstrat 2 fokussiert. Bevorzugt werden die Modifikationen 10 mit abnehmender Eindringtiefe der LASER-Strahlen bzw. mit kürzer werdendem Abstand des Fokuspunkts zur Eindringstelle erzeugt.

Fig. 17b zeigt die filamentartige Modifikationserzeugung. Die in Form von Filamenten erzeugten Modifikationen 10 sind dabei länger als ein Vielfaches, insbesondere z.B. das 10 fache, 20 fache oder 50 fache, ihrer Querschnittserstreckung.

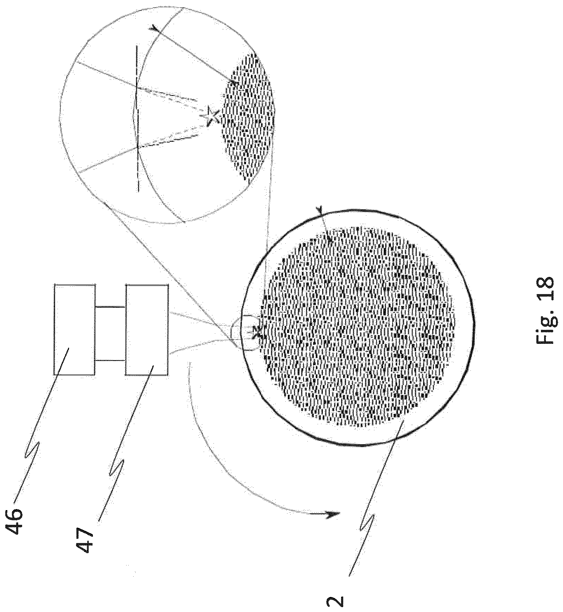

Fig. 18 zeigt eine LASER-Einrichtung 46, ein Aberrationsmittel 47 und eine Schnittdarstellung eines Spendersubstrats 2. Die Detaildarstellung der Fig. 18 zeigt den über die gebogene umlaufende Oberfläche des Spenderwafers 2 in den Spenderwafer 2 eindringenden LASER-Strahl 12, wobei durch die gestrichelt dargestellten Linien der mittels des Aberrationsmittels 47 angepasste Strahlungsverlauf dargestellt ist.

Weitere Ausführungsformen beziehen sich somit auf ein Verfahren zum Abtrennen von Festkörperscheiben 1 von einem Spendersubstrat 2. Solche Ausführungsformen umfassen dabei mindestens die Schritte: Bereitstellen eines Spendersubstrats 2, Erzeugen von mindestens einer Modifikationen 10 im Inneren des Spendersubstrats 2 mittels mindestens eines LASER-Strahls 12, wobei der LASER-Strahl 12 über eine ebene Oberfläche 16 des Spendersubstrats 2 in das Spendersubstrat 2 eindringt, wobei der LASER-Strahl 12 derart gegenüber der ebenen Oberfläche 16 des Spendersubstrats 2 geneigt ist, dass er in einem Winkel von ungleich 0° oder 180° gegenüber der Längsachse des Spendersubstrates in das Spendersubstrat eindringt, wobei der LASER-Strahl 12 zum Erzeugen der Modifikation 10 im Spendersubstrat 2 fokussiert wird, wobei sich die Festkörperscheibe 1 durch die erzeugten Modifikationen 10 von dem Spendersubstrat 2 ablöst oder eine Spannungserzeugungsschicht 14 an der ebenen Oberfläche 16 des Spendersubstrats 2 erzeugt oder angeordnet wird und durch ein thermisches Beaufschlagen der Spannungserzeugungsschicht 14 mechanische Spannungen in dem Spendersubstrat 2 erzeugt werden, wobei durch die mechanischen Spannungen ein Riss 20 zum Abtrennen einer Festkörperschicht 1 entsteht, der sich entlang der Modifikationen 10 ausbreitet.

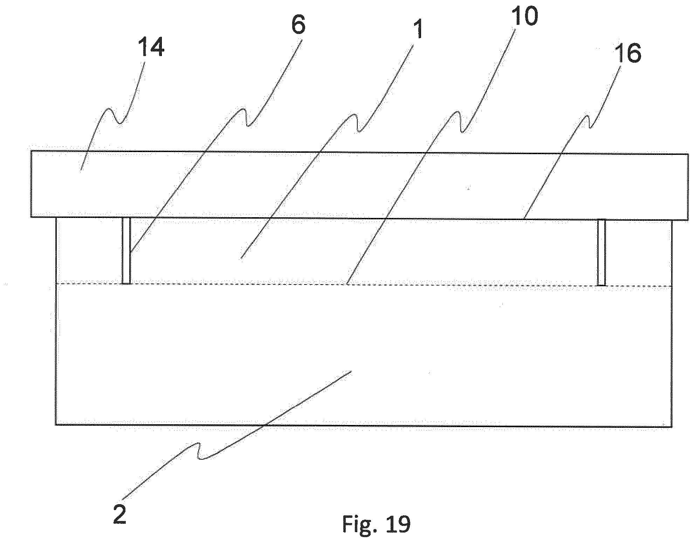

Fig. 19 zeigt schematisch eine Anordnung, gemäß der die Spannungserzeugungsschicht 14 bevorzugt mindestens eine Vertiefung 6, insbesondere Ausnehmung oder Graben, die sich bevorzugt ausgehend von einer ebenen bzw. im Wesentlichen ebenen Oberfläche 16 in Richtung einer zur ebenen Oberfläche 16 bevorzugt parallelen weiteren Oberfläche des Festkörpers 2 hin erstreckt, überlagert bzw. überdeckt bzw. verschließt.

Die Spannungserzeugungsschicht 14 wird bevorzugt als Polymerschicht erzeugt bzw. wird als Schicht erzeugt, die zu überwiegenden Massen- und/oder Volumenanteilen aus mindestens einem Polymermaterial besteht. Die Oberfläche 16, an der die Spannungserzeugungsschicht 14 angeordnet wird, weist bevorzugt behandelte Anteile auf. Als behandelte Anteile werden hierbei bevorzugt Anteile verstanden, in denen Material abgetragen wurde. Bevorzugt erstrecken sich somit ausgehende von der Oberfläche 16, an der die Spannungserzeugungsschicht 14 angeordnet wird und die sich bevorzugt im Wesentlichen oder vollständig parallel zu einer aus Modifikationen 10 gebildeten Rissführungsschicht erstreckt, Vertiefung/en, insbesondere Ausnehmungen 6 und/oder Gräben 6, bevorzugt orthogonal zur Oberfläche und/oder zur Rissführungsschicht. Es ist hierbei alternativ denkbar, dass nur eine Vertiefung 6, insbesondere ein Graben und/oder eine Ausnehmung, mittels Materialabtrag erzeugt wurde und/oder ausgebildet ist. Der Materialabtrag wird bevorzugt vor der Erzeugung oder Anbringung der Spannungserzeugungsschicht 14 an der Oberfläche 16 bewirkt, insbesondere mittels Laserablation. Die Spannungserzeugungsschicht 14 überdeckt im mit dem Festkörper 2 gekoppelten bzw. verbundenen Zustand die Vertiefung/en 6, insbesondere den Graben bzw. die Gräben oder die Ausnehmung bzw. die Ausnehmungen.

Bevorzugt erfolgt zwischen der Erzeugung der Vertiefung 6, insbesondere der Ausnehmung und/oder des Grabens, und der Anbringung der Spannungserzeugungsschicht keine weitere Beschichtung, insbesondere kein weiterer Materialauftrag. Dies ist vorteilhaft, da sich sonst Material in der Ausnehmung/Graben ansammeln könnte.

Bevorzugt erfolgt die Anbringung der Spannungserzeugungsschicht mittels eines Plasma-Laminationsprozesses. Dies ist vorteilhaft, das so über die Vertiefung 6, insbesondere Ausnehmung/Graben, hinweg eine Verbindung zwischen dem Festkörper 1, insbesondere der Hauptoberfläche 16 der späteren Festkörperschicht 1, und der Spannungserzeugungsschicht 14 erzeugt werden kann. Die Verbindung stellt bevorzugt ein Laminieren oder Kleben dar. Bevorzugt wird dies unter Verwendung von Kaltplasma umgesetzt.

Zusätzlich oder alternativ kann ein "Spontansplit" mit zuvor erzeugter Laserebene bzw. Rissführungsebene und Tiefenmodifikation durch einen Materialabtragungsschritt, insbesondere Laserablation, bewirkt werden. Bevorzugt wird dies ohne Spannungserzeugungsschicht 14 bewirkt.

Die Spannungserzeugungsschicht 14 kann auch als Stressorschicht, insbesondere als selbsttragende Stressorschicht, bezeichnet werden.

Eine selbsttragende Stressorschicht ist gegenüber einer aufgedampften oder anderweitig durch Abscheidung aufgebrachten Stressorschicht von entscheidendem technischem Vorteil, da solche Stressorschichten zum einen in größerem Volumen in einfacheren Verfahren in spezialisierten Anlagen mit höherem Durchsatz hergestellt werden können und zum anderen in Laminationsprozessen eingesetzt werden können, die ebenfalls höhere Prozessgeschwindigkeiten erlauben. Zusätzlich können selbsttragende Stressorschichten nach Laminationsprozessen auch unter geringem Aufwand wieder vom Substrat abgelöst werden, was zum Beispiel auch eine Wiederverwendung, d.h. der Stressorschicht bzw. der Spannungserzeugungsschicht, erlaubt, die mit abgeschiedenen Schichten unmöglich ist.

Besonders vorteilhaft ist, dass Laminationsprozesse auch ohne Klebeverfahren oder ähnliches rein durch eine Oberflächenaktivierung, Oberflächenbehandlung oder Oberflächenmodifikation des Substrates realisiert werden können. Somit erfolgt eine Kopplung bzw. Verbindung der Spannungserzeugungsschicht mit dem Festkörper, insbesondere mit der Oberfläche 16 der späteren Festkörperschicht 1, besonders bevorzugt durch eine Oberflächenaktivierung und/oder Oberflächenbehandlung und/oder Oberflächenmodifikation des Festkörpers bzw. der Oberfläche 16 der späteren Festkörperschicht 1.

So kann die Oberfläche z.B. bevorzugt durch Kontakt mit, insbesondere in einer Kammer, erzeugtem Ozon und/oder durch ultraviolettes Licht einer bestimmten Wellenlänge und/oder durch Plasmaverfahren mit unterschiedlichen gebildeten Spezies an den Oberflächen des Substrats und/oder der Stressorschicht und/oder im Prozessgas, insbesondere radikalische, Aldehyd-, und Alkohol-Spezies, aktiviert werden. Hier werden insbesondere Heißplasma-Verfahren bevorzugt, bei denen hohe Temperaturen Anwendung finden, um freie Ladungsträger und Radikale im Plasma zu erzeugen, was für die daraus folgenden Reaktionen an den Oberflächen von Substrat und Stressorschicht andere Reaktionspfade und chemische Oberflächenreaktionen erlaubt als bei niedrigeren Temperaturen. Der Oberflächenmodifikationsmechanismus kann sich also temperaturabhängig unterscheiden, ebenso zwischen verschiedenen Substraten, wobei z.B. bei SiC im Gegensatz zu Si, die beteiligten Kohlenstoffatome andere Oberflächenspezies in der Plasmabehandlung ausbilden können, die im Laminationsprozess ebenfalls haftvermittelnd wirken können.

Alternativ ist der Einsatz eines Kaltplasma-Verfahrens möglich, bei dem ein Plasma nicht durch Glühemission und über heiße Wolfram-Filamente oder ähnliche Methoden erzeugt wird, sondern über piezoelektrische Transformatoren bei atmosphärischem Druck und bevorzugt ohne erhöhte Temperatur. Diese niedrigeren Temperaturen vermindern und/oder verändern ebenfalls die zur Verfügung stehenden Reaktionspfade für Oberflächenaktivierungen und Oberflächenmodifikationen zur Haftvermittlung in Laminationsprozessen, sowohl am Substrat bzw. dem Festkörper als auch an der Stressorschicht. Die entstandenen Oberflächenspezies hängen also von einer Vielzahl von Parametern und der Oberflächenaktivierungsmethode im Besonderen ab.

Die Oberflächenbehandlung bzw. -modifikation umfasst beispielsweise die zumindest abschnittsweise Beaufschlagung der zu behandelnden Oberfläche durch eine Koronabehandlung und/oder durch eine Flammbehandlung und/oder durch eine Behanldung mittels elektrischer Barriereentladung und/oder durch Fluorierung und/oder durch Ozonierung und/oder durch Eximerbestahlung und/oder durch eine Behandlung mit einem Plasma, wobei bevorzugt einzelne oder mehrere physikalische Parameter, wie die Art des Plasmas, der Spurabstand bei der Plasmabehandlung, die Düsenart, der Düsenabstand und/oder die Dauer der Plasmabehandlung, variiert werden bzw. variierbar sind.

Bevorzugt wird eine Plasmavorbehandlung bzw. Plasmabehandlung sowohl zu einer Reinigung als auch anschließend zu einer Homogenisierung der Oberflächenspezies herangezogen (z.B. Hydrophobierung u.a.).

Mittels einer gezielten individuellen Plasmabehandlung ist eine ortsaufgelöste Variation der Oberflächenaktivierung erzeugbar bzw. einstellbar, die anschließend eine Lamination der Stressorschicht erlaubt - ebenfalls mit ortsveränderlichen Eigenschaften, wenn gewünscht.

Der Prozess der Plasmaoberflächenaktivierung bzw. der Plasmaoberflächenbehandlung gestattet eine größere Einflussnahme, um die gewünschte differenzierte Haftung bzw. Kraftübertragung nach der Lamination der Stressorschicht auf dem Substrat auch auf großen Flächen in einer definierten symmetrischen oder aber asymmetrischen Form aufzubringen. Hierbei kann durch Prozessvariation gezielt, insbesondere lokal, eine geänderte Adhäsion oder Kohäsion eingestellt werden. In Abhängigkeit der Ausgangseigenschaften der unterschiedlichen Festkörpermaterialien, insbesondere Halbleitermaterialien, können Schichten aufgebracht und/oder durch weitere graduelle Prozessgase (Sauerstoff, u.a.) die gewünschten Zusatzschicht/en, insbesondere Opfer/Schadschichten oder Substrat- und/oder Stressorschicht-Oberflächen, gezielt modifiziert werden (hydrophob, hydrophil, Benetzung etc.). Dies führt zu einer ortaufgelösten angepassten graduellen Haftung bzw. ortaufgelöst angepassten oder eingestellten Kraftübertragungsverbindung, auch in Laminationsprozessen, was gegenüber der durch Klebe- und Abscheidelösungen für die Stressorschicht nur homogen und nicht ortsaufgelöst.

Wie bereits beschrieben können unterschiedliche physikalische Parameter während der Plasmabehandlung zum Einsatz kommen (z.B. Art des Plasmas, Spurabstand bei der Plasmabehandlung, Düsenart, Düsenabstand, Dauer der Plasmabehandlung). Zusätzlich zu diesen Einflussparametern kann durch eine gezielte Beimischung von graduellen Prozessgasen wie z.B. Stickstoff, Sauerstoff, Wasserstoff, SiH4, Si(EtO)4 oder Me3SiOSiMe3 (u.a.) eine größere Bandbreite der notwendigen Oberflächeneigenschaften herbeigeführt werden. Diese resultieren bevorzugt aus neuen chemischen Oberflächenspezies, die sich auf der Halbleiteroberfläche und/oder den sich anschließenden Opferschichten und/oder der Stressorschicht abscheiden und so eine unterschiedlich ausgebildete Oberflächenfunktionalität und Laminationsprozesseigenschaften ermöglichen. Dies führt zu den gewünschten Zielprofilen, wie zum Beispiel unterschiedliche ortsaufgelöste Adhäsions- und Kohäsionseigenschaften, der Halbleiteroberflächen und/oder den sich anschließenden Stressor- und/oder anderen Schichten.

Eine Korona-Behandlung ist ein elektrochemisches Verfahren zur Oberflächenbehandlung bzw. -modifikation von Kunststoffen. Hierbei wird die Oberfläche einer elektrischen Hochspannungs-Entladung ausgesetzt. Eine Koronabehandlung wird z.B. zur Haftvermittlung bei Kunststoffen, Folien u.a. (PE, PP) verwendet.

Bei einer Flammenbehandlung kommt vor allem eine oberflächennahe Oxidation der jeweiligen Verbindungen zum Tragen. Im Wesentlichen erfolgen Oxidationsprozesse, durch die je nach Material und Versuchsbedingungen verschiedene polare funktionelle Gruppen gebildet werden (z.B. Oxide, Alkohole, Aldehyde, Carbonsäuren, Ester, Ether, Peroxide).

Eine Behandlung durch dielektrische Barriereentladung (DBE, Wechselspannungs-Gasentladung, dieelectric barrier discharge, auch DBD Behandlung) ist einem Niedertemperaturplasma bzw. einer Glimmentladung (z.B. GDMS) ähnlich. Bei der DBE-Behandlung wird die Oberfläche mit uni- oder bipolaren Pulsen mit Pulsdauern von wenigen Mikrosekunden bis hinunter zu einigen zehn Nanosekunden und Amplituden im einstelligen Kilovoltbereich beaufschlagt. Eine dielektrische Barriereentladung ist vorteilhaft, da hierbei keine metallischen Elektroden im Entladungsraum und somit keine metallischen Verunreinigungen oder Elektrodenverschleiß zu erwarten sind.

Weitere Vorteile der dielektrische Barriereentladung können je nach Anwendung z.B. sein, dass sie eine hohe Effizienz aufweist, da an den Elektroden keine Ladungsträger aus- oder eintreten müssen (Wegfall des Kathodenfalls, keine Glühemission nötig) oder dass die dielektrischen Oberflächen bei niedrigen Temperaturen modifiziert und chemisch aktiviert werden können. Die Oberflächenmodifikation erfolgt dabei bevorzugt durch eine Wechselwirkung und Reaktion der Oberflächenspezies durch ein Ionenbombardement und der Einwirkung der Ultraviolettstrahlung auf die Oberflächenspezies (z.B. 80nm - 350nm, inkohärentes Licht UV und VUV, durch Leistungs-Hochfrequenzgeneratoren). Die dielektrische Barriereentladung findet z.B. Anwendung zur in situ Herstellung von Ozon in der Trink- / Abwasseraufbereitung, wobei durch das Ozon eine Ozonierung des Wassers erfolgt. Analog hierzu erfolgt bei einer Oberflächenbehandlung oder -modifikation mittels Ozonierung im Rahmen einer Ausführungsform eine Beaufschlagung der zu behandelnden Oberfläche mittels Ozon.

Eine Oberflächenbehandlung bzw. -modifikation mittels Halogenierung, insbesondere Fluorierung, bewirkt die Überführung eines Elementes oder einer Verbindung in ein Halogenid. Durch die Fluorierung erfolgt somit die Einführung von Fluor in bevorzugt organische Verbindungen mit Hilfe von Fluorierungsmitteln.

Eine Oberflächenbehandlung bzw. -modifikation mittels einer UV-Behandlung erfolgt bevorzugt durch eine Eximer Bestrahlung oder durch ultraviolette Leuchtdiodenquellen, z.B. auf Aluminiumnitrid-Basis. Eine Eximerbestrahlung erfolgt durch die Verwendung von mindestens einem Excimerlaser. Eximerlaser sind Gaslaser, die elektromagnetische Strahlung im ultravioletten Wellenlängenbereich erzeugen können. Eine hierbei erfolgende Gasentladung wird somit durch ein elektromagnetisches Hochfrequenzfeld hervorgerufen. Deshalb werden auch keine Elektroden bei der Gasentladung benötigt. Die erzeugte UV-Strahlung, liegt bevorzugt in einem Wellenlängenbereich zwischen 120 nm und 380 nm.

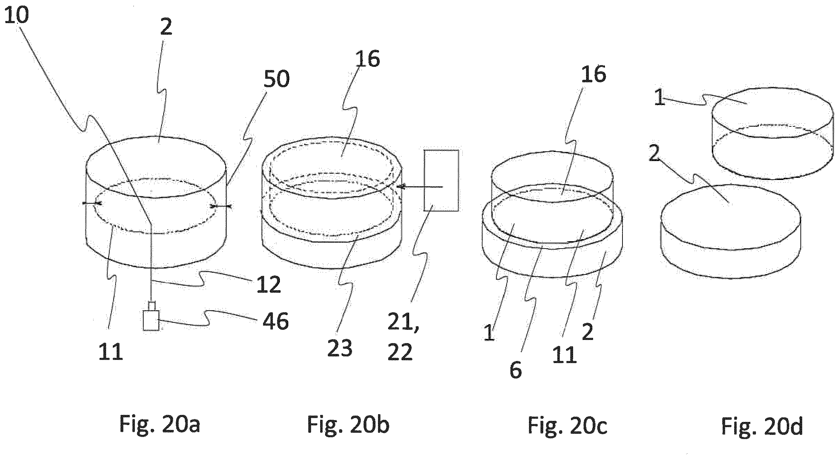

Fig. 20a zeigt eine gemäß einer Ausführungsform zusätzliche oder gemäß einem zum Verständnis der Erfindung beitragende alternative Lösung zum Abtrennen von Festkörperschichten 1 oder Festkörperlagen 1 von einem Spendersubstrat 2. Gemäß Fig. 20a erfolgt die Erzeugung eines Ablösebereichs 11 im inneren des Spendersubstrats 2. Die Modifikationen 10 sind dabei bevorzugt zu einer umlaufenden Begrenzungsfläche 50 des Spendersubstrats 2 beabstandet. Bevorzugt werden die Modifikationen 10 analog zur Darstellung 2 der Fig. 11 erzeugt. Es ist hierbei denkbar, dass die LASER-Strahlen 12 von oben, d.h. über die Oberfläche 16 in das Spendersubstrat 2 eingeleitet werden, oder von unten in das Spendersubstrat 2 eingeleitet werden, wobei unten auf der gegenüberliegenden Seite von "oben" ist. Bevorzugt erfolgt daher eine Laserbeaufschlagung von "unten" über eine Oberfläche des Festkörpers bzw. Spendersubstrats die bevorzugt parallel oder zumindest im Wesentlichen parallel zur Oberfläche 16 ist. Bei einer Bestrahlung von "unten" ist der Weg der Laserstrahlen bis zur Modifikationserzeugungsstelle bevorzugt länger als der Weg von der Modifikationserzeugungsstelle zur Oberfläche 16. Selbstverständlich kann der Festkörper auch rotiert werden, d.h. z.B. um 180° um eine horizontale Achse gedreht werden und dann die Modifikationen über die zur Oberfläche 16 parallelen Oberfläche eingebracht werden. Da in diesem Falle die erzeugten Modifikationen bevorzugt weiterhin näher zur Oberfläche 16 hin erzeugt werden, entspricht diese Variante der Modifikationserzeugung bzw. Defekterzeugung der von "unten"-Variante.

Fig. 20b zeigt schematisch die Bearbeitung des Spendersubstrats 2 mittels eines Ablationswerkzeug 22, insbesondere einem Werkzeug zum spanenden Bearbeiten des Spendersubstrats 2, wie einem Schleifwerkzeug 22. Durch die Bearbeitung wird zumindest abschnittsweise in Umfangsrichtung des Spendersubstrats 2 Material im gesamten Bereich zwischen dem Ablösebereich und einer zum Ablösebereich bevorzugt homogen, insbesondere parallel, beabstandeten Oberfläche des Spendersubstrats 2 zur Reduzierung der radialen Erstreckung des Spendersubstrats 2 abgetragen. Bevorzugt wird das Material ringförmigt, insbesondere mit einer konstanten oder im Wesentlichen konstanten radialen Ausdehnung, entfernt.

Fig. 20c zeigt ein Beispiel für einen Zustand nach dem Abtrag des Materials. Es ist hierbei z.B. denkbar, dass das Material in axialer Richtung des Spendersubstrats 2 bis auf die Ablöseebene oder darunter oder darüber abgetragen wird.

Fig. 20d zeigt einen Zustand nach dem Abtrennen bzw. Ablösen der Festkörperlage 1 von dem Spendersubstrat 2.

Das Verfahren kann gemäß einer weiteren Ausführungsform einen oder mehrere oder alle der nachfolgenden Schritte umfassen:

Bewegen des Festkörpers relativ zu einer Laserbeaufschlagungseinrichtung, nacheinander Erzeugen von einer Vielzahl an Laserstrahlen mittels der Laserbeaufschlagungseinrichtung zum Erzeugen von jeweils mindestens einer Modifikation, wobei die Laserbeaufschlagungseinrichtung zur definierten Fokussierung der Laserstrahlen und/oder zur Anpassung der Laserenergie, insbesondere kontinuierlich, in Abhängigkeit von mindestens einem Parameter, insbesondere von einer Vielzahl an Parametern eingestellt wird.

Der LASER-Strahl dringt bevorzugt über eine ebene Oberfläche des Spendersubstrats in das Spendersubstrat ein. Bevorzugt ist der LASER-Strahl derart gegenüber der, insbesondere ebenen, Oberfläche des Spendersubstrats bzw. Festkörpers geneigt, dass er in einem Winkel von ungleich 0° oder 180° gegenüber der Längsachse des Spendersubstrates in das Spendersubstrat eindringt. Bevorzugt wird der LASER-Strahl zum Erzeugen der Modifikation im Spendersubstrat fokussiert.

Der Festkörper weist bevorzugt Kristallgitterebenen auf, die gegenüber einer ebenen Hauptoberfläche geneigt sind, wobei die Hauptoberfläche des Festkörpers in Längsrichtung des Festkörpers einerseits begrenzt, wobei sich eine Kristallgitterebenennormale gegenüber einer Hauptoberflächennormalen in eine erste Richtung neigt, wobei die Modifikationen Veränderungen der Materialeigenschaft des Spendersubstrats sind. Die Veränderung der Materialeigenschaft bildet durch Verändern des Eindringortes der Laserstrahlung in dem Festkörper zumindest abschnittsweise eine linienförmige Gestalt aus, wobei die linienförmige Gestalt als Punktlinie, Strichlinie oder durchgehende Linie ausgebildet sein kann. Bevorzugt weist die linienförmige Gestalt oder mehrere linienförmige Gestalten oder alle oder die Mehrzahl der linienförmigen Gestalten eine Länge von mehr als 1mm oder von mehr als 5mm oder von mehr als 10mm oder von mehr als 20mm oder von mehr als 30mm auf oder eine von bis zu 1mm oder von bis zu 5mm oder von bis zu 10mm oder von bis zu 20mm oder von bis zu 30mm oder von bis zu 50mm oder von bis zu 100mm auf. Die Veränderungen der Materialeigenschaft werden bevorzugt auf einer Erzeugungsebene, insbesondere auf mindestens einer Erzeugungsebene oder auf genau einer Erzeugungsebene, oder in einem bzw. dem Ablösebereich erzeugt. Die Kristallgitterebenen des Festkörpers sind gegenüber der Erzeugungsebene bzw. dem Ablösebereich bevorzugt geneigt ausgerichtet. Die linienförmige Gestalt ist gegenüber einer sich an der Schnittstelle zwischen der Erzeugungsebene oder dem Ablösebereich und der Kristallgitterebene ergebenden Schnittlinie bevorzugt geneigt.

Durch die veränderte Materialeigenschaft reißt der Festkörper bevorzugt in Form von unterkritischen Rissen ein. Weiterhin erfolgt bevorzugt das Abtrennen der Festkörperschicht durch Einleiten einer äußeren Kraft in das Spendersubstrat zum Verbinden der unterkritischen Risse oder es wird so viel Material auf der Erzeugungsebene oder im Ablösebereich mittels der Lasterstrahlung verändert, dass sich unter Verbindung der unterkritischen Risse die Festkörperschicht von dem Spendersubstart ablöst.

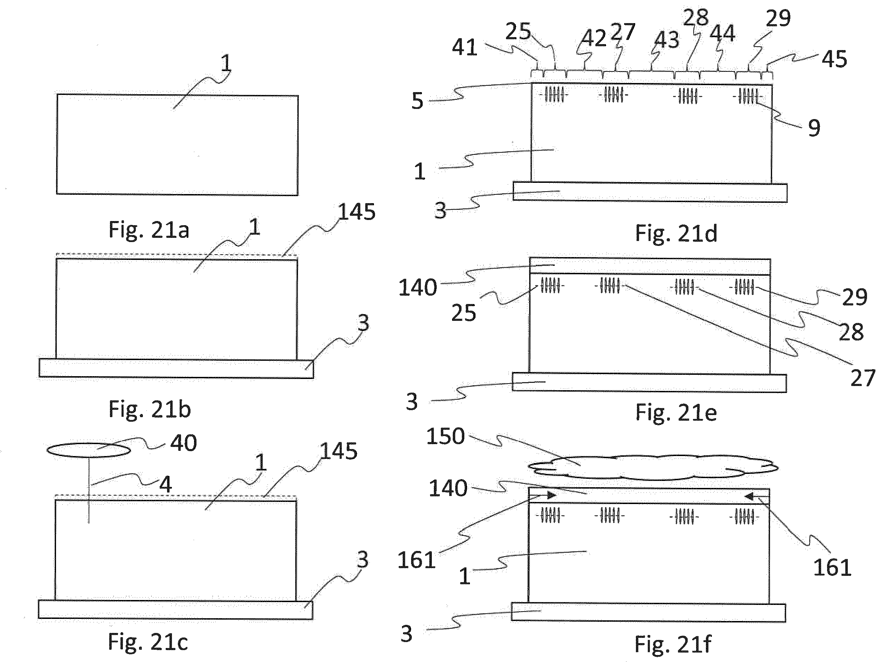

Fig. 21a zeigt die Bereitstellung des Festkörpers 1, insbesondere eines Wafers.

Gemäß Fig. 21b ist der bereitgestellte Festkörper 1 an einem Werkzeugträger (Chuck) 3 angekoppelt bzw. angeklebt oder angeschweißt oder angeschraubt oder angeklemmt oder angetrocknet oder angefroren oder durch ein Vakuum angesaugt, wobei der Werkzeugträger bevorzugt eine Kühlfunktionalität umfasst und dadurch bevorzugt zur Kühleinrichtung 3 wird. Angefrieren erfolgt hierbei bevorzugt über das Verfestigen eines Fluids, insbesondere einer Flüssigkeit, insbesondere Wasser oder einem oder mehreren anderen Materialien mit einer Verfestigungs- bzw. Erstarrungstemperatur unterhalb 50°C oder unterhalb von 30°C oder unterhalb von 20°C oder unterhalb von 10°C oder unterhalb von 5°C oder runterhalb von 0°C oder unterhalb von -10°C oder unterhalb von -20°C oder unterhalb von -50°C (in allen Fällen bezogen auf einen Umgebungsdruck von 1 bar). Antrocknen bedeutet hierbei bevorzugt das Verfestigen durch Feuchtigkeitsabgabe oder Feuchtigkeitsentzug. Es ist hierbei ebenfalls möglich, dass der Festkörper durch zwei oder mehr als zwei Effekte, z.B. ansaugen und anklemmen oder anklemmen und ankleben oder anklemmen und anschrauben und antrocknen am Chuck fixiert wird, Der Chuck bzw. Werkzeugträger ist besonderes bevorzugt als Vakuumchuck ausgebildet. Der Festkörper 1 wird bevorzugt in Längsrichtung mit seiner Unterseite, die bevorzugt in Längsrichtung gegenüber der Oberfläche 5 liegt, an der Kühleinrichtung 3 fixiert, insbesondere angeklebt. Die Laserstrahlen werden somit zum Erzeugen der Modifikationen 9 über die Oberfläche 5, die Bestandteil der abzutrennenden Festkörperschicht ist, in Richtung der Kühleinrichtung 3 in den Festkörper 1 eingeleitet. Besonders bevorzugt erfolgt ferner eine Hochtemperaturbehandlung der Oberfläche 5, insbesondere eine epitaktische Materialanordnung an der Festkörperoberfläche 5, woraus bevorzugt eine weitere Schicht 145 oder mehrere weitere Schichten 145 resultieren. Das mindestens eine Hochtemperaturverfahren ist bevorzugt ein Epitaxieverfahren, ein Dotierverfahren oder ein Verfahren unter Plasmaeinsatz, wobei durch das Hochtemperaturverfahren, insbesondere im Falle eines Epitaxiverfahrens, mindestens eine Schicht 145 auf dem Festkörper 1 erzeugt wird, wobei die mindestens eine erzeugte Schicht 145 vordefinierte Parameter aufweist, wobei zumindest ein vordefinierter Parameter einen maximalen Grad an Brechung und/oder Absorption und/oder Reflexion von Laserlichtwellen vorgibt, wobei der Grad an Brechung und/oder Absorption und/oder Reflexion unter 5% und bevorzugt unter 1% und besonders bevorzugt unter 0,1% liegt. Weiterhin kann die erzeugte Schicht 145 bzw. die weiteren erzeugten Schichten 145 bevorzugt metallfrei sein.

Fig. 21c zeigt schematisch die Erzeugung der Modifikationen 9 mittels der Laserstrahlen. Die Laserstrahlen dringen dabei bevorzugt über die zuvor mittels des Hochtemperaturverfahrens erzeugte Schicht 145 in den Festkörper 1 ein. Es ist alternativ jedoch ebenfalls denkbar, dass die Laserstrahlen über eine freie, d.h. nicht mit der weiteren Schicht 145 beschichteten Oberfläche des Festkörpers 1, insbesondere von unten, in den Festkörper 1 eindringen. Hierbei wird der Festkörper 1 bevorzugt seitlich oder an den äußeren Enden (Breiten- und/oder Tiefenrichtung) gehalten.

Fig. 21d zeigt eine schematische Schnittdarstellung des Festkörper 1 nach der Erzeugung der Modifikationen 9. Gemäß diesem Beispiel sind 4 Blöcke an Modifikationen 9 erkennbar, die zu den 4 Rissanteilen 25, 27, 28, 29 führen. Angrenzend an die Blöcke mit Modifikationen 9 kennzeichnen die Bezugszeichen 41, 42, 43, 44 und 45 jeweils Bereiche ohne Modifikationen 9 oder Bereiche, in denen weniger Modifikationen 9 erzeugt sind, als in den Bereichen, in denen die Blöcke an Modifikationen 9 erzeugt sind.

Fig. 21e zeigt einen Zustand, gemäß dem eine Aufnahmeschicht, insbesondere ein Polymermaterial aufweisend, an weiteren an der Oberfläche 5 oder einer an der Oberfläche 5 zuvor epitaktisch erzeugten weiteren Schicht angeordneten Bauteilen (nicht gezeigt) angeordnet oder erzeugt wird. Die Aufnahmeschicht ist bevorzugt als Folie erzeugt worden und nach ihrer Erzeugung an die Oberfläche 5 angekoppelt, insbesondere angebondet oder angeklebt, worden. Es ist jedoch ebenfalls möglich die Aufnahmeschicht durch Aufbringung eines flüssigen Polymers auf die Oberfläche 5 und anschließendes Verfestigen auszubilden.

Zwischen dem Schritt der Erzeugung der Modifikationen und der Anbringung der Aufnahmeschicht erfolgt bevorzugt eine Anordnung bzw. Erzeugung von weiteren Schichten 150 und/oder Bauteilen 150 an der Oberfläche 5 oder an einer daran bereits während eines vorgelagerten Hochtemperaturverfahrens erzeugten weiteren Schicht 145.

Fig. 21f zeigt schematisch eine Temperierung der Aufnahmeschicht. Bevorzugt wird die Aufnahmeschicht auf eine Temperatur unterhalb der Umgebungstemperatur, insbesondere auf eine Temperatur von weniger als 20°C, oder von weniger als 1°C oder von weniger als 0°C oder von weniger als -10°C oder von weniger als -50°C oder von weniger als -60°C temperiert, insbesondere gekühlt. Wobei das Material der Aufnahmeschicht 140 infolge der Abkühlung einen Glasübergang oder und eine Kristallisation erfährt. Bevorzugt erfolgt die Temperierung der Aufnahmeschicht mittels flüssigen Stickstoffs, insbesondere mittels eines Stickstoffnebels. Aufgrund der Temperierung, insbesondere aufgrund des Glasübergangs, zieht sich die Aufnahmeschicht zusammen, wodurch mechanische Spannungen in dem Festkörper 1 erzeugt werden. Aufgrund der mechanischen Spannungen wird ein die Rissanteile 25, 27, 28, 29 verbindender Riss ausgelöst, durch den der Festkörperanteil 12 von dem Festkörper 1 abgetrennt wird.

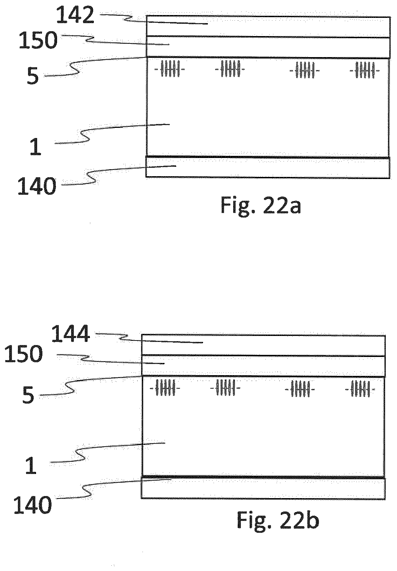

Fig. 22a zeigt eine Ausführungsform, gemäß der die Aufnahmeschicht 140 an einer Oberfläche des Festkörpers angeordnet ist, die weiter von den Modifikationen beabstandet ist als eine dazu parallele oder bevorzugt im Wesentlichen parallele oder vollständig parallele Oberfläche 5. Bevorzugt weist die Oberfläche eine weitere Schicht 145 (analog zu Fig. 21b-21f) auf. An der weiteren Schicht 145 oder an der freiliegenden Oberfläche 5 werden bevorzugt Bauteile 150 oder weitere Materialschichten 150 angeordnet. Bevorzugt wird an einer freiliegenden Oberfläche der weiteren Materialschicht 150 oder der Bauteile 150 eine Stabilisierungsschicht und/oder eine Schutzschicht 142 angeordnet oder erzeugt. Die Bauteile 150 können hierbei z.B. vergossen werden, insbesondere mit einem Polymermaterial und/oder Keramikmaterial. Zusätzlich ist vorstellbar, dass an die Stabilisierungsschicht und/oder Schutzschicht 142 eine Stabilisierungseinrichtung, insbesondere ein weiterer Wafer, wie z.B. ein Glaswafer, angekoppelt, insbesondere angeklebt bzw. angebondet wird. Der die Stabilisierungsschicht und/oder Schutzschicht 142 oder die Stabilisierungsschicht und/oder Schutzschicht 142 und die Stabilisierungseinrichtung bewirken dabei, dass sich die Bauteile 150 bzw. weiteren Materialschicht 150 beim Abspalten oder nach dem Abspalten nur unwesentlich oder nicht verformen. Beim Abspalten kann die Verformung durch die mittels der Aufnahmeschicht 140 erzeugten Kräfte bewirkt werden und nach dem Abspalten kann eine Verformung durch die verbleibenden Modifikationen, insbesondere Stoffumwandlungen, bewirkt werden. Die Modifikationen bewirken im Falle einer Stoffumwandlung, dass Druckkräfte entstehen, woraus ohne die Stabilisierungsschicht / Stabilisierungseinrichtung eine Wölbung (BOW) der abgetrennten Festkörperschicht resultieren würde. Die Stabilisierungsschicht 142 kann somit zusätzlich oder alternativ als Glaswafer oder Siliziumwafer oder als Metallschicht ausgebildet sein oder an der Stabilisierungsschicht 142 kann zusätzlich oder alternativ ein Glaswafer angeordnet sein bzw. werden. Wird die Stabilisierungsschicht 142 als Metallschicht ausgeführt, so kann diese angebondet werden, insbesondere angeklebt werden. Alternativ ist es möglich, dass die Metallschicht 142 an der Kompositstruktur erzeugt wird, insbesondere mittels Sputtern.

Eine Einheit aus abgetrennter Festkörperschicht und daran angeordneter Stabilisierungsschicht und/oder Schutzschicht 142 und eventuell daran angeordneter Stabilisierungseinrichtung wird dann bevorzugt zur Stressentfernung weiterbehandelt. Besonders bevorzugt bildet die Stabilisierungsschicht 142 oder die Stabilisierungseinrichtung eine Halteeinrichtung aus, mittels der die abgetrennte Festkörperschicht für eine Materialabtragbehandlung gegenüber einer Materialabtrageinrichtung, insbesondere einer Schleif- und/oder Poliereinrichtung, fixierbar ist. Mittels der Materialabtrageinrichtung werden dann die an der abgetrennten Festkörperschicht verbleibenden Modifikationsanteile abgetragen, insbesondere spanend entfernt.

Im Kontext dieser Erfindung ist die Festkörperschicht bevorzugt immer dünner als der verbleibende Festkörperanteil. Es ist jedoch ferner denkbar, dass die Aufnahmeschicht nicht an einer Oberfläche der späteren Festkörperschicht angeordnet oder erzeugt wird, sondern an einer Oberfläche des verbleibenden Festkörperanteils. Wenn es sich bei dem Festkörpermaterial um Silizium handelt, dann weist die abgetrennte Festkörperschicht gegenüber dem verbleibenden Festkörper bevorzugt ein Höhe von weniger als 40% der Höhe des verbleibenden Festkörpers auf, insbesondere von weniger als 30% oder 20% der Höhe des verbleibenden Festkörpers. Bei Silizium werden bevorzugt vorbestimmte Parameter für die Modifikationserzeugung vorgesehen, die Numerische Apertur liegt bevorzugt zwischen 0,5 und 0,8, insbesondere bei 0,65, die Einstrahltiefe liegt zwischen 150$\mu$m und 1000$\mu$m, insbesondere bei 300$\mu$m, der Pulsabstand

liegt zwischen 1μm und 5μm, insbesondere bei 2μm, der Linienabstand liegt zwischen 1μm und 5μm, insbesondere bei 2 μm, die Pulsdauer liegt zwischen 50ns und 400ns, insbesondere bei 300ns, und die Pulsenergie liegt zwischen 3μJ und 30μJ, insbesondere bei 10μJ.

Ist das Material SiC, dann weist die abgetrennte Festkörperschicht gegenüber dem verbleibenden Festkörper bevorzugt eine Höhe von weniger als 50% der Höhe des verbleibenden Festkörpers auf, insbesondere von weniger als 45% oder 40% oder 35% oder 30% oder 25% der Höhe des verbleibenden Festkörpers. Bei SiC werden bevorzugt vorbestimmte Parameter für die Modifikationserzeugung vorgesehen, die Numerische Apertur liegt bevorzugt zwischen 0,4 und 0,8, insbesondere bei 0,4, die Einstrahltiefe liegt bevorzugt zwischen 50μm und 500μm, insbesondere bei 180μm, der Pulsabstand liegt bevorzugt zwischen 0,1 μm und 3μm, insbesondere bei 1μm, der Linienabstand liegt bevorzugt zwischen 10μm und 100μm200μm, insbesondere zwischen 10 μm und 100 μm, insbesondere bei 75 μm, die Pulsdauer liegt bevorzugt zwischen 1fs und 10ns, insbesondere bei 3ns, und die Pulsenergie liegt bevorzugt zwischen 0,5μJ und 30μJ, insbesondere bei 7μJ.

Auch in Fig. 22b kann analog zu den Fig. 21b-21f eine weitere Schicht 145 erzeugt sein, auch wenn diese nicht kenntlich gemacht wurde. Die weiteren Materialschichten oder Bauteile 150 werden daher bevorzugt an der weiteren Schicht 145 oder an einer freiliegenden Oberfläche des Festkörpers erzeugt bzw. angeordnet.

Ferner zeigt Fig. 22b, dass an einer Oberfläche des verbleibenden Festkörpers die Aufnahmeschicht angeordnet sein kann und an den Bauteilen oder weiteren Materialschichten 150 eine weitere Aufnahmeschicht 146 angeordnet sein kann. Die Bauteile können hierbei zusätzlich mit einer Stabilisierungsschicht 142 versehen sein, wodurch die weitere Aufnahmeschicht 146 bevorzugt an der Stabilisierungsschicht und oder Schutzschicht 142 angeordnet oder erzeugt ist. Die weitere Aufnahmeschicht 146 wird bevorzugt als Folie bereitgestellt und besteht bevorzugt ebenfalls zumindest teilweise aus einem Polymermaterial. Besonders bevorzugt weist die weitere Aufnahmeschicht 146 das gleiche Material auf wie die Aufnahmeschicht 140 bzw. 142. Diese Ausführungsform ist vorteilhaft, da die Spannungen zum Erzeugen des Risses von zwei Seiten in den Festkörper eingeleitet werden können.

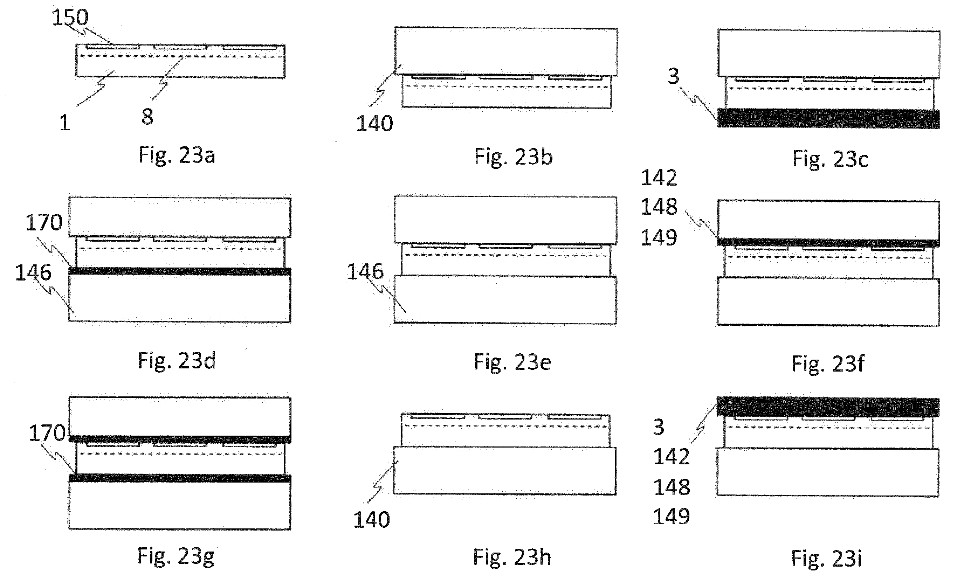

Die Figuren 23a bis 23i zeigen verschiedene Anordnungen, die nach der Erzeugung der weiteren Materialschichten bzw. Bauteile 150 zum Einleiten des Risses vorgesehen werden können.

Die Figuren 23a-23i zeigen diverse Festkörperanordnungen 176, wie sie zum Einleiten von Rissführungs- und/oder Rissauslösungsspannungen vorteilhaft sind.

Fig. 23a zeigt hierbei einen prozessierter Festkörper 1 bzw. Wafer mit Strukturen bzw. Bauteilen 150.

Gegenüber dem in Fig. 23a gezeigten Festkörper 1 ist bei dem in Fig. 23b gezeigten Festkörper 1 eine Aufnahmeschicht 140 an der Bauteilseite, insbesondere an den Bauteilen 150 bzw. den weiteren Materialschichten 150, angeordnet oder erzeugt. Die Aufnahmeschicht 140 ist hierbei bevorzugt an der abzutrennenden Festkörperschicht angeordnet. Die Aufnahmeschicht 140 kann hierbei auch als Splitfolie bezeichnet werden und ist somit bevorzugt auf der Strukturseite auflaminiert. Im Nachfolgeschritt erfolgt dann ein Abkühlen der Gesamtanordnung, wodurch der Split bzw. die Rissauslösung und/oder Rissführung bewirkt wird.

Gegenüber der Darstellung der Fig. 23b ist gemäß der Fig. 23c an der Unterseite des Festkörpers bzw. an der freiliegenden Oberfläche des Festkörpers eine Halteschicht/gebondeter Wafer angeordnet. Es kann sich bei der Halteschicht auch um einen Werkzeugträger bzw. Chuck 3 handeln. Im Nachfolgeschritt erfolgt dann ein Abkühlen der Gesamtanordnung, wodurch der Split bzw. die Rissauslösung und/oder Rissführung bewirkt wird.

Fig. 23d zeigt gegenüber der Fig. 23b eine Anordnung, gemäß welcher der Festkörper doppelseitig mit Aufnahmeschichten 140, 146 versehen ist. Die weitere Aufnahmeschicht 146 ist dabei an einer Oberfläche des später verbleibenden Restfestkörpers angeordnet, wobei zwischen der weiteren Aufnahmeschicht 146 und dem Festkörper 1 eine Haftvermittlungsschicht 148 und/oder Opferschicht 149 und/oder Schutzschicht 142 angeordnet oder erzeugt sein kann. Die beiden Aufnahmeschichten 140 und 146 sind bevorzugt auflaminiert. Im Nachfolgeschritt erfolgt dann ein Abkühlen der Gesamtanordnung, wodurch der Split bzw. die Rissauslösung und/oder Rissführung bewirkt wird.

Fig. 23e zeigt eine Anordnung, gemäß der gegenüber der aus Fig. 23d bekannten Anordnung keine Haftvermittlungsschicht 148 und/oder Opferschicht 149 und/oder Schutzschicht 142 zwischen der weiteren Aufnahmeschicht 146 und dem Festkörper 1 angeordnet oder erzeugt ist. Im Nachfolgeschritt erfolgt dann ein Abkühlen der Gesamtanordnung, wodurch der Split bzw. die Rissauslösung und/oder Rissführung bewirkt wird.

Fig. 23f zeigt eine Anordnung die invers zu der aus Fig. 23d bekannten Anordnung aufgebaut ist, d.h., dass die Haftvermittlungsschicht 148 und/oder Opferschicht 149 und/oder Schutzschicht 142 nicht zwischen der weiteren Aufnahmeschicht 146 und dem Festkörper 1 angeordnet oder erzeugt ist, sondern zwischen der Aufnahmeschicht 140 und dem Festkörper 1 und somit an der abzutrennenden Festkörperschicht erzeugt oder angeordnet ist/sind. Auf den Bauteilen 150 oder den Strukturen kann hierbei z.B. mittels Spinncoating eine oder mehrere Schichten erzeugt werden. Als Nachfolgeschritt erfolgt dann ein Abkühlen der Gesamtanordnung, wodurch der Split bzw. die Rissauslösung und/oder Rissführung bewirkt wird.

Fig. 23g zeigt eine Anordnung bzw. Ausprägung, die einer Kombination aus den Anordnungen der Figuren 3d und 3f entspricht. Der Festkörper ist bevorzugt doppelseitig mit Splitfolie laminiert, ebenso kann doppelseitig eine Schutzschicht und/oder Haftvermittlungsschicht und/oder Opferschicht unter der Splitfolie vorgesehen sein, auf den Strukturen ist ferner z.B. Spincoating möglich. Als Nachfolgeschritt erfolgt dann ein Abkühlen der Gesamtanordnung, wodurch der Split bzw. die Rissauslösung und/oder Rissführung bewirkt wird.

Fig. 23h zeigt eine Anordnung, die ähnlich zur in Fig. 23b gezeigten Anordnung ist, wobei die Aufnahmeschicht nicht auf einer Oberfläche der abzutrennenden Festkörperschicht, sondern auf dem nach der Abtrennung verbleibenden Restfestkörper einseitig angeordnet bzw. laminiert ist. Die Abtrennung erfolgt dann infolge der Abkühlung analog zur Abtrennung von einem Ingot bzw. wie in einem Ingot-Prozess.

Fig. 23i zeigt eine Anordnung, die ähnlich zur aus Fig. 23c bekannten Anordnung ist, wobei eine oder mehrere der nachfolgend genannten Schichten oder Einrichtungen an der Bauteilseite des Festkörpers bzw. an oder oberhalb der Bauteile 150 angeordnet oder erzeugt wird/werden. Diese Schichten oder Einrichtungen sind dabei bevorzugt: Mindestens oder genau eine Haftvermittlungsschicht 148 und/oder mindestens oder genau eine Opferschicht 149 und/oder mindestens oder genau eine Schutzschicht 142 und/oder mindestens oder genau eine Stabilisierungseinrichtung 3, insbesondere ein Werkzeugträger oder Chuck oder ein weiterer Wafer. Als Nachfolgeschritt erfolgt dann ein Abkühlen der Gesamtanordnung, wodurch der Split bzw. die Rissauslösung und/oder Rissführung bewirkt wird.

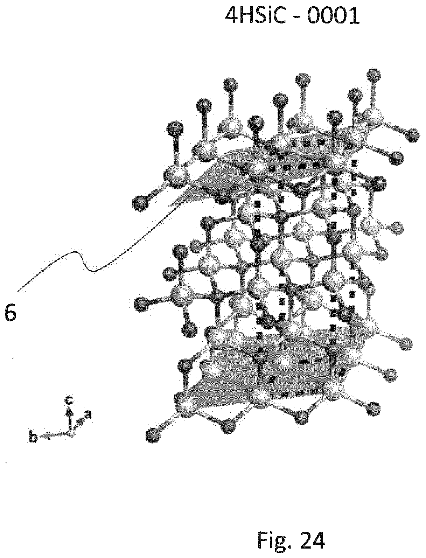

Fig. 24 zeigt ein Beispiel eines Kristallgitters mit Gleitebene für 4HSiC; Fig. 5a zeigt ein Beispiel eines Kristallgitters mit Gleitebene 110 für Si; Fig. 5b zeigt ein Beispiel eines Kristallgitters mit Gleitebene 100 für Si und Fig. 5c zeigt ein Beispiel eines Kristallgitters mit Gleitebene 111 für Si.

Bevorzugt handelt es sich bei den Kristallgitterebenen 6 um Gleitebenen eines bestimmten Typs. Ist die Kristallstruktur kubischflächenzentriert, dann ist die Gleitebene bevorzugt die Ebene {111} und die Gleitrichtung die Richtung <110>. Ist die Kristallstruktur kubischraumzentriert, dann ist die Gleitebene bevorzugt die Ebene {110} und die Gleitrichtung die Richtung <111> oder die Gleitebene ist bevorzugt die Ebene {112} und die Gleitrichtung ist die Richtung <111> oder die Gleitebene ist bevorzugt die Ebene {123} und die Gleitrichtung ist die Richtung <111>. Ist die Kristallstruktur hexagonal, dann ist die Gleitebene bevorzugt die Ebene {0001} und die Gleitrichtung die Richtung <1120> oder die Gleitebene ist bevorzugt die Ebene {1010} und die Gleitrichtung ist die Richtung <1120> oder die Gleitebene ist bevorzugt die Ebene {1011} und die Gleitrichtung ist die Richtung <1120>.

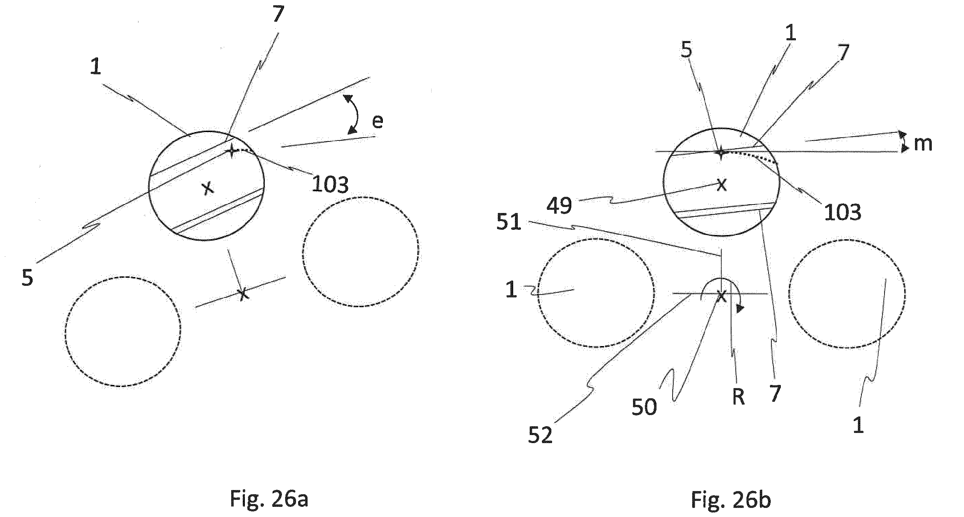

Die Figuren 26a bis 27a zeigen schematisch die Erzeugung einer linienförmigen Gestalt 103 mittels Laser bzw. Lasereinrichtung in einem Spendersubstrat 1. Die linienförmige Gestalt 103 wird hierbei bogenförmig bzw. gebogen erzeugt. Die Lasereinrichtung bzw. der Ort der Modifikationserzeugung verändert sich dabei bevorzugt nicht. D.h. der Ort der Modifikationserzeugung und das Drehzentrum 50 der Rotationseinrichtung 45 bleiben bevorzugt in derselben Ausrichtung zueinander. Es erfolgt somit bevorzugt lediglich eine Bewegung des Spendersubstrats 1 an der Lasereinrichtung 29 vorbei bzw. an einem Auslass für Laserstrahlung 32 vorbei. Das Spendersubstrat 1 wird bevorzugt derart auf der Rotationseinrichtung angeordnet, dass die linienausbildenden Enden 7 der Kristallgitterebenen 6 gegenüber einer sich orthogonal zur Verbindungsstrecke 51 zwischen dem Rotationszentrum 50 der Rotationseinrichtung 45 und dem Zentrum 49 des Spendersubstrats 1 erstreckenden Richtung 52 geneigt, insbesondere in einem Winkel zwischen 3° und 87° und bevorzugt in einem Winkel zwischen 10° und 60° oder 14° und 45°, ausgerichtet sind.

Es kann aus der Gesamtbetrachtung der Figuren 26a-27a erkannt werden, dass mit fortschreitender Rotation der Rotationseinrichtung 45 das Spendersubstrat 1 an der Lasereinrichtung vorbeigeführt wird und die linienförmige Gestalt 103 erzeugt bzw. verlängert wird. Zu Beginn (Fig. 26a) der linienförmigen Gestalt wird diese in einem Winkel e zur Schnittlinie 10 oder zu einer durch das Ende einer Kristallgitterebene ausgebildeten Linie erzeugt. In der Mitte (fig. 26b) der linienförmigen Gestalt wird diese in einem Winkel m zur Schnittlinie 10 oder zu einer durch das Ende einer Kristallgitterebene ausgebildeten Linie erzeugt. Am Ende (Fig. 27a) der linienförmigen Gestalt wird diese in einem Winkel s zur Schnittlinie 10 oder zu einer durch das Ende einer Kristallgitterebene ausgebildeten Linie erzeugt. Der Winkel e ist dabei bevorzugt größer als der Winkel m und der Winkel m ist bevorzugt größer als der Winkel s. Es ist hierbei jedoch ebenfalls denkbar, dass der Winkel s betragsmäßig größer ist als der Winkel m.

Die Winkel werden bevorzugt derart bestimmt, dass die Zentren zweier benachbarter Modifikationen miteinander gedanklich verbunden werden und der Winkel der daraus resultierenden Strecke gegenüber der Schnittlinie 10 oder gegenüber einer durch das Ende 7 einer Kristallgitterebene 6 ausgebildeten Linie bestimmt wird.

Gemäß den Figuren Fig. 26a-27a wird der ideale Schreibwinkel bei einer Anordnung rotierender Substrate als mittlerer Winkel zwischen dem Winkel der Tangenten am Waferrand und der Tangente in der Wafermitte gewählt, d.h. für SiC 30° mittlerer Winkel kann z.B. - abhängig vom Radius des Rotationstisches und des Substratradius' - ein Winkelintervall zwischen 25° und 35° bedeuten, womit z.B. ein bevorzugter Schreibwinkel von 30° für hexagonale Systeme im Mittel gewahrt bleibt.

Fig. 27b zeigt rein beispielhaft eine Draufsicht auf eine Rotationseinrichtung 45. Auf dieser Rotationseinrichtung 45 können eine Vielzahl, insbesondere mehr als 2 oder mehr als 3 oder mehr als 5 oder mehr als 10 bevorzugt bis zu 15 oder bis zu 20 oder bis zu 30 Spendersubstrate, insbesondere Boules oder Ingots oder Wafer, zeitgleich angeordnet sein.

Fig. 27c zeigt eine schematische Seitenansicht einer Anlage zur Erzeugung von Modifikationen 9 im Inneren eines Spendersubstrats 1 bzw. Festkörpers. Bevorzugt ist ein Element 29 einer Lasereinrichtung, insbesondere ein Laserkopf, oder ein mit einem Laser verbundener Strahlenleiter an einer Verfahr- bzw. Umpositioniereinrichtung 30, die bevorzugt raumfest angeordnet ist, angeordnet. Die Verfahr- bzw. Umpositioniereinrichtung 30 ermöglicht bevorzugt ein Bewegen des Elements 29 der Lasereinrichtung bzw. ein Bewegen der Lasereinrichtung in bevorzugt linearer Richtung, insbesondere in radialer Richtung der Rotationseinrichtung 45. Somit wird das Element 29 der Lasereinrichtung bzw. die Lasereinrichtung nach dem Erzeugen einer oder mehrerer definierter Schreiblinien 103 auf bevorzugt mehreren oder allen Spendersubstraten 1 umpositioniert. Durch die Umpositionierung werden die emittierten Laserstrahlen an einem anderen Ort 5 zur Modifikationserzeugung in das jeweilige Spendersubstrat 1 eingeleitet.

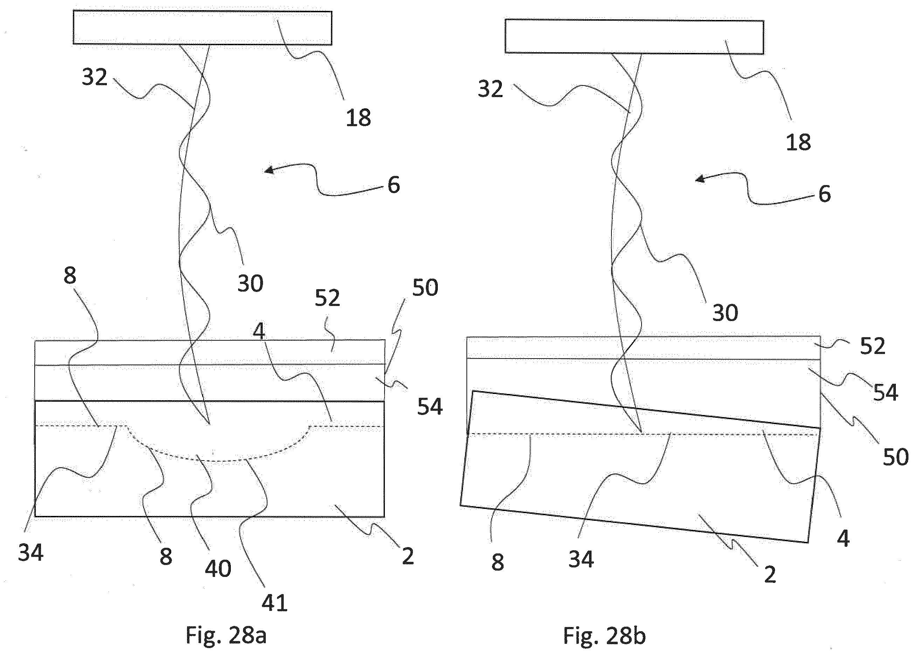

Gemäß Fig. 28a ist eine Defekterzeugungseinrichtung 18 bzw. Modifikationserzeugungseinrichtung gezeigt, die jedoch derart ausgeführt ist, dass sie die Modifikationen 34 bevorzugt zumindest abschnittsweise in voneinander verschiedenen Ebenen erzeugt, wodurch zumindest abschnittsweise die eine oder mehrere Rissführungsschichten 8 erzeugt werden, die der Oberfläche bzw. der Kontur der Oberfläche eines dreidimensionalen Körpers entsprechen.

Es kann somit durch die vorliegende Ausführungsform nicht nur eine ebene Festkörperschicht 4, sondern ebenfalls ein unebener Festkörper 40 in Folge eines Bruchs oder einer Rissführung aus einem Werkstück bzw. Festkörper 1 herausgelöst werden. Weiterhin ist denkbar, dass ein Festkörper 40 aus dem Festkörper 1 herausgelöst wird, der sich abschnittsweise eben und abschnittsweise dreidimensional erstreckt.

Ferner ist denkbar, dass eine Immersionsflüssigkeit 54 als Tropfen oder, wie dargestellt, als Flüssigkeitsschicht, auf der exponierten Oberfläche des Festkörpers 1 aufgebracht wird. Ist die Immersionsflüssigkeit 54 als Flüssigkeitsschicht vorgesehen, dann ist bevorzugt auch eine Wandungseinrichtung 50 zum Ausbilden einer Aufnahmewanne vorgesehen, damit die Flüssigkeit an der gewünschten Position gehalten wird. Weiterhin kann eine Abdeckplatte 52 auf die Flüssigkeit aufgebracht, insbesondere aufgelegt oder eingetaucht, werden. Die Immersionsflüssigkeit 54 weist bevorzugt im Wesentlichen oder genau denselben Brechungsindex auf, wie der Festkörper 1. Der Brechungsindex der Abdeckplatte kann von dem Brechungsindex der Immersionsflüssigkeit abweichen oder ebenfalls damit übereinstimmen. Es ist somit besonders bevorzugt denkbar, dass, insbesondere zum Ausgleich von Oberflächenrauheiten, die Defekterzeugung durch die Immersionsflüssigkeit 54 und besonders bevorzugt durch die Immersionsflüssigkeit 54 und die Abdeckplatte 52 hindurch erzeugt wird. Der Fokus des Lasers 18 wird zur Defekterzeugung bevorzugt computergesteuert geführt.

In Fig. 28b ist eine weitere Anordnung gezeigt, gemäß der in einem geneigten Festkörper 1, insbesondere einem Ingot, eine zum Ablösen einer unebene Festkörperschicht 4 bzw. eines unebenen Festkörpers 40 eine Rissführungsschicht 8 erzeugt wird. Zur präzisen Erzeugung der Rissführungsschicht 8 wird bevorzugt eine Immersionsflüssigkeit 54 bereitgestellt. Die als Tropfen oder, wie dargestellt, als Flüssigkeitsschicht auf der exponierten Oberfläche des Festkörpers 1 aufgebracht wird. Ist die Immersionsflüssigkeit 54 als Flüssigkeitsschicht vorgesehen, dann ist bevorzugt auch eine Wandungseinrichtung 50 zum Ausbilden einer Aufnahmewanne vorgesehen, damit die Flüssigkeit an der gewünschten Position gehalten wird. Weiterhin kann eine Abdeckplatte 52 auf die Flüssigkeit aufgebracht, insbesondere aufgelegt oder eingetaucht, werden. Die Immersionsflüssigkeit 54 weist bevorzugt im Wesentlichen oder genau denselben Brechungsindex auf, wie der Festkörper 1. Durch die Immersionsflüssigkeit 54 wird bewirkt, dass in dem Weg zwischen der Abdeckplatte 52 und der zu erzeugenden Rissführungsschicht 8 stets der gleiche Brechungsindex vorliegt, damit die Modifikationserzeugung möglichst fehlerfrei erfolgen kann.

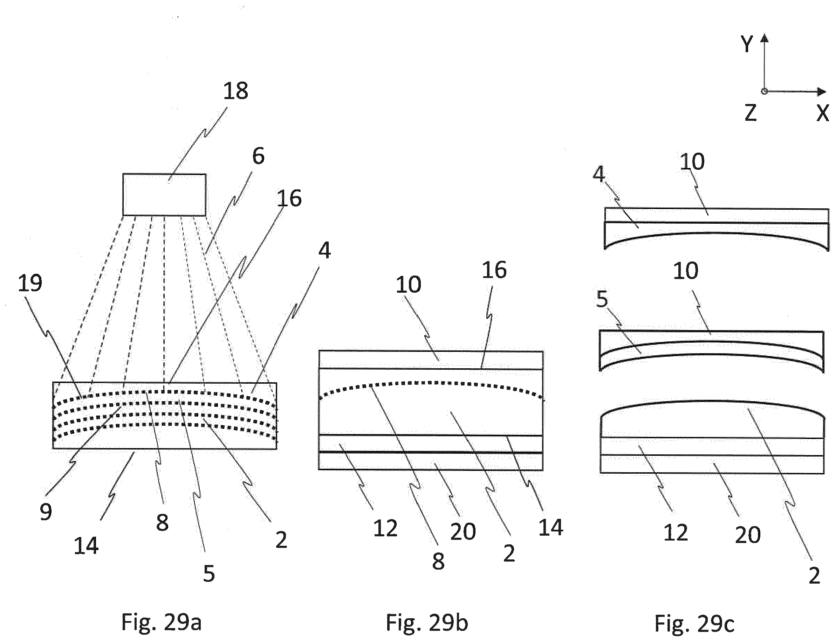

In Fig. 29a ist ein Festkörper 2 bzw. ein Substrat gezeigt, das im Bereich einer Strahlungsquelle 18, insbesondere einem Laser, angeordnet ist. Der Festkörper 2 weist bevorzugt einen ersten ebenen Flächenanteil 14 und einen zweiten ebenen Flächenanteil 16 auf, wobei der erste ebene Flächenanteil 14 bevorzugt im Wesentlichen oder genau parallel zu dem zweiten ebenen Flächenanteil 16 ausgerichtet ist. Der erste ebene Flächenanteil 14 und der zweite ebene Flächenanteil 16 begrenzen bevorzugt den Festkörper 2 in einer Y-Richtung, die bevorzugt vertikal bzw. lotrecht ausgerichtet ist. Die ebenen Flächenanteile 14 und 16 erstrecken sich bevorzugt jeweils in einer X-Z-Ebene, wobei die X-Z-Ebene bevorzugt horizontal ausgerichtet ist. Alternativ ist jedoch denkbar, dass der erste und/oder der zweite Flächenanteil 14, 16 eine unebene, insbesondere gewölbte, Form aufweist.

Weiterhin lässt sich dieser Darstellung entnehmen, dass die Strahlungsquelle 18 Stahlen 6 auf den Festkörper 2 ausstrahlt. Die Strahlen 6 dringen je nach Konfiguration bzw. in Abhängigkeit von vorgegebenen Parametern definiert tief in den Festkörper 2 ein und erzeugen an der jeweiligen Position bzw. an der jeweils vorbestimmten Position eine Kristallgittermodifikation 19, insbesondere einen Defekt. Bevorzugt werden so viele Modifikationen bzw. Kristallgittermodifikationen 19 erzeugt, dass durch diese mindestens ein Ablösebereich 8 vorgegeben wird. Bevorzugt weist der Ablösebereich 8 eine unebene Kontur bzw. unebene Form auf, wobei der Ablösebereich 8 besonders bevorzugt zumindest abschnittsweise eine sphärische, insbesondere gewellte und/oder gewölbte und/oder gebogene, Form aufweist. Weiterhin können die Strahlen 6 z.B. zum Fokussieren oder Bündeln durch eine Optik geleitet werden, die bevorzugt zwischen der Strahlungsquelle 18 und dem Festkörper 2 angeordnet ist (nicht gezeigt).

Das Bezugszeichen 9 kennzeichnet einen weiteren Ablösebereich in dem Festkörper 2. Gemäß einer Ausführungsform kann der weitere Ablösebereich 9 ebenfalls während der Erzeugung des Ablösebereichs 8 erzeugt werden. Alternativ ist denkbar, dass der weitere Ablösebereich 9 nach oder vor der Erzeugung des Ablösebereichs 8 erzeugt wird. Bevorzugt wird der weitere Ablösebereich 9 nach dem Abtrennen des Festkörperanteils 4 oder vor dem Abtrennen des Festkörperanteils 4 erzeugt. Bevorzugt werden durch mehrere Ablösebereiche 8, 9 in einem Festkörper 2 mehrere Festkörperanteile 4, 5 definiert, die bevorzugt nacheinander von dem Festkörper 2 abtrennbar sind. Gemäß einer bevorzugten Ausführungsform der vorliegenden Erfindung wird in einem Festkörper 2 genau oder mindestens oder höchstens ein Ablösebereich 8 erzeugt. Gemäß einer weiteren bevorzugten Ausführungsform der vorliegenden Erfindung werden zwei, mindestens zwei oder genau zwei oder drei, mindestens drei oder genau drei oder vier, mindestens vier oder genau vier oder fünf, mindestens fünf oder genau fünf oder mehrere, insbesondere z.B. bis zu 10 oder 25 oder 50 oder 100 oder 500, Ablösebereiche in dem Festkörper 2 erzeugt.

In Fig. 29b ist eine mehrschichtige Anordnung gezeigt, wobei der Festkörper 2 den Ablösebereich 8 beinhaltet und im Bereich des ersten Flächenanteils 14 mit einer Halteschicht 12 versehen ist, die wiederum bevorzugt von einer weiteren Schicht 20 überlagert wird, wobei die weitere Schicht 20 bevorzugt eine Stabilisierungseinrichtung, insbesondere eine Metallplatte, ist. An dem zweiten Flächenanteil 16 des Festkörpers 2 ist bevorzugt eine Aufnahmeschicht, insbesondere eine Polymerschicht 10, angeordnet. Die Aufnahmeschicht 10 und/oder die Halteschicht 12 bestehen bevorzugt zumindest teilweise und besonders bevorzugt vollständig aus einem Polymer, insbesondere aus PDMS.

Alternativ ist denkbar, dass die Aufnahmeschicht 10 z.B. mittels Epitaxie auf der Oberfläche des Festkörpers 2 erzeugt wird. Bevorzugt weisen die erzeugte Aufnahmeschicht 10 und der Festkörper 2 voneinander verschiedene Temperaturausdehnungskoeffizienten auf. Nach der Erzeugung der Aufnahmeschicht 10, die in diesem Fall auch als Beschichtung 50 verstanden werden kann, erfolgt bevorzugt eine Abkühlung der geschaffenen Mehrschichtanordnung, wodurch sich aufgrund der unterschiedlichen thermischen Ausdehnungskoeffizienten Spannungen ergeben, durch welche der Festkörperanteil 4 von dem Festkörper 2 entlang dem Ablösebereich 8 abgetrennt bzw. abgelöst wird.

In Fig. 29c ist ein Zustand nach einer Rissauslösung und anschließender Rissführung gezeigt. Die Festkörperschicht 4 haftet an der Polymerschicht 10 und ist von dem verbleibenden Rest des Festkörpers 2 beabstandet bzw. beabstandbar.

Weiterhin können gemäß Ausführungsformen der vorliegenden Erfindung unterschiedliche Ablösebereiche 8, 9 unterschiedliche Formen bzw. Konturen aufweisen. Weiterhin ist denkbar, dass z.B. der zweite Flächenanteil 16, der eine Oberfläche des später abgetrennten Festkörperanteils 4, 5 ist, vor dem Abtrennen des Festkörperanteils 4, 5 in eine andere Form gebracht wird. Diese Formänderung kann analog zum Abtrennen des Festkörperanteils 4, 5 erfolgen oder durch eine spanende Bearbeitung, insbesondere einen Schleifprozess, bewirkt werden.

Eine weitere Ausführungsform bezieht sich somit auf ein Verfahren zum Herstellen von Festkörperschichten. Das Verfahren gemäß einer solchen Ausführungsform umfasst dabei mindestens die Schritte des Bereitstellens eines Festkörpers 2 zum Abtrennen mindestens einer Festkörperschicht 4, des Erzeugens von Modifikationen, wie Kristallgitterdefekten, mittels mindestens eines Modifikationsmittels, insbesondere einer Strahlungsquelle, insbesondere mindestens einem Laser, insbesondere mindestens einem fs-Laser oder ps-Laser oder ns-Laser, in der inneren Struktur des Festkörpers zum Vorgeben mindestens eines Ablösebereichs 8, 9, entlang dem die Festkörperschicht/en 4, 5 vom Festkörper 2 abgetrennt wird, werden. Ferner umfasst das Verfahren gemäß einer Ausführungsform bevorzugt den Schritt des thermischen Beaufschlagens einer an dem Festkörper 2 angeordneten Polymerschicht 10 zum, insbesondere mechanischen, Erzeugen von Spannungen in dem Festkörper 2, wobei sich durch die Spannungen ein Riss in dem Festkörper 2 entlang des Ablösebereichs 8 ausbreitet, der die Festkörperschicht 4 von dem Festkörper 2 abtrennt.

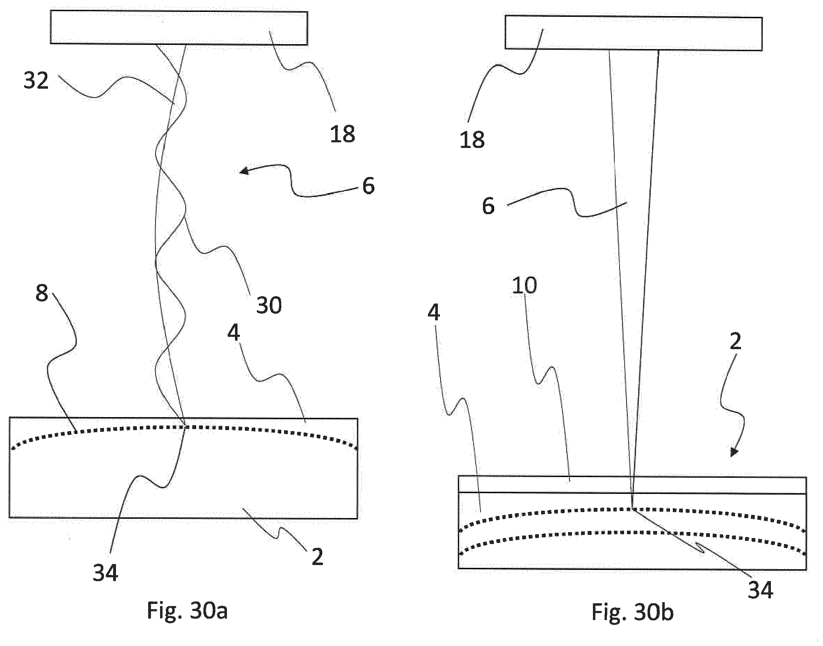

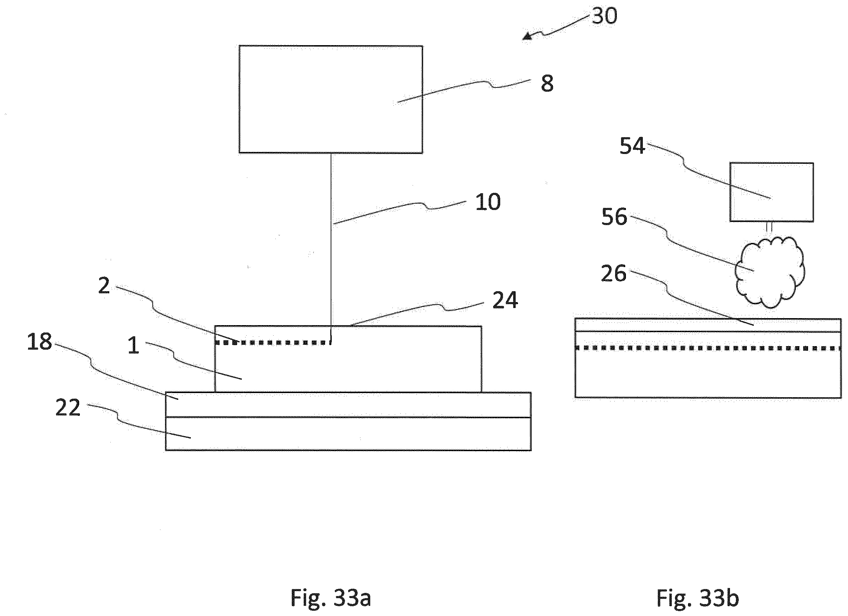

In den Figuren 30a und 30b sind Beispiele für die in Fig. 33a gezeigte Erzeugung eines Ablösebereichs 8 durch die Einbringung von Modifikationen 19, insbesondere Defekten oder Schadstellen, in einen Festkörper 2 mittels Laserstrahlen 6 gezeigt.

In Fig. 30a ist somit schematisch gezeigt, wie Modifikationen 19 in einem Festkörper 2, insbesondere zur Erzeugung eines Ablösebereichs 8 mittels einer Strahlungsquelle 18, insbesondere einem oder mehrerer Laser, insbesondere einem oder mehrerer fs-Laser, erzeugbar sind. Die Strahlungsquelle 18 emittiert dabei Strahlung 6 mit einer ersten Wellenlänge 30 und einer zweiten Wellenlänge 32. Die Wellenlängen 30, 32 sind dabei derart aufeinander abgestimmt bzw. die Distanz zwischen der Strahlungsquelle 18 und des zu erzeugenden Ablösebereichs 8 ist derart abgestimmt, dass die Wellen 30, 32 im Wesentlichen oder genau auf dem Ablösebereich 8 in dem Festkörper 2 zusammentreffen, wodurch am Ort des Zusammentreffens 34 infolge der Energien beider Wellen 30, 32 ein Defekt erzeugt wird. Die Defekterzeugung kann dabei durch unterschiedliche oder kombinierte Zersetzungsmechanismen wie z.B. Sublimation oder chemische Reaktion erfolgen, wobei die Zersetzung dabei z.B. thermisch und/oder photochemisch initiiert werden kann.

In Fig. 30b ist ein fokussierter Lichtstrahl 6 gezeigt, dessen Brennpunkt bevorzugt im Ablösebereich 8 liegt. Es ist hierbei denkbar, dass der Lichtstrahl 6 durch eine oder mehrere fokussierende Körper, insbesondere Linse/n (nichtgezeigt), fokussiert wird.

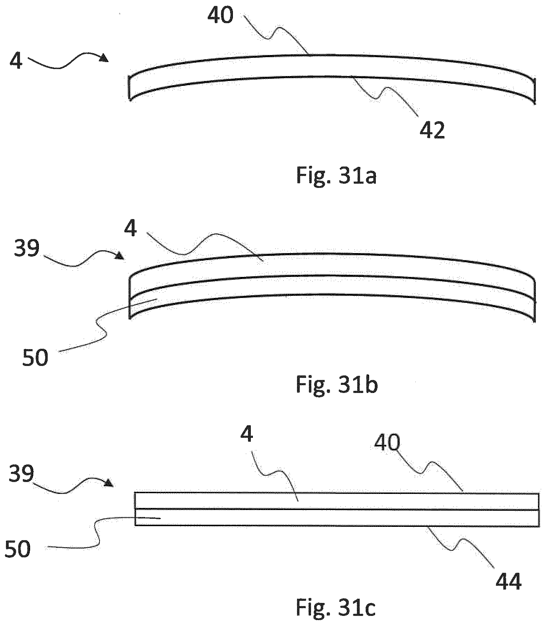

In Fig. 31a ist ein unebener Festkörperanteil 4 oder ein unebener Wafer dargestellt, wobei der Festkörperanteil 4 oder der Wafer 4 gemäß einer Darstellung ein Warp ausbildet bzw. im Querschnitt eine Warpform zeigt. Es ist hierbei denkbar, dass der Festkörperanteil 4 zwei zueinander negativ ausgebildete Oberflächenkonturen bzw. Oberflächenformen aufweist. Es ist jedoch ebenfalls denkbar, dass die Oberflächenkonturen bzw. Oberflächenformen der zwei einander gegenüberliegenden Hauptoberflächen 40, 42 des Festkörperanteils 4 nicht negativ zueinander ausgebildet sind, sondern voneinander verschiedene Konturen bzw. Formen aufweisen.

Fig. 31b zeigt die Erzeugung einer Beschichtung 50, insbesondere eine epitaktisch erzeugten Schicht. Die Beschichtung 50 wird bevorzugt bei einer Temperatur von über 50°C, insbesondere über 100°C oder über 150°C oder über 200°C oder über 300°C oder über 400°C, auf dem Festkörperanteil 4 angeordnet oder erzeugt. Es ist hierbei denkbar, dass die Beschichtung 50 im Wesentlichen oder mit einer konstanten Dicke auf dem Festkörperanteil 4 angeordnet oder erzeugt wird. Alternativ ist jedoch ebenfalls denkbar, dass die Beschichtung 50 lokal verschiedene Dicken aufweist. Die weitere Behandlung stellt somit bevorzugt die Anordnung oder Erzeugung einer definierten Beschichtung 50 auf mindestens einer Oberfläche 40, 42 des Festkörperanteils 4 dar. Die vorgegebenen Parameter umfassen dabei bevorzugt zumindest Daten, durch die zumindest mittelbar die thermischen Ausdehnungskoeffizienten des Materials des Festkörperanteils 4 und der Beschichtung 50 einbezogen werden oder durch die eine Verformung des Festkörperanteils 4 infolge einer definierten Temperierung des mit der Beschichtung 50 versehenen Festkörperanteils 4 einbezogen oder vorgegeben wird.

In Fig. 31c ist eine Situation nach der Erzeugung oder Anordnung der Beschichtung 50 an mindestens einer Oberfläche 40, 42 des Festkörperanteils 4 gezeigt, wobei sich die Form der erzeugten Mehrkomponentenanordnung 39 aufgrund von unterschiedlichen thermischen Ausdehnungskoeffizienten verändert hat. Bevorzugt ist zumindest eine der Hauptoberflächen 40 und 44 der Mehrkomponentenanordnung 39 bzw. Mehrschichtanordnung in eine ebene oder im Wesentlichen ebene Form überführt. Die Verformung ergibt sich bevorzugt in Folge einer bevorzugt definierten Temperierung, insbesondere Erwärmung oder Abkühlung, der Mehrschichtanordnung 39.

Der Festkörperanteil 4 ist somit derart in Abhängigkeit von dem nachgelagerten Behandlungsverfahren, insbesondere Beschichtungsverfahren, gestaltet, dass sich die Form einer oder beider Hauptoberflächen 40, 42 des Festkörperanteils 4 infolge der Behandlung, insbesondere des Beschichtungsverfahrens, definiert verändert, insbesondere abflacht oder eben ausbildet. Besonders bevorzugt handelt es sich bei der Beschichtung um eine Metallschicht oder eine Halbleiterschicht, insbesondere um eine Galliumnitridschicht (GaN) oder Siliziumschicht, die auf einem Festkörperanteil aus Silizium, Saphir, Siliziumcarbid (SiC) oder Galliumarsenid (GaAs) angeordnet oder erzeugt wird.

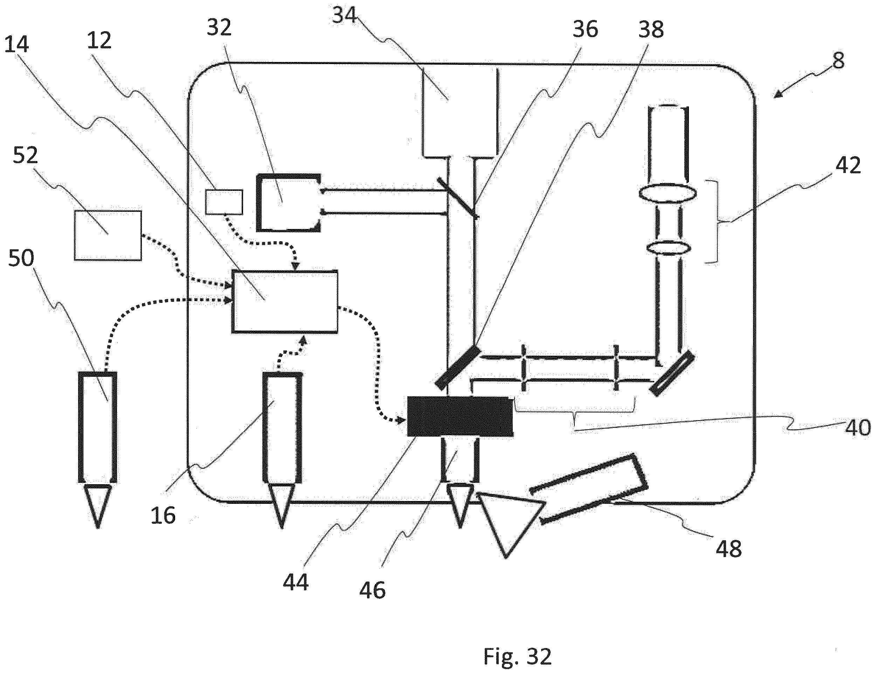

Fig. 32 zeigt einen Laserbeaufschlagungseinrichtung 8, wie sie gemäß einer Ausführungsform der Erfindung in einem Verfahren und in einer Vorrichtung 30 zum Erzeugen von Modifikationen 2 in einem Festkörper 1 vorgesehen ist.

Die Laserbeaufschlagungseinrichtung 8 weist hierbei mindestens eine Laserstrahlenquelle 32, insbesondere mit Fokusmarkierung, auf. Bei der Laserstrahlenquelle 32 kann es sich somit bevorzugt konkret um eine koaxiale Lichtquelle mit Fokusmarkierung handeln. Die durch die Laserstrahlenquelle 32 erzeugten Lichtstrahlen 10 werden bevorzugt auf einem vorbestimmten Weg von der Laserstrahlenquelle 32 zu einer Fokuseinrichtung 44 bzw. einer Einstelleinrichtung 44 zum Einstellen einer Fokusgröße und einer Fokusposition in dem Festkörper 1 geleitet. Bei der Einstelleinrichtung 44 kann es sich hierbei bevorzugt um eine Feinfokussiereinrichtung, insbesondere in Z-Richtung bzw. in Laserstrahlverlaufsrichtung, handeln. Bevorzugt kann die Einstelleinrichtung 44 als Piezofeinfokussiereinrichtung ausgebildet sein. Die durch die Einstelleinrichtung 44 hindurch gegangenen Laserstrahlen 10 passieren bevorzugt ein Mikroskop mit langem Arbeitsabstand 46. Besonders bevorzugt wird durch das Mikroskop mit dem langen Arbeitsabstand 46 und die Einstelleinrichtung 44 die Laserstrahlung derart angepasst bzw. eingestellt bzw. modifiziert, dass die Modifikation 2 an der vordefinierten Stelle erzeugt wird. Es ist hierbei denkbar, dass die Modifikation 2 an einer Stelle erzeugt wird, die z.B. weniger als 5 μm und bevorzugt weniger als 2 μm und besonders bevorzugt weniger als 1 μm von der vordefinierten Stelle abweicht bzw. dazu beabstandet ist. Die Einstelleinrichtung 44 wird bevorzugt mittels einer Steuereinrichtung 14 angesteuert, wobei die Steuereinrichtung 14 bevorzugt die Relativposition und Orientierung des Festkörpers 1 gegenüber der Laserbeaufschlagungseinrichtung 8 oder den Abstand des aktuellen Oberflächenanteils, in den Laserstrahlung eingeleitet werden soll, zu der Laserbeaufschlagungseinrichtung 8 sowie die lokale Brechzahl oder mittlere Brechzahl des Festkörpermaterials und die Bearbeitungstiefe des Festkörpers 1 an der jeweiligen Stelle für die Einstellung der Laserbeaufschlagungseinrichtung 8, insbesondere zumindest der Einstelleinrichtung 44, berechnet bzw. bestimmt bzw. verwendet. Die Steuerungseinrichtung 14 kann die erforderlichen Daten in Echtzeit durch entsprechende und damit kommunizierend verbundene Sensoreinrichtungen bzw. Sensormittel erfassen bzw. empfangen. Alternativ ist jedoch ebenfalls denkbar, dass z.B. für einen oder beide der Parameter Brechzahl und Bearbeitungstiefe vor Bearbeitungsbeginn eine Analyse der Oberfläche vorgenommen bzw. durchgeführt wird, über welche die Laserstrahlen 10 in den Festkörper 1 zur Erzeugung der Modifikationen 2 eindringen. Die Parameter können dann in Form entsprechender ortsabhängiger Daten in einer Speichereinrichtung bzw. einem Datenspeicher 12 vorgehalten werden bzw. darin eingelesen werden. Der Datenspeicher 12 kann hierbei als Wechselmedium, insbesondere eine Speicherkarte, oder als fest verbauter Speicher ein Teil der Laserbeaufschlagungseinrichtung 8 sein.

Alternativ ist jedoch ebenfalls denkbar, dass der Datenspeicher 12 außerhalb der Laserbeaufschlagungseinrichtung 8 angeordnet ist und zumindest zeitweise kommunizierend mit der Laserbeaufschlagungseinrichtung 8 verbindbar ist. Zusätzlich oder alternativ kann der Steuereinrichtung 14 durch einen Nutzer 52 Arbeitsabläufe oder Änderungen im Arbeitsablauf vorgegeben werden. Ferner ist denkbar, dass der Datenspeicher 12 als Bestandteil der Steuerungseinrichtung 14 ausgebildet ist. Zusätzlich oder alternativ können mittels einer Sensoreinrichtung 16 Distanzdaten zum Abstand zwischen vorgegebenen Oberflächenpunkten des Festkörpers 1 und der Laserbeaufschlagungseinrichtung 8 erfasst werden. Diese Distanzdaten werden bevorzugt ebenfalls der Steuerungseinrichtung 14 zur Verarbeitung bereitgestellt.

Weiterhin ist vorstellbar, dass die Laserstrahlbeaufschlagungseinrichtung 8 eine Kamera 34, insbesondere eine koaxiale Fokuskamera, aufweist. Die Kamera 34 ist bevorzugt in Richtung des Strahlengangs der aus der Laserbeaufschlagungseinrichtung 8 austretenden Laserstrahlen 10 angeordnet. Es ist hierbei denkbar, dass ein optisches Element 36, insbesondere ein teilweise transparenter Spiegel in dem optischen Feld der Kamera 34 angeordnet ist. Bevorzugt wird durch das optische Element 34 die Laserstrahlung 10 in das optische Feld der Kamera eingeschleust.

Weiterhin ist vorstellbar, dass ein weiteres optisches Element 38 bzw. ein diffraktives optisches Element, insbesondere ein Strahlteiler 38, vorgesehen ist. Durch den Strahlteiler 38 kann hierbei ein Teil des Laserstrahls 10 von dem Hauptstrahl ausgeleitet bzw. abgetrennt werden. Ferner kann der abgetrennte bzw. ausgeleitete Anteil der Laserstrahlung durch eine optionale sphärische Aberrationskompensation 40 und/oder durch eine optionale Strahlerweiterung 42 bzw. Strahlaufweitung modifiziert werden.

Ferner kennzeichnet das Bezugszeichen 48 eine bevorzugt vorgesehenen Fluidbereitstellungseinrichtung 48, insbesondere zum Bereitstellen eines Kühlfluides. Bevorzugt kann mittels der Fluidbereitstellungseinrichtung 48 eine Temperierung, insbesondere Abkühlung, des Festkörpers 1 und/oder des Mikroskops, bewirkt werden.

Das Bezugszeichen 50 kennzeichnet ein Brechzahlbestimmungsmittel, das bevorzugt auch transparente und reflektierende Oberflächen analysieren kann. Bevorzugt erfolgt die Brechzahlbestimmung mit dem Brechzahlbestimmungsmittel 50 im Vorfeld der Modifikationserzeugung. Es ist hierbei alternativ denkbar, dass die Brechzahlbestimmung an einer anderen Anlage durchgeführt wird und die erfassten Daten der vorliegenden Laserbeaufschlagungseinrichtung 8 mittels Datentransfer zugeführt wird.

Die in Fig. 32 dargestellten Punktlinien mit einem Pfeilende kennzeichnen hierbei bevorzugt Daten und/oder Signal Übertragungen.

Fig. 33a zeigt schematisch eine bevorzugte Anordnung der Vorrichtungskomponenten Laserbeaufschlagungseinrichtung 8, Aufnahmeeinrichtung 18 und Antriebs- bzw. Verfahreinrichtung 22 der Vorrichtung 30. Es ist ersichtlich, dass der Festkörper 1 gemäß dieser Anordnung bevorzugt zwischen der Aufnahmeeinrichtung 18 und der Laserbeaufschlagungseinrichtung 8 angeordnet ist. Bevorzugt ist der Festkörper 1 an der Aufnahmeeinrichtung 18 angeklebt, wobei auch denkbar ist, dass er daran angepresst wird.

Fig. 33b zeigt eine Anordnung nach der Erzeugung der Modifikationen 2 bzw. nach der vollständigen Erzeugung des Rissführungsbereichs 4. An der Oberfläche 24 des Festkörpers 1, über welche die Laserstrahlen 10 in den Festkörper 1 eingedrungen sind, ist gemäß dieser Darstellung eine Aufnahmeschicht bzw. Polymerschicht 26 angeordnet bzw. ausgebildet. Weiterhin wird durch die Einrichtung 54 eine Funktionsfluidquelle gekennzeichnet, die das Funktionsfluid 56 ausgibt. Bei dem Funktionsfluid 56 handelt es sich bevorzugt um flüssigen Stickstoff. Durch das Funktionsfluid 56 erfolgt somit eine Abkühlung der Aufnahmeschicht 26 auf eine Temperatur unterhalb von 20°C, insbesondere auf eine Temperatur unterhalb von 10°C oder auf eine Temperatur unterhalb von 0°C oder auf eine Temperatur unterhalb der Glasübergangstemperatur des Polymermaterials der Aufnahmeschicht 26. Durch die Abkühlung der Aufnahmeschicht 26 werden hohe mechanische Spannungen erzeugt, durch die eine Rissausbreitung entlang dem Rissführungsbereich 4 erfolgt.

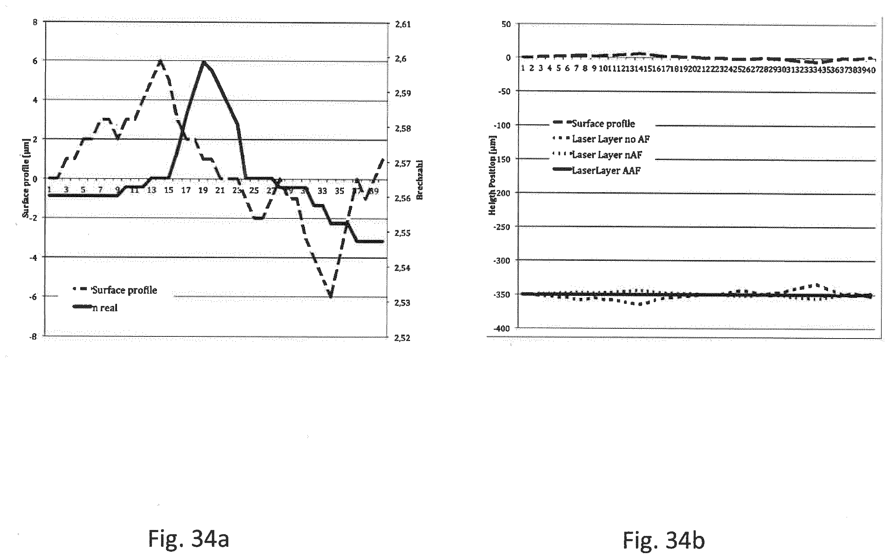

Fig. 34a zeigt rein exemplarisch den Zusammenhang zwischen einem Oberflächenprofil eines Festkörpers 1 und der Brechzahl des Festkörpermaterials. Die auf der horizontalen Achse angegebenen Werte liegen in der Einheit μm vor.

Fig. 34b zeigt exemplarische Abweichungen des zu lasernden Materials (Oberflächenprofil und lateraler Brechzahlverlauf) sowie Laserfokuslage (no AF: ohne Autofokus wird Oberflächenprofil invers um Brechzahl verstärkt in das Material geschrieben, ein Standard-AF kehrt diese Inversion um, so dass das Oberflächenprofil n-fach verstärkt übertragen wird. nAF: berücksichtigt die Substratbrechzahl bzw. Brechzahl als festen Faktor, so dass damit das Oberflächenprofil 1:1 in das Material übertragen wird. AAF: die gewünschte Advanced Autofokusfunktion kann mit Kenntnis der mittleren Substratbrechzahl und der Zieltiefe eine exakt horizontal Ebene in das Material schreiben).

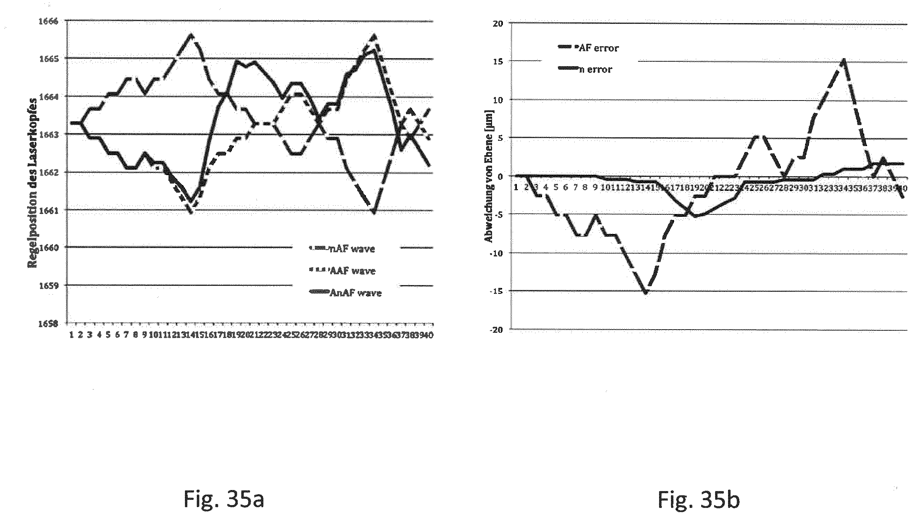

Fig. 35a zeigt rein exemplarisch verschiedene Regelpositionen des Laserfokus. Die auf der horizontalen Achse angegebenen Werte liegen in der Einheit μm vor. Somit kann die Waveform als Regeleingangsgröße für die Position des Laserkopfes in verschiedenen Fällen bestimmt werden:

nAF (n-aware AF): die Autofokusführungsgröße der Oberfläche um die mittlere Substratbrechzahl (n) zu korrigieren. Damit kann die Oberflächen-Abweichung 1:1 ins Volumen übertragen werden. Der abzuspaltende Wafer wird somit theoretisch keine Dickenschwankungen (TTV) aufweisen. Jedoch bleibt die Topographie und somit die schlechte Planarität sowohl für den Wafer als auch den Verbleibenden Ingot erhalten.

AAF (advanced AF): die Autofokusführungsgröße der Oberfläche mit Kenntnis der mittlere Substratbrechzahl und der Ausgleichsebene der Oberfläche zu korrigieren. Damit gelingt bei homogenen Proben ohne Abweichungen von der mittleren Brechzahl eine plane Laserebene, die mit preiswertem Polierschritt den Halbleiterkristall sehr plan für weitere Splits vorbereitet. Hingegen wird der abgespaltene Wafer direkt nach dem Split einseitig plan aber höherer Dickenabweichung aufweisen.

AnAF (Advanced n-aware AF): die Autofokusführungsgröße der Oberfläche mit Kenntnis der lokalen Substratbrechzahl und der Ausgleichsebene der Oberfläche zu korrigieren. Damit gelingt auch bei inhomogenen Proben mit Vorwissen eine plane Laserebene, die mit preiswertem Polierschritt den Halbleiterkristall sehr plan für weitere Splits vorbereitet.

Ein Verfahren zur Erzeugung von Modifikationen in einem Festkörper, wobei durch die Modifikationen ein Rissführungsbereich zum Führen eines Risses zum Abtrennen eines Festkörperanteils, insbesondere einer Festkörperschicht, von dem Festkörper vorgegeben wird, umfasst einen oder mehrere oder alle der nachfolgend genannten Schritte:

Bewegen des Festkörpers relativ zu einer Laserbeaufschlagungseinrichtung, nacheinander Erzeugen von einer Vielzahl an Laserstrahlen mittels der Laserbeaufschlagungseinrichtung zum Erzeugen von jeweils mindestens einer Modifikation, wobei die Laserbeaufschlagungseinrichtung zur definierten Fokussierung der Laserstrahlen kontinuierlich in Abhängigkeit von einer Vielzahl an Parametern, insbesondere mindestens zwei Parametern, eingestellt wird. Bevorzugt wird durch das Verfahren gemäß einer solchen Ausführungsform ein planarer Mikrofokus für Mehrphotonen-Materialbearbeitung im Volumen ermöglicht.

Fig. 35b zeigt zwei Verläufe, die Profile unterschiedlicher Modifikationsverteilungen repräsentieren.

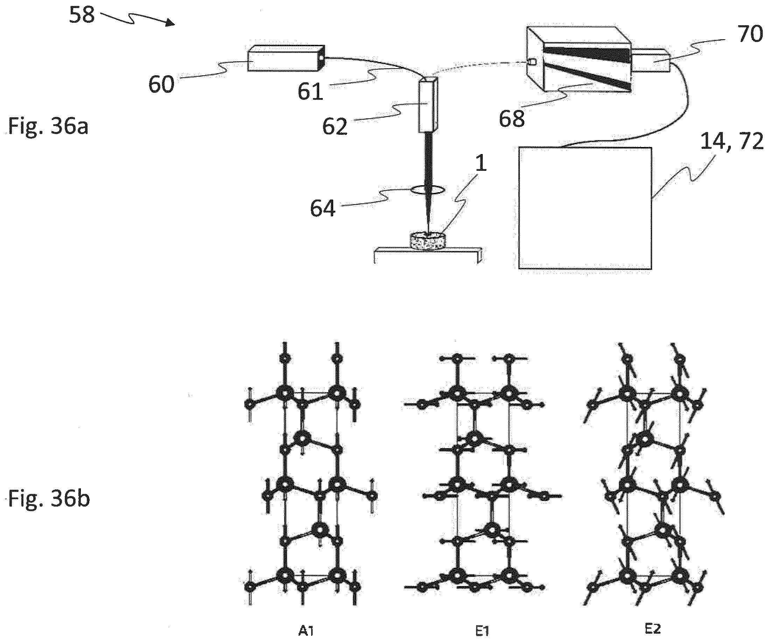

Fig. 36a zeigt ein Raman-Instrument. Das hier gezeigte Raman-Instrument 58 weist einen Laser 60 zum Emittieren von Strahlung auf. Die Strahlung wird bevorzugt mittels mindestens einer optischen Faser 61 für eine Anregung bevorzugt einer Optik zugeführt und von dieser Optik, insbesondere Linse 64, bevorzugt fokussiert, insbesondere in den Festkörper fokussiert. Diese Strahlung wird zumindest teilweise gestreut, wobei bevorzugt mittels einer Filtereinrichtung bzw. Anregungsfilter 62 Lichtanteile herausgefiltert werden, welche dieselbe Wellenlänge wie die vom Laser emittierte Strahlung aufweisen. Die sonstigen Strahlungsanteile werden dann einem Spektrographen 68 zugeführt und mittels einer Kameraeinrichtung, insbesondere einem CCD-Detektor 70 erfasst und von einer Steuerungseinrichtung 14, 72, insbesondere einem Computer, ausgewertet bzw. aufbereitet.

Es werden somit bevorzugt Atomschwingungen im Kristall durch einen bevorzugt externen oder besonders bevorzugt weiteren Laser angeregt. Diese Schwingungen werden durch Lichtstreuung an Kristallatomen erzeugt, was zu beobachtbarem gestreutem Licht führt, was eine um den Betrag der Schwingungsenergie veränderte Photonenenergie aufweist. Bei mehreren anregbaren Schwingungen treten auch mehrere Peaks im Spektrum des gestreuten Lichts auf. Mit einem Spektrometer (Gitterspektrometer) kann dann das entstandene Raman-Streuungsspektrum näher untersucht werden (sog. Raman-Spektroskopie). Bei dieser Methode sind den einzelnen Raman-Linien in ihrer Form die lokalen Bedingungen im Kristall aufgeprägt und durch eine Analyse der Form der Raman-Linie kann auf den Dotiergrad rückgeschlossen werden.

Fig. 36b zeigt, wie mögliche Gitterschwingungen in SiC aussehen, wobei diese Moden durch Kristallsymmetrie und Richtungen vorgegeben sind und auch gleichzeitig angeregt sein können. Die gezeigten Ansichten weisen eine Erstreckung entlang der Kristallachse A auf. Hierbei sind Schwingungen der Atome nur in bestimmten Richtungen möglich, wobei die Richtungen durch die Symmetrie des Kristalls vorgegeben sind.

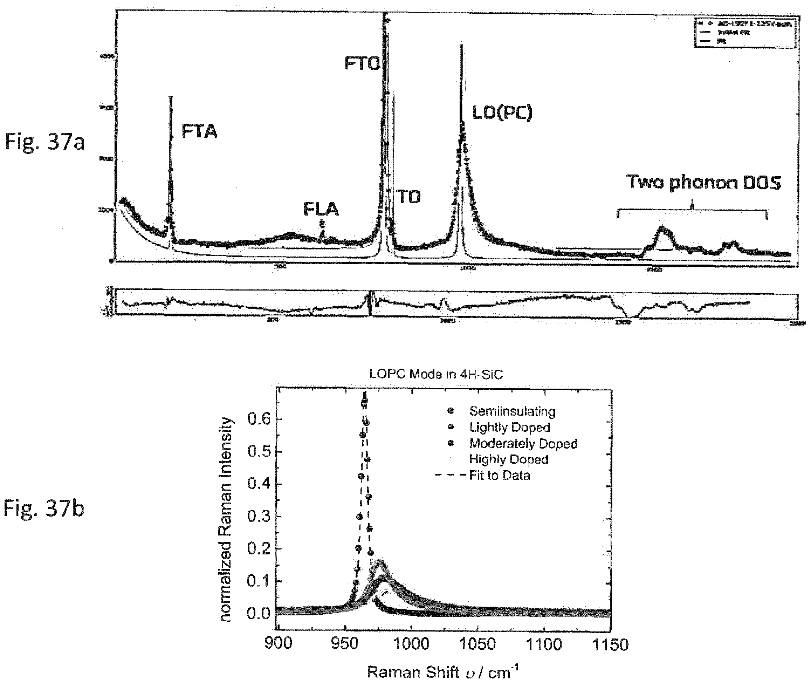

Fig. 37a zeigt einen Ausschnitt eines Raman-Verlaufs, eines mit Stickstoff dotierten 4H-Siliziumcarbid-Festkörpers (Beispielspektrum für Raman an dotiertem SiC). Hierbei wird die Form der LO(PC)-Mode zur Messung der Dotierkonzentration herangezogen und gefittet. Unteres Panel: Fitting-Residual.

Fig. 37b zeigt einen kleineren Ausschnitt des Raman-Verlaufs.

Wie dargestellt ergibt sich eine direkte Methode, um mit Raman-Messungen die Dotandenkonzentration zu bestimmen aus einer Messung der Form und folgendem Fit an die LO(PC)-Mode.

Generell ist es somit das Ziel, durch Einstellen der Laserparameter den optimalen (kleinstmöglichen, kürzestmöglichen) Rissverlauf im Material einzustellen, der immer noch zu erfolgreichem Trennen infolge einer Rissausbreitung führt, jedoch anderweitig alle Materialverluste (auch in Schleifschritten) minimiert bzw. reduziert.

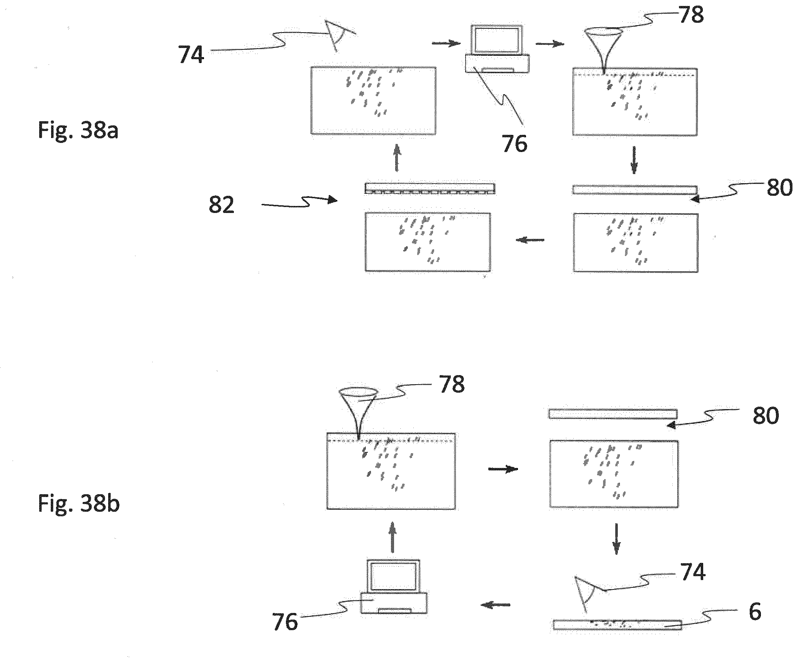

Fig. 38a und Fig. 38b zeigen zwei Möglichkeiten, das Abheben einzelner Wafer vom Boule/Ingot zu gestalten.

Gemäß Fig. 38a wird dies als Feedforward-Loop und gemäß Fig. 38b als Feedback-Loop ausgestaltet.

Beim Feedforward wird die Verteilung vor dem Laserprozess charakterisiert und daraus eine Karte, insbesondere Höhen- und/oder Energiekarte, bzw. Behandlungsanweisungen bzw. Parameteranpassungen, insbesondere ortsabhängig, für den Laserprozess, insbesondere die Modifikationserzeugung, berechnet. Feedforward wird bevorzugt am Ingot/Boule durchgeführt.

Alternativ kann, wie in Fig. 38b dargestellt, ein Feedback-Loop implementiert werden, gemäß dem nach jedem Trennschritt der entstandene Wafer charakterisiert wird und als Vorlage für den nächsten dient.

Je nach Material und Dotierung können somit unterschiedliche Anpassungen während des Laserprozesses vorgenommen werden:

Bei dem Material SiC können in unterschiedlichen Tiefen unterschiedliche Anpassungen der Laserparameter in Abhängigkeit von der auftretenden Dotierung vorgenommen werden. Dies kann bei den nachfolgend genannten Randbedingungen zu den ebenfalls nachfolgend genannten Funktionen führen:

Tiefe 180μm, Pulsdauer 3ns, numerische Apertur 0.4

Niedrige Dotierung: 7μJ - 21mOhmcm
hohe Dotierung: 8μJ - 16mOhmcm

Tiefe 350μm, Pulsdauer 3ns, numerische Apertur 0.4

Niedrige Dotierung: 9.5μJ - 21mOhmcm
hohe Dotierung: 12μJ - 16mOhmcm

Formel für 180μm Tiefe:

E     Energie in μJ
E0    Offset-Energie bei niedrigster Dotierung
K     Faktor Energieskalierung
R     gemessener Dotiergrad
B     Basisdotiergrad (21 mOhmcm)

$$E = E0+(B-R)*K$$

Hier

K = 1/(21-16) μJ/mOhmcm = 0,2μJ/mOhmcm
E0 = 7μJ
B = 21mOhmcm

Beispiel: gemessener Dotiergrad von 19mOhmcm: E = 7,4μJ

Formel für 350μm Tiefe:

E     Energie in μJ
E0    Offset-Energie bei niedrigster Dotierung
K     Faktor Energieskalierung
R     gemessener Dotiergrad
B     Basisdotiergrad (21 mOhmcm)

$$E = E0+(B-R)*K$$

Hier

K = 2,5/(21-16) μJ/mOhmcm = 0,5μJ/mOhmcm

E0 = 9,5μJ

B = 21mOhmcm

Beispiel: gemessener Dotiergrad von 19mOhmcm: E = 10,5μJ

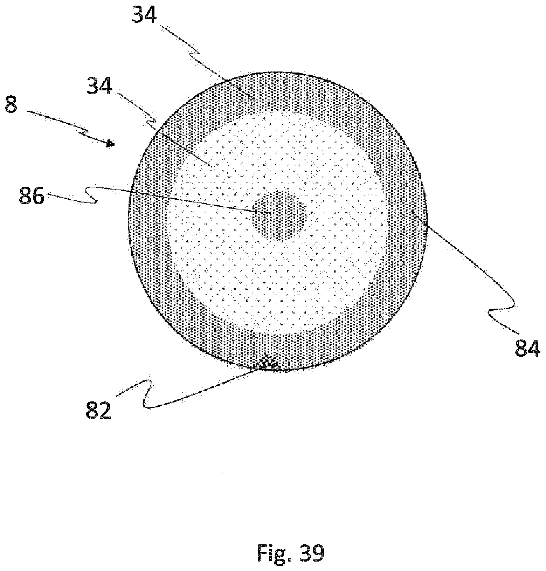

In Fig. 39 ist eine Ablöseebene 8 gezeigt, die Bereiche mit unterschiedlichen Defektkonzentrationen 82, 84, 86 bzw. Modifikationskonzentrationen bzw. Modifikationshäufungen aufweist. Es ist hierbei denkbar, dass eine Vielzahl an Bereichen mit unterschiedlichen Modifikationskonzentrationen eine Ablöseebene 8 bilden, wobei ebenfalls vorstellbar ist, dass die Modifikationen 34 in der Ablöseebene 8 im Wesentlichen oder genau gleichmäßig über die Fläche verteilt sind. Die unterschiedlichen Modifikationskonzentrationen können flächenmäßig gleich groß oder verschieden groß ausgebildet sein. Bevorzugt stellt eine erste erhöhte Modifikationskonzentration eine Rissauslösekonzentration 82 dar, die bevorzugt im Bereich des Randes oder sich zum Rand hin erstreckend bzw. den Rand benachbarend erzeugt wird. Zusätzlich oder alternativ kann eine Rissführungskonzentration 84 derart ausgebildet werden, dass der die Festkörperschicht 4 von dem Festkörper 2 abtrennende Riss kontrollierbar bzw. steuerbar ist. Weiterhin kann zusätzlich oder alternativ eine Zentrumskonzentration 86 erzeugt werden, die bevorzugt eine sehr ebene Oberfläche im Bereich des Zentrums des Festkörpers 2 ermöglicht. Bevorzugt ist die Rissführungskonzentration 84 teilweise oder vollständig ringförmig bzw. umschließend ausgebildet und umschließt somit bevorzugt abschnittsweise und besonders bevorzugt vollständig das Zentrum des Festkörpers 2 bzw. der Festkörperschicht 4. Es ist ferner denkbar, dass die Rissführungskonzentration 84 in einem ausgehend vom Rand des Festkörpers 2 und in Richtung Zentrum des Festkörpers 2 stufenweise oder stetig bzw. fließend abnimmt. Weiterhin ist denkbar, dass die Rissführungskonzentration 84 bandartig und homogen bzw. im Wesentlichen oder genau homogen ausgebildet ist.

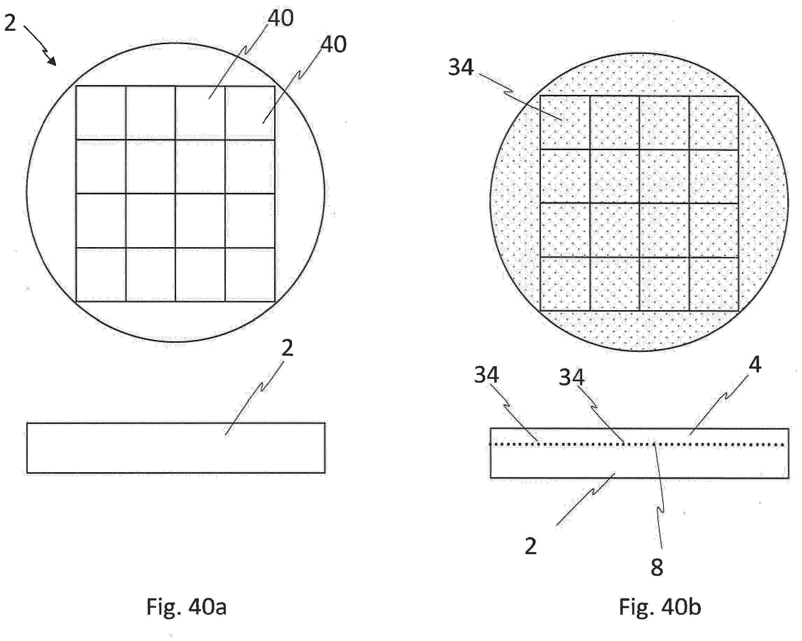

In Fig. 40a ist schematisch im oberen Bildteil eine Draufsicht auf einen Festkörper 2 gezeigt und im unteren Bildteil ist eine Seitenansicht, insbesondere eine Schnittdarstellung, gezeigt. Der Festkörper 2 ist in dieser Darstellung mit geraden Linien versehen, welche die einzelne aneinander angeordnete Festkörperelemente 40, insbesondere Trägerelemente, wie z.B. Computerchips oder Solarzellen, begrenzen. Die Linien können hierbei rein exemplarisch und zu Erläuterungszwecken die äußere Form der Festkörperelemente 40 beschreiben, wobei sie bei einem realen Festkörper 2 nicht oder nicht zwingend ersichtlich bzw. vorhanden sein müssen. Ferner kann der Festkörper 2 in der Draufsicht eine andere äußere Form, insbesondere mit geraden Anteilen, aufweisen.

In Fig. 40b sind der Draufsicht und der Seitenansicht jeweils eine Vielzahl an Defekte 34 zu entnehmen. Die Modifikationen bzw. Defekte 34 können, wie z.B. in der Draufsicht dargestellt, gleichmäßig verteilt sein oder in bestimmten Bereichen vermehrt bzw. vermindert erzeugt werden. Eine hohe Konzentration an Modifikationen bzw. Defekten 34 gegenüber einer geringen Konzentration an Defekten 34 ermöglicht z.B. eine definierte Rissauslösung und/oder ein einfacheres Ablösen der Festkörperschicht 4 in dem jeweiligen Bereich. Bevorzugt ist im Bereich einer Stelle des Festkörpers 2, an der ein Riss ausgelöst werden soll, eine erhöhte Konzentration an Defekten 34 vorgesehen. Weiterhin werden bevorzugt zur Steuerung des Rissverlaufs Defekte 34 in einer erhöhten Konzentration vorgegebenen, um die Rissausbreitung zu lenken. Weiterhin wird bevorzugt in der Mitte bzw. im Zentrum der ersten Ablöseebene 8 zusätzlich oder alternativ eine gegenüber anderen Bereichen der ersten Ablöseschicht 8 erhöhte Konzentration an Defekten bzw. Modifikationen 34 erzeugt. Es lässt sich der Seitenansicht entnehmen, dass die Ablöseebene 8 bevorzugt durch in einer Ebene erzeugte Defekte 34 gebildet wird.

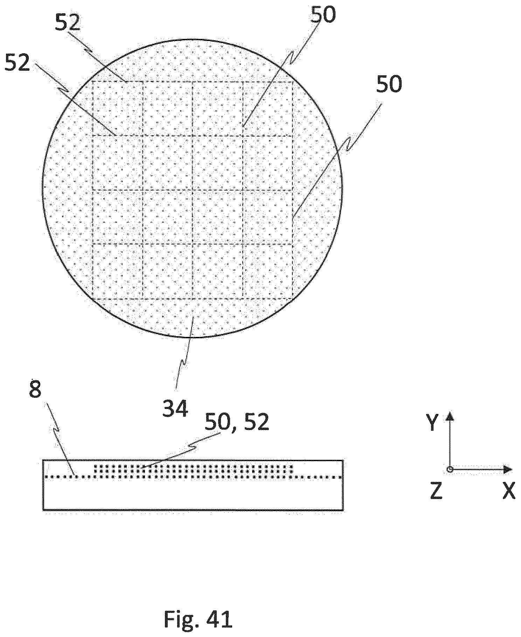

Die Draufsicht der Fig. 41 zeigt neben den Defekten 34, welche die erste Ablöseschicht 8 bilden, weitere in zweiten Ablöseebenen 50 erzeugte Defekte, die mittels gestrichelten Linien dargestellt sind und sich in Z-Richtung erstrecken. Weiterhin sind in X-Richtung orientierte gestrichelte Linien gezeigt, die ebenfalls Defekte repräsentieren und in dritten Ablöseebenen 52 liegen. Die erste Ablöseebene 8 liegt somit bevorzugt in der X-Z-Ebene, die zweite Ablöseebene 50 liegt bevorzugt in der Y-Z-Ebene und die dritte Ablöseebene 52 liegt bevorzugt in der x-Y-Ebene. Der Seitenansicht bzw. Schnittdarstellung der Fig. 4 lässt sich entnehmen, dass die Defekte, d.h. Defekte die zum Erzeugen der ersten Ablöseschicht 8 und die Defekte zum Erzeugen der zweiten Ablöseschicht 50 sowie der dritten Ablöseschicht 52 gegenüber einer ebenen Oberfläche des Festkörpers 2, insbesondere gegenüber einer in einer X-Z-Ebene liegenden Oberfläche des Festkörpers 2, unterschiedlich weit beabstandet sind.

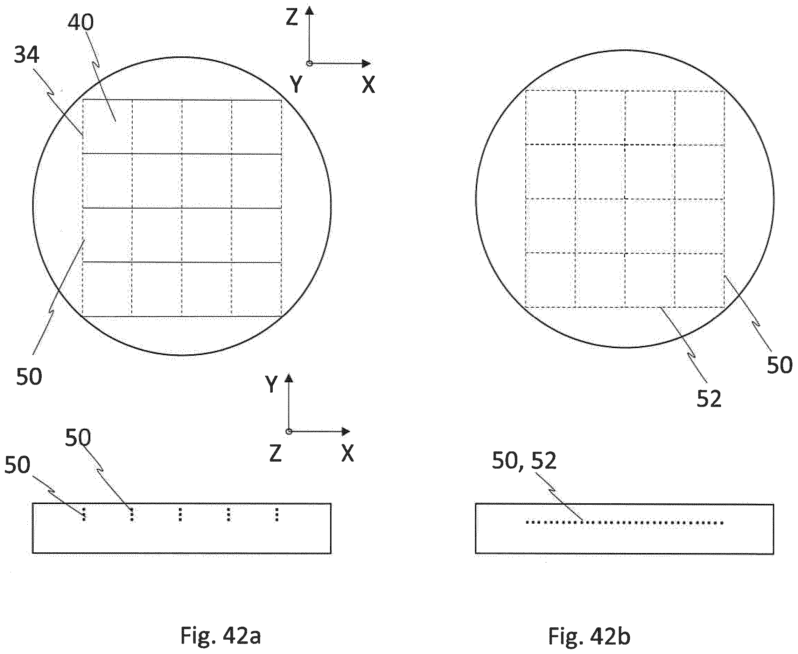

In Fig. 42a ist eine Draufsicht gezeigt, gemäß der die Defekte 34 zum Erzeugen der zweiten Ablöseebene/n 50 bereits erzeugt sind. Die Defekte 34 zum Ausbilden der dritten Ablöseebene/n 52 sind jedoch noch nicht erzeugt. Es ist somit denkbar, dass die Defekte zum Erzeugen der zweiten und dritten Ablöseebene/n 50, 52 zeitgleich, zeitversetzt oder vollständig nacheinander erzeugt werden. Weiterhin ist der Seitenansicht bzw. Schnittdarstellung zu entnehmen, dass die Defekte zum Erzeugen der zweiten Ablöseebene/n 50 mit unterschiedlichen Abständen zu einer sich in der X-Z-Ebene erstreckenden Oberfläche erzeugt werden können.

Fig. 42b lässt sich entnehmen, dass die Defekte zum Erzeugen der ersten Ablöseschicht 50 und der zweiten Ablöseschicht 52 in ihrer Gesamtheit auch mit demselben Abstand zu einer sich in der X-Z-Ebene erstreckenden Oberfläche erzeugt werden können.

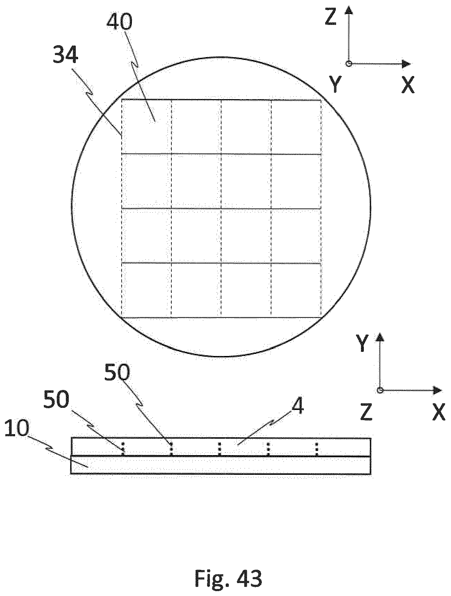

In Fig. 43 ist eine Ausführungsform gezeigt, gemäß der die Festkörperschicht 4 an der Polymerschicht 10 angeordnet ist. Es ist hierbei denkbar, dass die Defekte zum Erzeugen der zweiten Ablöseschicht 50 und der dritten Ablöseschicht 52 bereits in der Festkörperschicht 4 erzeugt sind. Weiterhin ist alternativ denkbar, dass die Defekte zum Erzeugen der zweiten Ablöseschicht 50 und der dritten Ablöseschicht 52 erst nach der Abspaltung der Festkörperschicht 4 von dem Festkörper 2 in der Festkörperschicht 4 erzeugt werden.

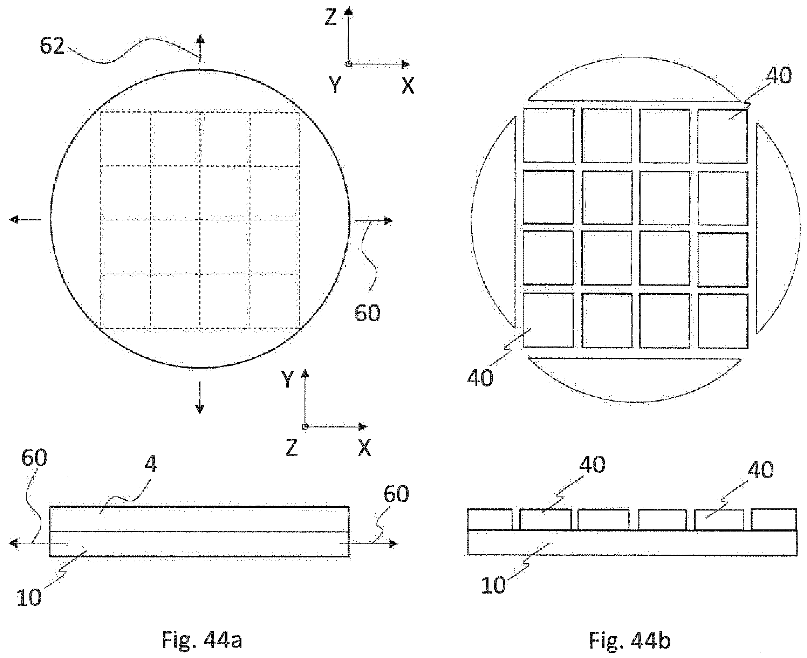

Fig. 44a zeigt eine Anordnung, gemäß der die Festkörperschicht 4 auf der Polymerschicht 10 angeordnet ist bzw. die Festkörperschicht 4 mit der Polymerschicht 10, insbesondere adhäsiv, verbunden ist. Die Polymerschicht 10 wird dabei in einer ersten Richtung 60 und/oder in einer zweiten Richtung 62 ausgelenkt und/oder um mindestens eine Achse gebogen. Die Auslenkung der Polymerschicht 10 kann durch thermische Effekte und/oder äußere Kraftbeaufschlagung, insbesondere Dehnung, Stauchung und/oder Biegung, bewirkt werden.

Fig. 44b zeigt eine Reaktion auf die bzgl. Fig. 44a beschriebene Auslenkung der Polymerschicht 10. Dabei erfolgt ein Ablösen der einzelnen Festkörperelemente 40 im Bereich bzw. entlang der zweiten Ablöseebene 50 und/oder der dritten Ablöseebene 52. Die Ablösung entspricht dabei bevorzugt einem Abbrechen oder Abreisen der einzelnen Festkörperelemente 40 voneinander.

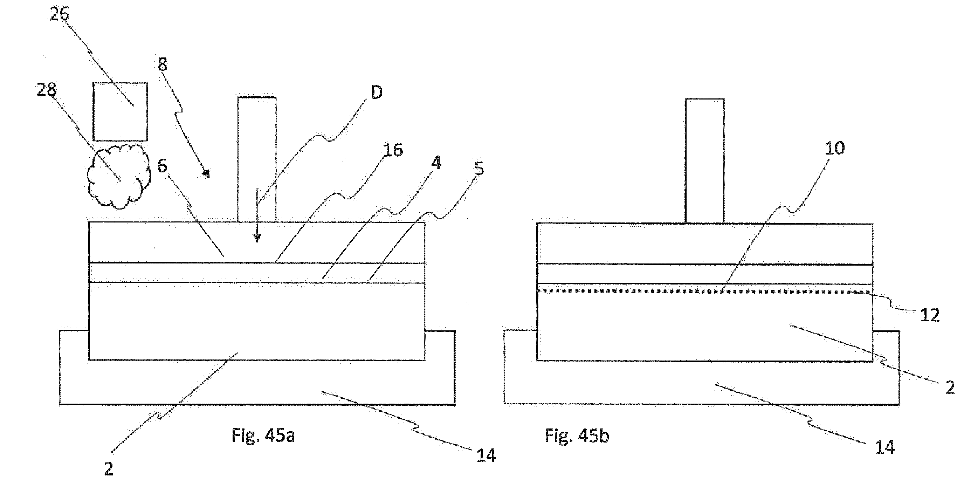

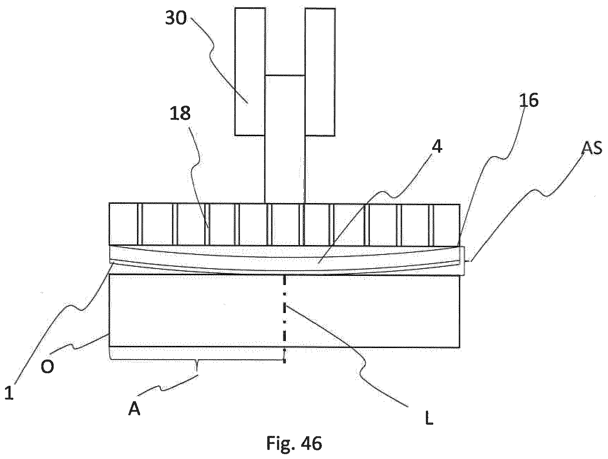

Fig. 45a zeigt eine Vorrichtung zum Abtrennen von Festkörperlagen 1 (vgl. Fig. 46) von einem Spendersubstrat 2. Die Vorrichtung weist dabei bevorzugt eine Halteeinrichtung 14 zum Fixieren des Spendersubstrats 2 auf. Auf dem Spendersubstrat 2 ist eine Spannungserzeugungsschicht 4, insbesondere aus einem Polymermaterial bestehend oder ein Polymermaterial aufweisend, angeordnet. Die vom Spendersubstrat 2 abgewandte Oberfläche der Spannungserzeugungsschicht 4 kontaktiert in der dargestellten Variante eine Kontaktseite eines Druckbeaufschlagungselements 6 einer Druckbeaufschlagungseinrichtung 8. Die Druckbeaufschlagungseinrichtung 8 kann hierbei z.B. eine elektrische oder hydraulische oder pneumatische oder mechanische Krafterzeugungseinrichtung, insbesondere ein Aktuator, zum Erzeugen einer Kraft zum Anpressen des Druckbeaufschlagungselement 6 an die Spannungserzeugungsschicht 4 aufweisen bzw. damit gekoppelt sein. Bevorzugt ist die Druckbeaufschlagung mittels der Krafterzeugungseinrichtung einstellbar. Mittels einer Temperiereinrichtung 26 erfolgt bevorzugt eine thermische Beaufschlagung, insbesondere Kühlung, der Spannungserzeugungsschicht 4. Die thermische Beaufschlagung der Spannungserzeugungsschicht 4 kann hierbei indirekt oder ausschließlich indirekt erfolgen, d.h. es kann z.B. zunächst das Druckbeaufschlagungselement 6 temperiert werden, das dann die Spannungserzeugungsschicht 4 temperiert. Ferner ist denkbar, dass zeitlich eine direkte und indirekte Temperierung der Spannungserzeugungsschicht 4 erfolgt. Die

Temperiereinrichtung 26 stellt bevorzugt ein Funktionsfluid 28, insbesondere Stickstoff in bevorzugt flüssiger oder nebelförmiger Form, bereit. Ferner kann das Druckbeaufschlagungselement 6 an vorbestimmte Anteile der Spannungserzeugungsschicht 4 angepresst werden und zeitgleich können andere vorbestimmte Anteile derselben Spannungserzeugungsschicht 4 durch die Temperierungseinrichtung 26 temperiert werden.

Durch die thermische Beaufschlagung zieht sich die Spannungserzeugungsschicht 4 zusammen, wodurch mechanische Spannungen in dem Spendersubstrat 2 erzeugt werden. Die Druckbeaufschlagungseinrichtung 8 bewirkt zeitgleich zur Spannungserzeugung eine Druckbeaufschlagung auf Anteile der Spannungserzeugungsschicht 4 oder auf die vollständige zwischen dem Druckbeaufschlagungselement 6 und dem Spendersubstrat 2 angeordnete Spannungserzeugungsschicht 4.

Die Druckbeaufschlagungseinrichtung 8 wirkt somit Kraftspitzen entgegen, die beim Erreichen des Glasübergangs der Spannungserzeugungsschicht 4 auftreten. Ferner reduziert die Druckbeaufschlagungseinrichtung 8 bevorzugt ebenfalls eine Auslenkung der abgespalteten Anteile der Festkörperlage 1, wodurch die sich bei der Rissausbreitung ergebende Keilwirkung mit einem signifikant kleineren Winkel Auftritt, wodurch der Riss deutlich stabiler in der vordefinierten Ablöseebene 12 (vgl. Fig. 1b) läuft.

Das Bezugszeichen D kennzeichnet die bevorzugte Druckaufbringungsrichtung.

Die in Fig. 45b gezeigte Darstellung entspricht im Wesentlichen der in Fig. 1a gezeigten Darstellung, wobei das Spendersubstrat 2 Modifikationen 10 aufweist, die mittels Laserstrahlen erzeugt wurde. Die Modifikationen 10 geben dabei einen Ablösebereich 12 zum Führen eines Risses zum Abtrennen der Festkörperlage 1 vom Spendersubstrat 2 vor.

Fig. 46 zeigt, dass das Druckbeaufschlagungselement 6 ein oder mehrere Durchlasselement/e 18 bzw. Leitungselement/e 18 zum Führen des Funktionsfluids aufweisen kann. Ferner zeigt diese Darstellung eine Situation, in der das Druckbeaufschlagungselement 6 zum Begrenzen der Auslenkbewegung der abgetrennten Festkörperlageanteile eingesetzt wird. Die Kontaktseite 16 des Druckbeaufschlagungselements 6 ist dabei bevorzugt in einem Abstand AS gegenüber der freiliegenden Oberfläche der Spannungserzeugungsschicht 4 oder gegenüber der Ablöseebene 12 beabstandet. Der Abstand AS ist dabei bevorzugt ein Bruchteil oder kleiner als ein definierter Bruchteil der kürzesten Strecke zwischen der radialen Umfangsoberfläche O und dem axialen Zentrum L. Ferner weist diese Ausführungsform rein exemplarisch eine Führungseinrichtung 30 zum Vorgeben einer Bewegungsrichtung der Druckbeaufschlagungseinrichtung 8 im Falle einer Auslenkung auf. Derartige

Führungseinrichtungen können in allen hierin beschriebenen Ausführungsformen vorgesehen sein.

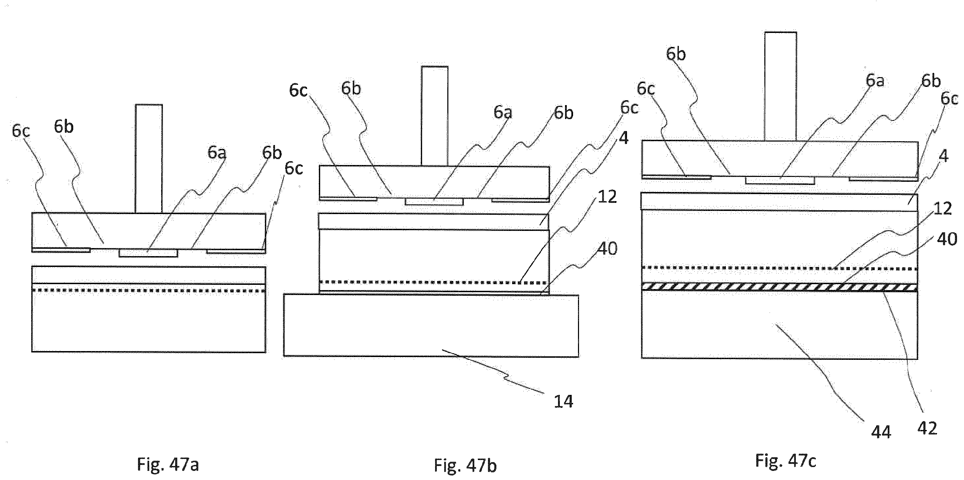

Fig. 47a zeigt schematisch, dass mehrere unterschiedlich gestaltete Druckbeaufschlagungselemente 6a, 6b, 6c Bestandteil der Druckbeaufschlagungseinrichtung 8 sein können. Die hier gezeigten Druckbeaufschlagungselemente 6a, 6b, 6c weisen unterschiedliche Höhen auf. Beim Anpressen von 6a an die Spannungserzeugungsschicht 4 erfolgt somit eine größere Komprimierung der Spannungserzeugungsschicht 4 als beim Anpressen von 6c. Somit herrscht im Bereich zwischen 6a und dem Spendersubstrat 2 ein größerer Druck als zwischen 6c und dem Spendersubstrat 2. D.h. im Zentrum wird bevorzugt ein größerer Druck aufgebaut als im Randbereich, wobei dies auch vice versa ausgestaltet sein kann. Der Bereich 6b wird gemäß dieser Ausführungsform am wenigsten oder gar nicht an das Spendersubstrat 4 angepresst.

Fig 47b zeigt schematisch, dass eine Druckbeaufschlagung von der "dickeren" Seite möglich ist, wobei die dünne Seite durch eine Halteeinrichung 14 (z.B. Vakuumhalter, oder aber auch durch Haltetape ...) am Verbiegen gehindert wird. Der Ablösebereich 12 liegt hierbei bevorzugt in zumindest der Mehrzahl der beim Zerteilen eines Spendersubstrats 2 in eine Vielzahl an Wafer erfolgenden Abtrennschritte näher zu einer prozessierten Schicht beabstandet als zu einer Oberfläche, mit der ein Druckbeaufschlagungselement in Kontakt gebracht wird. Wobei die prozessierte Oberfläche 40 das Spendersubstrat 2 in Spendersubstratlängsrichtung einerseits begrenzt und die Oberfläche, an der das Druckbeaufschlagungselement in Kontakt gebracht wird, das Spendersubstrat 2 in Spendersubstratlängsrichtung andererseits begrenzt. Dadurch wird bei zumindest teilweise fertiggestellten devices auf dem Wafer sichergestellt, dass diese nicht oder nur in einem begrenzten Rahmen verbogen werden. Weiterhin wird vermieden, dass eine Oberflächenbeaufschlagung der device Seite notwendig ist.

Fig 47c zeigt eine Variante, gemäß der die prozessierte Oberfläche 40 mittels einer Bondingschicht bzw. eines Bondinginterfaces 42 mit einem Transfersubstrat bzw. einem Wafer (technisch Transfer Wafer) verbunden ist. Die Bondingschicht bzw. das Bondinginterface 42 kann hierbei z.B. durch eine Klebeschicht, insbesondere ein Klebetape, oder durch eine Phasenwechselsubstanz, insbesondere ein Fluid, insbesondere eine Flüssigkeit, ausgebildet werden. Wird das Bondinginterface 42 durch eine Phasenwechselsubstanz ausgebildet, dann weist die Phasenwechselsubstanz bevorzugt bei Umgebungsdruck einen Gefrierpunkt von kleiner 20°C oder von kleiner 10°C oder von kleiner 5°C oder von 0°C oder von kleiner 0°C oder von kleiner -5°C oder von kleiner -20°C auf. Die Phasenwechselsubstanz ist bevorzugt Wasser, insbesondere vollentsalztes Wasser (VE-Wasser). Das Bondingsubstrat 44 und/oder die prozessierte Oberfläche 40 werden dabei bevorzugt mit der Phasenwechselsubstanz benetzt bzw. befeuchtet, wobei sich die Phasenwechselsubstanz dabei in einem ersten Aggregatszustand befindet. Anschließend wird die prozessierte Oberfläche 40 an das Bondingsubstrat 44 angelegt oder aufgelegt, insbesondere angepresst. Weiterhin erfolgt bevorzugt eine Temperierung der Phasenwechselsubstanz unter den Gefrierpunkt der Phasenwechselsubstanz, wobei die Phasenwechselsubstanz dadurch aus dem ersten Aggregatszustand, insbesondere flüssig, in einen zweiten Aggregatszustand, insbesondere fest, überführt wird. Die Abkühlung kann hierbei durch die zur Temperierung der Aufnahmeschicht erfolgende Abkühlung bewirkt werden. Zusätzlich oder alternativ ist es möglich, dass die Phasenwechselsubstanz vor der Temperierung der Aufnahmeschicht auf eine Temperatur unterhalb ihres Gefrierpunkts temperiert wird. Dies ist vorteilhaft, da dieses Bondinginterface reversibel erzeugbar und aufhebbar ist. Ferner werden hierbei besonders bevorzugt keine toxischen Stoffe benötigt.

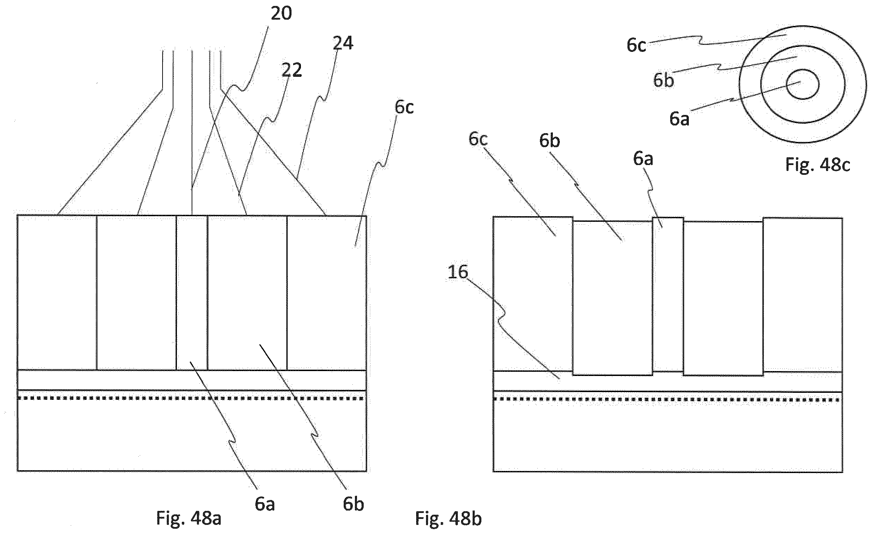

Fig. 48a zeigt ein Ausführungsbeispiel, gemäß dem die Druckbeaufschlagungseinrichtung 8 mehrere zueinander bewegliche Druckbeaufschlagungselemente 6a, 6b und 6c aufweist. Diese Druckbeaufschlagungselemente 6a, 6b, 6c können jeweils über Kraftübertragungsmittel 20, 22, 24 mit einem oder mehrere Aktuatoren zum Bereitstellen gleicher oder verschiedener Anpresskräfte gekoppelt sein. Nach einer Ausführungsform können die einzelnen Druckbeaufschlagungselemente 6a, 6b, 6c unabhängig voneinander ausgelenkt werden, insbesondere wenn die auf das jeweilige Druckbeaufschlagungselement 6a, 6b, 6c wirkende Kraft eine für das jeweilige Druckbeaufschlagungselement 6a, 6b, 6c definierte Schwellkraft bzw. Mindestkraft übersteigt.

Fig. 48b zeigt eine Ausführungsform, gemäß der das Druckbeaufschlagungselement 6b weiter in die Spannungserzeugungsschicht 4 hineinbewegt wird als die anderen Druckbeaufschlagungselemente 6a und 6c.

Fig. 48c zeigt rein exemplarisch, dass die Druckbeaufschlagungseinrichtung 8 eine runde Kontaktseite 16 aufweisen kann. Die Druckbeaufschlagungselemente 6a, 6b, 6c sind dabei entsprechend ausgebildet. Alternativ ist es jedoch im Rahmen von Ausführungsformen der vorliegenden Erfindung ebenfalls möglich, dass die Kontaktseite 16 eine von einer runden Form abweichende Form, insbesondere eine Form mit einer oder mehreren geraden Kanten, insbesondere eine rechteckige Form, aufweisen kann.

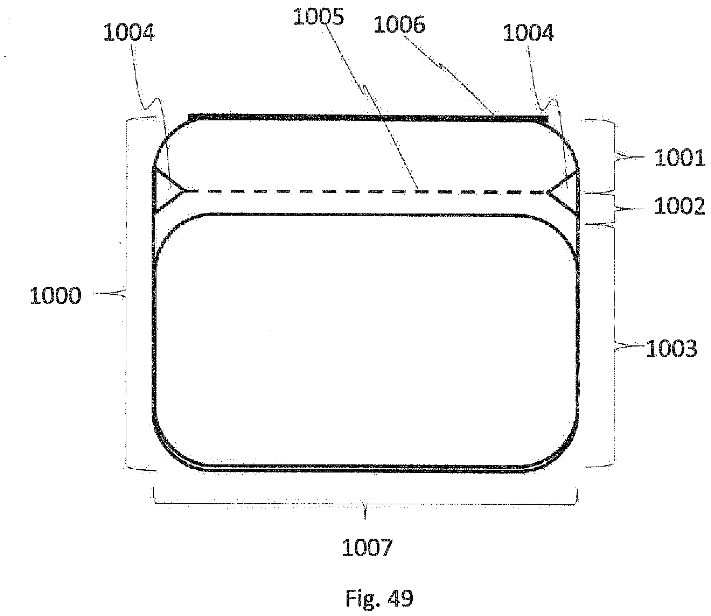

Fig. 49 zeigt eine schematische Querschnittsdarstellung von einen Wafer 1000. Dieser Wafer 1000 ist bevorzugt in mindestens oder genau zwei oder mehr als zwei Festkörperscheiben teilbar. Der Wafer 1000 kann hierbei als dicker Wafer bezeichnet werden. Der Wafer 1000 wurde bevorzugt in einem Waferingprozess von einem Festkörper, insbesondere Ingot oder Boule, abgetrennt. Die Teilung des Wafers 1000 erfolgt bevorzugt im Rahmen einer Thinningbehandlung bzw. im Rahmen eines Thinningschritts oder mehrerer Thinningschritte.

Somit umfasst das vorliegende Verfahren gemäß einer Ausführungsform einen oder mehrere der nachfolgend genannten Schritte:

Bereitstellen oder Abtrennen einer Festkörperscheibe 1001 oder Festkörperschicht oder eines Wafers, insbesondere eines dicken Wafers, Anbringen oder Erzeugen von einer oder mehrerer weiterer Schichten und/oder Anordnen oder Erzeugen von elektrischen Bauteilen 1006 an zumindest oder genau einer Oberfläche des Wafers 1000, Einbringen von Modifikationen in die Festkörperscheibe oder Festkörperschicht oder den Wafer zum Ausbilden eines Ablösebereichs 1005 oder Erzeugen von Modifikationen im Inneren des der Festkörperscheibe oder der Festkörperschicht oder dem Wafer. Die Modifikationen werden dabei bevorzugt durch Laserstrahlen erzeugt oder bewirkt. Durchführen einer Randbearbeitung 1004, insbesondere eines materialentfernenden Schrittes, auf der umlaufenden Oberfläche der Festkörperscheibe oder der Festkörperschicht oder dem Wafer. Die Randbearbeitung und/oder die Modifikationserzeugung erfolgt bevorzugt vor der Aufbringung einer Metallschicht. Bevorzugt legt die Randbearbeitung einen zuvor erzeugten Ablösebereich 1005 frei bzw. verringert den Abstand des Ablösebereichs zur äußeren Umlauffläche der Festkörperscheibe oder der Festkörperschicht oder des Wafers. Die abgetrennte Festkörperscheibe oder Festkörperschicht oder der abgetrennte Wafer hat dabei bevorzugt eine Dicke die geringe ist als die verbleibende Restdicke des Restfestkörpers. Bevorzugt beträgt die Dicke der Festkörperscheibe oder der Festkörperschicht oder des Wafers maximal 99% oder maximal 95% oder maximal 90% oder maximal 85% oder maximal 80% oder maximal 75% oder maximal 65% oder maximal 55% der Dicke des Restfestkörpers (1002 plus 1003). Der Restfestkörper wird bevorzugt durch ein oder mehrere Oberflächenaufbereitungsverfahren, insbesondere Grinding, Kantenprozess bzw. Abtragen der Kante, chemisch-mechanischem Polieren und/oder erneuter Anordnung oder Erzeugung von elektrischen Bauteilen an einer aufbereiteten Oberfläche, weiterverwendet. Bevorzugt ist der Durchmesser der abgetrennten Festkörperscheibe 1001 und der Durchmesser des aufbereiteten Restfestkörpers, insbesondere nach einer Erzeugung oder Anordnung von elektrischen Bauteilen, identisch oder nur marginal abweichend, insbesondere weniger als 5% oder weniger als 1% oder weniger als 0,1% oder weniger als 0,01 % abweichend.

Nach der Abtrennung der Festkörperscheibe 1001 oder Festkörperschicht oder eines Wafers wird somit bevorzugt die durch die Abtrennung freigelegte Oberfläche des Restfestkörpers materialabtragend, insbesondere oberflächenaufbereitend, behandelt. Dabei wird bevorzugt der Anteil 1002 abgetrennt, insbesondere durch Grinden oder Polieren entfernt. An der aus der materialabtregenden Bearbeitung resultierenden Zweitfestkörperschicht 1003 werden dann bevorzugt weitere Schichten, insbesondere mindestens eine oder mehrere Metallschichten, und/oder elektrische Bauteile angeordnet oder erzeugt oder ausgebildet.

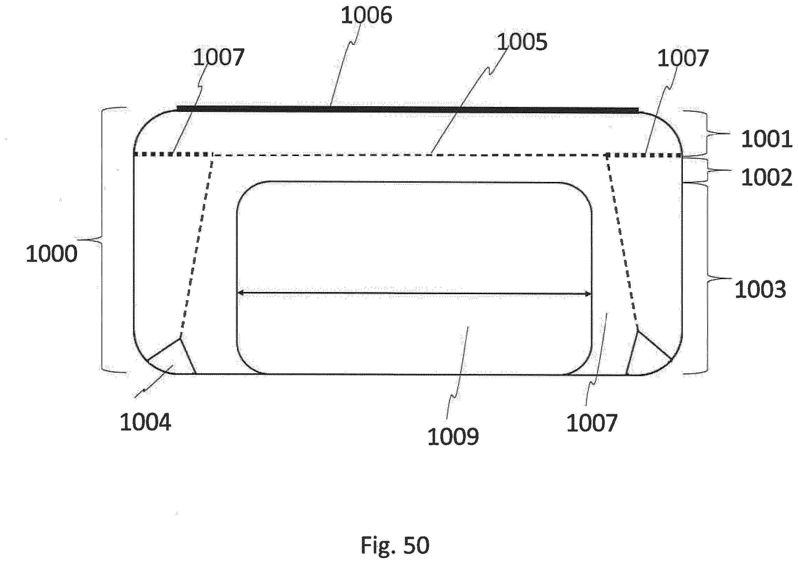

Fig. 50 zeigt eine schematische Querschnittsdarstellung von einen Wafer 1000. Dieser Wafer 1000 ist bevorzugt in mindestens oder genau zwei oder mehr als zwei Festkörperscheiben teilbar. Der Wafer 1000 kann hierbei als dicker Wafer bezeichnet werden. Der Wafer 1000 wurde bevorzugt in einem Waferingprozess von einem Festkörper, insbesondere Ingot oder Boule, abgetrennt. Die Teilung des Wafers 1000 erfolgt bevorzugt im Rahmen einer Thinningbehandlung bzw. im Rahmen eines Thinningschritts oder mehrerer Thinningschritte.

Somit umfasst das vorliegende Verfahren gemäß einer Ausführungsform bevorzugt einen oder mehrere der nachfolgend genannten Schritte:
Bereitstellen oder Abtrennen einer Festkörperscheibe 1001 oder Festkörperschicht oder eines Wafers, insbesondere eines dicken Wafers, Anbringen oder Erzeugen von einer oder mehrerer weiterer Schichten und/oder Anordnen oder Erzeugen von elektrischen Bauteilen 1006 an zumindest oder genau einer Oberfläche des Wafers 1000, Einbringen von Modifikationen in die Festkörperscheibe oder Festkörperschicht oder den Wafer zum Ausbilden eines Ablösebereichs 1005 oder Erzeugen von Modifikationen im Inneren des der Festkörperscheibe oder der Festkörperschicht oder dem Wafer. Die Modifikationen werden dabei bevorzugt durch Laserstrahlen erzeugt oder bewirkt. Durchführen einer Randbearbeitung 1004, insbesondere eines materialentfernenden Schrittes, auf einer Oberfläche der Festkörperscheibe oder der Festkörperschicht oder dem Wafer. Die Randbearbeitung und/oder die Modifikationserzeugung erfolgt bevorzugt vor der Aufbringung einer Metallschicht. Bevorzugt legt die Randbearbeitung einen zuvor erzeugten Ablösebereich 1005 frei bzw. verringert den Abstand des Ablösebereichs zur Oberfläche der Festkörperscheibe oder der Festkörperschicht oder des Wafers. Der Ablösebereich erstreckt sich dabei schalen- oder topfförmig oder bildet eine 3D-Kontur aus. Somit wird gemäß dieser Ausführungsform ein zweiter Wafer bzw. eine zweite Festkörperschicht bzw. Festkörperlage aus einem Ausgangswafer 1000 herausgeteilt, wobei der Ausgangswafer 1000 dicker ist als die zweite Festkörperlage bzw. Zweitfestkörperschicht 1009. Bevorzugt ändert sich somit die Richtung des Risses während seiner Ausbreitung. Es ist hierbei möglich, dass zunächst die erste Festkörperschicht 1001 von dem Restfestkörper (1002 plus 1003) abgetrennt wird. Hierzu kann dann eine Randbearbeitung zum Freilegen der Modifikationen 1007 vorgesehen sein. Alternativ kann zunächst die der die zweite Festkörperlage 1003 umfassende Restfestkörper 1007 aus dem Wafer 1007 herausgeteilt bzw. herausgesplittet werden. Anschließend erfolgt dann bevorzugt das Abtrennen der Festkörperschicht 1001 entlang des eingezeichneten Bereichs 1007 bzw. entlang eventuell erzeugter Modifikationen 1007. Die Abtrennung kann somit z.B. mittels Splitten oder mittels eines spanenden Verfahrens, insbesondere Sägen, erfolgen. Der Restfestkörper 1007 wird anschließend bevorzugt mittels einem oder mehreren Oberflächenaufbereitungsschritten behandelt, insbesondere um die zweite Festkörperlage 1003 herauszuarbeiten. Beispielsweise kann auf diese Weise aus einem Ausgangswafer mit einem Durchmesser von 150 mm eine erste Festkörperlage (mit 150mm Durchmesser) und eine zweite Festkörperlage 1003 mit 100 mm Durchmesser erzeugt werden. Beispielsweise kann auf diese Weise aus einem Ausgangswafer mit einem Durchmesser von 200 mm eine erste Festkörperlage (mit 200mm Durchmesser) und eine zweite Festkörperlage 1003 mit 150 mm Durchmesser erzeugt werden. Beispielsweise kann auf diese Weise aus einem Ausgangswafer mit einem Durchmesser von 300 mm eine erste Festkörperlage (mit 300mm Durchmesser) und eine zweite Festkörperlage 1003 mit 200 mm Durchmesser erzeugt werden.

Die in den Figuren 49 und 50 gezeigte Kantenbearbeitung kann z.B. mittels eines spanenden Verfahrens oder eines ätzenden Verfahrens oder eines Laserablationsverfahrens bewirkt werden.

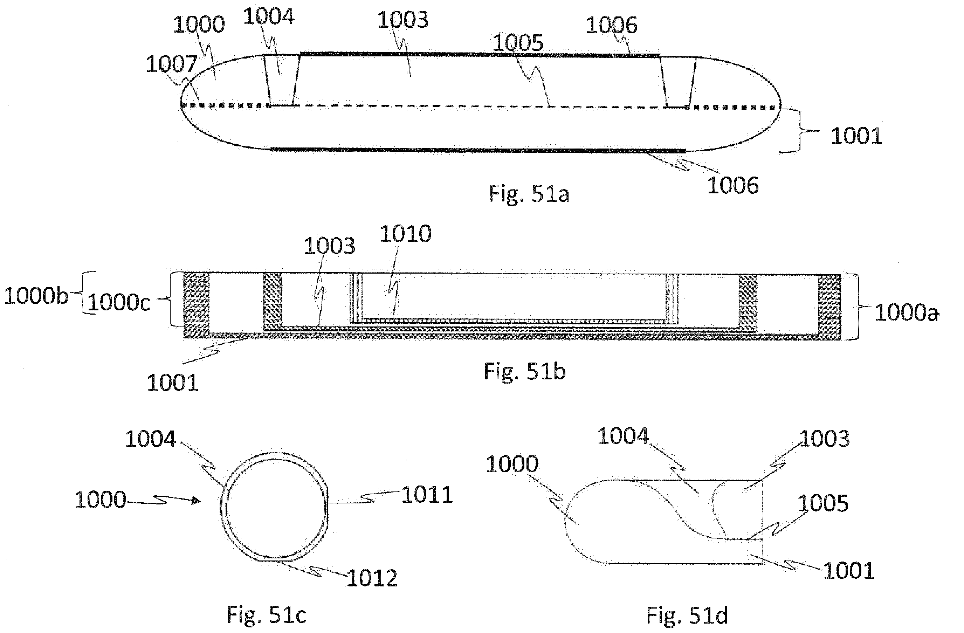

Fig. 51a zeigt ein weiteres Beispiel du dem im Fig. 50 gezeigten Konzept. Hierbei ist die Modifikationsebene 1005 bzw. der Ablösebereich 1005 bevorzugt eben ausgebildet. Das

Bezugszeichen 1004 stellt hierbei bevorzugt eine Grabenbearbeitung bzw. Grabenerzeugung dar. Die Grabenerzeugung kann hierbei z.B. mittels eines spanenden Verfahrens oder eines ätzenden Verfahrens oder eines Laserablationsverfahrens bewirkt werden. Weiterhin kann ein Bereich 1007 und/oder Modifikationen 1007 analog zur Ausführungsform von Fig. 50 vorgesehen sein. Ferner kann an einer Oberfläche der ersten Festkörperschicht 1001 und/oder an einer Oberfläche der zweiten Festkörperschicht 1003 eine oder mehrere Schichten, insbesondere aus Metall oder Metall aufweisend, und/oder elektrische Bauteile angeordnet oder erzeugt sein.

Fig. 51b zeigt ein Beispiel gemäß dem aus dem Wafer 1000a zwei weitere Wafer 1000b, 1000c herausgeteilt werden. Von dem Wafer 1000a wird dann bevorzugt die Festkörperschicht 1001 abgetrennt und von dem Wafer 1000b wird dann bevorzugt die Festkörperschicht 1003 abgetrennt. Der Wafer 1000c kann ebenfalls zur weiteren Heraustrennung verwendet werden. Wird aus dem Wafer 1000c ein weiterer Wafer (nicht gezeigt) herausgetrennt, so kann die Festkörperschicht 1010 abgetrennt werden. Alternativ ist jedoch ebenfalls denkbar, dass der Wafer 1000c zur Erzeugung von elektrischen Bauteilen verwendet wird. Bevorzugt werden die elektrischen Bauteile an dem Wafer bzw. der jeweiligen Festkörperschicht erzeugt oder angeordnet.

Fig. 51c zeigt eine Draufsicht auf einen dicken Wafer 1000. Dieser dicke Wafer 1000 dient zum Erzeugen von zumindest einer ersten Festkörperschicht 1001 und einer zweiten Festkörperschicht 1003. Hierzu weist der dicke Wafer 1000 bevorzugt eine umlaufende Vertiefung 1004, insbesondere einen Graben, auf. Weiterhin weist der dicke Wafer 1000 bevorzugt einen ersten Flat 1011 und/oder einen zweiten Flat 1012 auf.

Fig. 51d zeigt eine schematische Schnittdarstellung des in Fig. 51c gezeigten Wafers 1000. Gemäß dieser Darstellung ist erkennbar, dass die Vertiefung 1004 eine spezielle bzw. definierte Form aufweist.

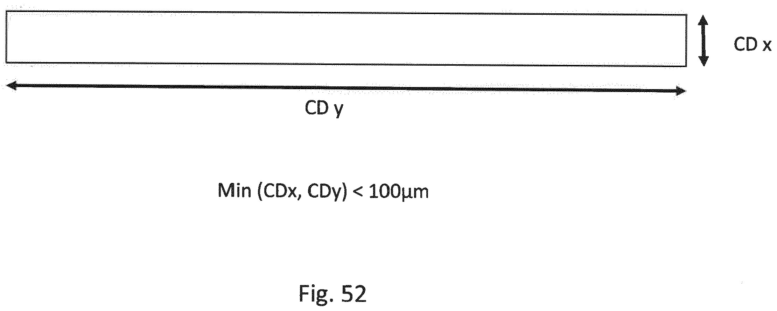

Fig. 52 illustriert schematisch eine Beschichtung einer Festkörperschicht, insbesondere mit einer oder mehreren Metallschichten, und/oder mit einem oder mehreren elektrischen Bauteilen. Die Abmessungen der Schicht bzw. Struktur, insbesondere des Bauteils oder der Bauteile, folgt dabei bevorzugt der Formel Min (CDx, CDy) < 100$\mu$m. CDx bedeutet dabei die kritische Ausdehnung in x-Richtung, insbesondere in Breitenrichtung. CDy bedeutet dabei die kritische Ausdehnung in y-Richtung, insbesondere in Tiefenrichtung. Die mittels Laserstrahlen erzeugten Modifikationen können bevorzugt auch nach der Erzeugung einer oder mehrerer Schichten und/oder einer oder mehrerer Strukturen erfolgen, wenn die Bedingung Min (CDx, CDy) < 100$\mu$m je Schicht und/oder Struktur eingehalten wird. Wenn die Ausbreitung der Struktur (Kritische Dimension - CD) in eine Richtung klein genug ist, wird eine Schädigung durch die Laserstrahlung vermieden. Die aufgenommene Energie pro Fläche ist dann klein genug, um an die Umgebung abgegeben zu werden. Somit wird eine Möglichkeit bereit gestellt, dass mittels Laserstrahlen im Inneren des Festkörpers Modifikationen zu einem Zeitpunkt erzeugt werden können zu dem bereits eine oder mehrere Schichten und/oder eine oder mehrere Strukturen an der Oberfläche der Festkörperschicht erzeugt wurden. Die Einstrahlrichtung der Laserstrahlen läuft dabei über die Oberfläche der Festkörperschicht in den Festkörper hinein, an der die Schicht oder die Schichten oder die Struktur oder die Strukturen angeordnet bzw. erzeugt ist/sind.

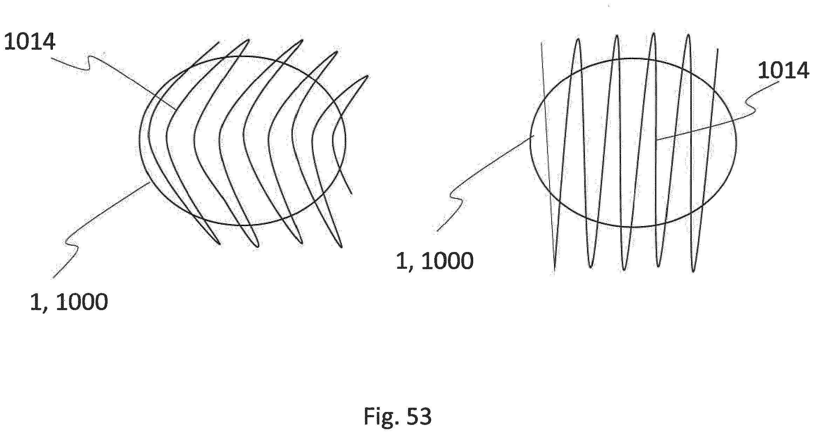

Fig. 53 zeigt zwei Beispiele für die Erzeugung der Modifikationen im dem Festkörper 1 in Form gebogener linearer Gestalten, insbesondere kurvenförmiger Linien oder ungerader Linien oder gebogener Linien. Der Festkörper und ein optisches Element des Lasers, werden bevorzugt entsprechend der Transportpfade 1014 zueinander bewegt. Die Laserstrahlen können somit entlang der Pfadanteile 1014, welche den Festkörper überdecken, in den Festkörper eingebracht werden. Somit können linienförmige Gestalten erzeugt werden, deren Gestalt bevorzugt abschnittsweise der abschnittsweisen Gestalt des Pfades 1014 entspricht. Die Modifikationen werden daher gemäß dieser Ausführungsform bevorzugt mittels eines nicht-linearen Schreibverfahrens erzeugt.

Die Form des Pfades 1014 bzw. des Schreibverlaufs kann dabei bevorzugt eine Spirale darstellen oder spiralförmig sein oder eine aus kreisförmigen Bewegungen abgeleitete Form oder Formen darstellen. Bevorzugt wird der Schreibverlauf oder der Pfad mit einer solchen Gestalt gewählt, dass z.B. ein parabelförmiges Zick-Zack resultiert. Diese Lösung führt dazu, dass überwiegend oder stets ein kontinuierliches relatives Bewegen zeitgleich in X und Y Richtung erfolgt bzw. ein kontinuierliches Abfahren einer Kurvenbahn erfolgt. Es erfolgt somit bevorzugt keine relative Bewegung in nur einer ersten Richtung. Somit wird auch bevorzugt kein Einteilungsschritt oder Indexschritt oder Versatzschritt bewirkt. Ferner erfolgt bevorzugt keine relative Bewegung in einer zweiten Richtung senkrecht zur ersten Richtung.

Das Spendersubstrats (bzw. der Festkörpers) weist dabei bevorzugt Kristallgitterebenen auf, die gegenüber einer ebenen Hauptoberfläche geneigt sind. Die Hauptoberfläche das Spendersubstrat ist dabei bevorzugt in Längsrichtung des Spendersubstarts einerseits begrenzt, wobei sich eine Kristallgitterebenennormale gegenüber einer Hauptoberflächennormalen in eine erste Richtung neigt. Gemäß einer bevorzugten Ausführungsform der vorliegenden Erfindung sind mindestens 20% oder mindestens 40% oder mindestens 50% oder mindestens 70% oder mindestens 90% der Längserstreckung einer, einzelner oder mehrerer oder der Mehrzahl aller linienförmigen Gestalten oder alle linienförmige Gestalten bzw. Schreiblinie/n gegenüber der Schnittlinie in einem Winkelbereich zwischen 0,05° und 87°, insbesondere in einem Winkelbereich zwischen 3° oder 5° und 60° und bevorzugt zwischen 10° und 50°, insbesondere zwischen 10° und 30°, wie z.B. zwischen 12° und 20° oder zwischen 13° und 15°, oder zwischen 20° und 50°, insbesondere zwischen 25° und 40° oder zwischen 30° und 45° oder zwischen 28° und 35°, geneigt. Diese Lösung ist vorteilhaft, da die Neigung so groß ist, dass ausreichend viele unterschiedliche Kristallgitterebenen Bestandteil jeder weiteren Modifikation derselben linienförmigen Gestalt bzw. Schreiblinie sind. Das Spendersubstrat besteht hierbei bevorzugt aus SiC oder weist bevorzugt SiC auf.

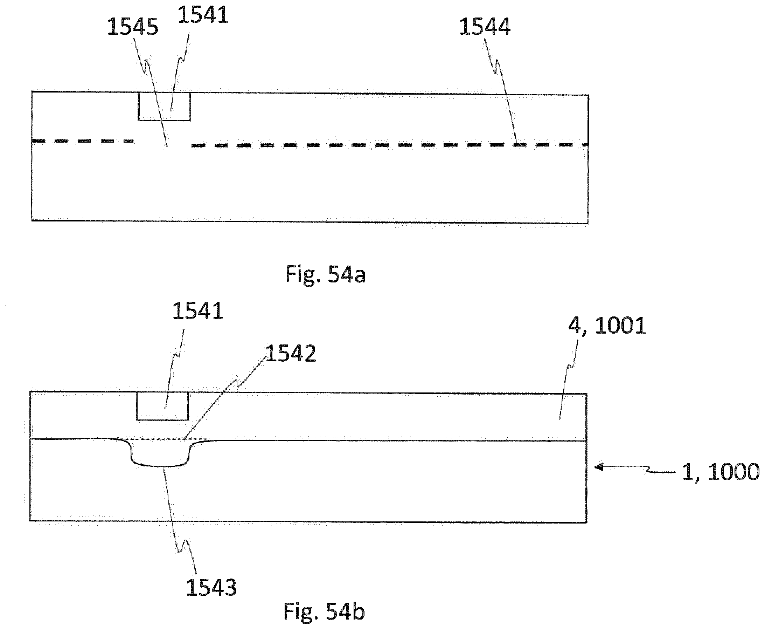

Fig. 54a zeigt eine Beispiel, gemäß dem aufgrund eines Einstrahlhindernisses die optischen Eigenschaften lokal unterschiedlich sind und sich daher der Abstand des Fokuspunkts der Laserstrahlung zur Oberfläche, über welche die Laserstrahlung in den Festkörper eindringt, verändert bzw. lokal verändert bzw. unmittelbar in Abhängigkeit verändert. Dies kann dazu führen, dass die Modifikationen nicht in einer Ebene erzeugt werden bzw. nicht auf einer gewünschten Ebene liegen bzw. eine gewünschte Kontur bzw. Form nicht beschreiben. Somit kann sich der Output reduzieren bzw. der Nacharbeitsaufwand erhöhen. Die Einstrahlhindernisse können dabei z.B. Implantgebiete und/oder elektrische Bauteile und/oder Komponenten von elektrischen Bauteilen und/oder der Festkörperrand bzw. Waferrand und/oder eine oder mehrere EPI Schicht/en, Strukturierung (z.B. Ätzgräben) und/oder andere regelmässige Veränderungen durch das Chipdesign sein. Implantgebiete 1541 stellen dabei bevorzugt Gebiete mit höherer Dotierung mit Fremdatomen, z.B. Phosphor, Bor, etc. dar. Diese Fremdatome verändern die optischen Eigenschaften - z.B. können eine größere Absorption bewirken, was wiederum eine Rissausbildung im Material verhindern kann. Das Bezugszeichen 1544 kennzeichnet dabei eine Rissausbreitung und das Bezugszeichen 1545 kennzeichnet dabei eine im Bereich des Einstrahlhindernisses gestoppte oder ausgelenkte Rissausbreitung 1545.

Es kann somit ein Schritt des Erfassens und/oder Analysierens von Einstrahlhindernissen vorgesehen sein, wobei bevorzugt eine Energieanpassung in Abhängigkeit von dem erfassten Einstrahlhindernis oder den Einstrahlhindernissen erfolgt. Diese Lösung ist von der Erkenntnis getragen, dass jede lateral inhomogene Veränderung der optischen Eigenschaften den Energieschwellwert beeinflusst. Je besser diese Veränderungen detektiert und korrigiert werden können, desto homogener kann die Laserebene bzw. Modifikationsebene bzw. Ablöseebene bzw. der Ablösebereich erzeugt werden.

In Fig. 54b kennzeichnet das Bezugszeichen 1543 eine Modifikationserzeugung bzw. Laserebene ohne Tiefenkorrektur und das Bezugszeichen 1542 kennzeichnet eine Modifikationserzeugung bzw. Laserebene mit Tiefenkorrektur.

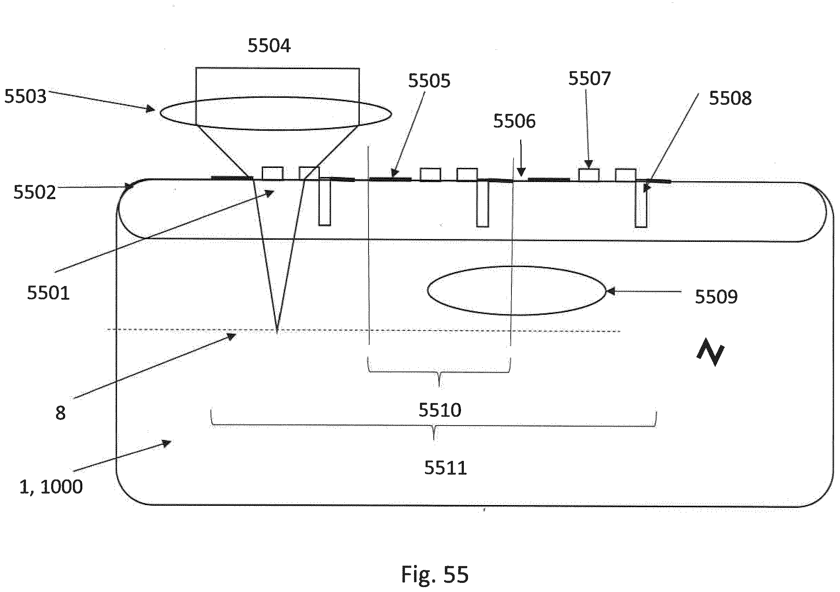

Fig. 55 zeigt eine detailliertere Darstellung des bzgl. der Fig. 54a und 54b beschriebenen Zusammenhangs. Die Energieanpassung erfolgt gemäß diesem Beispiel aufgrund mehrerer bzw. abwechselnder Einstrahlhindernisse. Die dargestellten Einstrahlhindernisse, die den Strahlengang 5501 des Laserstrahls 5504 nach dem Objektiv 5503 im Festkörper 1, 1000 bzw. der Kompositstruktur verändern, können hierbei neben anderem z.B. eine EPI-Schicht 5502, ein Implantgebiet 5505, eine Dicing Street 5506, Metallstrukturen 5507, geätzte Gräben 5508, Bereiche mit hohen Dotierkonzentrationen 5509 und einen Chip 5510 umfassen.

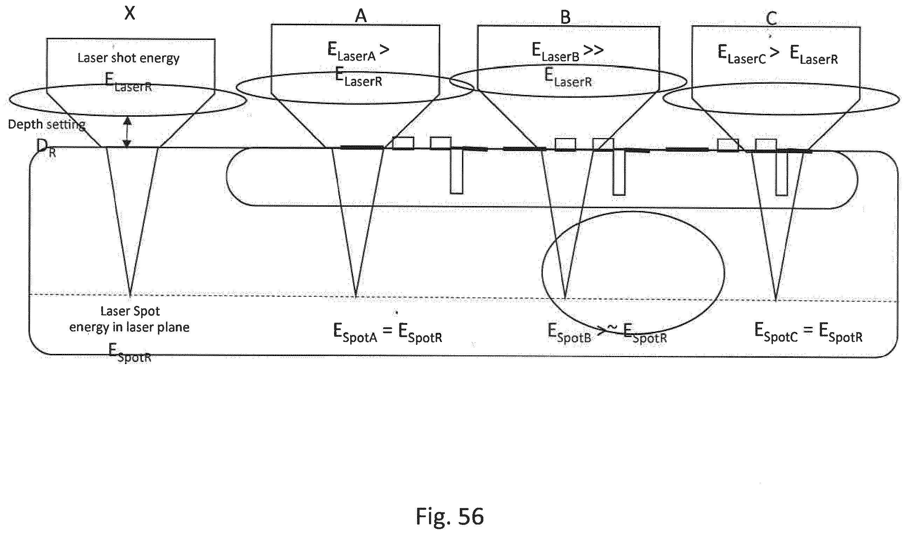

Fig. 56 zeigt eine weitere Darstellung zur Illustration der hinsichtlich der Figuren 54 und 55 bereits beschriebenen Zusammenhänge.

Es sind in dieser Darstellung 4 verschiedene Zustände (X, A, B, C) gezeigt. Der Zustand X repräsentiert einen Referenzzustand. Die Laserenergieeinstellungen und die Tiefeneinstellungen sind dabei für ein definiertes Material bestimmt.

Gemäß dem Zustand A sind aufgrund einer EPI-Schicht und einem Implantgebiet im Lichtpfad Anpassungen der Laserenergieeinstellungen und der Tiefeneinstellungen erforderlich. Dies kann z.B. durch eine höhere Absorption und/oder durch eine verschobene optische Konstante n bedingt sein.

Gemäß dem Zustand B befindet sich ein Implantgebiet, eine EPI-Schicht und Metallstrukturen im Lichtpfad, wodurch sehr große Absorptionen bewirkt werden. Ferner befindet sich zudem noch eine höherdotierte Zone im Lichtpfad, wodurch z.B. eine größere Absorption und ein kleiner Versatz der optischen Konstante n bewirkt wird. Hierdurch sind Anpassungen der Laserenergieeinstellungen und der Tiefeneinstellungen erforderlich.

Gemäß dem Zustand C befindet sich ein Implantgebiet, eine EPI-Schicht, eine metallische Struktur und geätzte Gräben (bewirken eine Fokusverschiebung und eine große Absorption) im Lichtpfad. Hierdurch sind Anpassungen der Laserenergieeinstellungen und der Tiefeneinstellungen erforderlich.

Allgemein wurde hierzu erkannt, dass die Ausbildung der Lasermodifikation somit durch Überschreiten einer Laserenergieschwelle erreicht wird, ab der eine Phasenumwandlung auftritt. Wird nun die Energie im Laserpuls erhöht, so wird bei Fokussierung die Schwelle entlang der Strahlrichtung früher überschritten, was ungeachtet der tatsächlichen geometrischen Fokuslage zu einem früheren Auftreten der Phasenumwandlung oder Materialmodifikation durch den Laser bzw. die Laserstrahlung führt. Dies bedeutet, dass bei stetiger Bearbeitung mit einer Laserpulsenergie über der Schwelle, die Lage der Lasermodifikationsebene im Material näher zur Materialoberfläche rückt und dementsprechend höher liegt als über den optischen Fokus definiert.

Auch können weitere Effekte, wie z.B. der Kerr-Effekt, der die Intensitätsabhängigkeit des Brechindexes beschreibt, oder eine durch freie Ladungsträger verursachte Selbstfokussierung zu einer intensitätsabhängigen Verschiebung der Höhe der Lasermodifikationsebene führen. Diese Effekte sind deterministisch und können über geeignete Verfahren quantifiziert und danach entsprechend kompensiert werden, mit dem Ziel, dass die Differenz zwischen vorgegebener Lage der Laserebene und tatsächlicher Lage der Laserebene möglichst minimiert wird.

Zum Beispiel hat bei einer Bearbeitungstiefe von $400\mu m$ in dotiertem Siliziumkarbid eine um $10\mu J$ gegenüber der minimal benötigten Schwellenergie erhöhte Laserpulsenergie den Effekt, dass die Modifikationsebene um ca. $20\mu m$ näher zur Festkörperoberfläche wandert.

Da dieser Effekt messbar ist, kann bei der Erstellung einer oder mehrerer Höhenkarten und/oder Dotierkarten und/oder Energiekarten für eine Nachführung des Laserfokus relativ zur Werkstückoberfläche dieser Effekt durch eine Wechselwirkung der ortsaufgelösten Laserleistungssteuerung mit der verwendeten Höhenkarte kompensiert werden.

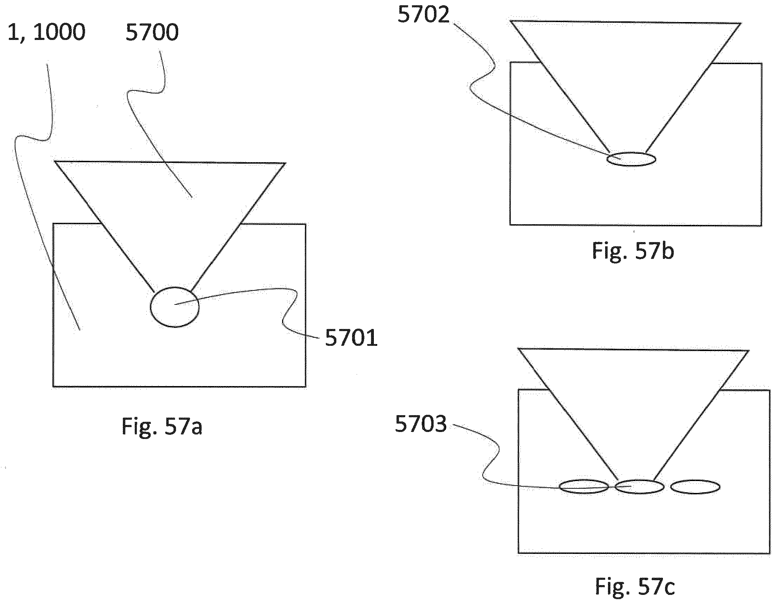

Fig. 57a zeigt einen einfallenden Lichtkegel 5700, durch den im Festkörper 1, 1000 ein Fokus 5700 erzeugt wird. Dargestellt ist dabei ein Fokusabbild eines Objektivs durchstrahlt von einem Laser mit gaußschen Strahlprofil.

Fig. 57b stellt schematisch ein Fokusabbild 5702 eines Objektivs durchstrahlt von einem Laser mit NICHT-gaußschen Strahlprofil dar, z.B. nachdem der Strahl durch einen SLM verändert wurde. Ein Spatial light modulator (SLM) ist dabei ein räumlicher Modulator für Licht und somit ein Gerät durch das Licht eine räumliche Modulation aufprägbar ist. Gegenüber dem gaußschen Strahlprofil ist die Z-Ausdehung des Fokuspunktes deutlich reduziert bzw. reduzierbar.

Fig. 57c stellt schematisch ein Fokusabbild 5703 eines Objektivs durchstrahlt von einem Laser mit NICHT-gaußschen Strahlprofil dar, z.B. nachdem der Strahl durch einen diffraktives optisches Element (DOE) verändert wurde. Der Strahl ist dabei bevorzugt zum Ausbilden mehrerer Fokusse durch das DOE aufgeteilt. Ein DOE dient dabei bevorzugt dazu die Beugung eines Laserstrahls um die räumliche Abbildung des Fokuspunktes zu verändern.

Diffraktive optische Elemente (DOEs) wirken durch Beugung auf Laserstrahlung ein. Hierbei werden Strukturen verwendet, die auf der Größenskala der Laserwellenlänge liegen. Mittels numerischer Simulation der Lichtbeugung an beugenden Strukturen wird ein Element berechnet, was dann in größeren Stückzahlen hergestellt werden kann. Generell wird die räumliche Verteilung des Lichts im Laserstrahlprofil geändert, entweder direkt nach dem Element oder im Brennpunkt nach einem fokussierenden Element. Dies bedeutet, dass z.B. ein Strahl in mehrere Strahlen aufgespalten werden kann, dass ein - üblicherweise auftretendes - Gauß-Strahlintensitätsprofil in eine andere Form überführt wird, oder dass sich die Intensitätsverteilung der Laserstrahlung im Fokus in einer durch herkömmliche Linsen nicht erreichbaren Weise ändert, z.B. durch das bewusste Einbringen oder Unterdrücken von Nebenmaxima, die für die erwünschte Laserwechselwirkung erforderlich sind.

Im Gegensatz dazu ist ein räumlicher Modulator für Licht (englisch: Spatial Light Modulator (SLM)) ein Gerät, um Licht eine räumliche Modulation aufzuprägen.

Gewöhnlicherweise moduliert ein SLM die Intensität eines Lichtstrahls, es ist jedoch auch möglich, die Phase oder auch die Phase und die Intensität gleichzeitig zu modulieren.

Diese räumliche Modulation wird beim DOE durch die Strukturen im Element vorgenommen, beim SLM hingegen durch die einzelnen Pixel am SLM. Besonders nach Abbildung oder Fokussierung eines intensitäts- und phasenmodulierten Strahls sind damit programmierbare Intensitätsverteilungen im Fokus zu erreichen. Während ein DOE also statisch und reproduzierbar auf den Laserstrahl wirkt, kann z.B. mit Hilfe eines SLM die Zahl der Strahlen oder auch das verwendete Laserstrahlprofil in einer Laserbearbeitungsvorrichtung dynamisch umgeschaltet werden. Auch ist eine dynamische Anpassung im Prozessverlauf möglich, z.B. nach Feedback einer gleichzeitigen Überwachung des Prozessfortschritts.

Das hiermit vorgeschlagene Verfahren weist gemäß einer Ausführungsform den Schritt des Veränderns einer Strahleigenschaften der Laserstrahlen vor dem Eindringen in den Festkörper auf, wobei die Strahleigenschaft die Intensitätsverteilung im Fokus ist, wobei die Veränderung oder Anpassung der Strahleigenschaft von mindestens oder genau einem Spatial Light Modulator und/oder von mindestens oder genau einem DOE bewirkt wird, wobei der Spatial Light Modulator und/oder das DOE im Strahlengang der Laserstrahlung zwischen dem Festkörper und der Strahlungsquelle angeordnet ist.

Zur Erläuterung der Funktionsweise von DOEs und Spatial Light Modulatoren wird auf die nachfolgend genannte Druckschrift verwiesen: Flexible beam shaping system for the next generation of process development in laser micromachining, LANE 2016, 9th International Conference on Photonic Technologies LANE 2016, Tobias Klerks, Stephan Eifel.

Laserstrahlintensitätsprofile die von der normalerweise üblichen Gaußform abweichen werden als nicht-gaußsche Strahlenprofile bezeichnet und können eingesetzt werden, um ein anderes Bearbeitungsergebnis zu erzielen. So ist z.B. ein Linienfokus denkbar, der in einer Dimension senkrecht zur Strahlfortpflanzungsrichtung eine deutlich andere Ausdehnung aufweist als in einer zweiten Dimension. Dies ermöglicht ein Überstreichen breiterer Bereiche des Werkstücks mit dem Laserstrahl im Bearbeitungsschritt. Auch ist ein "top-hat"-Profil bekannt, dass eine konstante Intensität im Zentrum des Strahls aufweist, was den Vorteil bietet, dass in der Bearbeitung im Fokus keine Bereiche unterschiedlicher Intensität vorliegen oder zumindest nur Bereiche gleicher Intensität über der Laserbearbeitungsschwelle liegen. Dies kann zum Beispiel zur Minimierung der Schleifverluste nach dem Trennen dienen.

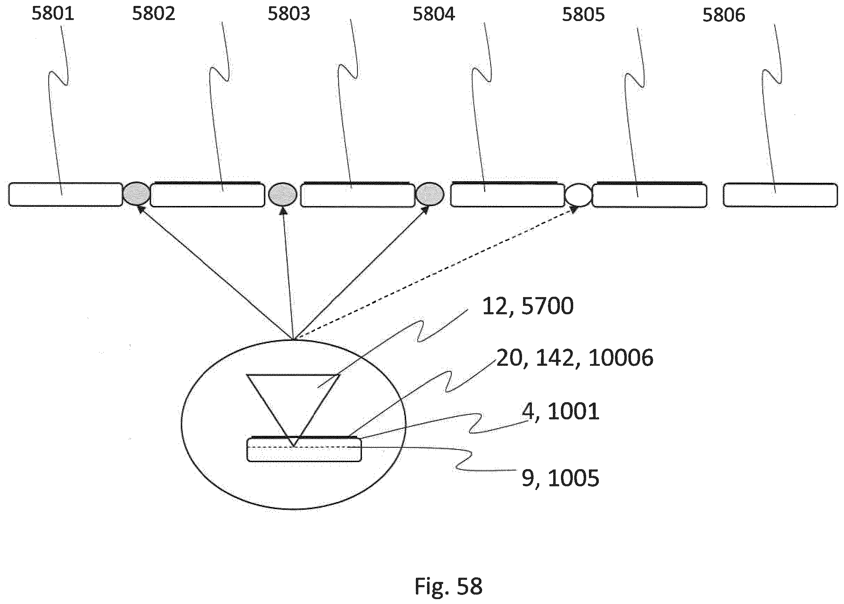

Fig. 58 zeigt einen sogenannten Frontsideprozess. Hierbei werden die Laserstrahlen über eine Oberfläche des Festkörpers in den Festkörper eingebracht, die näher an der zu erzeugenden Ablöseebene bzw. Modifikationsebene liegt als eine den Festkörper an einem gegenüberliegenden Ende begrenzenden weitere Oberfläche. Dieser Frontsideprozess ist vorteilhaft, da die Lasertiefe (bevorzugt $<100\mu m$) gegenüber einem Backsideprozess (z.B. $>250$ $\mu m$ bzw.

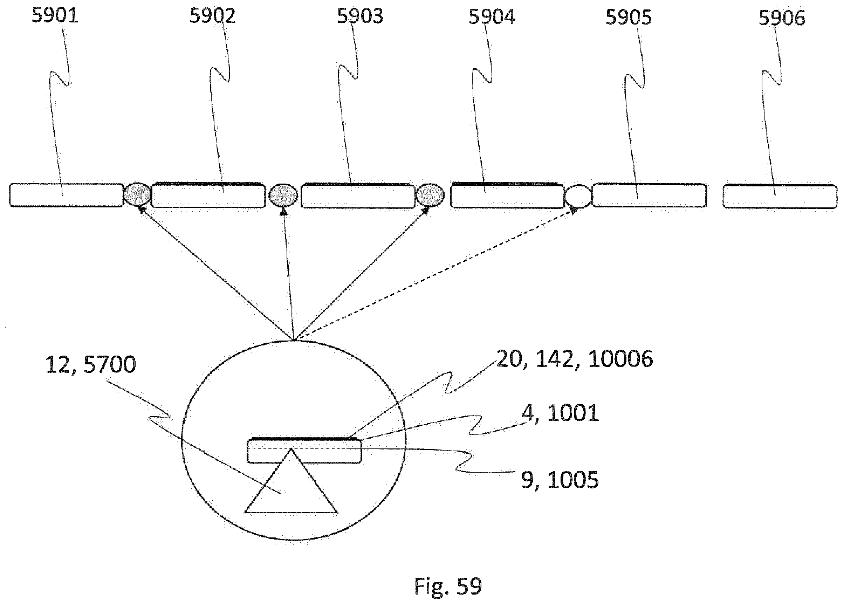

bis zu 400 μm oder mehr) (vgl. Fig. 59) deutlich geringer ist. Dies bewirkt geringer Laserstrahlenergien, bessere Tiefenkontrolle und eine bessere Laserbeamqualität in der Laserebene bzw. auf der Ablöseebene bzw. im Bereich der Ablöseebene. Ferner muss die Rückseite des Festkörpers nicht noch zusätzlich bearbeitet werden.

Somit werden beim Frontsideprozess die Modifikationen im Festkörper vor der Erzeugung einer metallischen Kontaktschicht erzeugt. Gemäß einer weiteren bevorzugten Ausführungsform kann die Modifikationserzeugung nach dem Polieren (5801) und/oder vor dem Erzeugen einer EPI-Schicht (5802) oder nach dem Erzeugen einer EPI-Schicht (5802) und/oder vor dem Erzeugen eines Implantgebiets (5803) im Festkörper oder nach dem Erzeugen eines Implantgebiets (5803) und/oder vor dem Erzeugen oder Anordnen einer ersten Metallschicht (5804) erfolgen. In Abhängigkeit der Eigenschaften der ersten Metallschicht (5804), insbesondere der Größe (vgl. Ausführungen zu Fig. 52) und/oder der Zusammensetzung, kann nach der Erzeugung oder dem Anordnen der ersten Metallschicht (5804) und/oder vor dem Erzeugen oder Anordnen einer metallischen Kontaktierschicht (5805) zusätzlich oder alternativ der Frontsideprozess, d.h. das Einleiten von Laserstrahlen in den Festkörper über eine Oberfläche der abzutrennenden Festkörperschicht, durchgeführt werden.

Fig. 59 zeigt einen sogenannten Backsideprozess. Hierbei werden die Laserstrahlen über eine Oberfläche des Festkörpers in den Festkörper eingebracht, die weiter von einer zu erzeugenden Ablöseebene bzw. Modifikationsebene beabstandet ist als eine den Festkörper an einem gegenüberliegenden Ende begrenzenden Oberfläche bzw. Hauptoberfläche. Dieser Backsideprozess ist vorteilhaft, da keine oder nur geringe Anpassungen des Chipdesigns auf der Frontseite während des Anordnens oder Erzeugens von Bauteilen, insbesondere elektrischen Bauteilen, insbesondere Metall aufweisend oder aus Metall bestehend, erforderlich sind.

Somit werden beim Backsideprozess die Modifikationen im Festkörper vor der Erzeugung einer metallischen Kontaktschicht erzeugt. Gemäß einer weiteren bevorzugten Ausführungsform kann die Modifikationserzeugung nach dem Polieren (5901) und/oder vor dem Erzeugen einer EPI-Schicht (5902) oder nach dem Erzeugen einer EPI-Schicht (5902) und/oder vor dem Erzeugen eines Implantgebiets (5903) im Festkörper oder nach dem Erzeugen eines Implantgebiets (5903) und/oder vor dem Erzeugen oder Anordnen einer ersten Metallschicht (5904) erfolgen. In Abhängigkeit der Eigenschaften der ersten Metallschicht (5904), insbesondere der Größe (vgl. Ausführungen zu Fig. 52) und/oder der Zusammensetzung, kann nach der Erzeugung oder dem Anordnen der ersten Metallschicht (5904) und/oder vor dem Erzeugen oder Anordnen einer metallischen Kontaktierschicht (5905) zusätzlich oder alternativ der Backsideprozess, d.h. das Einleiten von Laserstrahlen in den Festkörper über eine Oberfläche der abzutrennenden Festkörperschicht, durchgeführt werden.

Dieses Verfahren ist insbesondere für das Abtrennen von Festkörperschichten von einem aus SIC bestehenden oder SiC aufweisenden Festkörper bzw. Spendersubstrat sinnvoll.

Ferner können die Modifikationen nacheinander in mindestens einer Zeile oder Reihe oder Linie erzeugt werden, wobei die in einer Zeile oder Reihe oder Linie erzeugten Modifikationen 9 bevorzugt in einem Abstand X und mit einer Höhe H erzeugt werden, damit ein sich zwischen zwei aufeinander folgenden Modifikationen ausbreitender Riss, insbesondere in Kristallgitterrichtung ausbreitender Riss, dessen Rissausbreitungsrichtung in einem Winkel W gegenüber der Ablöseebene ausgerichtet ist, die beiden Modifikationen miteinander verbindet. Der Winkel W liegt hierbei bevorzugt zwischen 2° und 6°, insbesondere bei 4°. Bevorzugt breitet sich der Riss von einem Bereich unterhalb des Zentrums einer ersten Modifikation hin zu einem Bereich oberhalb des Zentrums einer zweiten Modifikation hin aus. Der hierbei wesentliche Zusammenhang ist daher, dass die Größe der Modifikation in Abhängigkeit des Abstands der Modifikationen und des Winkels W verändert werden kann bzw. muss.

Für den Laserprozess ist außerdem vorteilhaft, die Polarisation der eingesetzten Laserstrahlung speziell auszubilden. Um eine möglichst geringe Abhängigkeit von der Schreibrichtung zu erreichen, kann der Laser zirkular polarisiert sein, zum Beispiel durch Verwendung einer Lambda/4-Platte nach einer linear polarisierten Laserquelle.

Besonders vorteilhaft ist jedoch, linear polarisiertes Laserlicht zur Bearbeitung zu verwenden. Im Bearbeitungsprozess wird eine initiale Ladungsträgerdichte im Material zunächst durch Multiphotonenabsorption erzeugt. Die Wahrscheinlichkeit für das Auftreten von Multiphotonenabsorption im Material ist insbesondere bei Kristallen abhängig von der Lage der Kristallachsen zur Richtung des elektrischen Feldes der Laserstrahlung. Diese Winkelabhängigkeit der Multiphotonenabsorption kann genutzt werden, um den Laserprozess im Inneren des Materials besonders effizient zu führen und möglichst gleichmäßig zu gestalten.

Ferner kann dieses Verfahren auch den Schritt des Erzeugens einer Kompositstruktur durch Anordnen oder Erzeugen von Schichten und/oder Bauteilen 150 an oder oberhalb einer zunächst freiliegenden Oberfläche des Festkörpers 1 aufweisen, wobei die freiliegende Oberfläche bevorzugt Bestandteil der abzutrennenden Festkörperschicht ist. Besonders bevorzugt werden die Modifikationen zum Ausbilden der Ablöseebene vor der Erzeugung der Kompositstruktur erzeugt.

Zum Einleiten der äußeren Kraft kann z.B. analog zu den zuvor beschriebenen Verfahren eine Aufnahmeschicht 140 an einer freiliegenden Oberfläche der Kompositstruktur bzw. des Festkörpers angeordnet werden.

Somit werden im weiteren Laserverfahren gemäß einer Ausführungsform bevorzugt auf SiC (aber auch anderen Materialien) Linien parallel zur Rissausbreitungsrichtung (bevorzugt Querlinien genannt) erzeugt, um zunächst eine Ebene für die bevorzugte Rissauslösung zu definieren (Rissinitialisierung), bevor Längslinien die Risse treiben. Hierbei werden die Risse erst quer, dann längs initialisiert, bevor ein finaler Schritt Linien zwischen die Längslinien des zweiten Schritts setzt um die Risse vollflächig auszulösen. Dies ermöglicht kürzere Risslaufwege, was die finale Oberflächenrauheit minimiert.

Beispielbild für Querlinien (mit dem Sägezahn) und Rissauslöselinien (auf den Wellenkämmen des Sägezahns).

Somit bezieht sich eine Ausführungsform auf ein Verfahren zum Abtrennen von mindestens einer Festkörperschicht 2 von einem Spendersubstrat 1. Das Verfahren umfasst dabei bevorzugt mindesten die Schritte: Bereitstellen des Spendersubstrats 1, wobei das Spendersubstrat 1 Kristallgitterebenen 6 aufweist, die gegenüber einer ebenen Hauptoberfläche 8 geneigt sind, wobei die Hauptoberfläche 8 das Spendersubstrat 1 in Längsrichtung des Spendersubstarts 1 einerseits begrenzt, wobei sich eine Kristallgitterebenennormale gegenüber einer Hauptoberflächennormalen in eine erste Richtung neigt, Bereitstellen von mindestens einem Laser 29, Einbringen von Laserstrahlung 14 des Lasers 29 in das Innere des Festkörpers 1 über die Hauptoberfläche (8) zum Verändern der Materialeigenschaften des Festkörpers 1 im Bereich von mindestens einem Laserfokus, wobei der Laserfokus durch von dem Laser emittierten Laserstrahlen des Lasers gebildet wird, wobei die Veränderung der Materialeigenschaft durch Verändern des Eindringortes der Laserstrahlung in das Spendersubstrat 1 eine linienförmige Gestalt 103 ausbildet, wobei die Veränderungen der Materialeigenschaft auf mindestens einer Erzeugungsebene 4 erzeugt werden, wobei die Kristallgitterebenen 6 des Spendersubstrats 1 gegenüber der Erzeugungsebene 4 geneigt ausgerichtet sind, wobei die linienförmige Gestalt 103 gegenüber einer sich an der Schnittstelle zwischen der Erzeugungsebene 4 und der Kristallgitterebene 6 ergebenden Schnittlinie 10 geneigt ist, wobei durch die veränderte Materialeigenschaft das Spendersubstrat 1 in Form von unterkritischen Rissen einreißt, Abtrennen der Festkörperschicht 2 durch Einleiten einer äußeren Kraft in das Spendersubstrat 1 zum Verbinden der unterkritischen Risse oder so viel Material auf der Erzeugungsebene 4 mittels der Lasterstrahlung verändert wird, dass sich unter Verbindung der unterkritischen Risse die Festkörperschicht 2 von dem Spendersubstart 1 ablöst.

Jedes hier beschriebene Verfahren kann im Rahmen einer Ausführungsform zusätzlich oder gemäß einem zum Verständnis der Erfindung beitragenden Beispiel alternativ den Schritt des Einleiten einer äußeren Kraft in den Festkörper 1 zum Erzeugen von Spannungen in dem Festkörper 1 aufweisen, wobei die äußere Kraft so stark ist, dass die Spannungen eine Rissausbreitung entlang der Ablöseebene 8 bewirkt.

Jedes hier beschriebene Verfahren kann im Rahmen einer Ausführungsform zusätzlich oder gemäß einem zum Verständnis der Erfindung beitragenden Beispiel alternativ den Schritt des Erzeugen einer zweiten Gruppe von Modifikationen mittels Laserstrahlen zum Vorgeben von mindestens einer, insbesondere mehrerer zweiter Ablöseebene/n, aufweisen. Die erste Ablöseebene und die zweite Ablöseebene sind dabei bevorzugt zueinander orthogonal ausgerichtet. Ferner erfolgt besonders bevorzugt unmittelbar oder mittelbar nach der Abtrennung der Festkörperschicht von dem Festkörper ein Schritt des Teilens der vom Festkörper abgetrennten Festkörperschicht entlang der zweiten Ablöseebene zum Vereinzeln von Festkörperelemente.

Jedes hier beschriebene Verfahren kann im Rahmen einer Ausführungsform zusätzlich oder gemäß einem zum Verständnis der Erfindung beitragenden Beispiel alternativ den Schritt des Anpressens von mindestens einem Druckbeaufschlagungselement einer Druckbeaufschlagungseinrichtung an zumindest einen vorbestimmten Anteil der Spannungserzeugungsschicht zum Anpressen der Spannungserzeugungsschicht an die Oberfläche aufweisen. Bevorzugt wird das Druckbeaufschlagungselement zumindest während der thermischen Beaufschlagung der Spannungserzeugungsschicht und/oder während der Rissausbreitung an die Spannungserzeugungsschicht angepresst.

Bevorzugt wird zumindest ein abgetrennter Anteil der Festkörperlage bzw. Festkörperschicht aufgrund der Spannungserzeugungsschicht bzw. aufgrund der Polymerschicht in Richtung des Druckbeaufschlagungselements ausgelenkt und gegen das Druckbeaufschlagungselement angepresst. Das Druckbeaufschlagungselement begrenzt dabei bevorzugt die maximale Auslenkung der Festkörperlage bzw. der Festkörperschicht.

Eine Ausführungsform kann sich ferner auf eine Mehrkomponentenanordnung beziehen, die mindestens eine Festkörperschicht oder einen Festkörper aufweist. Die Festkörperschicht oder der Festkörper besteht dabei bevorzugt zu mehr als 50% (massemäßig), insbesondere zu mehr als 75% (massemäßig) oder zu mehr als 90% (massemäßig) oder zu mehr als 95% (massemäßig) oder zu mehr als 98% (massemäßig) oder zu mehr als 99% (massemäßig) aus SiC, wobei die Festkörperschicht oder der Festkörper im Bereich einer ersten Oberfläche Druckspannungen erzeugende Modifikationen oder Modifikationsbestandteile aufweist, wobei die Modifikationen amorphisierte Bestandteile der Festkörperschicht oder des Festkörpers sind, wobei die Modifikationen näher zur ersten Oberfläche beabstandet sind oder diese mit ausbilden als zu einer zweiten Oberfläche, wobei die zweite Oberfläche parallel oder im Wesentlichen parallel zur ersten Oberfläche ausgebildet ist, wobei die erste Oberfläche bevorzugt eben oder im Wesentlichen eben ist, wobei die Festkörperschicht oder der Festkörper Kristallgitterebenen aufweist, die gegenüber der ersten Oberfläche geneigt sind, wobei die erste Oberfläche des Festkörper oder der Festkörperschicht in Längsrichtung den Festkörpers oder die Festkörperschicht einerseits begrenzt, wobei sich eine Kristallgitterebenennormale gegenüber einer Hauptoberflächennormalen in eine erste Richtung neigt, wobei die Modifikationen eine oder mehrere linienförmige Gestalt/en im Inneren des Spendersubstrats auf einer Erzeugungsebene ausbilden, wobei die Kristallgitterebenen des Festkörpers oder der Festkörperschicht gegenüber der Erzeugungsebene geneigt ausgerichtet sind, wobei die linienförmige Gestalt/en zumindest abschnittsweise und bevorzugt mehrheitlich gegenüber einer sich an der Schnittstelle zwischen der Erzeugungsebene und der Kristallgitterebene ergebenden Schnittlinie geneigt ist/sind und eine an der ersten Oberfläche der Festkörperschicht oder des Festkörpers erzeugten Metallschicht oder angeordneten Metallschicht und/oder erzeugten oder angeordneten elektrischen Bauteilen. Die erste Oberfläche kann hierbei alternativ als Hauptoberfläche bezeichnet werden.

**Bezugszeichenliste**

| | | | |
|---|---|---|---|
| 1 | Festkörper / Spendersubstrat | 52 | Orthogonale zur radialen Richtung |
| 2 | Festkörperschicht | 51 | |
| 4 | Ablöseebene / Erzeugungsebene | 60 | Kristallgitterebenennormale |
| 5 | Ort der Modifikationserzeugung | 70 | Neigungswinkel zwischen Orthogonale zur Hauptoberfläche und Kristallgitterebenennormale |
| 6 | Kristallgitterebene | | |
| 7 | Ende der Kristallgitterebene | | |
| 8 | Hauptoberfläche | 80 | Orthogonale zur Hauptoberfläche |
| 9 | Modifikation | 90 | Normalenebene |
| 10 | Schnittlinie | 92 | Orthogonalebene zur Normalenebene |
| 12 | Winkel | | |
| 14 | Laserstrahlung | 94 | Erstreckungsrichtung der Enden der Kristallgitterebenen |
| 29 | Element der Lasereinrichtung, insbesondere Laserkopf | 103 | erste Linie / linienförmige Gestalt |
| 30 | Verfahreinrichtung zur Umpositionierung eines Elements der Lasereinrichtung | 103a | erste Erstreckungsrichtung der linienförmigen Gestalt |
| | | 103b | alternative Erstreckungsrichtung der linienförmigen Gestalt |
| 32 | Auslass für die Laserstrahlung | 105 | zweite Linie |
| 45 | Rotationseinrichtung | 140 | Aufnahmeschicht |
| 49 | Rotationszentrum des Spendersubstrats | 146 | Aufnahmeschicht |
| | | 150 | Bauteil |
| 50 | Rotationszentrum der Rotationseinrichtung | 170 | Pfeil |
| | | 172 | Pfeil |
| 51 | Radiale Richtung zwischen Rotationszentrum der Rotationseinrichtung und dem Rotationszentrum des Spendersubstrats | 174 | Kühleinrichtung |
| | | 176 | prozessierte Festkörperanordnung |
| | | 178 | Gas |
| | | 180 | Positioniereinrichtung |
| | | R | Rotationsrichtung |

**Patentansprüche**

1. Verfahren zur Modifikation eines Festkörpers, insbesondere zum Abtrennen von mindestens einer Festkörperschicht (2) von einem Spendersubstrat (1), mindestens umfassend die Schritte:

Bereitstellen des Spendersubstrats (1), wobei das Spendersubstrat (1) Kristallgitterebenen(6) aufweist, die gegenüber einer ebenen Hauptoberfläche (8) geneigt sind, wobei die Hauptoberfläche (8) das Spendersubstrat (1) in Längsrichtung des Spendersubstarts (1) einerseits begrenzt, wobei sich eine Kritallgitterebenennormale gegenüber einer Hauptoberflächennormalen in eine erste Richtung neigt,
Bereitstellen von mindestens einem Laser,
Einbringen von Laserstrahlung des Lasers in das Innere des Spendersubstrats (1), insbesondere über die Hauptoberfläche (8), zum Verändern der Materialeigenschaften des Spendersubstrats (1) im Bereich von mindestens einem Laserfokus, wobei der Laserfokus durch von dem Laser emittierten Laserstrahlen des Lasers gebildet wird,

wobei die Veränderung der Materialeigenschaft durch Verändern des Eindringortes der Laserstrahlung in das Spendersubstrat (1) eine linienförmige Gestalt (103) ausbildet,

wobei die Veränderungen der Materialeigenschaft auf mindestens einer Erzeugungsebene (4) erzeugt werden,

wobei die Kristallgitterebenen (6) des Spendersubstrats (1) gegenüber der Erzeugungsebene (4) geneigt ausgerichtet sind,

wobei die linienförmige Gestalt (103) zumindest abschnittsweise, bevorzugt mehrheitlich, gegenüber einer sich an der Schnittstelle zwischen der Erzeugungsebene (4) und der Kristallgitterebene (6) ergebenden Schnittlinie (10) geneigt ist.

2. Verfahren nach Anspruch 1,
**dadurch gekennzeichnet, dass**

durch die veränderte Materialeigenschaft das Spendersubstrat (1) in Form von unterkritischen Rissen einreißt, Abtrennen der Festkörperschicht (2) durch Einleiten einer äußeren Kraft in das Spendersubstrat (1) zum Verbinden der unterkritischen Risse oder so viel Material auf der Erzeugungsebene (4) mittels der Lasterstrahlung verändert wird, dass sich unter Verbindung der unterkritischen Risse die Festkörperschicht (2) von dem Spendersubstart (1) ablöst,

wobei

die linienförmige Gestalt (103) zumindest abschnittsweise und bevorzugt mehrheitlich oder vollständig gegenüber der Schnittlinie (10) in einem Winkelbereich zwischen 3° und 87°, insbesondere in einem Winkelbereich zwischen 5° und 60° und bevorzugt zwischen 10° und 50°, geneigt ist.

3. Verfahren nach Anspruch 2,
**dadurch gekennzeichnet, dass**
soviel Material des Spendersubstrats (1) unter Ausbildung einer linienförmigen Gestalt (103) verändert wird, dass sich aus den infolge der Festkörperschichtenabtrennung freigelegten Enden der einzelnen Kristallgitterebenen und den Materialveränderungen Moirémuster ergeben, wobei hierzu eine Vielzahl sich linienförmig und bevorzugt geradlinig erstreckender und parallel zueinander ausgerichteter Materialveränderungsbereiche erzeugt werden.

4. Verfahren nach einem der vorangegangenen Ansprüche 2 oder 3
**dadurch gekennzeichnet, dass**

die Laserstrahlung mit Pulslängen von weniger als 5ns oder von weniger als 2ns oder weniger als 1ns, insbesondere von weniger als 700ps oder von weniger als 600ps oder von weniger als 500ps oder von weniger als 400ps oder von weniger als 300ps oder von weniger als 200ps oder von weniger als 150ps oder von weniger als 100ps oder von weniger als 50ps oder von weniger als 10ps, erzeugt werden
und
die Laserstrahlung mit Pulsenergien erzeugt werden, die zwischen 100 nJ und 1 mJ oder 500 nJ und 100 $\mu$J oder 1 $\mu$J und 50 $\mu$J oder 0,1 $\mu$J und 50 $\mu$J liegen, wobei die unterkritischen Risse mit einer Risslänge zwischen 10$\mu$m und 100$\mu$m, insbesondere zwischen 20$\mu$m und 70$\mu$m und bevorzugt zwischen 30$\mu$m und 50$\mu$m und besonders bevorzugt zwischen 35$\mu$m und 45$\mu$m, insbesondere 40$\mu$m, erzeugt werden.

5. Verfahren nach einem der vorangegangenen Ansprüche,
**dadurch gekennzeichnet, dass**

im Weg der Laserstrahlung vor dem Eindringen der Laserstrahlung in das Spendersubstrat (1) ein diffraktives optisches Element (DOE) angeordnet ist, wobei die Laserstrahlung durch das DOE auf mehrere Lichtpfade zum Erzeugen mehrerer Fokusse aufgeteilt wird,
wobei das DOE bevorzugt über eine Länge von 200$\mu$m eine Bildfeldwölbung bewirkt, die kleiner oder gleich 50$\mu$m, insbesondere kleiner oder gleich 30$\mu$m oder kleiner oder gleich 10$\mu$m oder kleiner oder gleich 5 $\mu$m oder kleiner oder gleich 3$\mu$m, ist, wobei durch das DOE zumindest 2 und bevorzugt mindestens oder genau 3 oder mindestens oder genau 4 oder mindestens oder genau oder mindestens oder genau oder bis zu 5 oder mindestens oder genau oder bis zu 10 oder mindestens oder genau oder bis zu 20 oder mindestens oder genau oder bis zu 50 oder bis zu 100 Fokusse zur Veränderung der Materialeigenschaften des Spendersubstrats zeitgleich erzeugt werden.

6. Verfahren nach einem der vorangegangenen Ansprüche,
**dadurch gekennzeichnet, dass**

mehrere Spendersubstrate (1) während der Veränderung der Materialeigenschaft zeitgleich nebeneinander auf einer Rotationseinrichtung, insbesondere einem Rotationstisch, angeordnet sind und um eine gemeinsame Rotationsachse rotierbar sind, wobei die Rotationsgeschwindigkeit größer als 10 Umdrehungen / Minute und bevorzugt größer als 50 Umdrehungen / Minute und besonders bevorzugt größer als 150 Umdrehungen / Minute, insbesondere bis zu 600 Umdrehungen / Minute, ist.

7.  Verfahren nach Anspruch 6,
    **dadurch gekennzeichnet, dass**
    eine Strahlformungseinrichtung zur Veränderung der Eigenschaften der beaufschlagenden Laserstrahlung, insbesondere eine Einrichtung zur Veränderung der Polarisation der Laserstrahlen (16), insbesondere in Form einer drehenden Lambda-Halbe-Platte oder einer Pockels-Zelle, vorgesehen ist und/oder die Strahlformungseinrichtung dazu ausgebildet ist, die Laserstrahlung zirkulär oder elliptisch zu polarisieren, wobei das Spendersubstrat mit der zirkulär oder elliptisch polarisierten Laserstrahlung, insbesondere in Form von LambdaViertel-Platten, beaufschlagt wird.

8.  Verfahren nach einem der vorangegangenen Ansprüche,
    **dadurch gekennzeichnet, dass**

    das Spendersubstrat (1) eine chemischen Verbindung, wie Siliziumcarbid, aufweist, wobei die chemische Verbindung bevorzugt einen Stoff oder mehrere Stoffe ausgewählt aus der dritten, vierten und/oder fünften Hauptgruppe des Periodensystems der Elemente und/oder der 12. Nebengruppe des Periodensystem der Elemente aufweist, wobei die Materialveränderung eine vorbestimmte Stoffumwandlung des Ausgangsmaterials, insbesondere Siliziumcarbid, des Spendersubstrats in ein Zielmaterial, insbesondere Silizium und Kohlenstoff, darstellt.

9.  Verfahren nach einem der vorangegangenen Ansprüche 2 bis 4 oder nach einem der von einem der Ansprüche 2 bis 4 abhängigen Ansprüche 5 bis 8,
    **dadurch gekennzeichnet, dass**

    zum Erzeugen der äußeren Kraft ein Polymermaterial an der Hauptoberfläche (8) angeordnet wird, wobei das Polymermaterial eine Glasübergangstemperatur von unter 20°C, insbesondere von unter 10°C oder von unter 0°C, aufweist und wobei das Polymermaterial auf eine Temperatur unterhalb der Glasübergangstemperatur abgekühlt wird, wobei durch den erfolgenden Glasübergang mechanische Spannungen im Spendersubstrat (1) erzeugt werden, wobei durch die mechanischen Spannungen die unterkritischen Risse miteinander verbunden werden, wodurch die Festkörperschicht (2) vom Spendersubstrat (1) abgelöst wird.

10.  Verfahren nach einem der vorangegangenen Ansprüche,
     ferner umfassend die Schritte:

     Bewegen des Spendersubstrats (1) relativ zum Laser,
     wobei der Laser zur definierten Fokussierung der Laserstrahlung und/oder zur Anpassung der Laserenergie kontinuierlich in Abhängigkeit von mindestens einem Parameter und bevorzugt einer Vielzahl an Parametern, insbesondere mindestens zwei Parametern, eingestellt wird.

11.  Verfahren nach einem der vorangegangenen Ansprüche,
     **dadurch gekennzeichnet, dass**

     mehrere erste linienförmige Gestalten (103) erzeugt werden,
     wobei durch jede linienförmige Gestalt ein unterkritischer Riss oder mehrere unterkritische Risse erzeugt werden,
     wobei die unterkritischen Risse der ersten linienförmigen Gestalten in einem definierten Abstand zueinander beabstandet sind, wobei der Abstand so groß ist, dass sich die unterkritischen Risse in axialer Richtung des Spendersubstrats nicht überlagern, insbesondere mindestens oder bis zu 2μm oder mindestens oder bis zu 5μm oder mindestens oder bis zu 10μm oder mindestens oder bis zu 20μm oder mindestens oder bis zu 30μm oder mindestens oder bis zu 50μm oder mindestens oder bis zu 75μm oder mindestens oder bis zu 100μm voneinander beabstandet sind,
     und nach der Erzeugung der ersten linienförmigen Gestalten zumindest zwischen zwei ersten linienförmigen Gestalten und bevorzugt zwischen mehr als zwei ersten linienförmigen Gestalten jeweils mindestens eine weitere linienförmige Gestalt mittels Laserstrahlen, insbesondere durch Verändern der Materialeigenschaften, erzeugt wird.

**12.** Verfahren nach einem der vorangegangenen Ansprüche,
**dadurch gekennzeichnet, dass**

das Spendersubstrat ein hexagonales Kristallgitter mit Wurzitstruktur oder Korundstruktur aufweist, wobei die linienförmige Gestalt in einem vorbestimmten Winkel zwischen 15° und 60°, insbesondere bei der Wurzitstruktur in einem Winkel zwischen 25° und 35° und bevorzugt in einem Winkel von 30° und bei der Korundstruktur zwischen 10° und 60° und bevorzugt in einem Winkel von 45°, gegenüber der Schnittgeraden erzeugt wird oder das Spendersubstrat ein kubisches Kristallgitter aufweist, wobei die linienförmige Gestalt in einem vorbestimmten Winkel zwischen 7,5° und 60°, insbesondere bei einer monoklinen kubischen Struktur in einem Winkel zwischen 17,5° und 27,5° und bevorzugt in einem Winkel von 22,5° oder bei Yttrium-Aluminium-Granat zwischen 8° und 37° und bevorzugt in einem Winkel von 22,5°, gegenüber der Schnittgeraden erzeugt wird oder das Spendersubstrat eine trikline Kristallgitterstruktur aufweist, wobei die linienförmige Gestalt in einem vorbestimmten Winkel von 5° bis 50°, insbesondere zwischen 10° und 45° oder mit 10° oder mit 45°, gegenüber der Schnittgeraden erzeugt wird oder das Spendersubstrat eine Zinkblende-Kristallstruktur aufweist, wobei die linienförmige Gestalt in einem vorbestimmten Winkel zwischen 15° und 60°, insbesondere bei Galliumarsenid in einem vorbestimmten Winkel zwischen 18° und 27° und bevorzugt in einem Winkel von 22,5° oder bei Indiumphosphid zwischen 18 und 27° und bevorzugt in einem Winkel von 22,5°, gegenüber der Schnittgeraden erzeugt wird, wobei die Kristallgitterebenen Gleitebenen des Spendersubstrats sind.

**13.** Verfahren nach einem der vorangegangenen Ansprüche,
**gekennzeichnet durch** die Schritte;

wobei der LASER-Strahl über eine ebene Oberfläche des Spendersubstrats in das Spendersubstrat (2) eindringt, wobei der LASER-Strahl derart gegenüber der ebenen Oberfläche des Spendersubstrats geneigt ist, dass er in einem Winkel von ungleich 0° oder 180° gegenüber der Längsachse des Spendersubstrates in das Spendersubstrat eindringt, wobei der LASER-Strahl zum Erzeugen der Modifikation im Spendersubstrat fokussiert wird
oder durch den Schritt:
Abtragen von Material des Spendersubstrats ausgehend von einer sich in Umfangsrichtung des Spendersubstrats erstreckenden Oberfläche in Richtung Zentrum des Spendersubstrats, wobei das Material bevorzugt mittels eines Schleifwerkezugs oder mittels Ablations-Laserstrahlen abgetragen wird.

**14.** Verfahren nach einem der vorangegangenen Ansprüche,
**dadurch gekennzeichnet, dass**

die Modifikationen mindestens einen Ablösebereich vorgeben,
wobei der Ablösebereich zumindest eine dreidimensionale Kontur beschreibt
oder
wobei mehrere Modifikationen zum Ausbilden eines unebenen, insbesondere gewölbten, Ablösebereichs im Inneren des Festkörpers erzeugt werden,
wobei die Modifikationen in Abhängigkeit von vorgegebenen Parametern erzeugt werden, wobei die vorgegebenen Parameter einen Zusammenhang zwischen einer Verformung des Festkörperanteils in Abhängigkeit von einer definierten weiteren Behandlung des Festkörperanteils beschreiben,
wobei ein erster Parameter die mittlere Brechzahl des Materials des Festkörpers (1) oder die Brechzahl des Materials des Festkörpers (1) in dem Bereich des Festkörpers (1) ist, der zur Erzeugung einer definierten Modifikation (2) von Laserstrahlen (10) zu durchqueren ist und
ein zweiter Parameter die Bearbeitungstiefe in dem Bereich des Festkörpers (1) ist, der zur Erzeugung einer definierten Modifikation (2) von Laserstrahlen (10) zu durchqueren ist,
wobei der erste Parameter mittels eines Brechzahlbestimmungsmittels, insbesondere mittels spektraler Reflektion, bestimmt wird und/oder
der zweite Parameter mittels eines Topografiebestimmungsmittels, insbesondere mittels eines konfokal-chromatischen Distanzsensors, bestimmt wird,
wobei Daten zu den Parametern, insbesondere zu dem ersten Parameter und zu dem zweiten Parameter, in einer Datenspeichereinrichtung (12) bereitgestellt werden und zumindest vor der Erzeugung der Modifikationen (2) einer Steuerungseinrichtung (14) zugeführt werden, wobei die Steuerungseinrichtung (14) die Laserbeaufschlagungseinrichtung (8) in Abhängigkeit vom jeweiligen Ort der zu erzeugenden Modifikation (2) einstellt, wobei die Steuerungseinrichtung (14) zur Einstellung der Laserbeaufschlagungseinrichtung (8) ebenfalls Distanzdaten zu einem Distanzparameter verarbeitet, wobei der Distanzparameter den Abstand des jeweiligen Ortes, an dem Laserstrahlen (10) zur Erzeugung der jeweiligen Modifikation (2) in den Festkörper (1) zum Zeitpunkt der Modifikationserzeugung eingeleitet werden, gegenüber der Laserbeaufschlagungseinrichtung (8) wiedergibt, wobei die Distanzdaten mittels einer Sensoreinrichtung (16) erfasst werden,

wobei die Einstellung der Laserbeaufschlagungseinrichtung (8) in Abhängigkeit von einer während der Modifikationserzeugung erfolgenden Bestimmung des ersten Parameters und des zweiten Parameters mittels jeweils eines Sensormittels, insbesondere einem Brechzahlbestimmungsmittel und einem Topografiebestimmungsmittel, erfolgt.

**15.** Verfahren nach Anspruch 14,
**dadurch gekennzeichnet, dass**
ein Parameter der Grad der Dotierung des Festkörpers an einem vorbestimmten Ort oder in einem vorbestimmten Bereich, insbesondere im Inneren, des Festkörpers, insbesondere beabstandet zur Festkörperoberfläche, ist.

**Claims**

**1.** Method of modifying a solid-state body, especially of removing at least one solid-state layer (2) from a donor substrate (1),
at least comprising the steps of:

providing the donor substrate (1), wherein the donor substrate (1) has crystal lattice planes (6) inclined relative to a planar main surface (8), wherein the main surface (8) delimits the donor substrate (1) in longitudinal direction of the donor substrate (1) on one side, wherein a crystal lattice plane normal is inclined in a first direction relative to a main surface normal, providing at least one laser,

introducing laser radiation from the laser into the interior of the donor substrate (1), especially via the main surface (8), to change the material properties of the donor substrate (1) in the region of at least one laser focus, wherein the laser focus is formed by laser beams from the laser emitted by the laser,

wherein the change in the material property by changing the site of penetration of the laser radiation into the donor substrate (1) forms a linear design (103),

wherein the changes in the material property are generated in at least one generation plane (4),

wherein the crystal lattice planes (6) of the donor substrate (1) are in an inclined alignment relative to the generation plane (4),

wherein the linear design (103) is inclined at least in sections, preferably mainly, with respect to a cutting line (10) that arises at the interface between the generation plane (4) and the crystal lattice plane (6).

**2.** Method according to Claim 1,
**characterized in that**

the changed material property results in tearing of the donor substrate (1) in the form of subcritical cracks, removing the solid-state layer (2) by introducing an external force into the donor substrate (1) to connect the subcritical cracks or so much material in the generation plane (4) is changed by means of the laser radiation that the solid-state layer (2) becomes detached from the donor substrate (1) with connection of the subcritical cracks, wherein

the linear design (103) is inclined at least in sections and preferably mainly or completely relative to the cutting line (10) in an angle range between 3° and 87°, especially in an angle range between 5° and 60° and preferably between 10° and 50°.

**3.** Method according to Claim 2,
**characterized in that**
a sufficient amount of material of the donor substrate (1) is changed to form a linear design (103) that the ends of the individual crystal lattice planes that are exposed as a result of the solid-state layer removal and the changes in the material result in Moiré patterns, for which purpose a multitude of material change regions that extend in a linear and preferably rectilinear manner and are aligned parallel to one another are generated.

**4.** Method according to either of the preceding Claims 2 or 3,
**characterized in that**

the laser radiation is generated with pulse lengths of less than 5 ns or less than 2 ns, especially less than 700 ps or less than 600 ps or less than 500 ps or less than 400 ps or less than 300 ps or less than 200 ps or less than 150 ps or less than 100 ps or less than 50 ps or less than 10 ps,
and
the laser radiation is generated with pulse energies between 100 nJ and 1 mJ or 500 nJ and 100 $\mu$J or 1 $\mu$J and 50 $\mu$J or 0.1 $\mu$J and 50 pj, wherein
the subcritical cracks are generated with a crack length between 10 pm and 100 pm, especially between 20 $\mu$m and 70 pm and preferably between 30 $\mu$m and 50 pm and more preferably between 35 $\mu$m and 45 pm, especially 40 pm.

**5.** Method according to any of the preceding claims,
**characterized in that**
a diffractive optical element (DOE) is disposed in the pathway of the laser radiation prior to the penetration of the laser radiation into the donor substrate (1), wherein the laser radiation is split by the DOE into multiple light pathways for generation of multiple foci, wherein the DOE preferably brings about an image field curvature over a length of 200 $\mu$m of not more than 50 $\mu$m, especially not more than 30 pm or not more than 10 pm or not more than 5 $\mu$m or not more than 3 $\mu$m, wherein the DOE simultaneously generates at least 2 and preferably at least or exactly 3 or at least or exactly 4 or at least or exactly or at least or exactly or up to 5 or at least or exactly or up to 10 or at least or exactly or up to 20 or at least or exactly or up to 50 or up to 100 foci to change the material properties of the donor substrate.

**6.** Method according to any of the preceding claims,
**characterized in that**
multiple donor substrates (1), during the change in the material property, are simultaneously disposed alongside one another on a rotating device, especially a turntable, and are rotatable about a common axis of rotation, wherein the speed of rotation is greater than 10 revolutions/minute and preferably greater than 50 revolutions/minute, and more preferably greater than 150 revolutions/minute, especially up to 600 revolutions/minute.

**7.** Method according to Claim 6,
**characterized in that**
a beamforming device is provided to change the properties of the incident laser radiation, especially a device for changing the polarization of the laser beams (16), especially in the form of a rotating half-wave plate or a Pockels cell, and/or the beamforming device is set up for circular or elliptical polarization of the laser radiation, wherein the donor substrate is exposed to the circularly or elliptically polarized laser radiation, especially in the form of quarter-wave plates.

**8.** Method according to any of the preceding claims,
**characterized in that**

the donor substrate (1) includes a chemical compound, such as silicon carbide, wherein the chemical compound is preferably one or more substances selected from the third, fourth and/or fifth main group of the Periodic Table of the Elements and/or the 12th transition group of the Periodic Table of the Elements, wherein the material change is a predetermined physical transformation of the starting material, especially silicon carbide, in the donor substrate to a target material, especially silicon and carbon.

**9.** Method according to any of the preceding Claims 2 to 4 or according to any of Claims 5 to 8 which are dependent on any of Claims 2 to 4,
**characterized in that**

the external force is generated by disposing a polymer material on the main surface (8),
wherein the polymer material has a glass transition temperature of below 20°C, especially of below 10°C or below 0°C, and
wherein the polymer material is cooled to a temperature below the glass transition temperature, wherein the glass transition that takes place generates mechanical stresses in the donor substrate (1), wherein the mechanical stresses join the subcritical cracks to one another, whereby the solid-state layer (2) becomes detached from the donor substrate (1).

**10.** Method according to any of the preceding claims, further comprising the steps of:

moving the donor substrate (1) relative to the laser,
wherein the laser is adjusted for defined focusing of the laser radiation and/or for adjustment of the laser energy continuously as a function of at least one parameter and preferably a multitude of parameters, especially at least two parameters.

**11.** Method according to any of the preceding claims, **characterized in that**

multiple first linear designs (103) are generated, wherein each linear design generates a subcritical crack or multiple subcritical cracks,
wherein the subcritical cracks of the first linear designs are spaced apart from one another at a defined distance, wherein the distance is sufficiently great that the subcritical cracks do not overlap in the axial direction of the donor substrate, especially spaced apart from one another by at least or up to 2 um or at least or up to 5 um or at least or up to 10 um or at least or up to 20 um or at least or up to 30 um or at least or up to 50 um or at least or up to 75 um or at least or up to 100 um,
and, after the generation of the first linear designs, at least one further linear design in each case is generated by means of laser beams, especially by changing the material properties, at least between two first linear designs and preferably between more than two first linear designs.

**12.** Method according to any of the preceding claims, **characterized in that**

the donor substrate has a hexagonal crystal lattice with wurtzite structure or corundum structure, wherein the linear design is generated at a predetermined angle between 15° and 60°, especially in the wurtzite structure at an angle between 25° and 35° and preferably at an angle of 30° and in the corundum structure between 10° and 60° and preferably at an angle of 45°, relative to the cutting line or
the donor substrate has a cubic crystal lattice, wherein the linear design is generated at a predetermined angle between 7.5° and 60°, especially in a monoclinic cubic structure at an angle between 17.5° and 27.5° and preferably at an angle of 22.5°, or in yttrium aluminum garnet between 8° and 37° and preferably at an angle of 22.5°, relative to the cutting line, or
the donor substrate has a triclinic crystal lattice structure, wherein the linear design is generated at a predetermined angle of 5° to 50°, especially between 10° and 45° or at 10° or at 45°, relative to the cutting line, or
the donor substrate has a zincblende crystal structure, wherein the linear design is generated at a predetermined angle between 15° and 60°, especially in gallium arsenide at a predetermined angle between 18° and 27° and preferably at an angle of 22.5° or in indium phosphide between 18 and 27° and preferably at an angle of 22.5°, relative to the cutting line, wherein
the crystal lattice planes are slip planes of the donor substrate.

**13.** Method according to any of the preceding claims, **characterized by** the steps:

wherein the laser beam penetrates into the donor substrate (2) via a planar surface of the donor substrate,
wherein the laser beam is inclined relative to the planar surface of the donor substrate such that it enters the donor substrate at an angle other than 0° or 180° to the longitudinal axis of the donor substrate, wherein the laser beam is focused to generate the modification in the donor substrate
or by the step of:
removing material from the donor substrate proceeding from a surface extending in the circumferential direction of the donor substrate in the direction of the center of the donor substrate, wherein the material is preferably removed by means of a grinding tool or by means of ablation laser beams.

**14.** Method according to any of the preceding claims, **characterized in that**

the modifications define at least one detachment region, wherein the detachment region describes at least a three-dimensional outline
or
wherein multiple modifications are generated to form an uneven, especially curved, detachment region within the solid-state body,

wherein the modifications are generated as a function of preset parameters, wherein the preset parameters describe a relationship between a deformation of the solid-state component as a function of a defined further treatment of the solid-state component,

wherein a first parameter is the average refractive index of the material of the solid-state body (1) or the refractive index of the material of the solid-state body (1) in the region of the solid-state body (1) to be traversed to generate a defined modification (2) by laser beams (10) and

a second parameter is the processing depth in the region of the solid-state body (1) to be traversed to generate a defined modification (2) by laser beams (10),

wherein the first parameter is determined by a means of determining refractive index, especially by means of spectral reflection, and/or

the second parameter is determined by a means of determining topography, especially by means of a confocal-chromatic distance sensor,

wherein data for the parameters, especially for the first parameter and for the second parameter, are provided in a data storage device (12) and sent to a control device (14) at least prior to the generation of the modifications (2), wherein the control device (14) adjusts the laser exposure device (8) as a function of the respective location of the modification (2) to be produced,

wherein the control device (14), for adjustment of the laser exposure device (8), likewise processes distance data to give a distance parameter, wherein the distance parameter gives the distance of the respective location at which laser beams (10) generate the respective modification (2) by being introduced into the solid-state body (1) at the time of generation of the modification from the laser exposure device (8), wherein the distance data are detected by means of a sensor device (16), wherein the laser exposure device (8) is adjusted as a function of a determination of the first parameter and of the second parameter during the generation of the modification by means of a respective sensor means, especially a means of determining refractive index and a means of determining topography.

**15.** Method according to Claim 14,
**characterized in that**
one parameter is the degree of doping of the solid-state body at a predetermined location or in a predetermined region, especially in the interior, of the solid-state body, especially at a distance from the surface of the solid-state body.

**Revendications**

**1.** Procédé de modification d'un semi-conducteur, en particulier pour la séparation d'au moins une couche (2) de semi-conducteur d'un substrat (1) dispensateur,
comprenant au moins les stades :

on se procure le substrat (1) dispensateur, dans lequel le substrat (1) dispensateur a des plans (6) de réseau cristallin, qui sont inclinés par rapport à une surface (8) principale plane, dans lequel la surface (8) principale délimite d'une part le substrat (1) dispensateur dans la direction longitudinale du substrat (1) dispensateur, dans lequel une normale au plan du réseau cristallin est inclinée dans une première direction par rapport à une normale à la surface principale,
on se procure au moins un laser,
on introduit du rayonnement laser du laser à l'intérieur du substrat (1) dispensateur, en particulier par la surface (8) principale, pour modifier les propriétés de matériau du substrat (1) dispensateur dans la partie d'au moins un foyer laser, dans lequel on forme le foyer laser par le faisceau laser du laser émis par le laser,
dans lequel la modification de la propriété du matériau par modification de l'emplacement de pénétration du rayonnement laser dans le substrat (1) dispensateur constitue une forme (103) linéaire,
dans lequel on produit des modifications de la propriété du matériau sur au moins un plan (4) de production,
dans lequel les plans (6) de réseau cristallin du substrat (1) dispensateur sont dirigés de manière inclinée par rapport au plan (4) de production,
dans lequel la forme (103) linéaire est, au moins par endroit, de préférence en majorité, inclinée par rapport à une ligne (10) d'intersection donnée à l'endroit d'intersection entre le plan (4) de production et le plan (6) de réseau cristallin.

**2.** Procédé suivant la revendication 1,

**caractérisé en ce que**

par la modification de propriété du matériau, le substrat (1) dispensateur est fissuré sous la forme de fissures sous-critiques, séparation de la couche (2) de semi-conducteur par application d'une force extérieure au substrat (1) dispensateur pour la liaison des fissures sous-critiques ou on modifie au moyen du rayonnement laser tant de matériau sur le plan (4) de production que, par liaison des fissures sous-critiques, la couche (2) de semi-conducteur se détache du substrat (1) dispensateur,

dans lequel

la forme (103) linéaire est inclinée au moins par endroit et de préférence en majorité ou complètement par rapport à la ligne (10) d'intersection dans une plage angulaire comprise entre 3° et 87°, en particulier dans une plage angulaire comprise entre 5° et 60° et, de préférence, comprise entre 10° et 50°.

3. Procédé suivant la revendication 2,
**caractérisé en ce que**
on modifie tant de matériau du substrat (1) dispensateur avec formation d'une forme (103) linéaire qu'il apparaît, à partir des extrémités, mises à nu en raison de la séparation de la couche de semi-conducteur, des divers plans de réseau cristallin et des modifications de matériau, des franges de Moiré, dans lequel à cet effet on produit une pluralité de parties de modification de matériau, s'étendant linéairement et de préférence en ligne droite et dirigées parallèlement entre elles.

4. Procédé suivant l'une des revendications 2 ou 3 précédentes,
**caractérisé en ce que**

l'on produit le rayonnement laser à des longueurs d'impulsion de moins de 5ns ou de moins de 2ns ou de moins de 1ns, en particulier de moins de 700ps, ou de moins de 600ps ou de moins de 500ps ou de moins de 400ps ou de moins de 300ps ou de moins de 200ps ou de moins de 150ps ou de moins de 100ps ou de moins de 50ps ou de moins de 10ps et

on produit le rayonnement laser à des énergies d'impulsion, qui sont comprises entre 100nJ et 1mJ ou 500nJ et 100pJ ou 1μJ et 50pJ ou 0,1μJ et 50pJ, dans lequel

on produit les fissures sous-critiques à une longueur de fissure comprise entre 10pm et 100pm, comprise en particulier entre 20pm et 70pm et comprise, de préférence, entre 30pm et 50pm et, d'une manière particulièrement préférée, comprise entre 35μm et 45μm, en particulier de 40μm.

5. Procédé suivant l'une des revendications précédentes,
**caractérisé en ce que**

dans le chemin du rayonnement laser avant la pénétration du rayonnement laser dans le substrat (1) dispensateur, est monté un élément (DOE) optique de diffraction, dans lequel on subdivise le rayonnement laser par le DOE en plusieurs chemins lumineux pour la production de plusieurs foyers,

dans lequel le DOE provoque une courbure du champ d'image, de préférence sur une longueur de 200pm, qui est inférieure ou égale à 50μm, en particulier inférieure ou égale à 30pm ou inférieure ou égale à 10pm ou inférieure ou égale à 5pm ou inférieure ou égale à 3μm, dans lequel

on produit en même temps pour la modification des propriétés de matériau du substrat dispensateur par le DOE au moins 2 et de préférence au moins ou exactement 3 ou au moins exactement 4 ou au moins exactement ou au moins exactement ou jusqu'à 5 ou au moins ou exactement ou jusqu'à 10 ou au moins ou exactement jusqu'à 20 ou au moins ou exactement jusqu'à 50 ou jusqu'à 100 foyers.

6. Procédé suivant l'une des revendications précédentes, **caractérisé en ce que**
plusieurs substrats (1) dispensateurs sont disposés pendant la modification de la propriété du matériau en même temps les uns à côté des autres sur un dispositif de rotation, en particulier sur une table tournante, et peuvent tourner autour d'un axe de rotation commun, dans lequel la vitesse de rotation est plus grande que 10 tours/minute et, de préférence, plus grande que 50 tours/minute et, d'une manière particulièrement préférée, plus grande que 150 tours/minute, en allant en particulier jusqu'à 600 tours/minute.

7. Procédé suivant la revendication 6,
**caractérisé en ce que**
il est prévu un dispositif de formation de faisceau pour la modification des propriétés du rayonnement laser d'alimentation en particulier un dispositif de modifications de la polarisation du faisceau (16) laser en particulier sous la forme d'une lame demi-onde tournante ou d'une cellule Pockel et/ou le dispositif de formation de faisceau est constitué pour polariser le rayonnement laser circulairement ou elliptiquement, dans lequel le substrat dispensateur est soumis au rayonnement laser polarisé circulairement ou elliptiquement, en particulier sous la forme de lames quart d'onde.

**8.** Procédé suivant l'une des revendications précédentes, **caractérisé en ce que**
le substrat (1) dispensateur comporte un composé chimique, comme du carbure de silicium, dans lequel le composé chimique est de préférence une substance ou plusieurs substances choisies parmi le troisième, quatrième et/ou cinquième groupe principal de la classification périodique des éléments et/ou le 12ème groupe auxiliaire de la classification périodique des éléments, dans lequel la modification de matériau représente un changement de matière déterminé à l'avance du matériau de départ, en particulier du carbure de silicium, du substrat dispensateur en un matériau cible, en particulier en du silicium et du carbone.

**9.** Procédé suivant l'une des revendications 2 à 4 précédentes, ou suivant l'une des revendications 5 à 8, lorsqu'elles dépendent de l'une des revendications 2 à 4,
**caractérisé en ce que**

pour la production de la force extérieure, on met une matière polymère sur la surface (8) principale,
dans lequel la matière polymère a un point de transition à l'état vitreux inférieur à 20°C, en particulier inférieur à 10°C ou inférieur à 0°C et,
dans lequel on refroidit la matière polymère à une température en-dessous du point de transition à l'état vitreux, dans lequel par la transition à l'état vitreux qui est effectuée, on produit des tensions mécaniques dans le substrat (1) dispensateur, dans lequel par les tensions mécaniques on relie entre elles les fissures sous-critiques, grâce à quoi on détache la couche (2) de semi-conducteur du substrat (1) dispensateur.

**10.** Procédé suivant l'une des revendications précédentes comprenant en outre les stades :

on déplace le substrat (1) dispensateur par rapport au laser,
dans lequel on règle le laser pour la focalisation définie du rayonnement laser et/ou pour l'adaptation de l'énergie laser d'une manière continue en fonction d'au moins un paramètre et, de préférence, d'une pluralité de paramètre, en particulier d'au moins deux paramètres.

**11.** Procédé suivant l'une des revendications précédentes,
**caractérisé en ce que**

on produit plusieurs premières formes (103) linéaires,
dans lequel on produit par chaque forme linéaire une fissure sous-critique ou plusieurs fissures sous-critiques, dans lequel les fissures sous-critiques de la première forme linéaire sont à distance les unes des autres d'une distance définie, dans lequel la distance est si grande que les fissures sous-critiques ne se chevauchent pas dans la direction axiale du substrat dispensateur, en étant à distance les unes des autres en particulier d'au moins ou jusqu'à 2pm ou d'au moins ou jusqu'à 5pm ou d'au moins jusqu'à 10pm ou d'au moins ou jusqu'à 20pm ou d'au moins ou jusqu'à 30pm ou d'au moins ou jusqu'à 50pm ou d'au moins ou jusqu'à $75\mu m$ ou d'au moins ou jusqu'à 100pm, et
après la production des premières formes linéaires, on produit au moyen de faisceau laser, en particulier en modifiant les propriétés de matériau, respectivement au moins une autre forme linéaire au moins entre deux premières formes linéaires et de préférence entre plus de deux premières formes linéaires.

**12.** Procédé suivant l'une des revendications précédentes, **caractérisé en ce que**

le substrat dispensateur a un réseau cristallin hexagonal ayant une structure de wurtzite ou une structure de corindon, dans lequel on produit la forme linéaire suivant un angle déterminé à l'avance compris entre 15° et 60°, en particulier pour la structure de wurtzite suivant un angle compris entre 25° et 35° et, de préférence, suivant un angle de 30° et pour la structure de corindon compris entre 10° et 60° de préférence suivant un angle de 45° par rapport aux droites d'intersection ou le substrat dispensateur a un réseau cristallin cubique, dans lequel on produit les formes linéaires suivant un angle déterminé à l'avance compris entre 7,5° et 60°, en particulier pour une structure cubique monoclinique suivant un angle compris entre 17,5° et 27,5° et, de préférence, suivant un angle de 22,5° ou pour un grenat d'yttrium-aluminium compris entre 8° et 37° et, de préférence, suivant un angle de 22,5° par rapport aux droites d'intersection ou

le substrat dispensateur a une structure de réseau cristallin triclinique, dans lequel on produit la forme linéaire suivant un angle défini à l'avance de 5° à 50°, en particulier entre 10° et 45° ou de 10° ou de 45° par rapport aux lignes d'intersection ou le substrat dispensateur a une structure cristalline de blende de zinc, dans lequel on produit la forme linéaire suivant un angle défini à l'avance compris entre 15° et 60°, en particulier pour de l'arséniure de gallium suivant un angle défini à l'avance compris entre 18° et 27° et, de préférence, suivant un angle de 22,5° ou pour du phosphure d'indium compris entre 18 et 27° et, de préférence, suivant un angle de 22,5° par rapport aux droites d'intersection, dans lequel

les plans de réseau cristallin sont des plans de glissement du substrat dispensateur.

**13.** Procédé suivant l'une des revendications précédentes, **caractérisé par** les stades :

dans lequel le faisceau laser pénètre dans le substrat (2) dispensateur par une surface plane du substrat dispensateur,

dans lequel le faisceau laser est incliné par rapport à la surface plane du substrat dispensateur, de manière à pénétrer dans le substrat dispensateur suivant un angle différent de 0° ou de 180° par rapport à l'axe longitudinal du substrat dispensateur, dans lequel on focalise le faisceau laser pour la production de la modification dans le substrat dispensateur

ou par le stade :

enlèvement de matériau du substrat dispensateur à partir d'une surface s'étendant dans la direction périphérique du substrat dispensateur en direction du centre du substrat dispensateur, dans lequel on enlève le matériau, de préférence, au moyen d'un outil de rectification ou au moyen d'un faisceau laser d'ablation.

**14.** Procédé suivant l'une des revendications précédentes, **caractérisé en ce que**

les modifications prescrivent au moins une partie de détachement, dans lequel la partie de détachement décrit au moins un contour tridimensionnel

ou,

dans lequel on produit plusieurs modifications pour la constitution à l'intérieur du semi-conducteur d'une partie de détachement non plane, en particulier incurvée,

dans lequel on produit les modifications en fonction de paramètres donnés à l'avance, dans lequel les paramètres donnés à l'avance décrivent une relation entre une déformation de la proportion de semi-conducteur en fonction d'un autre traitement défini de la proportion de semi-conducteur,

dans lequel un premier paramètre est l'indice de réfraction moyen du matériau du semi-conducteur (1) ou l'indice de réfraction du matériau du semi-conducteur (1) dans la partie du semi-conducteur (1) qui est, pour la production d'une modification (2) définie, traversée par le faisceau (10) laser et

un deuxième paramètre est la profondeur d'usinage dans la partie du semi-conducteur (1) qui, pour la production d'une modification (2) définie, est traversée par le faisceau (10) laser,

dans lequel on détermine le premier paramètre au moyen d'un moyen de détermination de l'indice de réfraction, en particulier au moyen d'une réflexion spectrale, et/ou dans lequel on détermine le deuxième paramètre au moyen d'un moyen de détermination de la topographie, en particulier au moyen d'un capteur de distance chromatique confocal,

dans lequel on met des données se rapportant aux paramètres, en particulier au premier paramètre et au deuxième paramètre, dans un dispositif (12) de mémoire de données et on les envoie au moins avant la production des modifications (2) à un dispositif (14) de commande, dans lequel le dispositif (14) de commande règle le dispositif (8) d'alimentation laser en fonction de l'emplacement respectif des modifications (2) à produire, dans lequel le dispositif (14) de commande traite, pour le réglage du dispositif (8) d'alimentation laser, également des données de distance en un paramètre de distance, dans lequel le paramètre de distance reproduit, par rapport au dispositif (8) d'alimentation laser, la distance de l'emplacement respectif où des faisceaux (10) laser sont, pour la production de la modification (2) respective, envoyés dans le semi-conducteur (1) à l'instant de la production de modifications, dans lequel on détecte les données de distance au moyen d'un dispositif (16) capteur,

dans lequel le réglage du dispositif (8) d'alimentation laser s'effectue en fonction d'une détermination, s'effectuant pendant la production de modifications, du premier paramètre et du deuxième paramètre au moyen de, respectivement, un moyen capteur, en particulier d'un moyen de détermination de l'indice de réfraction ou d'un moyen de détermination topographique.

**15.** Procédé suivant la revendication 14,
**caractérisé en ce que**

un paramètre est le degré de dopage du semi-conducteur en un emplacement déterminé à l'avance ou dans une partie déterminée à l'avance, en particulier à l'intérieur du semi-conducteur, en particulier à distance de la surface du semi-conducteur.

Fig. 1

Fig. 2

Fig. 3

EP 3 612 342 B1

Fig. 4

Fig. 5a

Fig. 5b

Fig. 5c

Fig. 5d

EP 3 612 342 B1

Fig. 6a

Fig. 6b

Fig. 6c

Fig. 7

150

145

4

20

9

200

Fig. 8

250

251 252 253 254

255

9

256 145 4 20 259

Fig. 9

Fig. 10a

Fig. 10b

Fig. 10c

Fig. 11

Fig. 12

Fig. 13

Fig. 14b

Fig. 14a

Fig. 15

Fig. 16a  Fig. 16b

Fig. 17b

Fig. 17a

Fig. 18

Fig. 19

Fig. 20a            Fig. 20b            Fig. 20c            Fig. 20d

Fig. 21a

Fig. 21b

Fig. 21c

Fig. 21d

Fig. 21e

Fig. 21f

EP 3 612 342 B1

Fig. 22a

Fig. 22b

EP 3 612 342 B1

Fig. 23a

Fig. 23b

Fig. 23c

Fig. 23d

Fig. 23e

Fig. 23f

Fig. 23g

Fig. 23h

Fig. 23i

4HSiC - 0001

Fig. 24

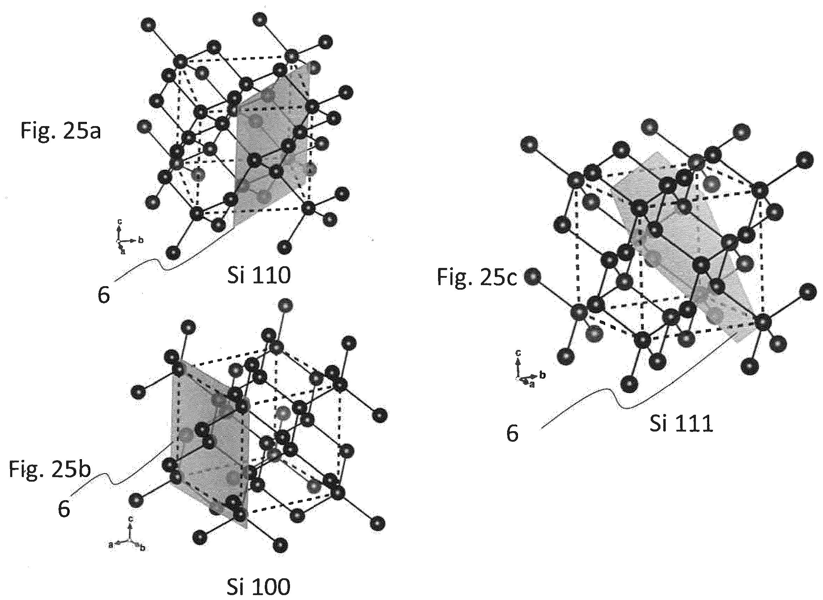

Fig. 25a
Si 110
6

Fig. 25b
Si 100
6

Fig. 25c
Si 111
6

Fig. 26a

Fig. 26b

Fig. 27b

Fig. 27c

Fig. 27a

Fig. 28b

Fig. 28a

Fig. 29a          Fig. 29b          Fig. 29c

EP 3 612 342 B1

Fig. 30a

Fig. 30b

EP 3 612 342 B1

Fig. 31a

Fig. 31b

Fig. 31c

EP 3 612 342 B1

Fig. 32

EP 3 612 342 B1

Fig. 33b

Fig. 33a

Fig. 34b

Fig. 34a

Fig. 35b

Fig. 35a

95

Fig. 36a

Fig. 36b

EP 3 612 342 B1

Fig. 37a

Fig. 37b

Fig. 38a

Fig. 38b

Fig. 39

Fig. 40a

Fig. 40b

Fig. 41

Fig. 42b

Fig. 42a

Fig. 43

Fig. 44b

Fig. 44a

Fig. 45a

Fig. 45b

Fig. 46

EP 3 612 342 B1

Fig. 47a

Fig. 47b

Fig. 47c

Fig. 48a

Fig. 48b

Fig. 48c

Fig. 49

Fig. 50

EP 3 612 342 B1

Fig. 51a

Fig. 51b

Fig. 51c

Fig. 51d

EP 3 612 342 B1

Fig. 52

1014

1, 1000

1014

1, 1000

Fig. 53

Fig. 54a

Fig. 54b

Fig. 55

Fig. 56

Fig. 57b

Fig. 57c

Fig. 57a

Fig. 58

5801    5802    5803    5804    5805    5806

12, 5700

20, 142, 10006

4, 1001

9, 1005

EP 3 612 342 B1

Fig. 59

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2016083610 A
- DE 102016201780 A1